# EUROPEAN PATENT SPECIFICATION

(11) **EP 4 387 415 B1**
(45) Date of publication and mention of the grant of the patent: **26.08.2026**
(21) Application number: 22213037.9
(22) Date of filing: 13.12.2022
(51) Int. Cl.: H10K 50/19, H10K 50/17, H10K 85/60, H10K 50/13, H10K 59/32, H10K 85/30

(54) **ORGANIC ELECTROLUMINESCENT DEVICE COMPRISING A COMPOUND OF FORMULA (I) AND A COMPOUND OF FORMULA (II), AND DISPLAY DEVICE COMPRISING THE ORGANIC ELECTROLUMINESCENT DEVICE**
ORGANISCHE ELEKTROLUMINESZENZVORRICHTUNG MIT EINER VERBINDUNG DER FORMEL (I) UND EINER VERBINDUNG DER FORMEL (II) UND ANZEIGEVORRICHTUNG MIT DER ORGANISCHEN ELEKTROLUMINESZENZVORRICHTUNG
DISPOSITIF ÉLECTROLUMINESCENT ORGANIQUE COMPRENANT UN COMPOSÉ DE FORMULE (I) ET UN COMPOSÉ DE FORMULE (II), ET DISPOSITIF D'AFFICHAGE COMPRENANT LE DISPOSITIF ÉLECTROLUMINESCENT ORGANIQUE

(43) Date of publication of application: 19.06.2024
(73) Proprietor: Novaled GmbH, 01099 Dresden (DE)
(72) Inventor: UVAROV, Vladimir, 01099 Dresden (DE); PINTER, Piermaria, 01099 Dresden (DE); LUSCHTINETZ, Regina, 01099 Dresden (DE); ROSENOW, Thomas, 01099 Dresden (DE); ROBASCHIK, Peter, 01099 Dresden (DE)
(74) Representative: Michalski Hüttermann & Partner mbB

(56) References cited:
- WO-A1-2022/101439
- WO-A1-2022/161706
- US-A1- 2014 048 785
- US-A1- 2020 052 211

## Description

### Technical Field

The present invention relates to an electroluminescent device comprising a compound of formula (I) and a compound of formula (II), and a display device comprising the organic electroluminescent device.

### Background Art

Organic electronic devices, such as organic light-emitting diodes OLEDs, which are self-emitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

Performance of an organic light emitting diode may be affected by characteristics of the semiconductor layers, and among them, may be affected by characteristics of the compounds contained in the semiconductor layers.

There remains a need to improve performance of organic electroluminescent devices, in particular to achieve improved operating voltage, improved operating voltage stability over time and improved current efficiency.
Electroluminescent devices are inter alia disclosed in the WO 2022/ 101439, WO 2022/161706, US 2020/052211 and US 2014/48785.

### DISCLOSURE

An aspect of the present invention provides organic electroluminescent device comprising an anode layer, a cathode layer, a first emission layer, a second emission layer, a hole injection layer, and a first charge generation layer,
wherein the hole injection layer is in direct contact to the anode layer;
wherein the first charge generation layer is arranged between the first emission layer and the second emission layer;
wherein the first charge generation layer comprises a first n-type charge generation layer and a first p-type charge generation layer;
wherein the first n-type charge generation layer is closer to the anode layer than the first p-type charge generation layer;
wherein the n-type charge generation layer comprises a metal dopant and a matrix compound,
wherein the first p-type charge generation layer comprises a second hole transport matrix compound and a compound of formula (I); 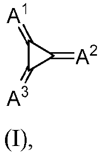
wherein in formula (I)
   - A¹ is independently selected from a group of formula (Ia) 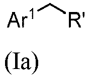
      wherein Ar¹ is independently selected from substituted or unsubstituted C₆ to C₃₆ aryl, and substituted or unsubstituted C₂ to C₃₆ heteroaryl;
      wherein for the case that Ar¹ is substituted, one or more of the substituents are independently selected from the group consisting of D, an electron-withdrawing group, halogen, Cl, F, CN, -NO₂, substituted or unsubstituted C₁ to C₈ alkyl, partially fluorinated C₁ to Cs alkyl, perfluorinated C₁ to Cs alkyl, substituted or unsubstituted C₁ to C₈ alkoxy, partially fluorinated C₁ to C₈ alkoxy, perfluorinated C₁ to C₈ alkoxy, substituted or unsubstituted C₆ to C₃₀ aryl, and substituted or unsubstituted C₆ to C₃₀ heteroaryl and;
         wherein the one or more substituents of C₆ to C₃₀ aryl, C₆ to C₃₀ heteroaryl, C₁ to C₈ alkyl, C₁ to C₈ alkoxy are independently selected from D, an electron-withdrawing group, halogen, Cl, F, CN, -NO₂, partially fluorinated C₁ to C₈ alkyl, perfluorinated C₁ to C₈ alkyl, partially fluorinated C₁ to C₈ alkoxy, perfluorinated C₁ to C₈ alkoxy;
   - A² is independently selected from a group of formula (Ib) 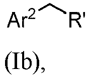 wherein Ar² is independently selected from substituted or unsubstituted C₆ to C₃₆ aryl, and substituted or unsubstituted C₂ to C₃₆ heteroaryl;
      wherein for the case that Ar² is substituted, one or more of the substituents are independently selected from the group consisting of D, an electron-withdrawing group, halogen, Cl, F, CN, -NO₂, substituted or unsubstituted C₁ to C₈ alkyl, partially fluorinated C₁ to C₈ alkyl, perfluorinated C₁ to C₈ alkyl, substituted or unsubstituted C₁ to C₈ alkoxy, partially fluorinated C₁ to C₈ alkoxy, perfluorinated C₁ to C₈ alkoxy, substituted or unsubstituted C₆ to C₃₀ aryl, and substituted or unsubstituted C₆ to C₃₀ heteroaryl and;
      wherein the one or more substituents of C₆ to C₃₀ aryl, C₆ to C₃₀ heteroaryl, C₁ to C₈ alkyl, C₁ to C₈ alkoxy are independently selected from D, an electron-withdrawing group, halogen, Cl, F, CN, -NO₂, partially fluorinated C₁ to C₈ alkyl, perfluorinated C₁ to C₈ alkyl, partially fluorinated C₁ to C₈ alkoxy, perfluorinated C₁ to C₈ alkoxy;
   - A³ is independently selected from a group of formula (Ic) 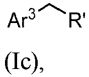 wherein Ar³ is independently selected from substituted or unsubstituted C₆ to C₃₆ aryl, and substituted or unsubstituted C₂ to C₃₆ heteroaryl;
      wherein for the case that Ar³ is substituted, one or more of the substituents are independently selected from the group consisting of D, an electron-withdrawing group, halogen, Cl, F, CN, -NO₂, substituted or unsubstituted C₁ to C₈ alkyl, partially fluorinated C₁ to C₈ alkyl, perfluorinated C₁ to C₈ alkyl, substituted or unsubstituted C₁ to C₈ alkoxy, partially fluorinated C₁ to C₈ alkoxy, perfluorinated C₁ to C₈ alkoxy, substituted or unsubstituted C₆ to C₃₀ aryl, and substituted or unsubstituted C₆ to C₃₀ heteroaryl and;
      wherein the one or more substituents of C₆ to C₃₀ aryl, C₆ to C₃₀ heteroaryl, C₁ to C₈ alkyl, C₁ to C₈ alkoxy are independently selected from D, an electron-withdrawing group, halogen, Cl, F, CN, -NO₂, partially fluorinated C₁ to C₈ alkyl, perfluorinated C₁ to C₈ alkyl, partially fluorinated C₁ to C₈ alkoxy, perfluorinated C₁ to C₈ alkoxy;
      and wherein in A¹, A², and A³ each R' is independently selected from substituted or unsubstituted C₆ to C₁₈ aryl, C₃ to C₁₈ heteroaryl, electron-withdrawing group, substituted or unsubstituted C₁ to C₈ alkyl, partially fluorinated C₁ to C₈ alkyl, perfluorinated C₁ to C₈ alkyl, halogen, F and CN;
      wherein the one or more substituents of C₆ to C₁₈ aryl, C₆ to C₁₈ heteroaryl, C₁ to C₈ alkyl are independently selected from D, an electron-withdrawing group, halogen, Cl, F, CN, -NO₂, partially fluorinated C₁ to C₆ alkyl, perfluorinated C₁ to C₆ alkyl, partially fluorinated C₁ to C₆ alkoxy, perfluorinated C₁ to C₆ alkoxy;
wherein the hole injection layer comprises a first hole transport matrix compound and a compound of formula (II) which is a metal compound selected from a metal salt or a metal complex comprising a metal cation and at least one monoanion consisting of at least 20 covalently bound atoms and/or at least one monoanionic ligand consisting of at least 20 covalently bound atoms.

It should be noted that throughout the application and the claims any Aⁿ, Bⁿ , Rⁿ, Xⁿ etc. always refer to the same moieties, unless otherwise noted.

In the present specification, when a definition is not otherwise provided, "substituted" refers to one substituted with a deuterium, C₁ to C₁₂ alkyl and C₁ to C₁₂ alkoxy.

However, in the present specification "aryl substituted" refers to a substitution with one or more aryl groups, which themselves may be substituted with one or more aryl and/or heteroaryl groups.

Correspondingly, in the present specification "heteroaryl substituted" refers to a substitution with one or more heteroaryl groups, which themselves may be substituted with one or more aryl and/or heteroaryl groups.

In the present specification, when a definition is not otherwise provided, an "alkyl group" refers to a saturated aliphatic hydrocarbyl group. The alkyl group may be a C₁ to C₁₂ alkyl group. More specifically, the alkyl group may be a C₁ to C₁₀ alkyl group or a C₁ to C₆ alkyl group. For example, a C₁ to C₄ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an isopropyl group, a butyl group, an iso-butyl group, a sec-butyl group, a tert-butyl group, a pentyl group, a hexyl group.

The term "cycloalkyl" refers to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methylcyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more

aromatic rings linked by single bonds, like biphenyl, and polycyclic groups comprising fused rings, like naphtyl or fluoren-2-yl.

Analogously, under heteroaryl, it is especially where suitable understood a group derived by formal abstraction of one ring hydrogen from a heterocyclic aromatic ring in a compound comprising at least one such ring.

Under heterocycloalkyl, it is especially where suitable understood a group derived by formal abstraction of one ring hydrogen from a saturated cycloalkyl ring in a compound comprising at least one such ring.

The term "fused aryl rings" or "condensed aryl rings" is understood the way that two aryl rings are considered fused or condensed when they share at least two common sp²-hybridized carbon atoms.

The term "cyano moiety" refers to a CN substituent.

The term "electron-withdrawing group" refers to a chemical group in a molecule, which can draw electrons away from an adjacent part of the molecule. The distance over which the electron-withdrawing group can exert its effect, namely the number of bonds over which the electron-withdrawing effect spans, is extended by conjugated pi-electron systems such as aromatic systems. Examples of electron-withdrawing groups include NO₂, CN, halogen, Cl, F, partially fluorinated or perfluorinated alkyl and partially fluorinated or perfluorinated C₁ to C₁₂ alkyl, partially fluorinated or perfluorinated alkoxy, partially fluorinated or perfluorinated C₁ to C₆ alkoxy.

**In** the present specification, the single bond refers to a direct bond.

The term "n-type charge generation layer" is sometimes in the art also named n-CGL or electron generation layer and is intended to include the both.

The term "p-type charge generation layer" is sometimes in the art also named p-CGL or hole generation layer and is intended to include the both.

The term "free of", "does not contain", "does not comprise" does not exclude impurities which may be present in the compounds prior to deposition. Impurities have no technical effect with respect to the object achieved by the present invention.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms "anode", "anode layer" and "anode electrode" are used synonymously.

The terms "cathode", "cathode layer" and "cathode electrode" are used synonymously.

The term "top emission device" is understood to mean an organic electronic device wherein the light is emitted through the cathode layer.

The term "bottom emission device" is understood to mean an organic electronic device wherein the light is emitted through the substrate.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

### Advantageous Effects

Surprisingly, it was found that the organic electroluminescent device according to the invention solves the problem underlying the present invention by enabling devices in various aspects superior over the organic electroluminescent devices known in the art, in particular with respect to improved operating voltage, improved operating voltage stability over time and improved current efficiency.

According to one embodiment of the present invention, the compound of formula (I) has a calculated LUMO energy level, expressed in the absolute scale referring to vacuum energy level being zero, of ≤-4.90 eV, preferably ≤ -5.00 eV, more preferably ≤ -5.05 eV, and most preferably ≤ -5.10 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to one embodiment of the present invention, the compound of formula (I) has a calculated LUMO energy level, expressed in the absolute scale referring to vacuum energy level being zero, in the range of ≤ -4.90 eV to ≥ -5.75 eV, preferably ≤ -5.00 eV to ≥ -5.75 eV, more preferably ≤ -5.05 eV to ≥ -5.75 eV and most preferably ≤ -5.10 eV to ≥ -5.75 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to one embodiment of the present invention, the compound of formula (I) is present in the p-type charge generation layer in an amount of ≥1 wt% and ≤20 wt% based on the total weight of the p-type charge generation layer, preferably ≥5 wt% and ≤10 wt%.

According to an embodiment, the compound of formula (I) is an organic p-dopant.

According to an embodiment, in the compound of formula (I) the following compounds are excluded: 4,4',4"-((1E,1'E,1"E)-cyclopropane-1,2,3-triylidenetris(cyanomethanylylidene))tris(2,3,5,6-tetrafluorobenzonitrile); (2E,2'E,2"E)-2,2',2"-(cyclopropane-1,2,3-triylidene)tris(2-(2,6-dichloro-3,5-difluoro-4-(trifluoromethyl)phenyl)-acetonitrile); α,α',α"-1,2,3-Cyclopropanetriylidenetris[2,3,4,5,6-pentafluorobenzeneacetonitrile]; and α,α',α"-1,2,3-Cyclopropanetriylidenetris[2,3,5,6-tetrafluoro-4-(trifluoromethyl)benzeneacetonitrile].

According to one embodiment of the present invention, the compound of formula (I) comprises at least one CF₃ group.

According to one embodiment of the present invention, the compound of formula (I) comprises at one to three CF₃ group.

According to one embodiment of the present invention, the compound of formula (I) comprises less than nine cyano moieties.

According to one embodiment of the present invention, the compound of formula (I) comprises less than eight cyano moieties.

According to one embodiment of the present invention, the compound of formula (I) comprises at least one cyano moiety.

According to one embodiment of the present invention, the compound of formula (I) comprises at least two cyano moieties.

According to one embodiment of the present invention, the compound of formula (I) comprises at least three cyano moieties.

According to one embodiment of the present invention, the compound of formula (I) comprises at least four cyano moieties.

According to one embodiment of the present invention, the compound of formula (I) comprises from 3 to 8 cyano moieties.

According to one embodiment of the present invention, the compound of formula (I) comprises from 3 to 7 cyano moieties.

According to one embodiment of the present invention, the compound of formula (I) comprises from 4 to 7 cyano moieties.

According to one embodiment of the present invention, formula (I) comprises at least 10 fluorine atoms, at least 12 fluorine atoms, at least 13 fluorine atoms,14 at least fluorine atoms, at least 15 fluorine atoms, at least 16 fluorine atoms, at least 17 fluorine atoms, or at least 18 fluorine atoms.

According to one embodiment of the present invention, formula (I) comprises 10 to 20 fluorine atoms, or 10 to 18 fluorine atoms or 12 to 18 fluorine atoms.

According to one embodiment of the present invention, formula (I) comprises 4 to 7 cyano moieties and 12 to 18 fluorine atoms.

According to one embodiment of the present invention, in formula (I), at least two of A¹, A², and A³ are selected the same.

According to one embodiment of the present invention, in formula (I), A² and A³ are identical.

According to one embodiment of the present invention, in formula (I), A¹, A² and A³ are identical.

According to one embodiment of the present invention, in formula (I) A¹ is different from A² and/or A³.

According to one embodiment of the present invention, in formula (I) Ar¹, Ar², and Ar³ are independently selected from substituted or unsubstituted C₆ to C₁₂ aryl and substituted or unsubstituted C₃ to C₁₂ heteroaryl.

According to one embodiment of the present invention, in formula (I) Ar¹, Ar², and Ar³ are independently selected from substituted or unsubstituted C₆ aryl and substituted or unsubstituted C₃ to C₅ heteroaryl.

According to one embodiment of the present invention, in formula (I) the substituents on Ar¹, Ar², and Ar³ are independently selected from the group consisting of an electron-withdrawing group, halogen, Cl, F, CN, partially fluorinated alkyl, and perfluorinated alkyl.

According to one embodiment of the present invention, in formula (I) the substituents on Ar¹, Ar², and Ar³ are independently selected from the group consisting of Cl, F, CN, and perfluorinated alkyl.

According to one embodiment of the present invention, in formula (I) the substituents on Ar¹, Ar², and Ar³ are independently selected from the group consisting of F, CN, and perfluorinated alkyl.

According to one embodiment of the present invention, in formula (I) the substituents on Ar¹, Ar², and Ar³ are independently selected from the group consisting of F, CN, and CF₃.

According to one embodiment of the present invention, in formula (I) the substituents on Ar¹, Ar², and Ar³ are independently selected from the group consisting of CN, and CF₃.

According to one embodiment of the present invention, in formula (I) the substituents on Ar¹, Ar², and Ar³ are independently selected from the group consisting of CN.

According to one embodiment of the present invention, in formula (I) the substituents on Ar¹, Ar², and Ar³ are independently selected from the group consisting of CF₃.

According to one embodiment of the present invention, in formula (I) Ar¹, Ar², and Ar³ independently each comprise more than one and less than five substituents, preferably more than two and less than four, for example 4.

According to one embodiment of the present invention, in formula (I) each R' is independently selected from electron-withdrawing group, partially fluorinated C₁ to C₈ alkyl, perfluorinated C₁ to C₈ alkyl, halogen, F and CN.

According to one embodiment of the present invention, in formula (I) each R' is independently selected from partially fluorinated C₁ to C₈ alkyl, perfluorinated C₁ to C₈ alkyl, halogen, F and CN.

According to one embodiment of the present invention, in formula (I) each R'is independently selected from CF₃, F and CN.

According to one embodiment of the present invention, in formula (I) each R' is CN.

According to one embodiment of the present invention, in formula (I) Ar¹, Ar² and Ar³ are independently selected from a group according to the following formula (III) and preferably each R' is selected from CN: 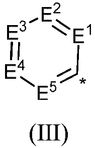 wherein
E¹ is selected from CW¹ or N;
E² is selected from CW² or N;
E³ is selected from CW³ or N;
E⁴ is selected from CW⁴ or N;
E⁵ is selected from CW⁵ or N;
W¹, W², W³, W⁴ and W⁵ (if present) are independently selected from electron-withdrawing group, CN, halogen, Cl, F, NO₂, substituted or unsubstituted C₁ to C₈ alkyl, partially fluorinated C₁ to C₈ alkyl, perfluorinated C₁ to C₈ alkyl, substituted or unsubstituted C₁ to C₈ alkoxy, partially fluorinated C₁ to C₈ alkoxy, perfluorinated C₁ to C₆ alkoxy, OCF₃, substituted or unsubstituted C₆ to C₃₀ aryl, substituted or unsubstituted C₃ to C₃₀ heteroaryl, D or H,
   wherein the one or more substituents is independently selected from D, halogen, Cl, F, CN, NO₂, partially fluorinated C₁ to C₈ alkyl, perfluorinated C₁ to C₈ alkyl, partially fluorinated C₁ to C₈ alkoxy, perfluorinated C₁ to C₈ alkoxy,
wherein the asterisk "*" denotes the binding position.

According to one embodiment of the present invention, in formula (III)
W¹, W², W³, W⁴ and W⁵ (if present) are independently selected from electron-withdrawing group, CN, halogen, Cl, F, NO₂, partially fluorinated or perfluorinated C₁ to C₈ alkyl, partially fluorinated or perfluorinated C₁ to C₆ alkoxy, D or H, and wherein preferably each R' is selected from CN.

According to one embodiment of the present invention, in formula (I), Ar¹, Ar² and Ar³ are independently selected from B1 to B64 and preferably each R' is selected from CN: 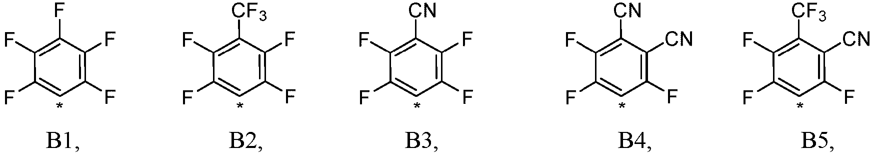 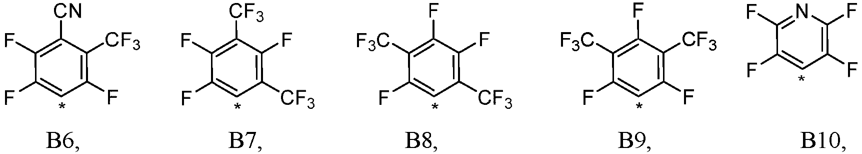 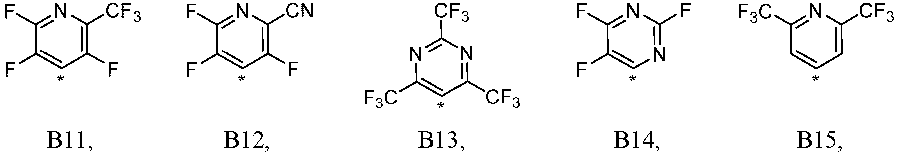 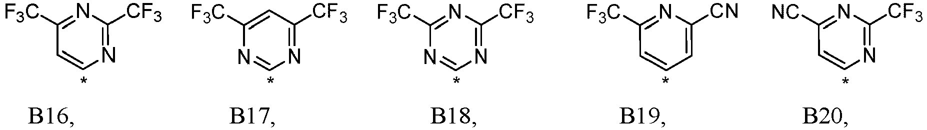 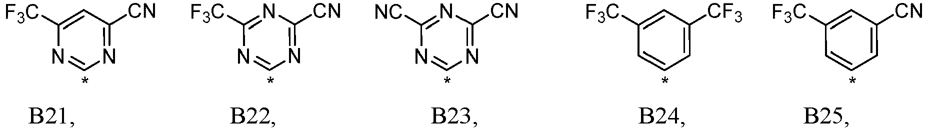 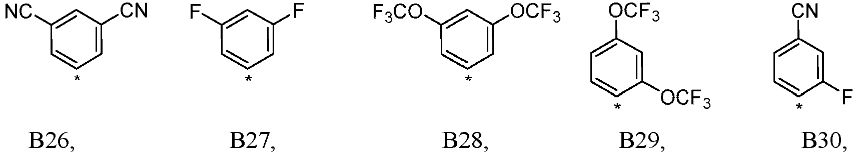 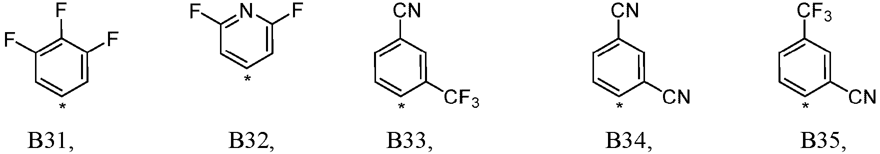 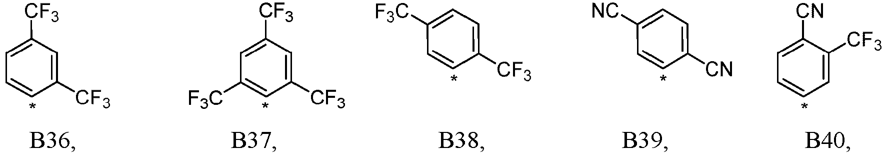 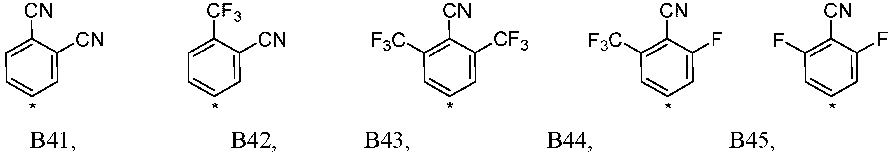 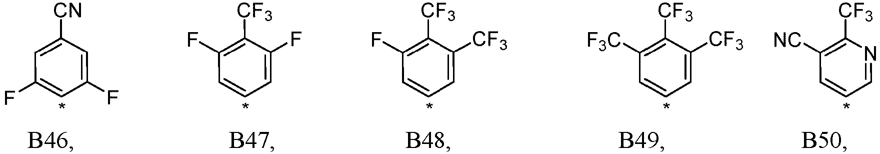 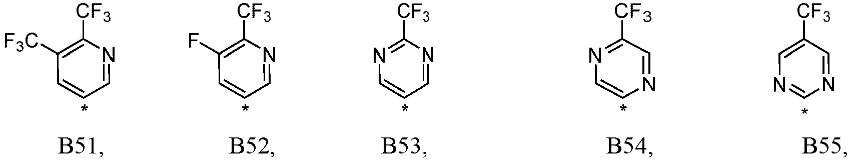 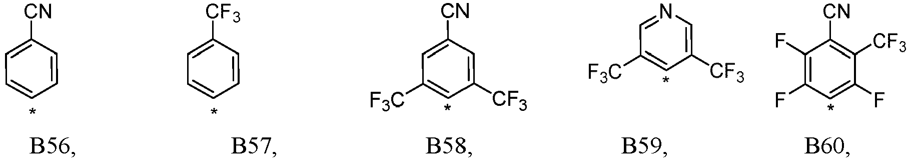 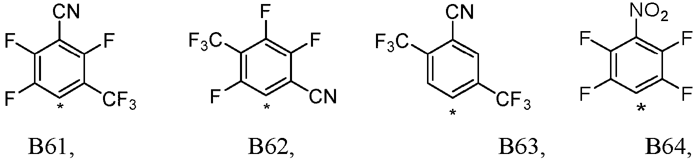 wherein the asterisk "*" denotes the binding position.
According to an embodiment, in the compound of formula (I) Ar¹, or Ar¹, Ar² and Ar³ and/or in the are independently selected from one of the following groups of B1 to B8, B10 to B17, B19 to B21, B24 to B26, B33, B34, B37, B40, B43, B58 to B62 and B64, and preferably in the compound of formula (I) Ar¹, or Ar¹, Ar² and Ar³ are independently selected from one of the following groups of B2, B3, B4, B11, B13, B37, B43, B58, B59, B60, B61, B63 and B64.

According to an embodiment, in the compound of formula (I) Ar¹, or Ar¹, Ar² and Ar³ are independently selected from one of the following groups of B1 to B64, and wherein preferably each R' and/or R" are selected from CN, and preferably wherein in the compound of formula (I) Ar¹, or Ar¹, Ar² and Ar³ are independently selected from one of the following groups of B1 to B5, B7, B8, B10 to B13, B15 to B17, B19 to B21, B37, B43, B58 to B61, B63 and B64 and wherein preferably each R' and/or R" are selected from CN.

According to an embodiment, wherein in the compound of formula (I) Ar¹, or Ar¹, Ar² and Ar³ are independently selected from one of the following groups: 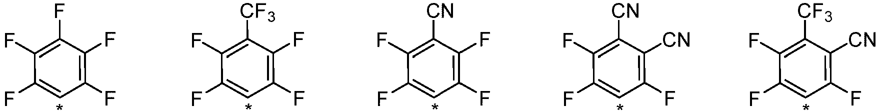 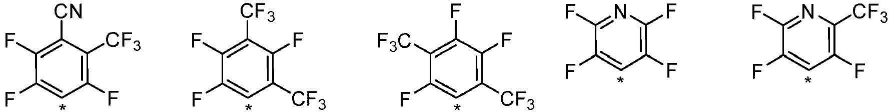 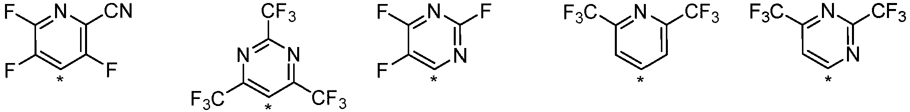 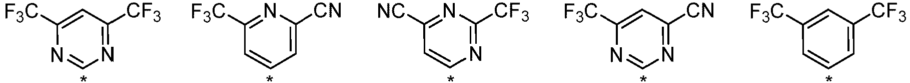 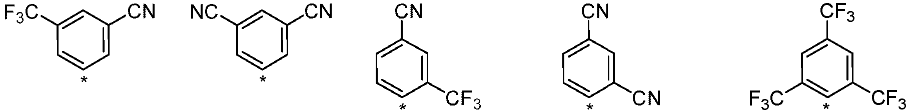 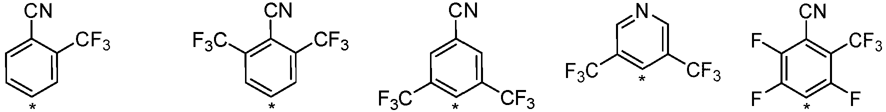 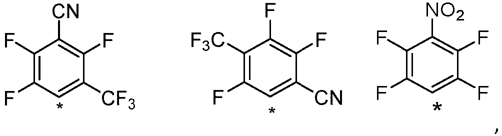 wherein the asterisk "*" denotes the binding position; and wherein preferably each R' and/or R" is selected from CN.

According to an embodiment, wherein in the compound of formula (I) Ar¹, or Ar¹, Ar² and Ar³ are independently selected from one of the following groups: 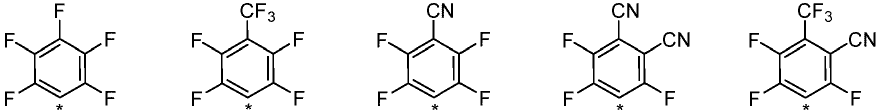 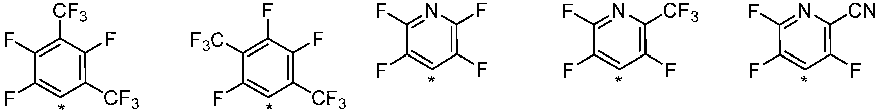 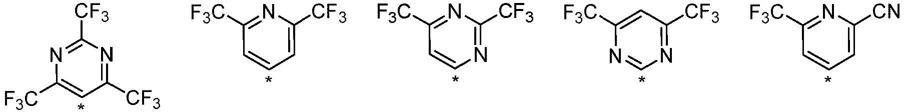 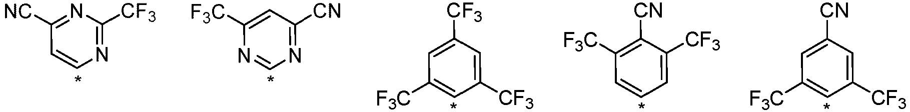 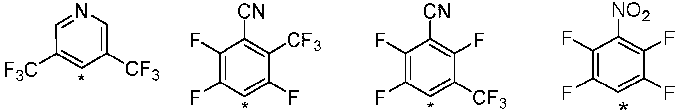 wherein the asterisk "*" denotes the binding position; and wherein preferably each R' and/or R" is selected from CN.

According to an embodiment, wherein in the compound of formula (I) Ar¹, or Ar¹, Ar² and Ar³ are independently selected from one of the following groups: 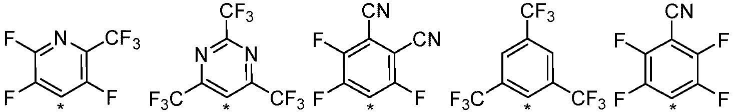 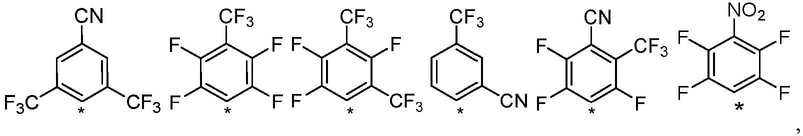 wherein the asterisk "*" denotes the binding position.

According to an embodiment, wherein in the compound of formula (I) Ar¹, or Ar¹, Ar² and Ar³ are independently selected from one of the following groups: 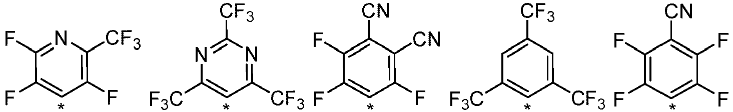 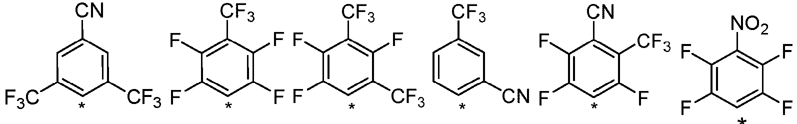 wherein the asterisk "*" denotes the binding position; and wherein each R' is selected from CN.

According to an embodiment, wherein the compound of formula (I) is selected from one of the following compounds BR1 to BR14, wherein R' is selected from CN and Ar¹ of A¹, Ar² of A², and Ar³ of A³ are selected as follows:

| Compound | Ar¹ of A¹ | Ar² of A² | Ar³ of A³ |
|---|---|---|---|
| BR1 | 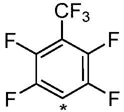 | 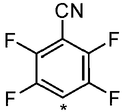 | 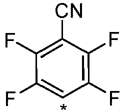 |
| BR2 | 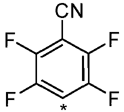 | 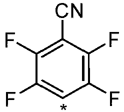 | 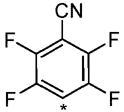 |
| BR3 | 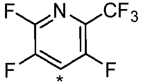 | 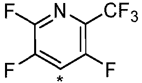 | 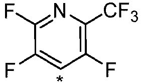 |
| BR4 | 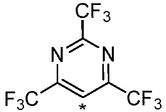 | 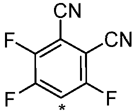 | 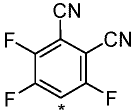 |
| BR5 | 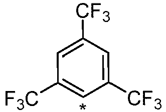 | 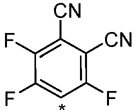 | 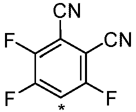 |
| BR6 | 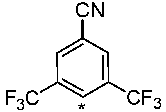 | 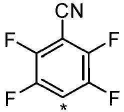 | 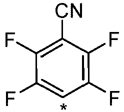 |
| BR7 | 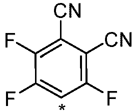 | 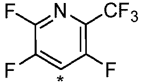 | 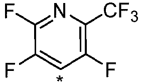 |
| BR8 | 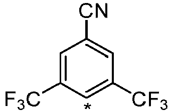 | 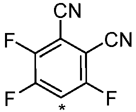 | 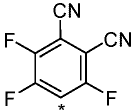 |
| BR9 | 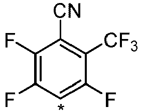 | 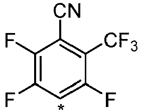 | 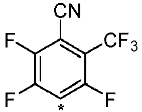 |
| BR10 | 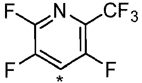 | 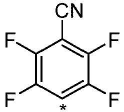 | 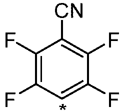 |
| BR11 | 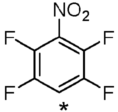 | 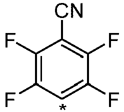 | 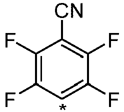 |
| BR12 | 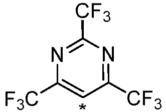 | 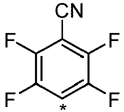 | 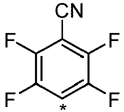 |
| BR13 | 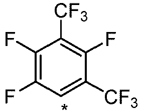 | 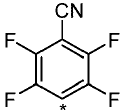 | 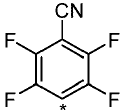 |
| BR14 | 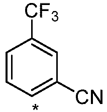 | 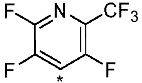 | 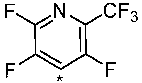 |

wherein the asterisk "*" denotes the binding position.

According to an embodiment, wherein the compound of formula (I) is selected from one of the following compounds BR2 to BR6, wherein R' is selected from CN and Ar¹ of A¹, Ar² of A², and Ar³ of A³ are selected as follows:

| Compound | Ar¹ of A¹ | Ar² of A² | Ar³ of A³ |
|---|---|---|---|
| BR2 | 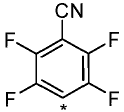 | 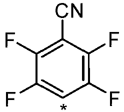 | 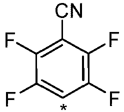 |
| BR3 | 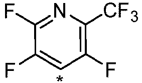 | 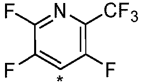 | 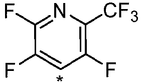 |
| BR4 | 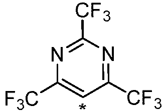 | 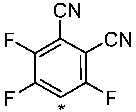 | 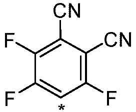 |
| BR5 | 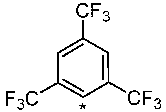 | 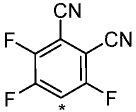 | 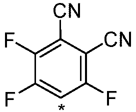 |
| BR6 | 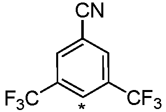 | 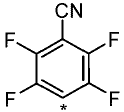 | 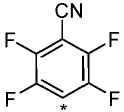 |

wherein the asterisk "*" denotes the binding position.

According to one embodiment of the present invention, the compound of formula (I) is represented by one of the following formulae (IIIa) to (IIIh): 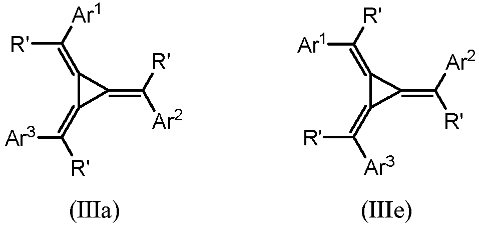 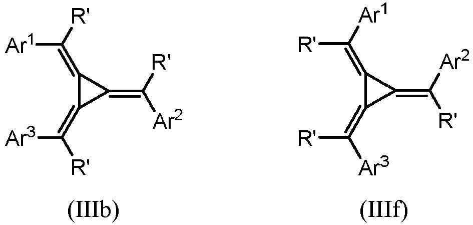 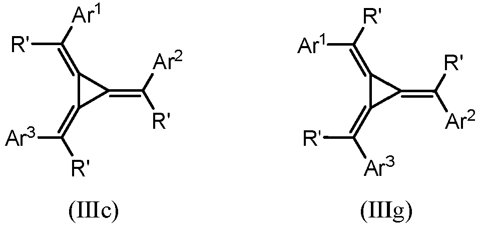 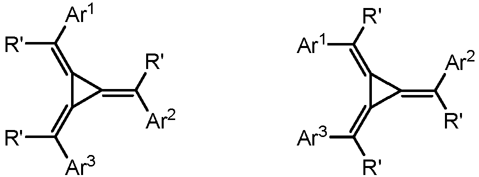 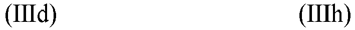 wherein Ar¹, Ar², Ar³, and R' are independently selected as above.

According to one embodiment of the present invention, the hole injection layer comprises as compound of formula (I) a mixture of at least two compounds selected from formulae (IIIa) to (IIIh) as defined above.

According to an embodiment, the compound of formula (II) has a LUMO energy level of ≥ -7.0 eV to ≤-1.5 eV whereby the calculations are performed by applying the hybrid functional B3LYP with the Def2-TZVP basis set with the SDD Effective Core Potentials (ECPs) for the metals, in the gas phase as implemented in the program package ORCA Version 5.0.3-f.1 (Department of Theory and Spectroscopy, Max Planck Institute für Kohlenforschung Kaiser Wilhelm Platz 1, 45470 Muelheim/Ruhr, Germany).

According to a preferred embodiment compound of formula (II) has a LUMO energy level of ≥-6. 5 eV to ≤ - 1.7 eV, or ≥-6.0 eV to ≤ -2.0 eV, or ≥-5.9 eV to ≤ -2.3 eV; or ≥-5.8 eV to ≤ -2.7 eV; or ≥-5.7 eV to ≤ -3.9 eV or ≥-5.6 eV to ≤ -4.2 eV; or preferred ≥-5.5 eV to ≤ -4.3 eV.

According to an embodiment, the compound of formula (II) comprises a metal cation selected from Ce, Cu, Ag, alkali metal, alkaline earth metal, Bi, Al, Ga, In; Zr, Hf, Cr, and/or Fe.

According to an embodiment, the compound of formula (II) comprises a metal cation selected from Ce, Cu, Ag, Li, Na, K, Rb, Cs, Be, Mg, Ca, Sr, Ba, Bi, In and/or Fe, preferably Ce(IV), Cu(II), Ag(I), Li(I), Na(I), K(I), Rb(I), Cs(I), Be(II), Mg(II), Ca(II), Sr(II), Ba(II), Bi(III), In(III), Cr(III) and/or Fe(III).

According to an embodiment, the compound of formula (II) comprises a metal cation selected from Ce, Cu, Ag, Na, Cs, Bi, and/or Fe, preferably Ce(IV), Cu(II), Ag(I), Na(I), Cs(I), Bi(III); Cr(III) and/or Fe(III).

According to an embodiment, the compound of formula (II) is comprises a metal cation selected from Ce, Cu and/or Fe preferably Ce(IV), Cu(II), and/or Fe(III).

According to an embodiment, the compound of formula (II) is a metal complex.

According to an embodiment, compound of formula (II) is metal complex comprising a metal cation selected from Ce, Cu and/or Fe preferably Ce(IV), Cu(II), and/or Fe(III).

According to an embodiment, compound of formula (II) is metal complex having a LUMO energy level of ≥ -7.00 eV to ≤ -1.50 eV whereby the calculations are performed by applying the hybrid functional B3LYP with the Def2-TZVP basis set with the SDD Effective Core Potentials (ECPs) for the metals, in the gas phase as implemented in the program package ORCA Version 5.0.3-f.1 (Department of Theory and Spectroscopy, Max Planck Institute für Kohlenforschung Kaiser Wilhelm Platz 1, 45470 Muelheim/Ruhr, Germany) wherein the metal complex comprises a metal cation selected from Ce, Fe, and/or Cu preferably Ce(IV), Cu(II), and/or Fe(III).

According to an embodiment, wherein compound of formula (II) comprises at least one CF₃ group.

According to an embodiment, wherein compound of formula (II) comprises at least one CF₃ group which is not bound to an oxygen.

According to an embodiment, the compound of formula (II) comprises at least one monoanion consisting of at least 20 covalently bound atoms and/or at least one monoanionic ligand consisting of at least 20 covalently bound atoms, wherein the monoanion or the monoanionic ligand is presented by L⁻ according to formula (IV) or compound of formula (II) is represented by formula (IIa) 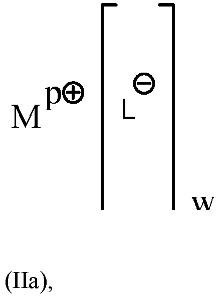 wherein
M is a metal ion;
p is the valency of M;
w is n;
wherein L⁻ can be selected the same or different;
wherein compound of formula (IIa) can optionally comprise an ancillary ligand (AL), which coordinates to the metal cation or the metal cation M^{p+};
wherein L⁻ is represented by 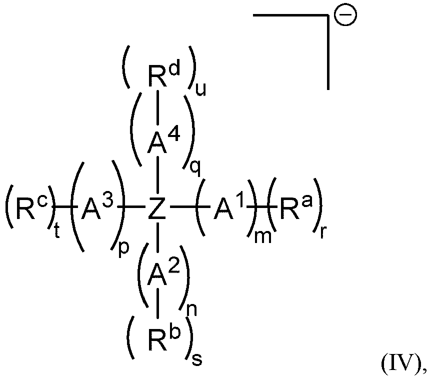
m, n, p, and q are independently selected from 0 or 1;
r, s, t, and u are independently selected from 0 or 1;
at least one of r, s, t, and u is 1;
Z is selected from CR¹, C, O, N, B;
if Z is selected O then n, p, q and are selected from 0 and s, t and u are selected from 0;
   if Z is selected from N or CR¹ then p and q are selected from 0, and t and u are selected from 0;
   if Z is selected from C then q is selected from 0, and u is selected from 0;
   if Z is selected from B then n, m, p, and q are selected from 1, and r, s, t, and u are selected from 1;
A¹, A², A³ and A⁴ are independently selected from C=O, C-O, C=NR², C-NR³, SO, SO₂, or P(=O)R⁴;
wherein Z can form a double bond to A¹, A², A³ and A⁴, if A¹, A², A³ and A⁴ is selected from C-O or C-NR³ and Z is selected from N, O or CR¹, or A¹, A², A³ and A⁴ is selected from CO or C-NR³ and Z is selected from C_{;}
and wherein optionally two of A¹, A², A³ and A⁴ together can form a substituted or unsubstituted heterocycle or substituted or unsubstituted carbocycle with Z, or wherein optionally one of A¹, A², A³ and A⁴ can form a substituted or unsubstituted heterocycle or substituted or unsubstituted carbocycle with Z
wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl;
R¹ is selected from H, D, electron-withdrawing group, halogen, Cl, F, CN, NO₂, SF₅, isonitrile, ester group, carboxylic group, carbonyl group, acyl group, thio group sulfinyl group, sulfonyl group, phosphine group, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₁ to C₁₂ alkoxy, partially perfluorinated C₁ to C₆ alkoxy, perfluorinated C₁ to C₆ alkoxy, CF₃, substituted or unsubstituted C₆ to C₄₀ aryl, substituted or unsubstituted C₂ to C₄₀ heteroaryl, substituted or unsubstituted C₃ to C₃₀, carbocyclyl, substituted or unsubstituted C₃ to C₃₀ heterocyclyl;
wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N;
R², R³ and R⁴ are independently selected from H, D, electron-withdrawing group, halogen, Cl, F, CN, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, substituted or unsubstituted C₁ to C₆ alkoxy, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₃₀ heteroaryl, substituted or unsubstituted C₃ to C₃₀ carbocyclyl, substituted or unsubstituted C₂ to C₃₀ heterocyclyl,
wherein the substituents on R², R³ and R⁴ are independently selected from D, electron-withdrawing group, halogen, Cl, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃;
R^{a}, R^{b}, R°and R^{d} are independently selected from H, D, electron-withdrawing group, halogen, F, Cl, CN, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₆ to C₄₀ aryl, substituted or unsubstituted C₂ to C₃₀ heteroaryl, substituted or unsubstituted C₃ to C₄₀ carbocyclyl, substituted or unsubstituted C₂ to C₃₀ heterocyclyl, O, S, N, NR⁵, substituted or unsubstituted amine group having 0 to 20 carbon atoms;
wherein the one more substituents on R^{a}, R^{b}, R^{c} and R^{d} are independently selected from electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, partially perfluorinated C₁ to C₆ alkoxy, perfluorinated C₁ to C₆ alkoxy, OCF₃;
   wherein R⁵ is selected from substituted or unsubstituted C₆ to C₄₀ aryl, substituted or unsubstituted C₂ to C₄₀ heteroaryl, substituted or unsubstituted C₁ to C₁₂ alkyl, partially perfluorinated C₁ to C₁₂ alkyl, perfluorinated C₁ to C₁₂ alkyl,
wherein the one or more substituents on R⁵ is selected from electron-withdrawing group, halogen, F, CN, NO₂, SF₅, isonitrile, ester group, carboxylic group, carbonyl group, acyl group, thio group sulfinyl group, sulfonyl group, phosphine group, partially fluorinated C₁ to C₁₂ alkyl, perfluorinated C₁ to C₁₂ alkyl, CF3, CF₂CF₃, partially fluorinated C₁ to C₆ alkoxy, perfluorinated C₁ to C₆ alkoxy, OCF₃, OCF₂CCF₃;
preferably at least one of R^{a}, R^{b}, R^{c} and R^{d} is independently selected from substituted or unsubstituted C₆ to C₄₀ aryl, substituted or unsubstituted C₂ to C₄₀ heteroaryl, substituted or unsubstituted C₁ to C₁₂ alkyl, substituted or unsubstituted C₃ to C₃₀ carbocyclyl, substituted or unsubstituted C₂ to C₃₀ heterocyclyl,
wherein the substituents on R^{a}, R^{b}, R^{c} and R^{d} are independently selected from electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃,;
wherein
optionally one of R^{a}, R^{b}, R^{c}, R^{d} can independently from each other form a substituted or unsubstituted heterocycle or substituted or unsubstituted carbocycle with R¹,
wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl;
wherein the one or more substituent on the substituent on the heterocycle or carbocyle is independently selected form D, electron-withdrawing group, halogen, F, substituted or unsubstituted C₁ to C₁₂ alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃.

According to one embodiment none R^{a}, R^{b}, R^{c} and R^{d} is substituted or unsubstituted C₃ to C₄₀ carbocyclyl.

### Ancillary ligand AL

Ancillary ligands are defined as those ligands that provide the appropriate steric and
electronic environment around the central element but remain innocent in any transformation that the compound undergoes. In contrast, reactive ligands are those groups that undergo changes.

According to one embodiment of the application AL is selected from the group comprising H₂O, C₂ to C₄₀ mono- or multi-dentate ethers and C₂ to C₄₀ thioethers, C₂ to C₄₀ amines, C₂ to C₄₀ phosphine, C₂ to C₂₀ alkyl nitrile or C₂ to C₄₀ aryl nitrile, or a compound according to Formula (AL-I); 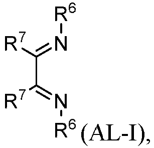 wherein
- R⁶ and R⁷: are independently selected from C₁ to C₂₀ alkyl, C₁ to C₂₀ heteroalkyl, C₆ to C₂₀ aryl, heteroaryl with 5 to 20 ring-forming atoms, halogenated or perhalogenated C₁ to C₂₀ alkyl, halogenated or perhalogenated C₁ to C₂₀ heteroalkyl, halogenated or perhalogenated C₆ to C₂₀ aryl, halogenated or perhalogenated heteroaryl with 5 to 20 ring-forming atoms, or at least one R⁶ and R⁷ are bridged and form a 5 to 20 member ring, or the two R⁶ and/or the two R⁷ are bridged and form a 5 to 40 member ring or form a 5 to 40 member ring comprising an unsubstituted or C₁ to C₁₂ substituted phenanthroline.

According to an embodiment, in formula (IV) A¹, A², A³ and A⁴ are independently selected from C=O, C-O, or SO₂.

According to an embodiment, wherein in formula (IV) Z can form a double bond to A¹, A², A³ and A⁴, if A¹, A², A³ and A⁴ is selected from C-O or C-NR³ and Z is selected from N, O or CR¹, or A¹, A², A³ and A⁴ is selected from C-O or C-NR³ and Z is selected from C_{;}
and wherein optionally two of A¹, A², A³ and A⁴ together can form a substituted or unsubstituted heterocycle or substituted or unsubstituted carbocycle with Z, or wherein optionally one of A¹, A², A³ and A ⁴ can form a substituted or unsubstituted heterocycle or substituted or unsubstituted carbocycle with Z,
wherein the one or more substituent on the heterocycle or carbocycle is independently selected from D, electron-withdrawing group, halogen, F, CN, NO₂, SF₅, partially perfluorinated C₁ to C₆ alkyl, perfluorinated C₁ to C₆ alkyl, CF₃, partially perfluorinated C₁ to C₆ alkoxy, perfluorinated C₁ to C₆ alkoxy, OCF₃, substituted or unsubstituted C₆ to C₁₂ aryl, substituted or unsubstituted C₃ to C₁₂ heteroaryl, substituted or unsubstituted C₃ to C₁₂ carbocyclyl, or substituted or unsubstituted C₃ to C₁₂ heterocyclyl;

According to an embodiment, in formula (IV) R¹ is selected from CN, substituted or unsubstituted C₁ to C₁₂ alkyl, perfluorinated C₁ to C₁₂ alkyl,or CF₃.

According to an embodiment, in formula (IV) R¹ is selected from CN, or substituted or unsubstituted C₁ to C₁₂ alkyl.

According to an embodiment, in formula (IV) R^{a}, R^{b}, R^{c} and R^{d} are independently selected from H, D, electron-withdrawing group, halogen, F, Cl, CN, substituted or unsubstituted C₁ to C₆ alkyl, partially perfluorinated C₁ to C₆ alkyl, perfluorinated C₁ to C₆ alkyl, CF₃, substituted or unsubstituted C₆ to C₁₂ aryl, substituted or unsubstituted C₃ to C₁₂ heteroaryl, substituted or unsubstituted C3 to C₁₂ heterocyclyl, O, S, N, NR⁵, substituted or unsubstituted amine group having 0 to 20 carbon atoms;
wherein the one more substituents on R^{a}, R^{b}, R^{c} and R^{d} are independently selected from electron-withdrawing group, halogen, F, CN, NO₂, SF₅, partially perfluorinated C₁ to C₆ alkyl, perfluorinated C₁ to C₆ alkyl, perfluorinated C₁ to C₆ alkoxy, OCF₃;
   wherein R⁵ is selected from substituted or unsubstituted C₆ to C₁₂ aryl, substituted or unsubstituted C₃ to C₁₂ heteroaryl, substituted or unsubstituted C₁ to C₆ alkyl, partially perfluorinated C₁ to C₆ alkyl, perfluorinated C₁ to C₆ alkyl,
wherein the one or more substituents on R⁵ is selected from electron-withdrawing group, halogen, F, CN, NO₂, SF₅,CF₃, CF₂CF₃, partially fluorinated C₁ to C₆ alkoxy, perfluorinated C₁ to C₆ alkoxy, OCF₃, OCF₂CCF₃;
preferably at least one of R^{a}, R^{b}, R^{c} and R^{d} is independently selected from substituted or unsubstituted C₆ to C₁₂ aryl, substituted or unsubstituted C₃ to C₁₂ heteroaryl, substituted or unsubstituted C₁ to C₆ alkyl, substituted or unsubstituted C₃ to C₁₂ heterocyclyl,
wherein the substituents on R^{a}, R^{b}, R^{c} and R^{d} are independently selected from electron-withdrawing group, halogen, F, CN, NO₂, SF₅, perfluorinated C₁ to C₆ alkyl, CF₃, perfluorinated C₁ to C₆ alkoxy, OCF₃,;
wherein
optionally one of R^{a}, R^{b}, R^{c}, R^{d} can independently from each other form a substituted or unsubstituted heterocycle or substituted or unsubstituted carbocycle with R¹,
wherein the one or more substituent on the heterocycle or carbocycle is independently selected from D, electron-withdrawing group, halogen, F, CN, NO₂, SF₅, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₁₂ aryl, substituted or unsubstituted C₃ to C₁₂ heteroaryl, substituted or unsubstituted C₃ to C₁₂ carbocyclyl, or substituted or unsubstituted C3 to C₁₂ heterocyclyl;
wherein the one or more substituent on the substituent on the heterocyle or carbocycle is independently selected form D, electron-withdrawing group, halogen, F, perfluorinated C₁ to C₆ alkyl, CF₃, perfluorinated C₁ to C₆ alkoxy, OCF₃.

According to an embodiment, in formula (IV) R², R³ and R⁴ are independently selected from substituted or unsubstituted alkyl, partially perfluorinated C₁ to C₁₂ alkyl, perfluorinated C₁ to C₁₂ alkyl, CF₃, substituted or unsubstituted C₁ to C₆ alkoxy, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₃₀ heteroaryl, substituted or unsubstituted C₃ to C₃₀ carbocyclyl, substituted or unsubstituted C₂ to C₃₀ heterocyclyl,
wherein the substituents on R², R³ and R⁴ are independently selected from D, F, CN, NO₂, SF₅.

According to an embodiment, in formula (IV) A¹, A², A³ and A⁴ are independently selected from C=O, C-O, or SO₂;
wherein Z can form a double bond to A¹, A², A³ and A⁴, if A¹, A², A³ and A⁴ is selected from C-O or C-NR³ and Z is selected from N, O or CR¹, or A¹, A², A³ and A⁴ is selected from CO or C-NR³ and Z is selected from C_{;}
and wherein optionally two of A¹, A², A³ and A⁴ together can form a substituted or unsubstituted heterocycle or substituted or unsubstituted carbocycle with Z, or wherein optionally one of A¹, A², A³ and A ⁴ can form a substituted or unsubstituted heterocycle or substituted or unsubstituted carbocycle with Z,
wherein the one or more substituent on the heterocycle or carbocycle is independently selected from D, electron-withdrawing group, halogen, F, CN, NO₂, SF₅, partially perfluorinated C₁ to C₆ alkyl, perfluorinated C₁ to C₆ alkyl, CF₃, partially perfluorinated C₁ to C₆ alkoxy, perfluorinated C₁ to C₆ alkoxy, OCF₃, substituted or unsubstituted C₆ to C₁₂ aryl, substituted or unsubstituted C₃ to C₁₂ heteroaryl, substituted or unsubstituted C₃ to C₁₂ carbocyclyl, or substituted or unsubstituted C₃ to C₁₂ heterocyclyl;
   R¹ is selected from CN, substituted or unsubstituted C₁ to C₁₂ alkyl, perfluorinated C₁ to C₁₂ alkyl,or CF₃;
      R², R³ and R⁴ are independently selected from substituted or unsubstituted alkyl, partially perfluorinated C₁ to C₁₂ alkyl, perfluorinated C₁ to C₁₂ alkyl, CF₃, substituted or unsubstituted C₁ to C₆ alkoxy, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₃₀ heteroaryl, substituted or unsubstituted C₃ to C₃₀ carbocyclyl, substituted or unsubstituted C₂ to C₃₀ heterocyclyl,
      wherein the substituents on R², R³ and R⁴ are independently selected from D, F, CN, NO₂, SF₅;
   R^{a}, R^{b}, R^{c} and R^{d} are independently selected from H, D, electron-withdrawing group, halogen, F, Cl, CN, substituted or unsubstituted C₁ to C₆ alkyl, partially perfluorinated C₁ to C₆ alkyl, perfluorinated C₁ to C₆ alkyl, CF₃, substituted or unsubstituted C₆ to C₁₂ aryl, substituted or unsubstituted C₃ to C₁₂ heteroaryl, substituted or unsubstituted C3 to C₁₂ heterocyclyl, O, S, N, NR⁵, substituted or unsubstituted amine group having 0 to 20 carbon atoms;
   wherein the one more substituents on R^{a}, R^{b}, R^{c} and R^{d} are independently selected from electron-withdrawing group, halogen, F, CN, NO₂, SF₅, partially perfluorinated C₁ to C₆ alkyl, perfluorinated C₁ to C₆ alkyl, perfluorinated C₁ to C₆ alkoxy, OCF₃;
      wherein R⁵ is selected from substituted or unsubstituted C₆ to C₁₂ aryl, substituted or unsubstituted C₃ to C₁₂ heteroaryl, substituted or unsubstituted C₁ to C₆ alkyl, partially perfluorinated C₁ to C₆ alkyl, perfluorinated C₁ to C₆ alkyl,
   wherein the one or more substituents on R⁵ is selected from electron-withdrawing group, halogen, F, CN, NO₂, SF₅,CF₃, CF₂CF₃, partially fluorinated C₁ to C₆ alkoxy, perfluorinated C₁ to C₆ alkoxy, OCF₃, OCF₂CCF₃;
   preferably at least one of R^{a}, R^{b}, R^{c} and R^{d} is independently selected from substituted or unsubstituted C₆ to C₁₂ aryl, substituted or unsubstituted C₃ to C₁₂ heteroaryl, substituted or unsubstituted C₁ to C₆ alkyl, substituted or unsubstituted C₃ to C₁₂ heterocyclyl,
   wherein the substituents on R^{a}, R^{b}, R^{c} and R^{d} are independently selected from electron-withdrawing group, halogen, F, CN, NO₂, SF₅, perfluorinated C₁ to C₆ alkyl, CF₃, perfluorinated C₁ to C₆ alkoxy, OCF₃,;
   wherein
   optionally one of R^{a}, R^{b}, R^{c}, R^{d} can independently from each other form a substituted or unsubstituted heterocycle or substituted or unsubstituted carbocycle with R¹,
   wherein the one or more substituent on the heterocycle or carbocycle is independently selected from D, electron-withdrawing group, halogen, F, CN, NO₂, SF₅, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₁₂ aryl, substituted or unsubstituted C₃ to C₁₂ heteroaryl, substituted or unsubstituted C₃ to C₁₂ carbocyclyl, or substituted or unsubstituted C3 to C12 heterocyclyl;
   wherein the one or more substituent on the substituent on the heterocyle or carbocycle is independently selected form D, electron-withdrawing group, halogen, F, perfluorinated C₁ to C₆ alkyl, CF₃, perfluorinated C₁ to C₆ alkoxy, OCF₃.

According to an embodiment, in formula (IV) if Z is selected from N and p and q are selected from 0, t and u are selected from 0, m and n are selected from 1, and r and s are selected from 1 then if one of A¹ and A² is selected from SO₂ then the other one of A¹ and A² cannot be C=O or C-O.

According to an embodiment, in formula (IV) if Z is selected from N and p and q are selected from 0, and t and u are selected from 0 then if one of A¹ and A² is selected from SO₂ then the other one of A¹ and A² cannot be C=O or C-O.

According to an embodiment, the monoanion or the monoanionic ligand L⁻ is selected from (V), (VI), (VII), (VIII) or (IX) 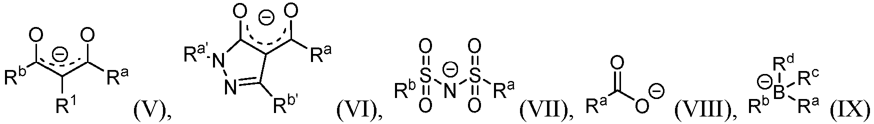
R^{a'} are independently selected from substituted or unsubstituted C₁ to C₁₂ alkyl,
substituted or unsubstituted C₆ to C₁₉ aryl, substituted or unsubstituted C₂ to C₂₀ heteroaryl, or substituted or unsubstituted 6-membered heteroaryl;
R^{b'} is selected from substituted or unsubstituted C₁ to C₁₂ alkyl, substituted or unsubstituted C₆ to C₁₉ aryl, substituted or unsubstituted C₂ to C₂₀ heteroaryl, substituted or unsubstituted 6-membered heteroaryl, or CN;
wherein
at least one of the substituents of the substituted C₁ to C₁₂ alkyl, substituted C₆ to C₁₉ aryl, substituted C₂ to C₂₀ heteroaryl, or substituted 6-membered heteroaryl are independently selected from halogen, Cl, F, CN, partially or perfluorinated C₁ to C₈ alkyl, partially or perfluorinated C₁ to C₈ alkoxy;
wherein in formula (VI)
at least one of R^{a'}, R^{b'} and R^{a} or the group of R^{a'}, R^{b'} and R^{a} comprises at least three atoms selected from the group consisting of halogen, Cl, F or N;
   - the remaining Rs are as defined above.

According to an embodiment, L⁻ is represented by formula (X) 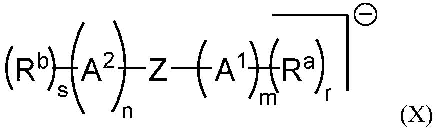
and wherein Z is selected from O, N, or CR¹,
wherein if Z is selected from O then n is selected from 0, and s is selected from 0.

According to an embodiment, L⁻ is represented by formula (XI) 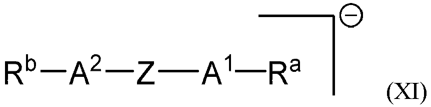 wherein Z is selected from N or CR¹.

According to an embodiment, in formula (IV) if Z is selected from N or CR¹ then p and q are selected from 0, and t and u are selected from 0, and
if Z is selected from N then A¹ and A² are selected from SO₂,
if Z is selected from CR¹ then A¹ and A² are selected from C=O or C-O.

According to an embodiment, in formula (X) if Z is selected from N, and
if Z is selected from N then A¹ and A² are selected from SO₂,
if Z is selected from CR¹ then A¹ and A² are selected from C=O or C-O.

According to an embodiment, in formula (X) if Z is selected from N, m and n are selected from 1, and r and s are selected from 1, then if one of A¹ and A² is selected from SO₂ then the other one of A¹ and A² cannot be C=O or CO.

According to an embodiment, in formula (X) if Z is selected from N, then if one of A¹ and A² is selected from SO₂ then the other one of A¹ and A² cannot be C=O or CO.

According to an embodiment, in formula (X) if Z is selected from N, then if one of A¹ and A² is selected from SO₂ then the other one of A¹ and A² cannot be C=O or CO.

According to an embodiment, the monoanion or the monoanionic ligand L⁻ is selected from (V), (VI) or (VII) 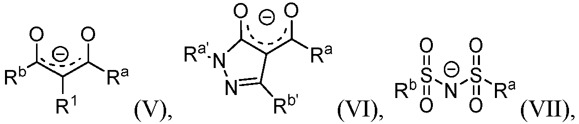
- Rs as defined above

According to an embodiment, the monoanion or the monoanionic ligand L⁻ is selected from (V), or (VI)

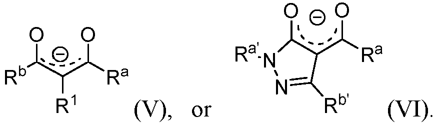

According to an embodiment, the monoanion or the monoanionic ligand L⁻ is selected from (V) 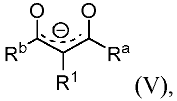 wherein two adjacent substituents R^{a}, R^{b}, and R¹ can optionally be connected to form heterocycle or carbocycle.

According to an embodiment, the monoanionic ligand L⁻ is selected from (V) 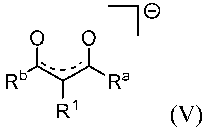
R^{a} and R^{b} are independently selected from perfluorinated C₁ to C₆ alkyl, CF₃, substituted or unsubstituted C₆ to C₄₀ aryl, 3,5-CF₃-phenyl, N, NR⁵, substituted or unsubstituted C₂ to C₄₀ heteroaryl, 2,6-CF₃-pyridinyl, substituted or unsubstituted amine group having 0 to 20 carbon atoms;
   wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N;
R¹ is selected from H, D, CN, substituted or unsubstituted C₁ to C₈ alkyl;
wherein the one ore more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N;
wherein two adjacent substituents R^{a}, R^{b}, and R¹ can optionally be connected to form heterocycle or carbocycle.

According to an embodiment, the monoanionic ligand L⁻ is selected from (V) 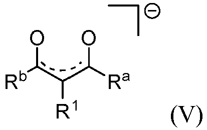
R^{a} and R^{b} are independently selected from perfluorinated C₁ to C₆ alkyl, CF₃, 3,5-CF₃-phenyl, N, NR⁵, 2,6-CF₃-pyridinyl, substituted or unsubstituted amine group having 0 to 20 carbon atoms;
   wherein the one or more substituents are independently selected from wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N;
R¹ is selected from H, D, CN, substituted or unsubstituted C₁ to C₈ alkyl;
wherein the one ore more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N;
wherein two adjacent substituents R^{a}, R^{b}, and R¹ can optionally be connected to form heterocycle or carbocycle.

According to an embodiment, at least one of R^{a}, R^{b}, R^{c} or R^{d} or R^{a}, R^{b}, R^{c} and R^{d} is/are independently selected from D1 to D105 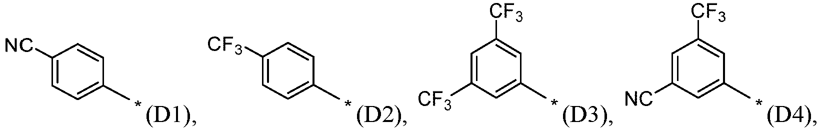 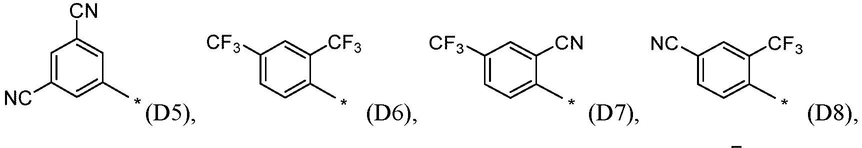 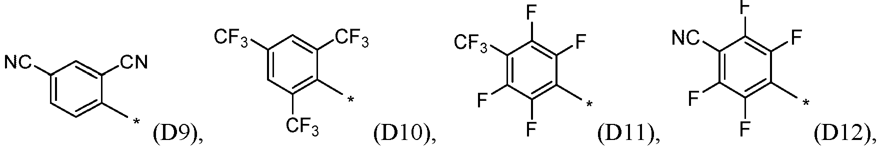 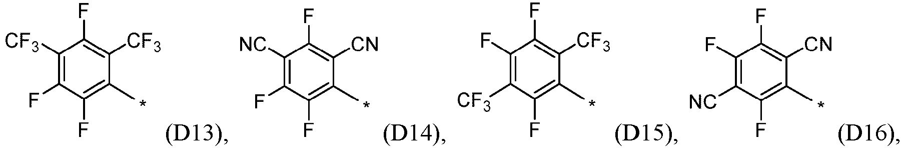 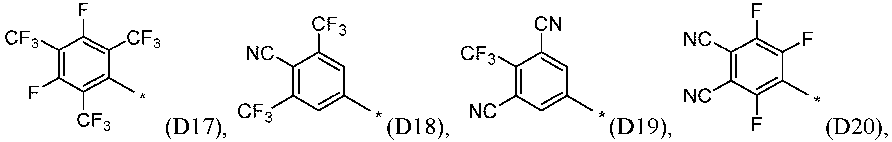 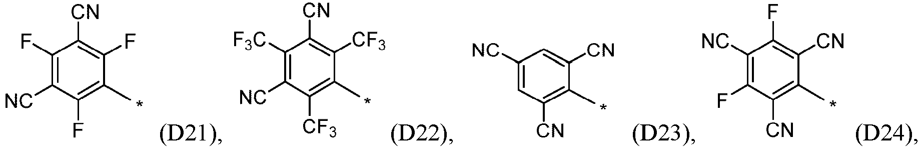 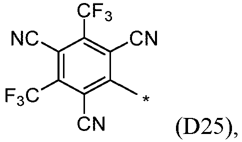 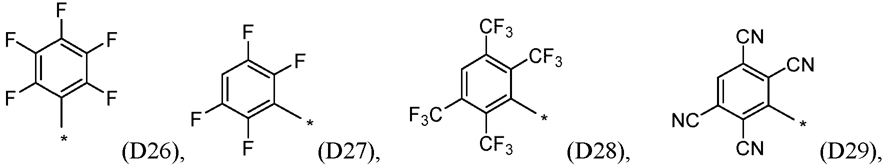 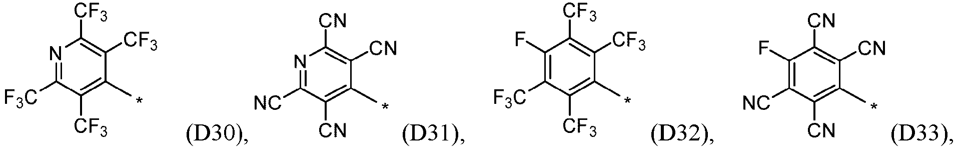 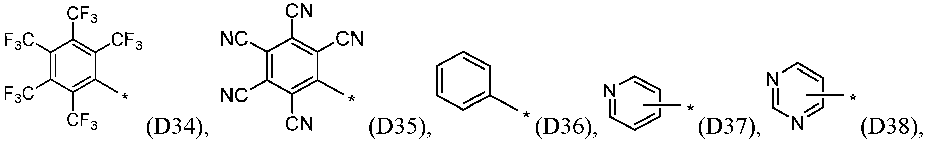 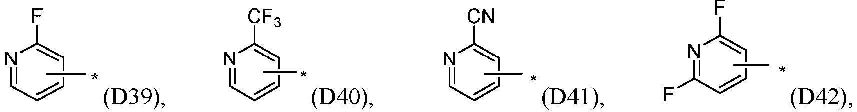 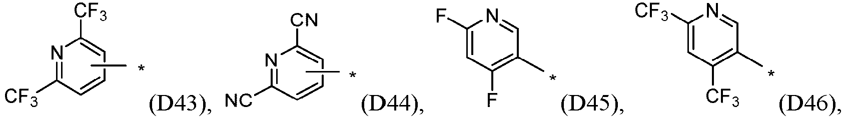 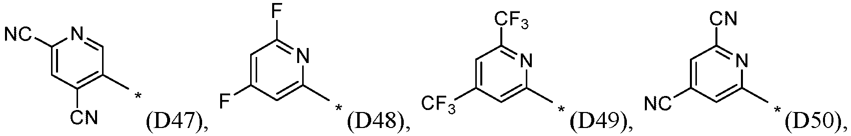 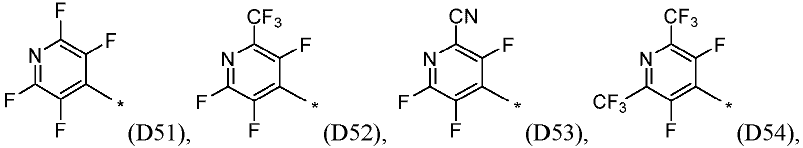 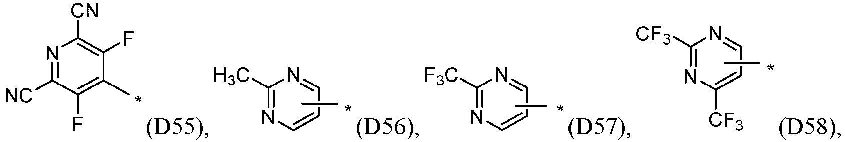 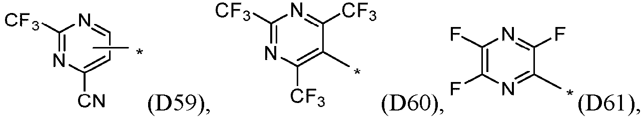 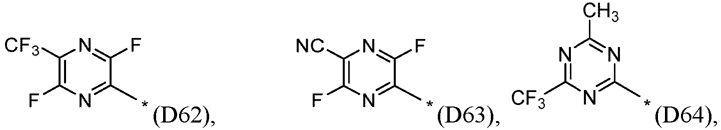 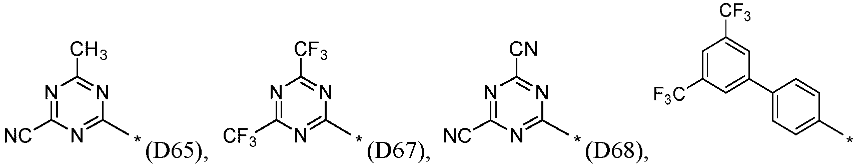 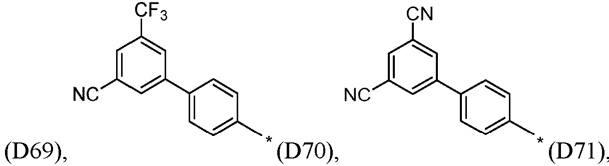 -CF₃ (D72), -C₂F₅ (D73), -C₃F₇ (D74), -CF₂CF₂CF₃ (D75), 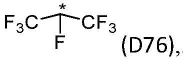 -C₄F₉ (D77), -CF₂CF₂CF₂CF₃ (D78) 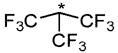 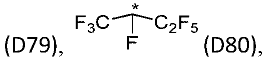 -C₅F₁₁ (D81), ), -C₆F₁₃ (D82), -CH3 (D83), -C₂H₅ (D84) -CH(CH₃)₂ (D85), -C(CH₃)₃ (D86), 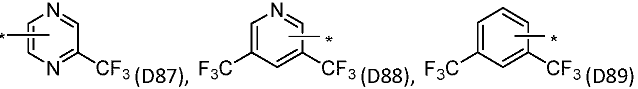 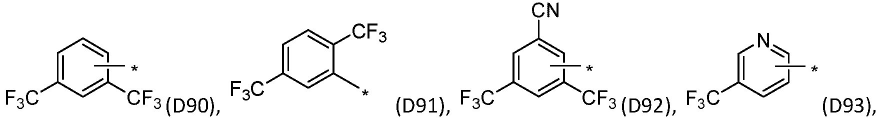 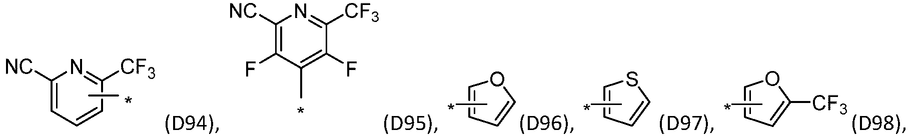 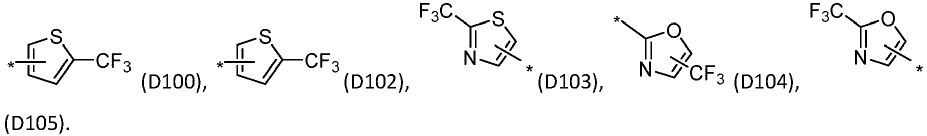 wherein the "*" or "-" denotes the binding position.

According to an embodiment, wherein at least one of R^{a}, R^{b}, R^{c} or R^{d} or R^{a}, R^{b}, R^{c} and R^{d} is/are independently selected from D1 to D105 or NR⁵, wherein R⁵ is independently selected from D1 to D105.

According to an embodiment, wherein the monoanion or the monoanionic ligand is selected from L1 to L405:

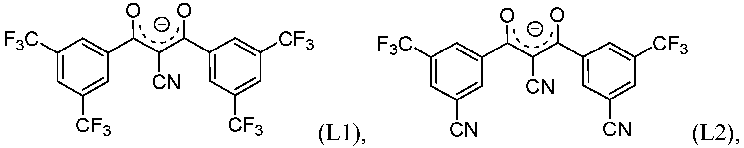

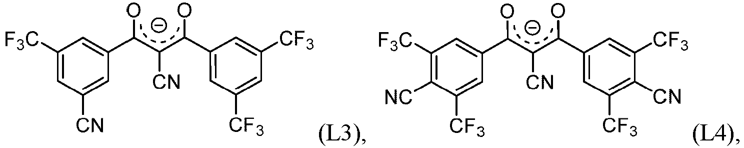

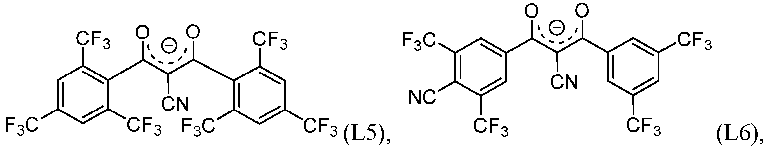

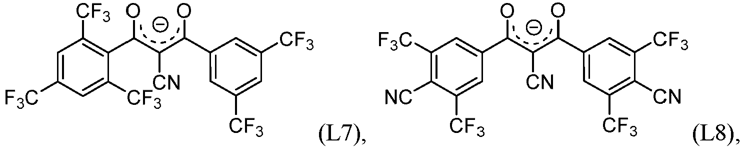

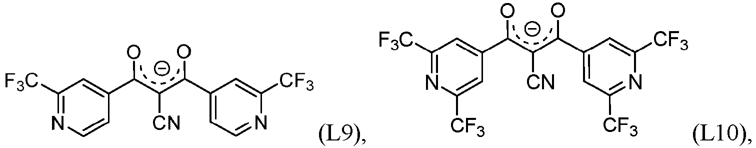

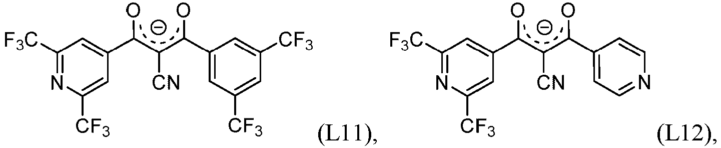

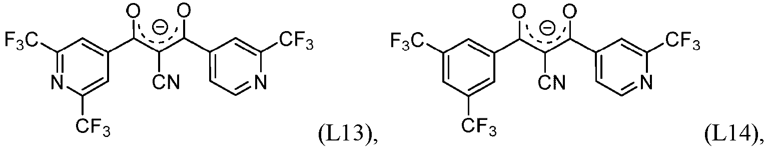

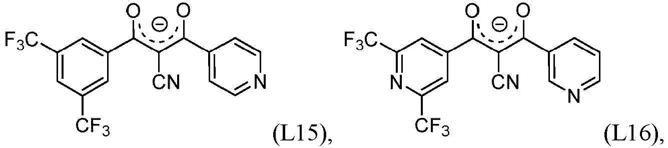

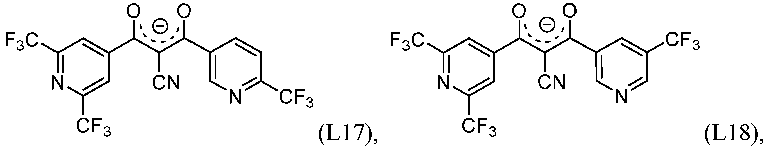

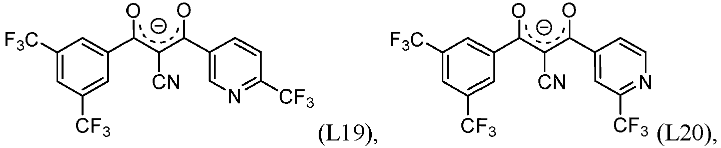

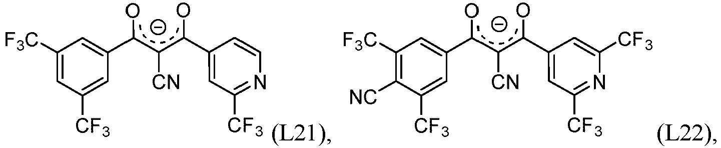

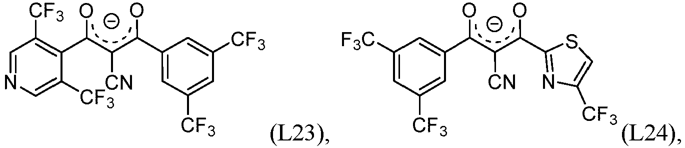

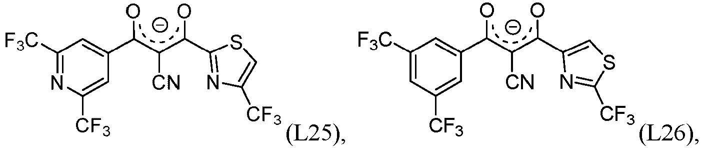

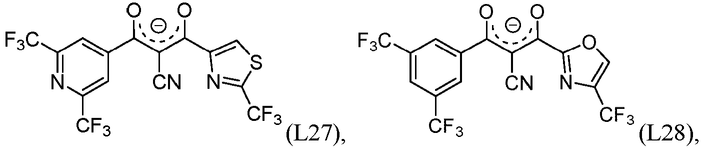

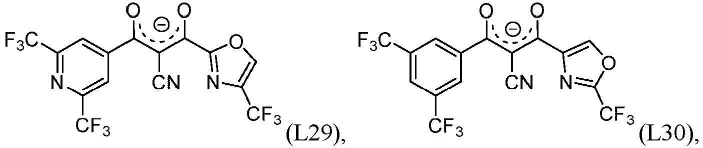

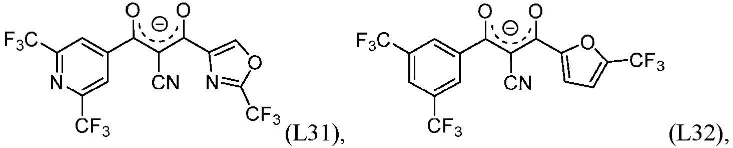

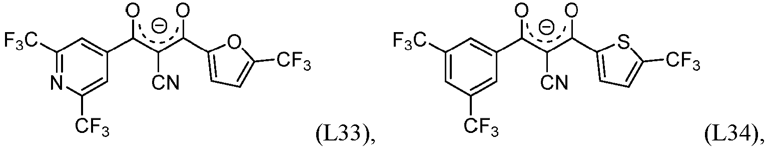

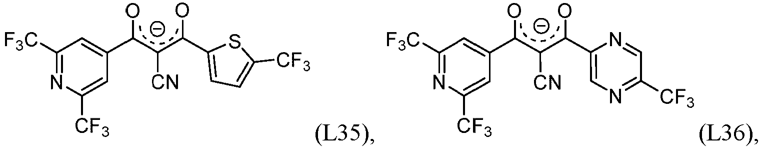

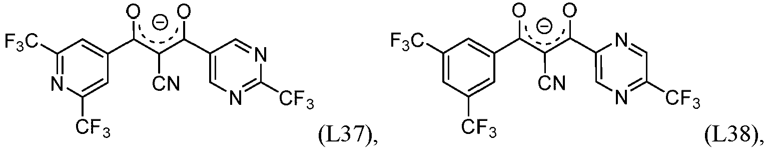

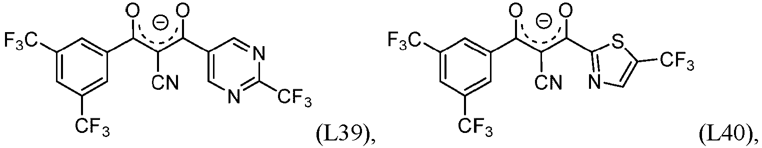

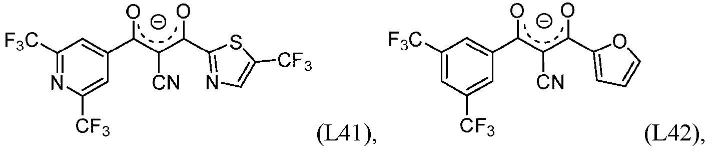

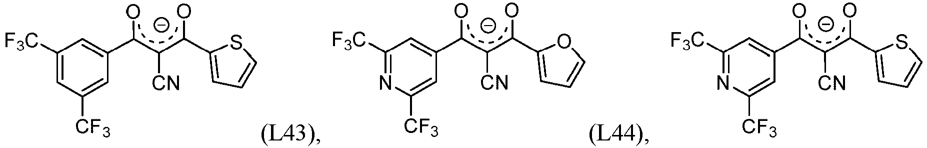

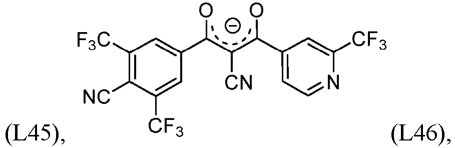

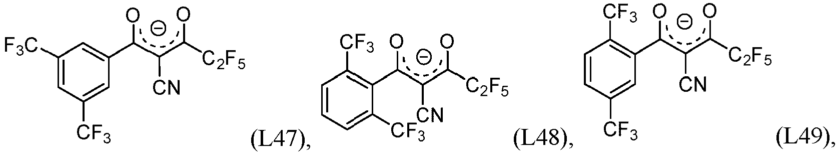

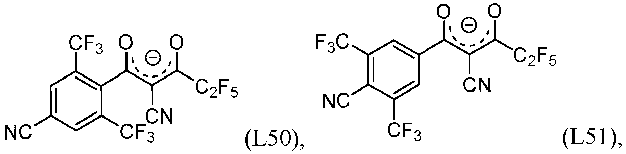

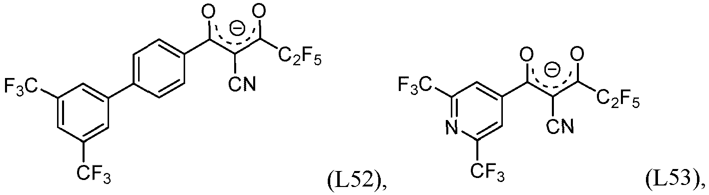

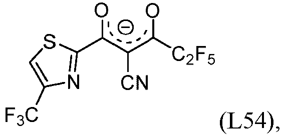

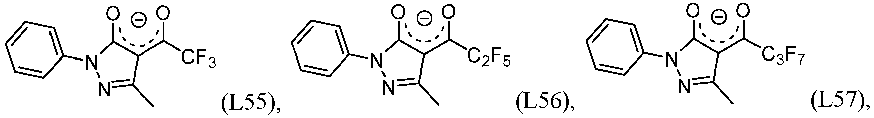

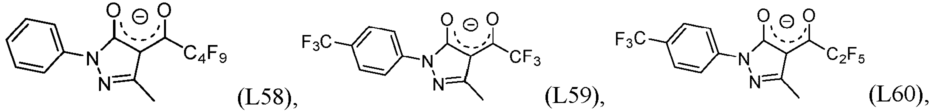

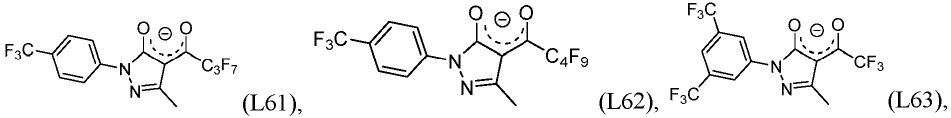

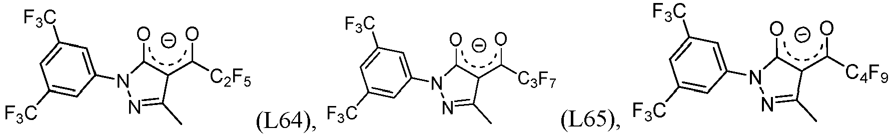

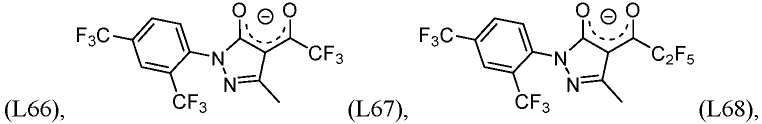

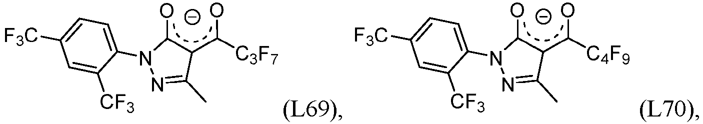

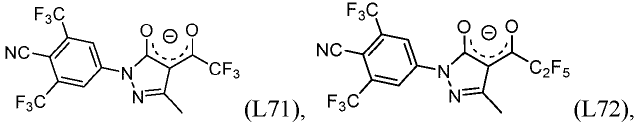

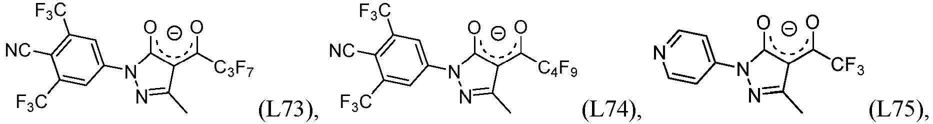

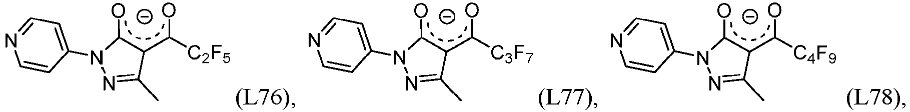

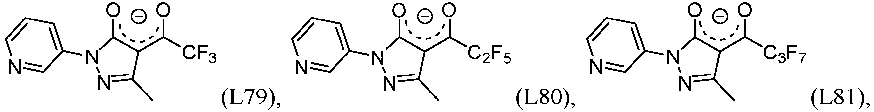

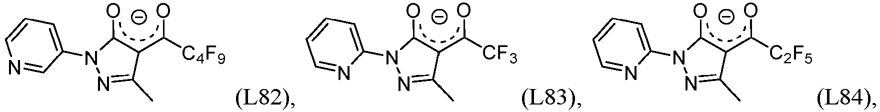

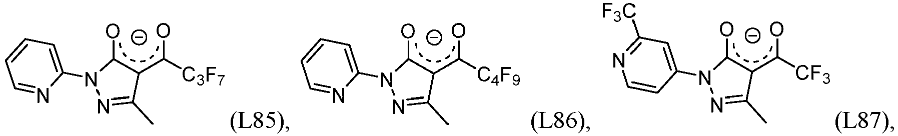

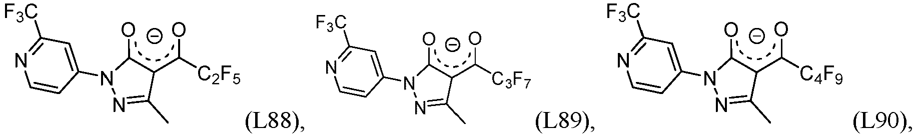

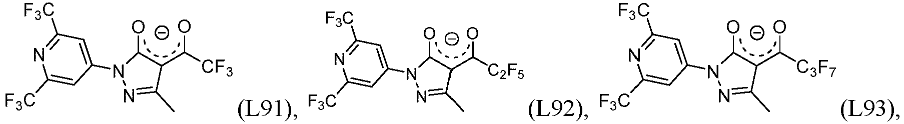

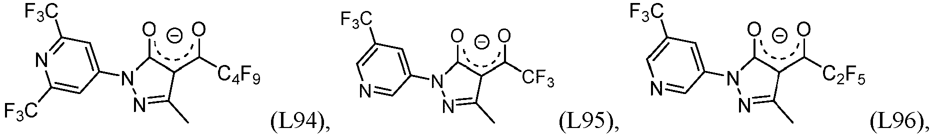

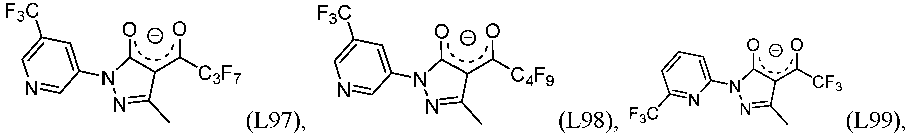

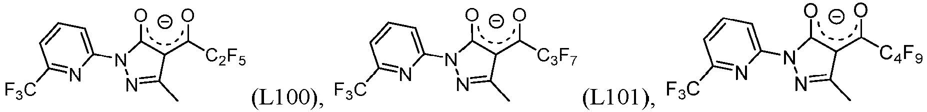

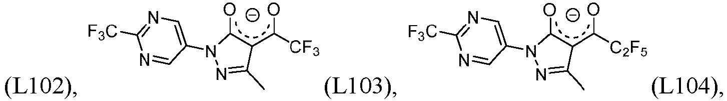

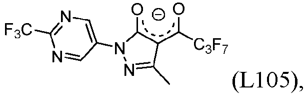

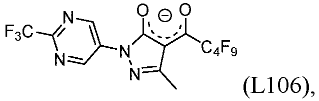

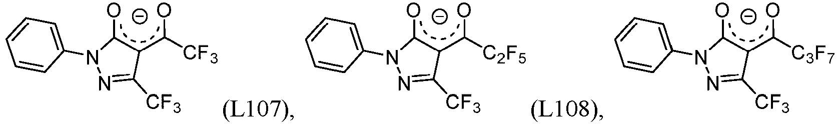

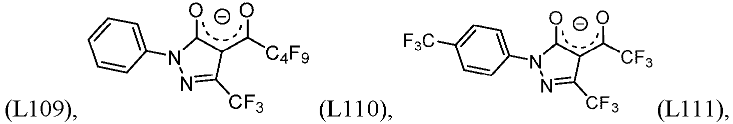

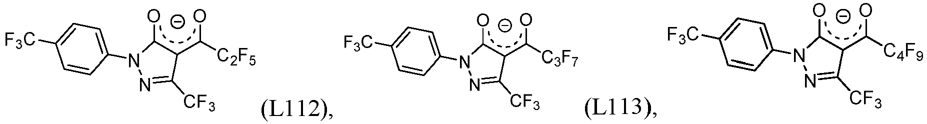

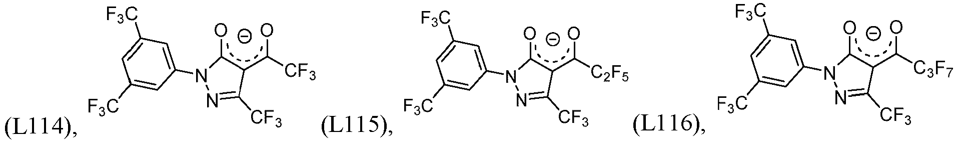

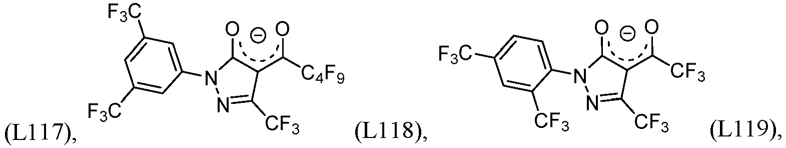

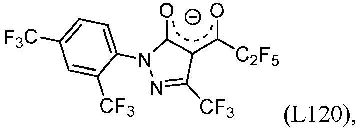

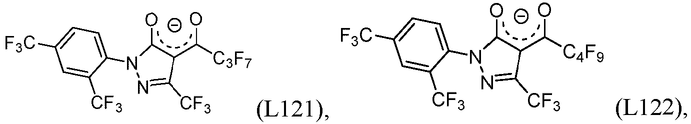

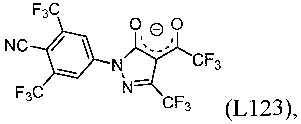

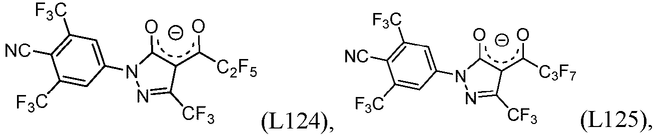

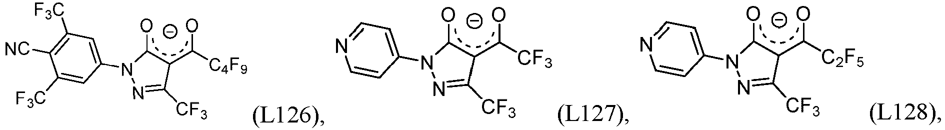

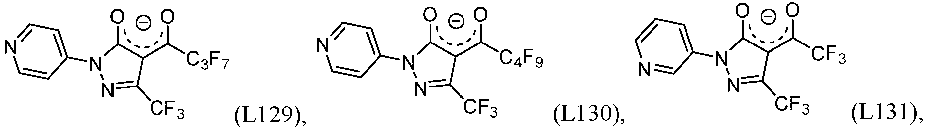

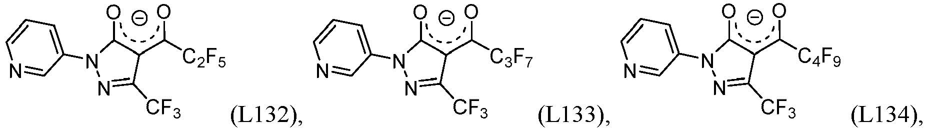

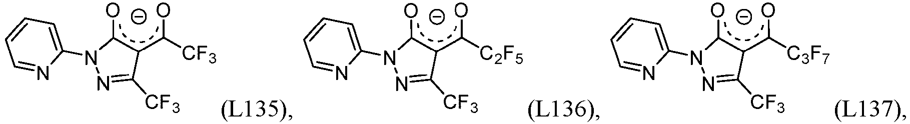

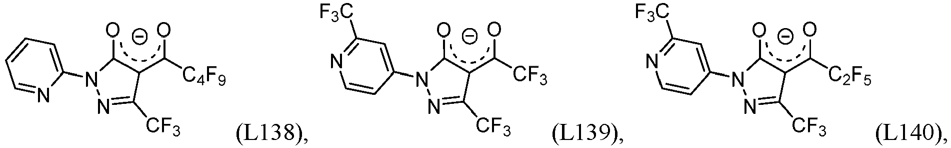

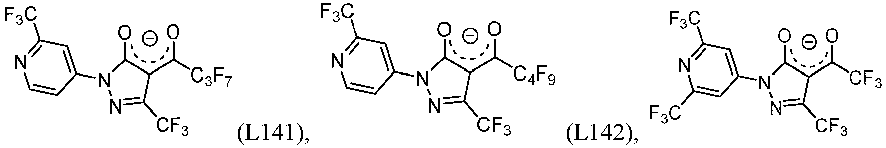

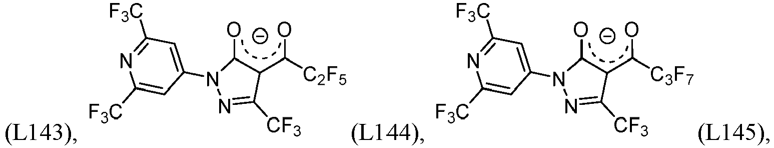

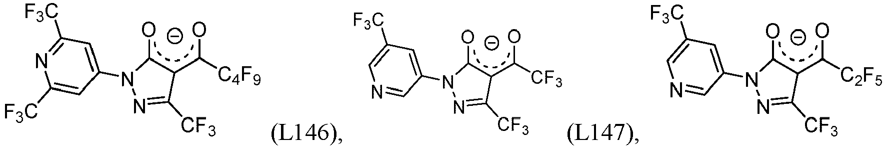

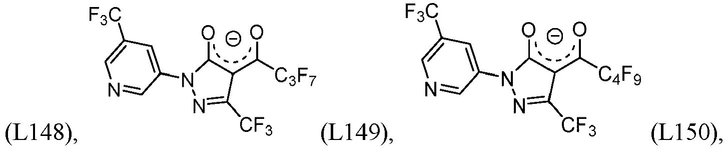

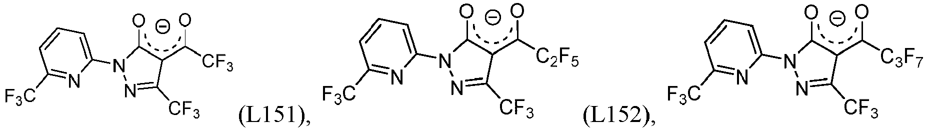

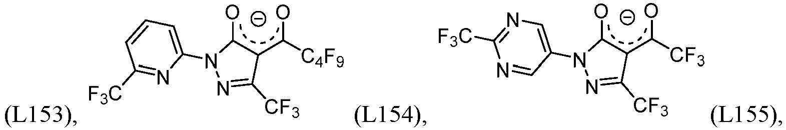

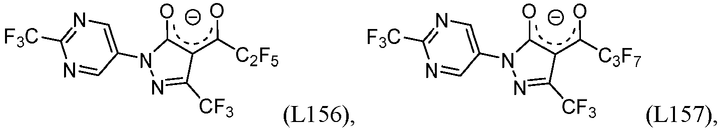

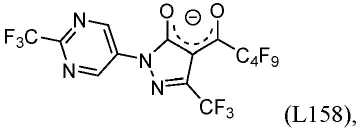

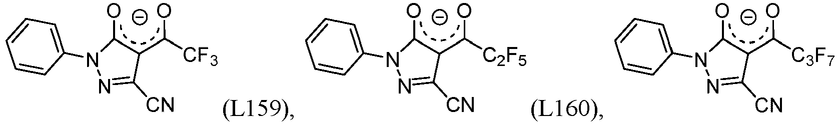

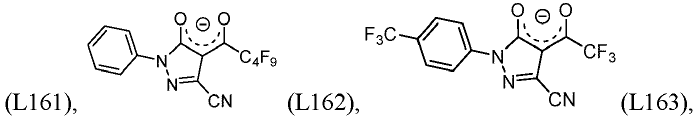

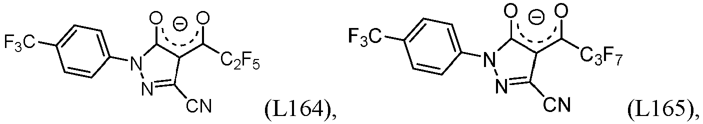

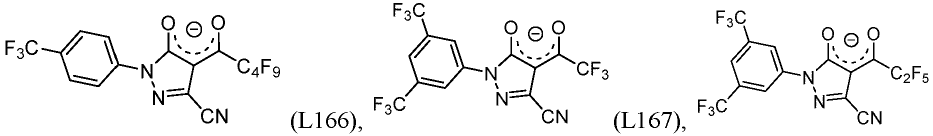

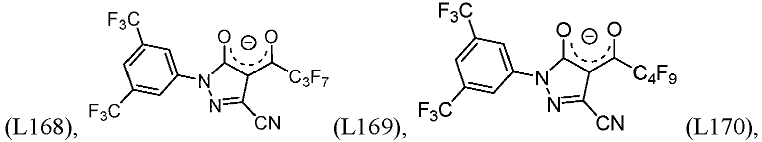

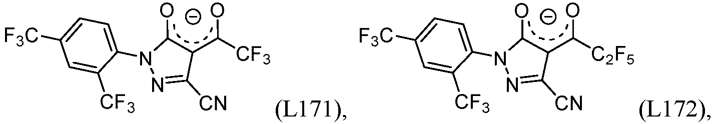

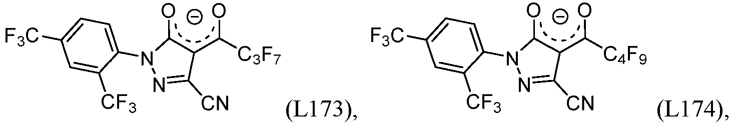

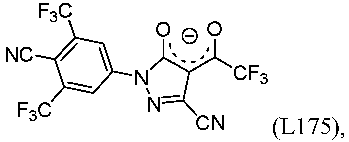

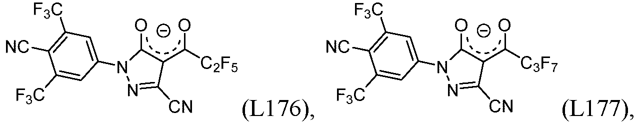

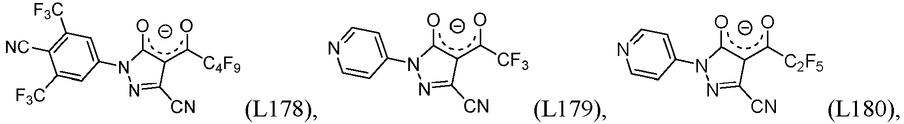

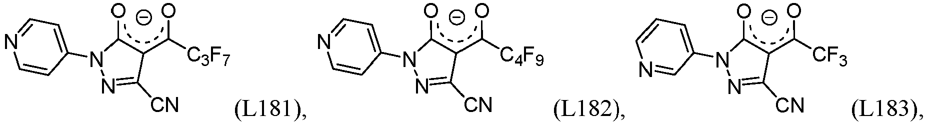

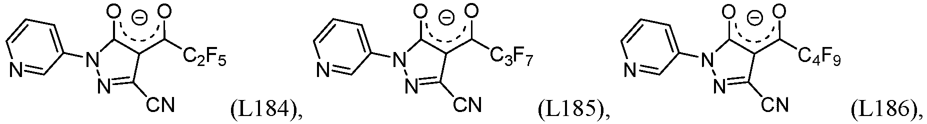

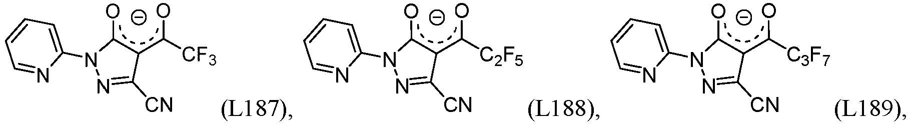

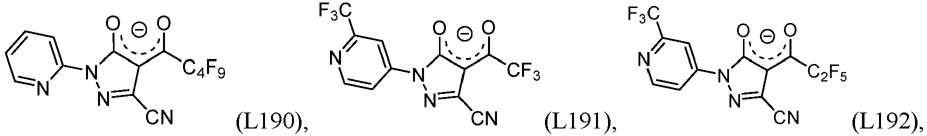

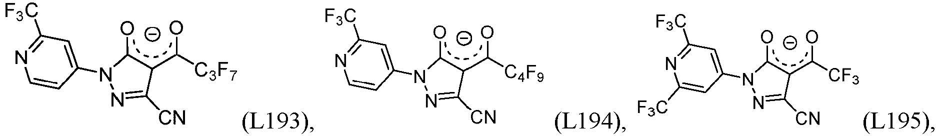

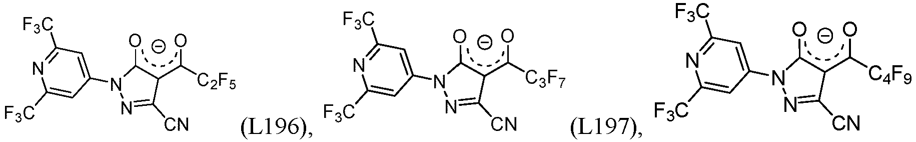

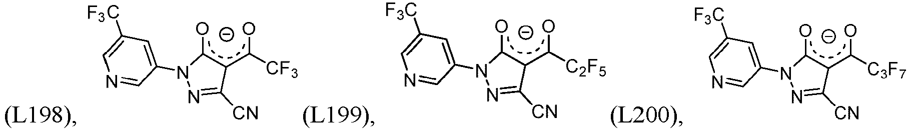

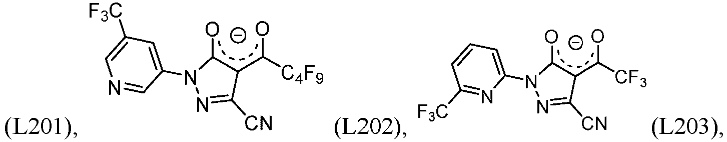

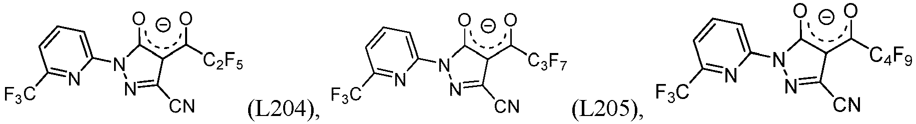

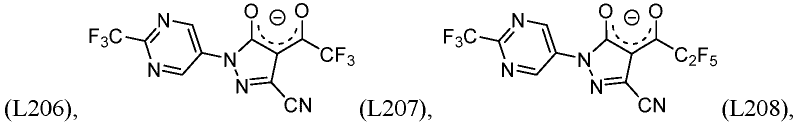

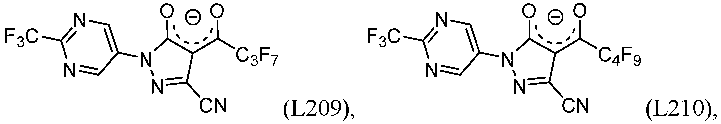

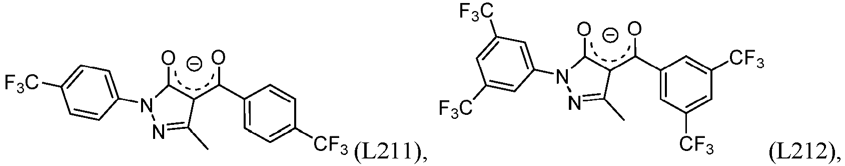

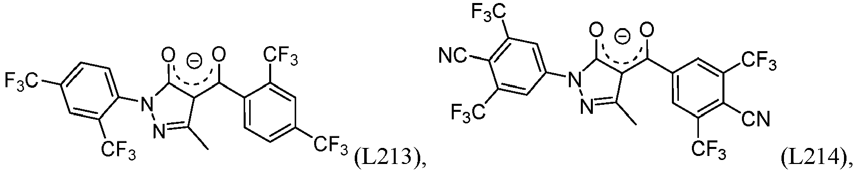

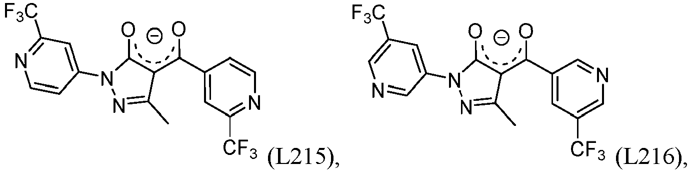

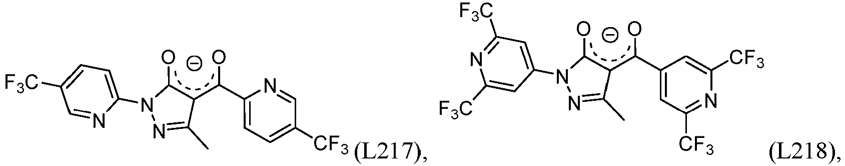

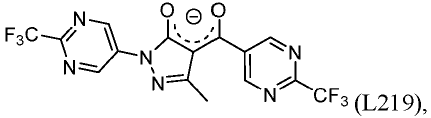

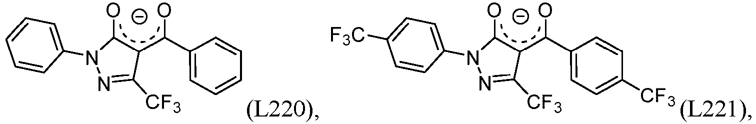

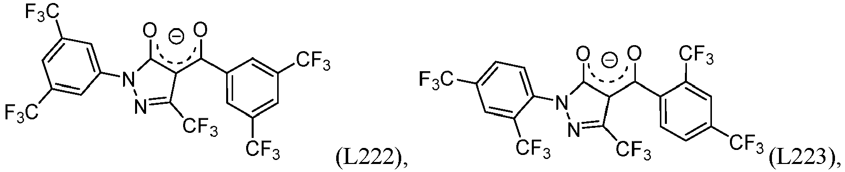

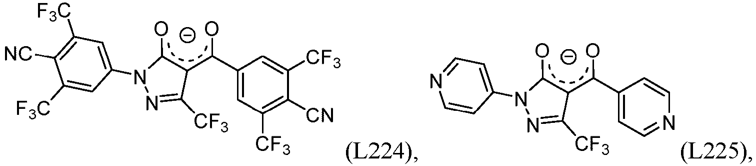

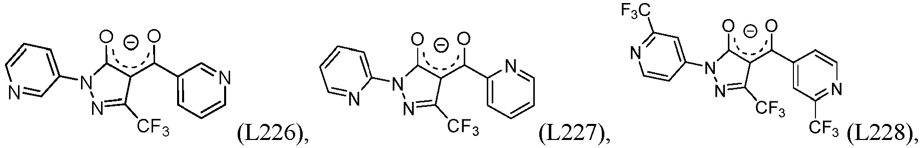

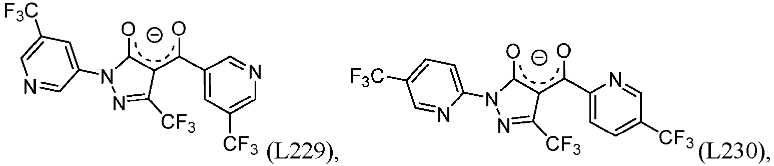

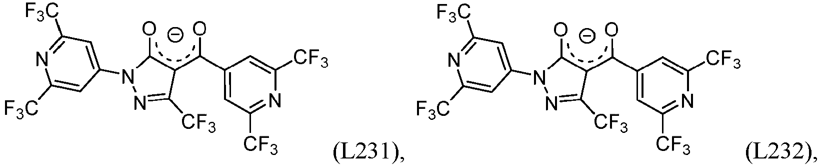

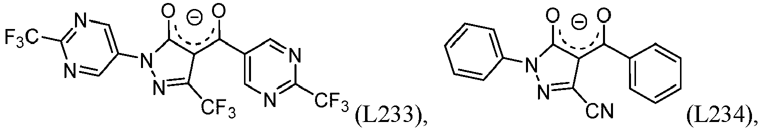

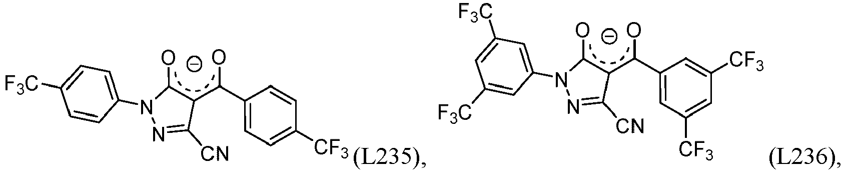

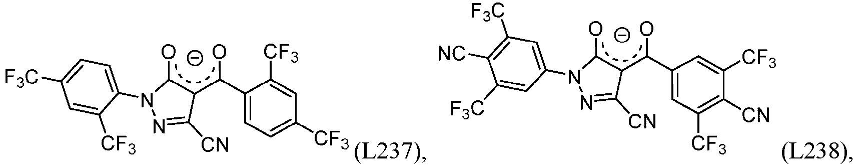

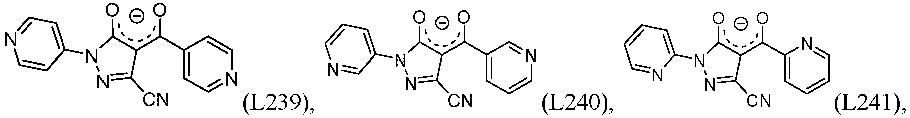

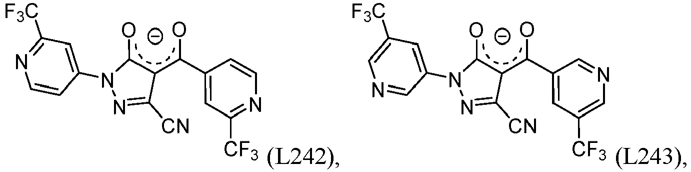

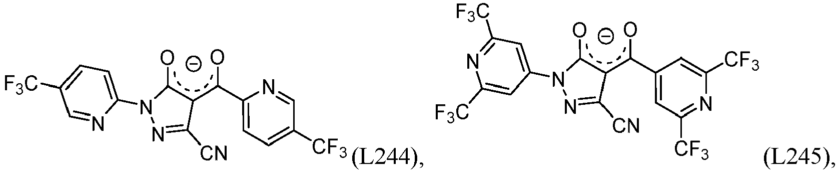

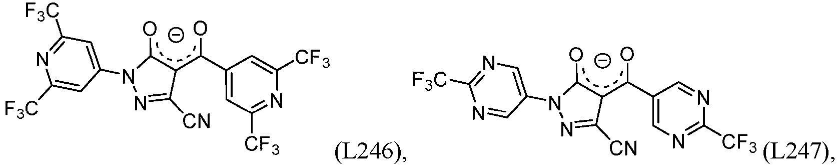

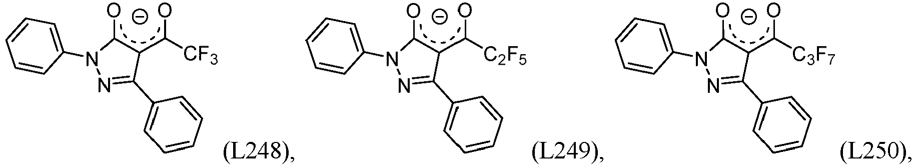

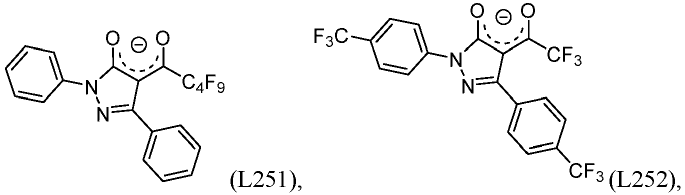

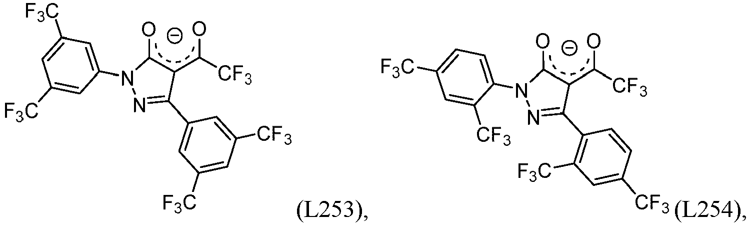

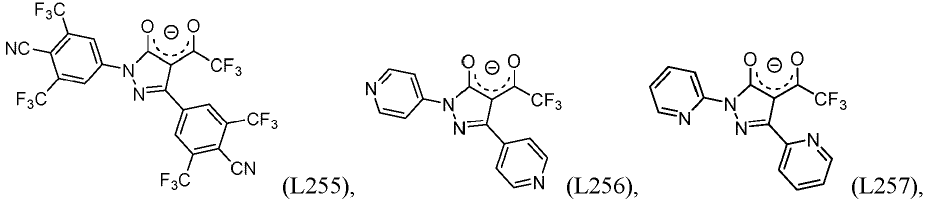

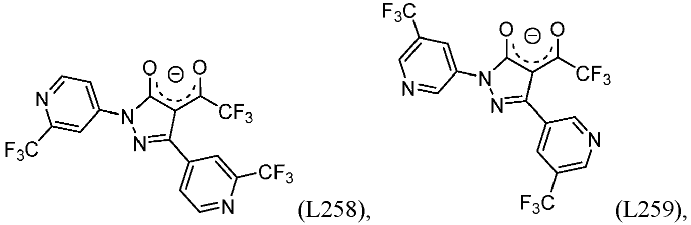

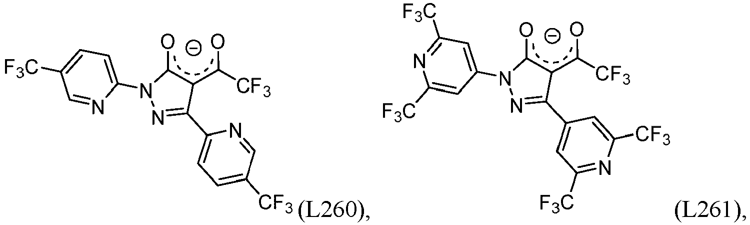

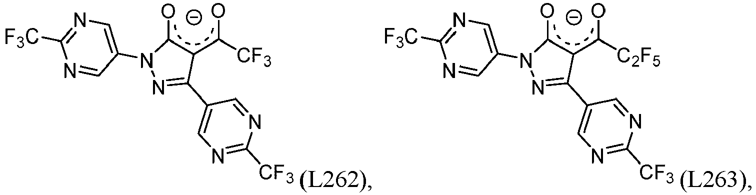

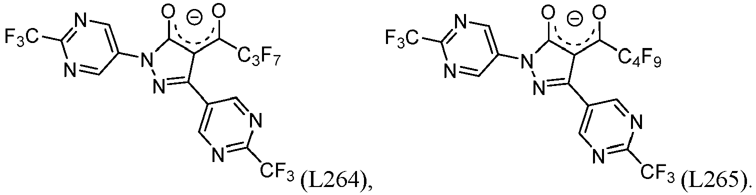

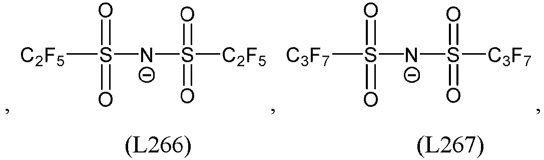

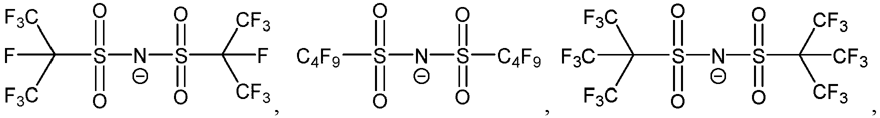

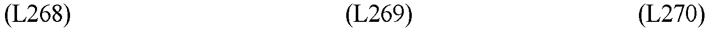

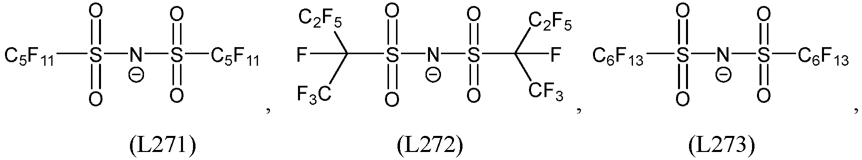

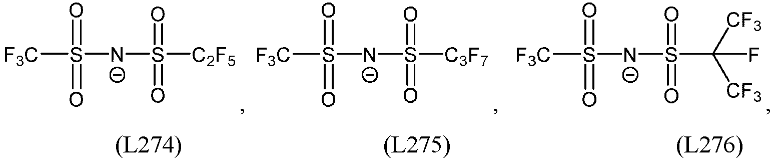

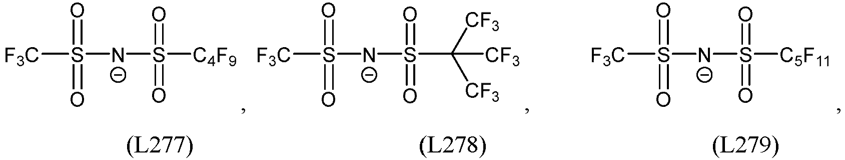

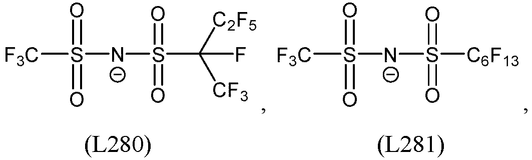

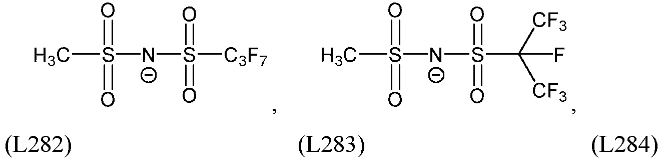

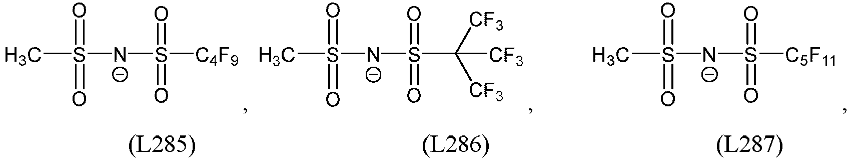

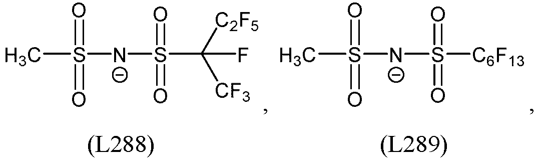

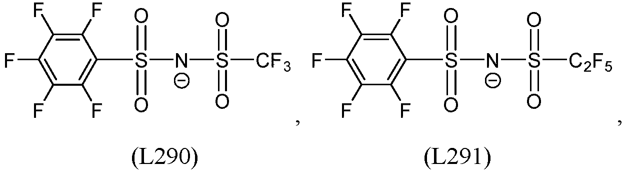

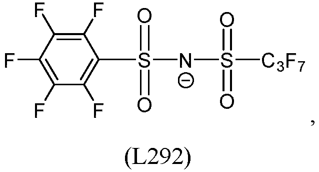

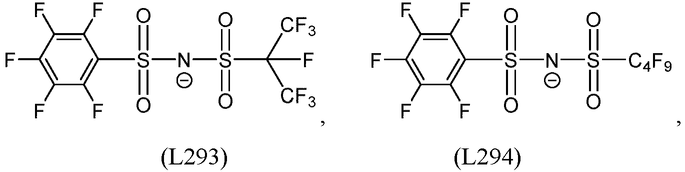

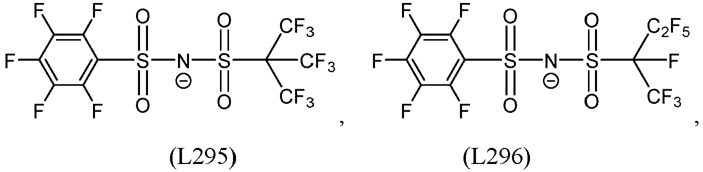

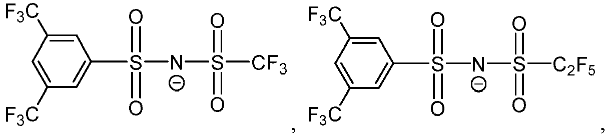

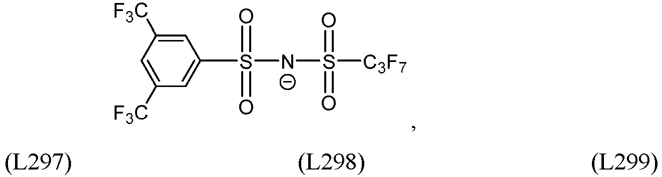

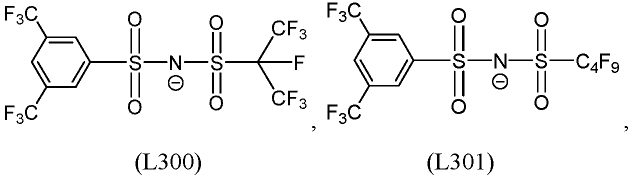

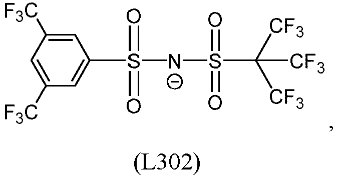

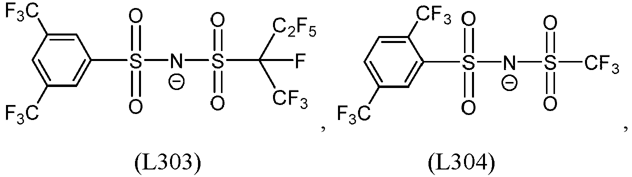

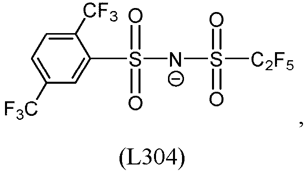

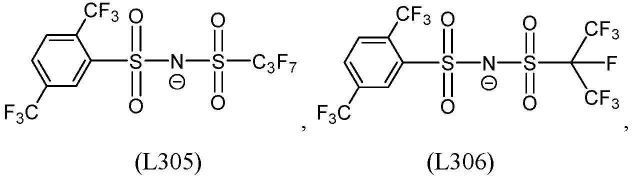

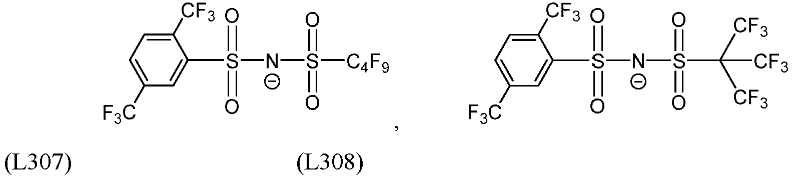

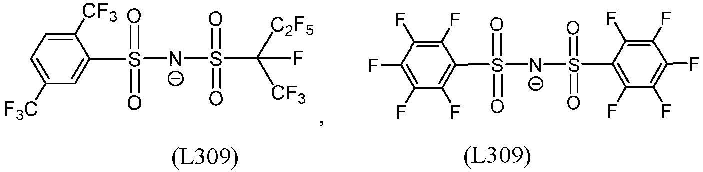

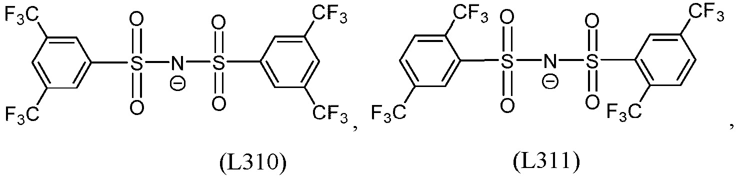

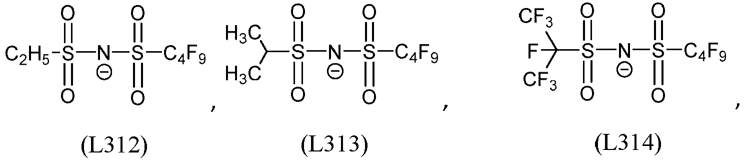

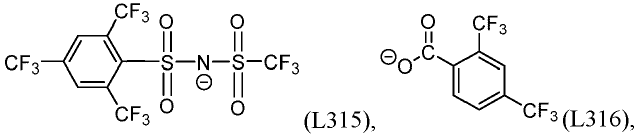

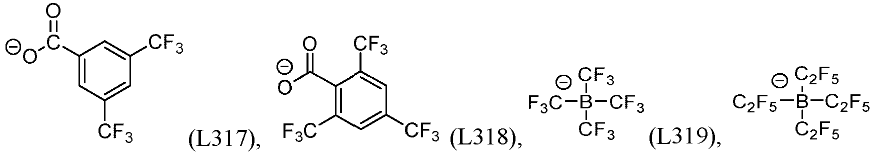

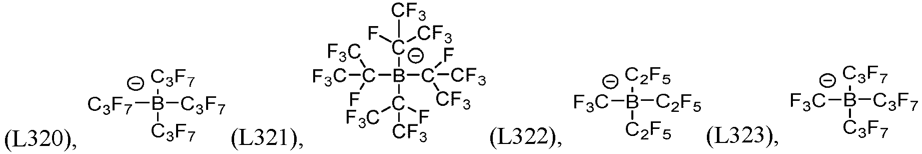

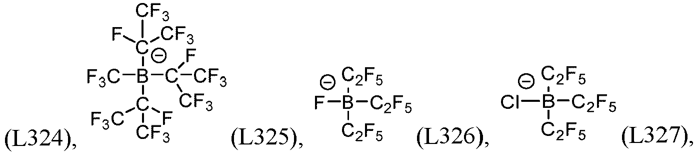

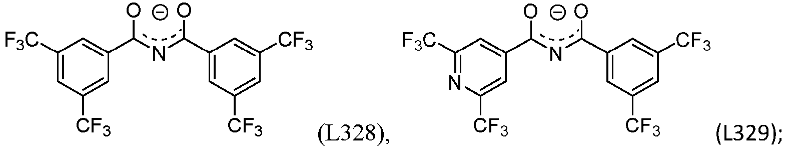

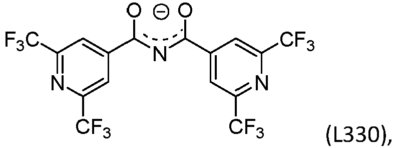

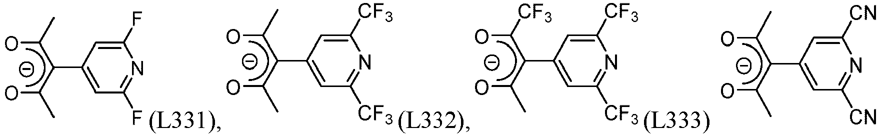

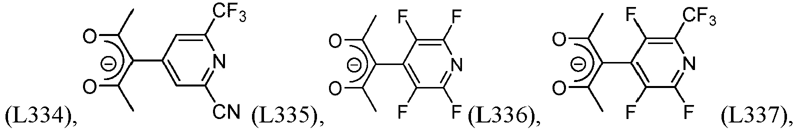

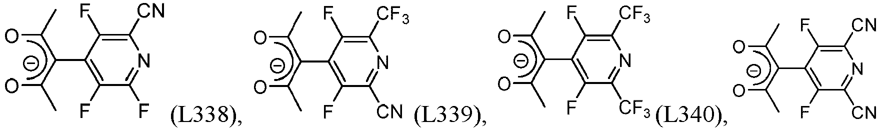

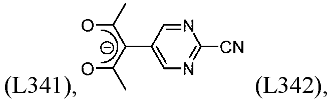

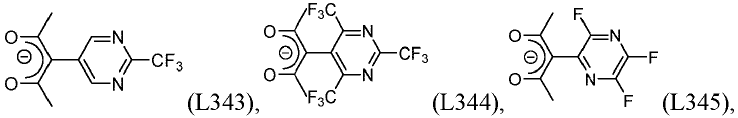

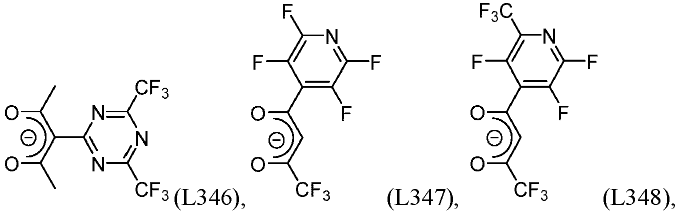

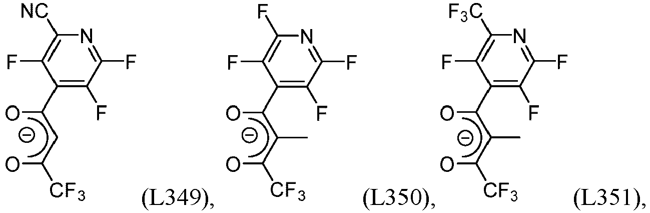

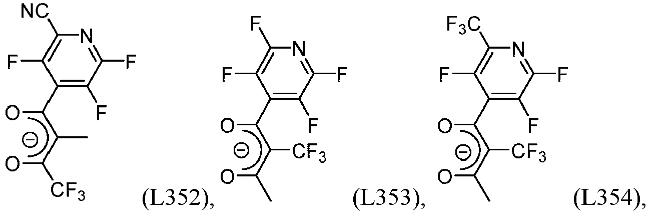

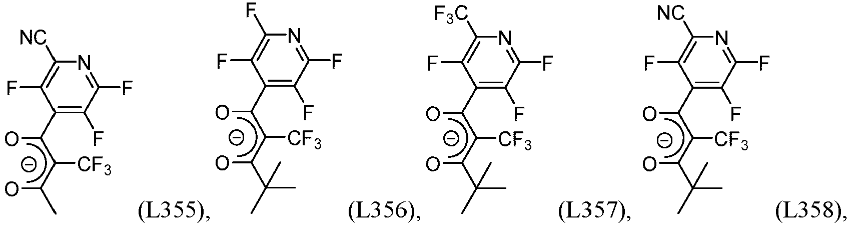

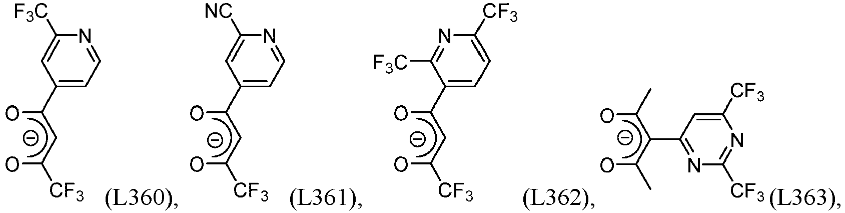

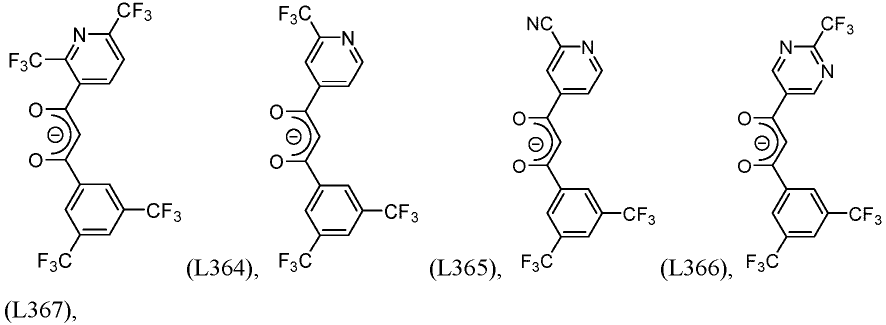

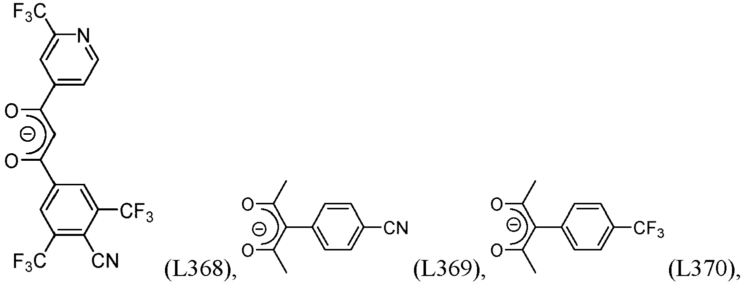

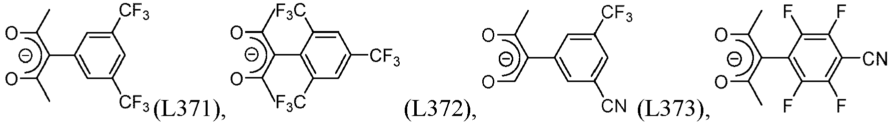

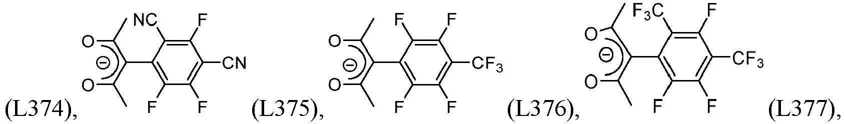

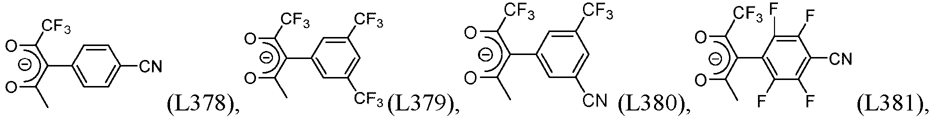

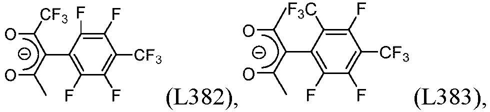

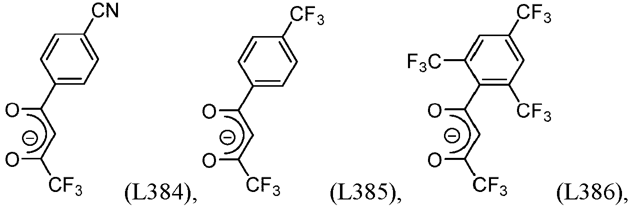

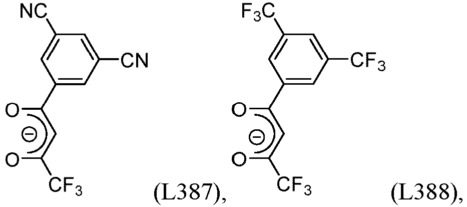

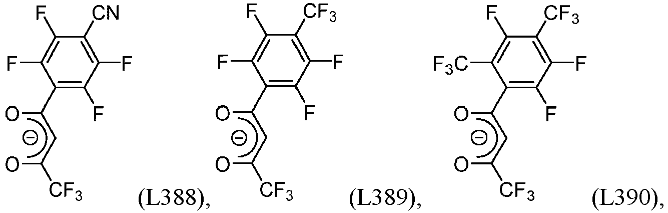

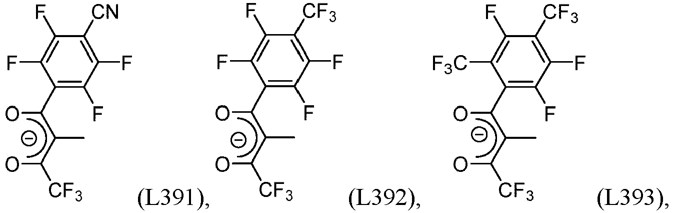

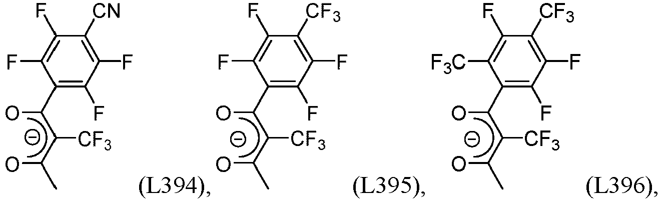

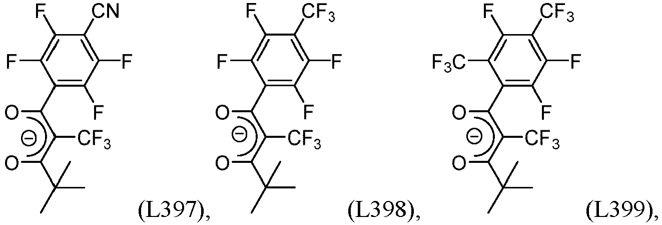

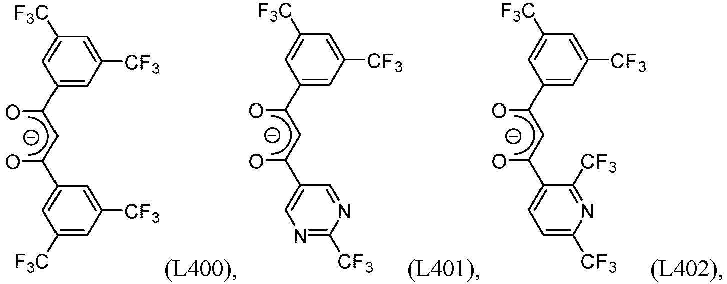

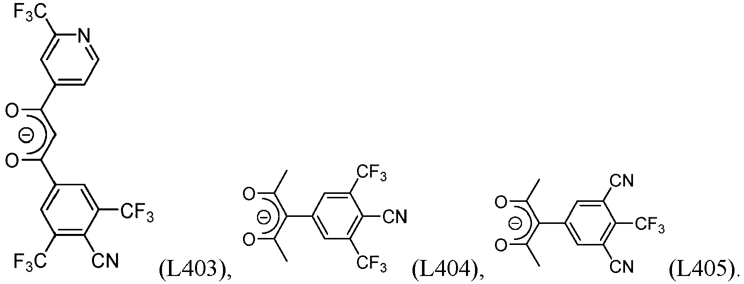

According to an embodiment, wherein the monoanion or the monoanionic ligand is selected from L1 to L315, L319 to L327, L331 to L405.

According to an embodiment, wherein the monoanion or the monoanionic ligand is selected from L1 to L315, and L331 to L405

According to an embodiment, wherein the monoanion or the monoanionic ligand is selected from L1 to L265, and L331 to L405.

According to an embodiment, wherein the monoanion or the monoanionic ligand is selected from L1 to L265.

According to an embodiment, wherein the monoanion or the monoanionic ligand is selected from L1 to L54.

According to an embodiment, wherein the monoanion or the monoanionic ligand is selected from L55 to L265.

According to an embodiment, compound of formula (II) is selected from the following compounds M1 to M17

| | |
|---|---|
| 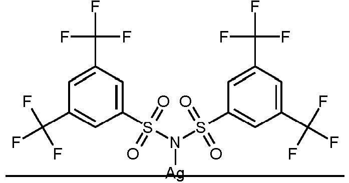 | 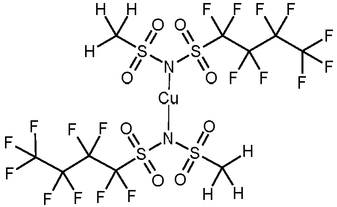 |
| M1 | M2 |
| 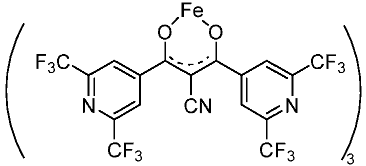 | 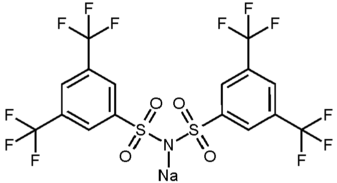 |
| M3 | M4 |
| 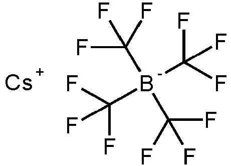 | 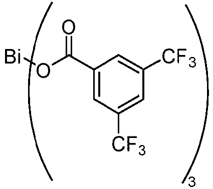 |
| M5 | M6 |
| 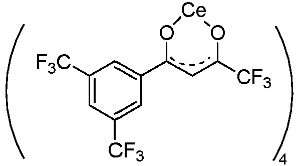 | 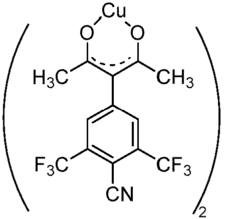 |
| M7 | M8 |
| 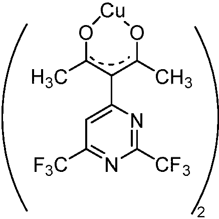 | 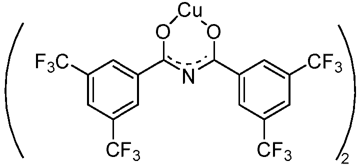 |
| M9 | M10 |
| 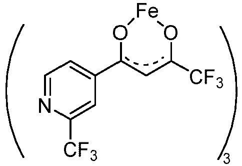 | 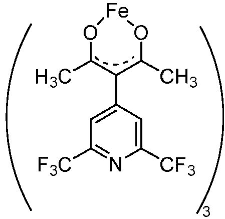 |
| M11 | M12 |
| 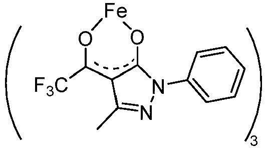 | 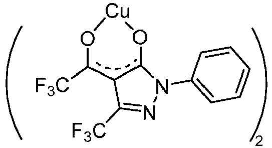 |
| M13 | M14 |
| 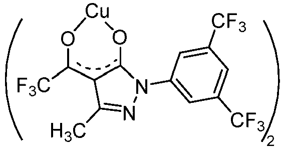 | 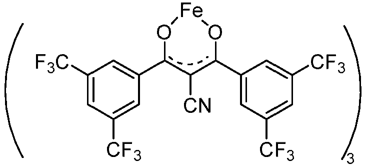 |
| M15 | M16 |
| 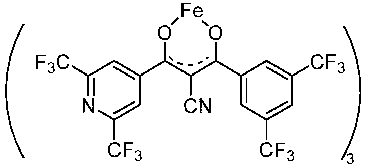 | |
| M17 | |

According to one embodiment of the present invention, the compound of formula (II) is present in the hole injection layer in an amount of ≤99.9 mol% based on the total number of molecules in the hole injection layer, preferably ≤99 mol% , more preferably ≤95 mol% , more preferably ≤90 mol% , more preferably ≤80 mol% , more preferably ≤70 mol% , more preferably ≤60 mol% , more preferably ≤50 mol% , more preferably ≤40 mol% , more preferably ≤30 mol%, more preferably ≤20 mol% , more preferably ≤ 10 mol%, more preferably ≤ 7 mol%, more preferably ≤ 6 mol%, more preferably ≤ 5 mol%, more preferably ≤ 4 mol%, and most preferably ≤ 3.0..

According to one embodiment of the present invention, the first hole transport matrix compound is present in the hole injection layer in an amount of ≥0.1 mol% based on the total number of molecules in the hole injection layer, preferably ≥1 mol%, more preferably ≥5 mol%, more preferably ≥10 mol%, more preferably ≥20 mol%, more preferably ≥30 mol%, more preferably ≥40 mol%, more preferably ≥50 mol%, more preferably ≥60 mol%, more preferably ≥70 mol%, more preferably ≥80 mol%, more preferably ≥90 mol%, more preferably ≥93 mol%,

more preferably ≥94 mol%, more preferably ≥95 mol%, more preferably ≥96 wt%, and most preferably ≥97.0 mol%.

According to one embodiment of the present invention, the organic electroluminescent device further comprises a third emission layer.

According to one embodiment of the present invention, between the first emission layer and the second emission layer no more than one charge generation layer is arranged, in particular no more than one charge generation layer comprising a p-type charge generation layer and an n-type charge generation layer.

According to one embodiment of the present invention, the second emission layer and the third emission layer, no more than one charge generation layer is arranged, in particular no more than one charge generation layer comprising a p-type charge generation layer and an n-type charge generation layer.

According to one embodiment of the present invention, a third emission layer and a second charge generation layer, wherein the second charge generation layer is arranged between the second emission layer and the third emission layer, wherein the second charge generation layer comprises a second p-type charge generation layer and a second n-type charge generation layer, wherein the second n-type charge generation layer is closer to the anode layer than the second p-type charge generation layer,
wherein the second n-type charge generation layer comprises a metal dopant and a matrix compound,
wherein the second p-type charge generation layer comprises a second hole transport matrix compound and a compound of formula (I).

According to one embodiment of the present invention, the organic electroluminescent device further comprises a third emission layer and a fourth emission layer.

According to one embodiment of the present invention, the organic electroluminescent device comprises
comprises a third emission layer, a fourth emission layer, a second charge generation layer, and third charge generation layer, wherein the second charge generation layer is arranged between the second emission layer and the third emission layer, wherein the third charge generation layer is arranged between the third and the fourth emission layer,
wherein the second charge generation layer comprises a second p-type charge generation layer and a second n-type charge generation layer,
wherein the third charge generation layer comprises a third p-type charge generation layer and a third n-type charge generation layer,
wherein the second n-type charge generation layer is closer to the anode layer than the second p-type charge generation layer,
wherein the third n-type charge generation layer is closer to the anode layer than the third p-type charge generation layer,
wherein the second n-type charge generation layer comprises a metal dopant and a matrix compound,
wherein the third n-type charge generation layer comprises a metal dopant and a matrix compound,
wherein the second p-type charge generation layer comprises a second hole transport matrix compound and a compound of formula (I),
wherein the third p-type charge generation layer comprises a second hole transport matrix compound and a compound of formula (I).

According to an embodiment, the organic electroluminescent device further comprises a layer selected from hole injection layer, hole transport layer, electron blocking layer, a hole blocking layer, an electron transport layer, and an electron injection layer.

According to an embodiment, the organic electroluminescent device further comprises a hole injection layer, a first hole transport layer, a second hole transport layer, first electron blocking layer, second electron blocking layer, optionally a first hole blocking layer, optionally a second hole blocking layer, a first electron transport layer, a second electron transport layer, and an electron injection layer.

According to one embodiment of the present invention, the first n-type charge generation layer is in direct contact to the first p-type charge generation layer.

According to one embodiment of the present invention, the second n-type charge generation layer is in direct contact to the second p-type charge generation layer.

According to one embodiment of the present invention, the third n-type charge generation layer is in direct contact to the third p-type charge generation layer.

According to one embodiment of the present invention, each of the at least two light-emitting units comprises an electron transport layer.

According to one embodiment of the present invention, the organic electroluminescent device further comprises an electron transport layer, wherein the electron transport layer is arranged between the first emission layer and the second emission layer, wherein the electron transport layer is arranged in direct contact to the first n-type charge generation layer, and wherein the electron transport layer is arranged between the first emission layer and the first n-type charge generation layer..

According to one embodiment of the present invention, the organic electroluminescent device further comprises an electron transport layer, wherein the electron transport layer is arranged between the first emission layer and the second emission layer, wherein the electron transport layer is arranged in direct contact to the first n-type charge generation layer, and wherein the electron transport layer is arranged between the first emission layer and the first n-type charge generation layer, and wherein the first n-type charge generation layer is in direct contact to the to the first p-type charge generation layer.

According to one embodiment of the present invention, the matrix compound of the first n-type charge generation layer is an electron transport material.

According to one embodiment of the present invention, the matrix compound of the first n-type charge generation layer an organic electron transport material.

According to one embodiment of the present invention, the matrix compound of the first n-type charge generation layer comprises at least one C₂ to C₂₄ N-heteroaryl or P=X group, with X being O, P, Se, with P=O especially preferred.

According to an embodiment of the present invention, the at least one C₂ to C₂₄ N-heteroaryl may be selected from a compound comprising at least one azine group, preferably at least two azine groups, also preferred three azine groups.

According to an embodiment of the present invention, the matrix compound of the first n-type charge generation layer comprises at least one group selected from the list consisting of pyridine, pyrimidine, triazine, imidazole, benzimidazole, benzooxazole, quinone, benzoquinone, imidazo[1,5-*a*]pyridine, quinoxaline, benzoquinoxaline, acridine, phenanthroline, benzoacridine, dibenzoacridine phosphine oxide, terpyridine.

According to an embodiment of the present invention, the matrix compound of the first n-type charge generation layer comprises at least one phenanthroline group, preferably two phenanthroline groups, one or more pyridine groups, one or more pyrimidine groups, one or more triazine groups, one or more imidazo[1,5-*a*]pyridine groups, or one or more phosphine oxide groups.

According to an embodiment of the present invention, the matrix compound of the first n-type charge generation layer comprises at least one phenanthroline group, preferably two phenanthroline groups, one or more pyridine groups, one or more pyrimidine groups, or one or more phosphine oxide groups.

According to an embodiment of the present invention, the matrix compound of the first n-type charge generation layer comprises at least one phenanthroline group, preferably two phenanthroline groups, a pyridine group, a pyrimidine groups, or a phosphine oxide group.

According to an embodiment of the present invention, the matrix compound of the first n-type charge generation layer comprises at least one phenanthroline group, preferably two phenanthroline groups, one or more pyridine groups, one or more pyrimidine groups, one or more triazine groups.

According to an embodiment of the present invention, the matrix compound of the first n-type charge generation layer is selected from the group comprising 2,2'-(1,3-Phenylene)bis[9-phenyl-1,10-phenanthroline], (3-(10-(3-(2,6-diphenylpyrimidin-4-yl)phenyl)anthracen-9-yl)phenyl)dimethylphosphine oxide, 3-(3-(9,10-diphenylanthracen-2-yl)phenyl)-1-(pyridin-2-yl)imidazo[1,5-a]pyridine, 7-(3-(1,10-phenanthrolin-2-yl)phenyl)dibenzo[c,h]acridine, 7-(3-([2,2':6',2"-terpyridin]-4'-yl)phenyl)dibenzo[c,h]acridine, 4'-(4'-(4,6-diphenyl-1,3,5-triazin-2-yl)-[1,1'-biphenyl]-4-yl)-2,2':6',2"-terpyridine, 4'-(4-(fluoranthen-3-yl)phenyl)-2,2':6',2"-terpyridine, or 3-(9,10-di-2-naphthalenyl-2-anthracenyl)phenyl]dimethylphosphine oxide.

According to an embodiment of the present invention, the matrix compound of the first n-type charge generation layer comprises at least one phenanthroline group, preferably two phenanthroline groups.

According to one embodiment of the present invention, the metal dopant is selected from a metal with an electronegativity of ≤ 1.4 eV by Pauling scale or a metal alloy comprising a metal with an electronegativity of ≤ 1.4 eV by Pauling scale.

According to one embodiment of the present invention, the metal dopant is selected from a metal with an electronegativity of ≤ 1.35 eV by Pauling scale or a metal alloy comprising a metal with an electronegativity of ≤ 1.35 eV by Pauling scale.

According to one embodiment of the present invention, the metal dopant is a metal selected from the group consisting of Li, Na, K, Rb, Cs, Mg, Ca, Sr, Ba, Sm, Eu and Yb or a metal alloy comprising a metal selected from the group consisting of Li, Na, K, Rb, Cs, Mg, Ca, Sr, Ba, Sm, Eu and Yb.

According to one embodiment of the present invention, the metal dopant is a metal selected from the group consisting of Li, Na, K, Cs, Mg, Ca, Ba, Sm, Eu and Yb or a metal alloy comprising a metal selected from the group consisting of Li, Na, K, Cs, Mg, Ca, Ba, Sm, Eu and Yb.

According to one embodiment of the present invention, the metal dopant is a metal selected from the group consisting of Li, Mg and Yb or a metal alloy comprising a metal selected from the group consisting of Li, Mg and Yb.

According to one embodiment of the present invention, the metal dopant is a metal selected from the group consisting of Li and Yb or a metal alloy comprising a metal selected from the group consisting of Li, and Yb.

According to one embodiment of the present invention, the metal dopant is Yb or a metal alloy comprising a metal selected from the group consisting of Li and Yb.

According to one embodiment of the present invention, the metal dopant is Yb.

According to one embodiment of the present invention, the metal dopant is in the oxidations state ±0.

According to one embodiment of the present invention, the metal dopant is present in the first n-type charge generation layer in an amount of ≤99.9 vol% based on the total volume of the layer, preferably ≤99 vol%, more preferably ≤95 vol%, more preferably ≤90 vol%, more preferably ≤80 vol%, more preferably ≤70 vol%, more preferably ≤60 vol% , more preferably ≤50 vol%, more preferably ≤40 vol%, more preferably ≤30 vol%, more preferably ≤20 vol%, more preferably ≤ 10 vol%, more preferably ≤ 5 vol% , more preferably ≤ 3.0 vol%, more preferably ≤ 2 vol%, more preferably ≤ 1.5 vol%, more preferably ≤ 1.25 vol%, and most preferably ≤ 1.0 vol%.more

According to one embodiment of the present invention, the matrix compound is present in the first n-type charge generation layer in an amount of ≥0.1 vol% based on the total volume of the layer, preferably ≥1 vol%, more preferably ≥5 vol%, more preferably ≥10 vol%, more preferably ≥20 vol%, more preferably ≥30 vol%, more preferably ≥40 vol%, more preferably ≥50 vol%, more preferably ≥60 vol%, more preferably ≥70 vol%, more preferably ≥80 vol%, more preferably ≥90 vol%, more preferably ≥95 vol%, more preferably ≥97.0 vol%, more preferably ≥98 vol%, more preferably ≥98.25 vol%, more preferably ≥98.5 vol%, more preferably ≥98.75 vol% and most preferably ≥99.0 vol%.

According to one embodiment of the present invention, the compound of formula (I) is present in the first p-type charge generation layer in an amount of ≤99.9 mol% based on the total numbers of molecules in the p-type charge generation layer, preferably ≤99 mol%, more preferably ≤95 mol%, more preferably ≤90 mol%, more preferably ≤80 mol%, more preferably ≤70 mol%, more preferably ≤60 mol%, more preferably ≤50 mol%, more preferably ≤40 mol%, more preferably ≤30 mol%, more preferably ≤20 mol%, more preferably ≤ 10 mol%, and more preferably ≤ 7 mol%,

According to one embodiment of the present invention, the second hole transport matrix compound is present in the first p-type charge generation layer in an amount of ≥0.1 mol% based on the total number of molecules in the p-type charge generation layer, preferably ≥1 mol%, more preferably ≥5 mol%, more preferably ≥10 mol%, more preferably ≥20 mol%, more preferably ≥30 mol%, more preferably ≥40 mol%, more preferably ≥50 mol%, more preferably ≥60 mol%, more preferably ≥70 mol%, more preferably ≥80 mol%, more preferably ≥90 mol%, and more preferably ≥93 mol%.

According to one embodiment of the present invention, the electroluminescent device further comprises at least one hole transport layer.

According to one embodiment of the present invention, the organic electroluminescent device further comprises a hole transport layer, wherein the hole transport layer is arranged between the first emission layer and the second emission layer, wherein the hole transport layer is arranged in direct contact to the first p-type charge generation layer, and wherein the hole transport layer is arranged between the first p-type charge generation layer and the second emission layer.

According to one embodiment of the present invention, the organic electroluminescent device further comprises a hole transport layer, wherein the hole transport layer is arranged between the first emission layer and the second emission layer, wherein the hole transport layer is arranged in direct contact to the first p-type charge generation layer, and wherein the hole transport layer is arranged between the first p-type charge generation layer and the second emission layer, and wherein the first n-type charge generation layer is arranged in direct contact to the hole transport layer.

According to one embodiment of the present invention, the first hole transport matrix compound has a calculated HOMO energy level, expressed in the absolute scale referring to vacuum energy level being zero, in the range of ≤ -4.27 eV to ≥ -5.1 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably ≤ -4.3 eV to ≥ -5.0 eV, more preferably ≤ -4.4 eV and ≥ -5.0 eV, more preferably ≤ -4.5 eV and ≥ -5.0 eV, more preferably ≤ -4.5 eV and ≥ -4.9 eV and most preferably ≤ -4.6 eV and ≥ -4.9 eV.

According to one embodiment of the present invention, the first hole transport matrix compound is a substantially covalent matrix compound.

According to one embodiment of the present invention, the first hole transport matrix compound is an organic hole transport matrix compound.

According to one embodiment of the present invention, the first hole transport matrix compound is a substantially covalent organic matrix compound.

According to one embodiment of the present invention, the first hole transport matrix compound of the p-type charge generation layer is a substantially covalent matrix compound.

According to one embodiment of the present invention, the organic hole transport matrix compound of the charge generation layer is the same as the organic hole transport matrix compound of the p-type charge generation layer.

According to one embodiment of the present invention, the second hole transport matrix compound of the p-type charge generation layer is the same as the first hole transport matrix compound of the hole injection layer.

According to one embodiment of the present invention, the first hole transport matrix compound of the hole injection layer has a calculated HOMO energy level, expressed in the absolute scale referring to vacuum energy level being zero, in the range of ≤ -4.27 eV to ≥ -5.1 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably ≤ -4.3 eV to ≥ -5.0 eV, more preferably ≤ -4.4 eV and ≥ -5.0 eV, more preferably ≤ -4.5 eV and ≥ -5.0 eV, more preferably ≤ -4.5 eV and ≥ -4.9 eV and most preferably ≤ -4.6 eV and ≥ -4.9 eV.

According to one embodiment of the present invention, the first hole transport matrix compound is a substantially covalent matrix compound.

According to one embodiment of the present invention, the first hole transport matrix compound is an organic hole transport matrix compound.

According to one embodiment of the present invention, the first hole transport matrix compound is a substantially covalent organic matrix compound.

According to one embodiment of the present invention, the first hole transport matrix compound is present in the hole injection layer in an amount of ≥0.1 mol% based on the total number of molecules in the hole injection layer, preferably ≥1 mol%, more preferably ≥5 mol%, more preferably ≥10 mol%, more preferably ≥20 mol%, more preferably ≥30 mol%, more preferably ≥40 mol%, more preferably ≥50 mol%, more preferably ≥60 mol%, more preferably ≥70 mol%, more preferably ≥80 mol%, more preferably ≥90 mol%, more preferably ≥93 mol%, more preferably ≥94 mol%, more preferably ≥95 mol%, more preferably ≥96 wt%, and most preferably ≥97.0 mol%.

According to one embodiment of the present invention, the organic hole transport matrix compound of the p-type charge generation layer is the same as the organic hole transport layer of the hole injection layer.

According to one embodiment of the present invention, the second hole transport matrix compound of the p-type charge generation layer has a calculated HOMO energy level, expressed in the absolute scale referring to vacuum energy level being zero, in the range of ≤ -4.27 eV to ≥ - 5.1 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably ≤ -4.3 eV to ≥ -5.0 eV, more preferably ≤ -4.4 eV to ≥ -5.0 eV, more preferably ≤ -4.5 eV and ≥ -5.0 eV, more preferably ≤ -4.5 eV and ≥ -4.9 eV and most preferably ≤ -4.6 eV and ≥ -4.9 eV.

According to one embodiment of the present invention, the second hole transport matrix compound is a substantially covalent matrix compound.

According to one embodiment of the present invention, the second hole transport matrix compound is an organic hole transport matrix compound.

According to one embodiment of the present invention, the second hole transport matrix compound is a substantially covalent organic matrix compound.

According to one embodiment of the present invention, the second hole transport matrix compound is present in the p-type charge generation layer in an amount of ≥0.1 mol% based on the total number of moleculesin the p-type charge generation layer, preferably ≥1 mol%, more preferably ≥5 mol%, more preferably ≥10 mol%, more preferably ≥20 mol%, more preferably ≥30 mol%, more preferably ≥40 mol%, more preferably ≥50 mol%, more preferably ≥60 mol%, more preferably ≥70 mol%, more preferably ≥80 mol%, more preferably ≥90 mol%, and more preferably ≥93 mol%.

According to one embodiment of the present invention, the organic electroluminescent device comprises at least one electron injection layer (EIL).

According to one embodiment of the present invention, the electron injection layer is in direct contact to the cathode layer.

According to one embodiment of the present invention, the organic hole transport matrix compound of the p-type charge generation layer is a substantially covalent matrix compound and the same as the organic hole transport matrix compound of the hole injection layer.

### Substantially covalent matrix compound

According to one embodiment of the present invention, the substantially covalent matrix compound may be selected from at least one organic compound. The substantially covalent matrix may consists substantially from covalently bound C, H, O, N, S, which optionally comprise in addition covalently bound B, P, As and/or Se.

According to one embodiment of the present invention, the substantially covalent matrix compound may be selected from organic compounds consisting substantially from covalently bound C, H, O, N, S, which optionally comprise in addition covalently bound B, P, As and/or Se.

Organometallic compounds comprising covalent bonds carbon-metal, metal complexes comprising organic ligands and metal salts of organic acids are further examples of organic compounds that may serve as substantially covalent matrix compounds of the hole injection layer.

In one embodiment, the substantially covalent matrix compound lacks metal atoms and majority of its skeletal atoms may be selected from C, O, S, N. Alternatively, the substantially

covalent matrix compound lacks metal atoms and majority of its skeletal atoms may be selected from C and N.

According to one embodiment, the substantially covalent matrix compound may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

Preferably, the substantially covalent matrix compound comprises at least one arylamine moiety, alternatively a diarylamine moiety, alternatively a triarylamine moiety.

Preferably, the substantially covalent matrix compound is free of metals and/or ionic bonds.

### Compound of formula (XII) or a compound of formula (XIII)

According to another aspect of the present invention, the substantially covalent matrix compound, may comprises at least one arylamine compound, diarylamine compound, triarylamine compound, a compound of formula (XII) or a compound of formula (XIII): 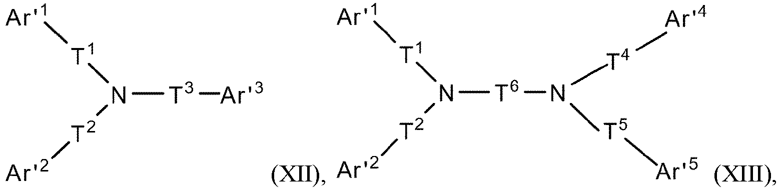 wherein:
T¹, T², T³, T⁴ and T⁵ are independently selected from a single bond, phenylene, biphenylene, terphenylene or naphthenylene, preferably a single bond or phenylene;
T⁶ is phenylene, biphenylene, terphenylene or naphthenylene;
Ar'¹, Ar'², Ar'³, Ar'⁴ and Ar'⁵ are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein
the substituents of Ar'¹, Ar'², Ar'³, Ar'⁴ and Ar'⁵ are selected the same or different from the group comprising H, D, F, C(=O)R'², CN, Si(R'²)₃, P(=O)(R'²)₂, OR'², S(=O)R'², S(=O)₂R'², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein R'² may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl.

According to an embodiment wherein T¹, T², T³, T⁴ and T⁵ may be independently selected from a single bond, phenylene, biphenylene or terphenylene. According to an embodiment wherein T¹, T², T³, T⁴ and T⁵ may be independently selected from phenylene, biphenylene or terphenylene and one of T¹, T², T³, T⁴ and T⁵ are a single bond. According to an embodiment wherein T¹, T², T³, T⁴ and T⁵ may be independently selected from phenylene or biphenylene and one of T¹, T², T³, T⁴ and T⁵ are a single bond. According to an embodiment wherein T¹, T², T³, T⁴ and T⁵ may be independently selected from phenylene or biphenylene and two of T¹, T², T³, T⁴ and T⁵ are a single bond.

According to an embodiment wherein T¹, T² and T³ may be independently selected from phenylene and one of T¹, T² and T³ are a single bond. According to an embodiment wherein T¹, T² and T³ may be independently selected from phenylene and two of T¹, T² and T³ are a single bond.

According to an embodiment wherein T⁶ may be phenylene, biphenylene, terphenylene. According to an embodiment wherein T⁶ may be phenylene. According to an embodiment wherein T⁶ may be biphenylene. According to an embodiment wherein T⁶ may be terphenylene.

According to an embodiment wherein Ar'¹, Ar'², Ar'³, Ar'⁴ and Ar'⁵ may be independently selected from E1 to E16: 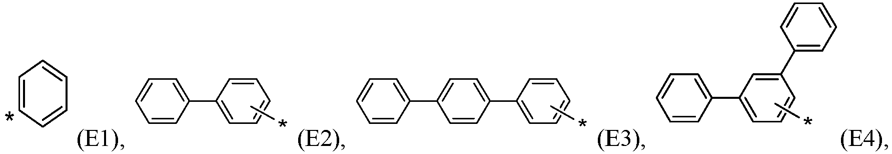 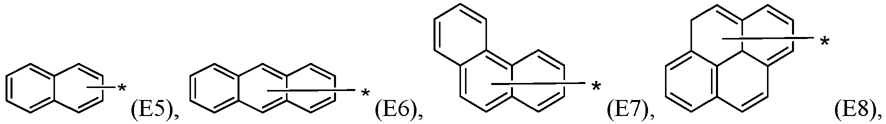 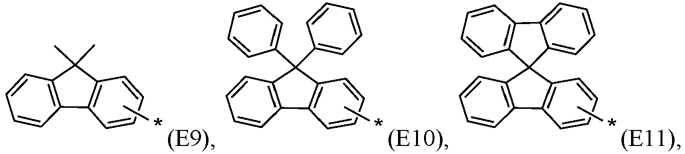 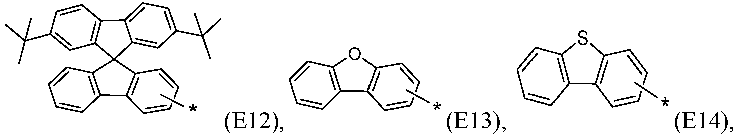 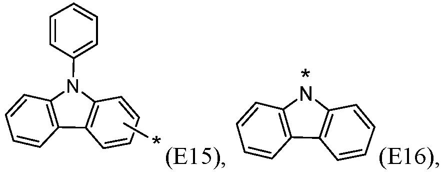 wherein the asterix "*" denotes the binding position.

According to an embodiment, wherein Ar'¹, Ar'², Ar'³, Ar'⁴ and Ar'⁵ may be independently selected from E1 to E15; alternatively selected from E1 to E10 and E13 to E15.

According to an embodiment, wherein Ar'¹, Ar'², Ar'³, Ar'⁴ and Ar'⁵ may be independently selected from the group consisting of E1, E2, E5, E7, E9, E10, E13 to E16.

The rate onset temperature may be in a range particularly suited to mass production, when Ar'¹, Ar'², Ar'³, Ar'⁴ and Ar'⁵ are selected in this range.

The "matrix compound of formula (XII) or formula (XIII)" may be also referred to as "hole transport compound".

According to one embodiment, the substantially covalent matrix compound comprises at least one naphthyl group, carbazole group, dibenzofuran group, dibenzothiophene group and/or substituted fluorenyl group, wherein the substituents are independently selected from methyl, phenyl or fluorenyl.

According to an embodiment of the electronic device, wherein the matrix compound of formula (XII) or formula (XIII) are selected from F1 to F20:

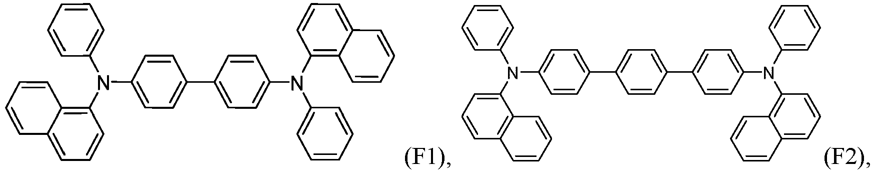

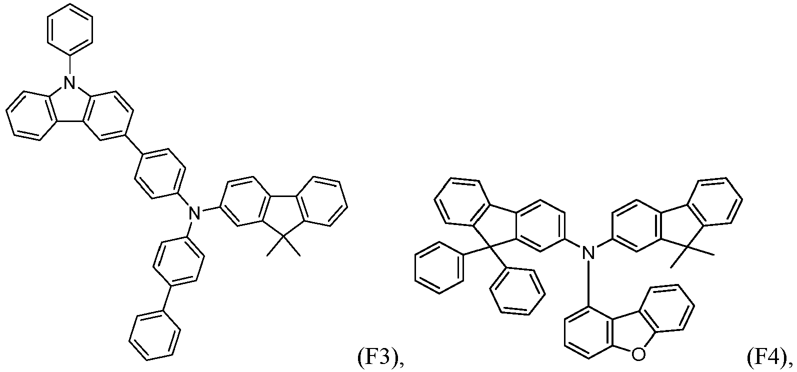

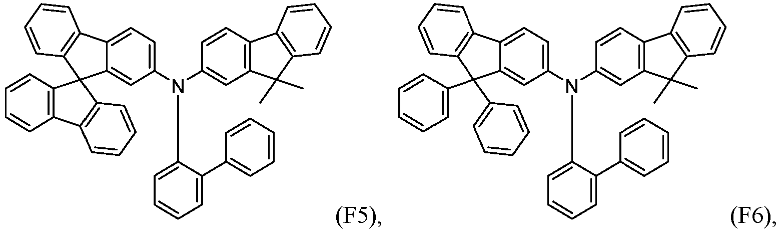

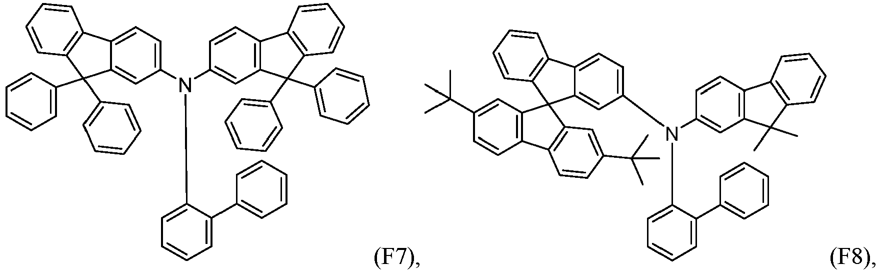

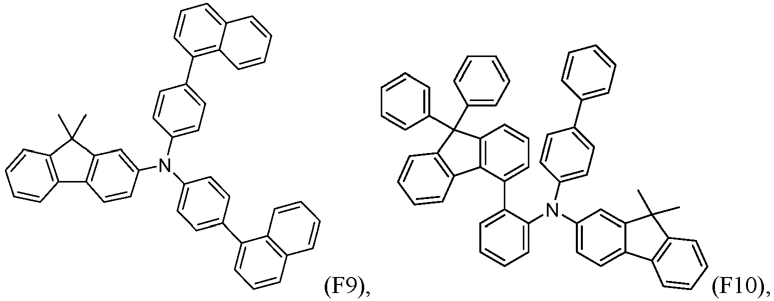

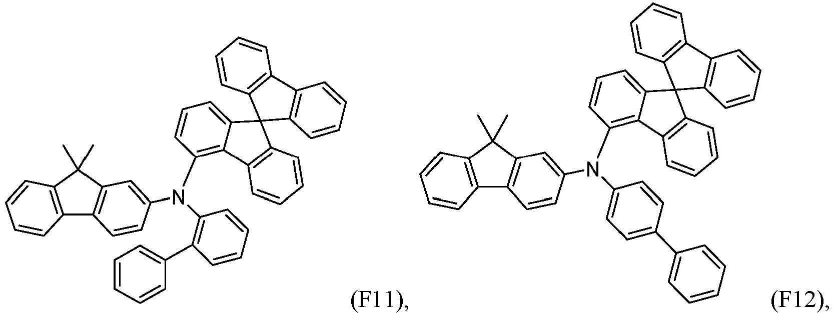

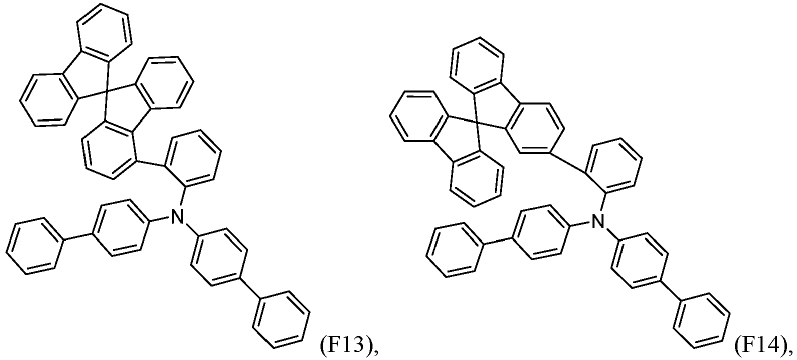

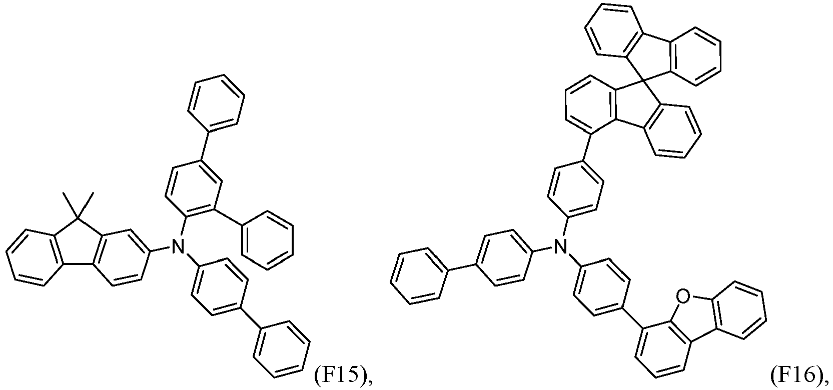

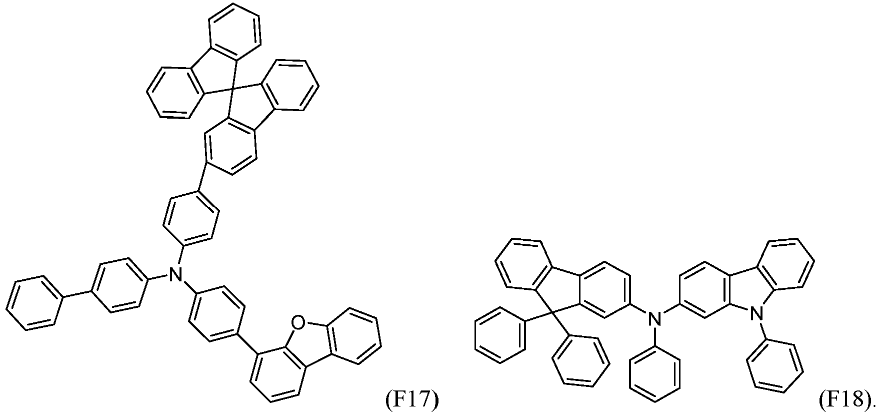

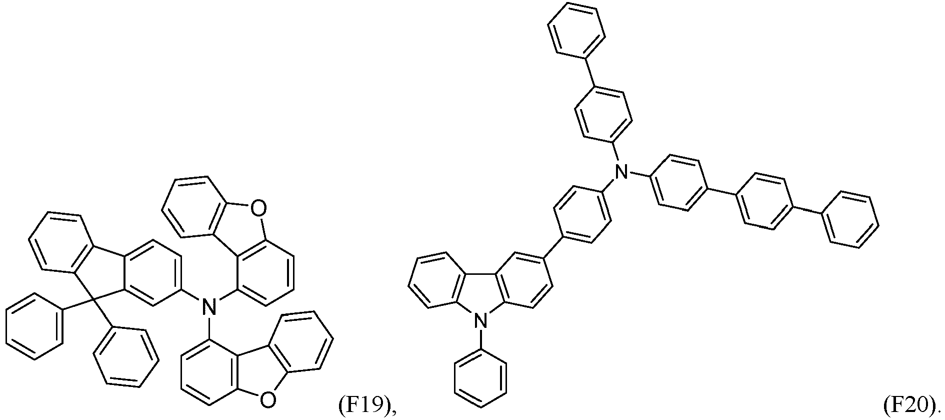

According to one embodiment of the invention the electronic organic device is an organic light emitting diode.

According to a preferred embodiment of the invention, the electroluminescent device is an organic light emitting diode, wherein light is emitted through the cathode layer.

The present invention furthermore relates to a display device comprising an organic electroluminescent device according to the present invention.

According to a preferred embodiment of the invention, the display device comprising an organic electroluminescent device according to the present invention, wherein the cathode layer is transparent.

### p-type charge generation layer

The p-type charge generation layer may be formed on the anode layer or cathode layer by vacuum deposition, spin coating, printing, casting, slot-die coating, Langmuir-Blodgett (LB) deposition, or the like. When the a p-type charge generation layer is formed using vacuum deposition, the deposition conditions may vary according to the compound(s) that are used to form the layer, and the desired structure and thermal properties of the layer. In general, however, conditions for vacuum deposition may include a deposition temperature of 100° C to 350° C, a pressure of 10⁻⁸ to 10⁻³ Torr (1 Torr equals 133.322 Pa), and a deposition rate of 0.1 to 10 nm/sec.

When the a p-type charge generation layer is formed using spin coating or printing, coating conditions may vary according to the compound(s) that are used to form the layer, and the desired structure and thermal properties of the organic semiconductor layer. For example, the coating conditions may include a coating speed of about 2000 rpm to about 5000 rpm, and a thermal treatment temperature of about 80° C to about 200° C. Thermal treatment removes a solvent after the coating is performed.

The thickness of the p-type charge generation layer may be in the range from about 1 nm to about 20 nm, and for example, from about 2 nm to about 15 nm, alternatively about 2 nm to about 12 nm.

### Hole injection layer

A hole injection layer (HIL) may be formed on the anode layer by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of 10⁻⁸ to 10⁻³ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

### Further layers

In accordance with the invention, the organic electroluminescent device may comprise, besides the layers already mentioned above, further layers. Exemplary embodiments of respective layers are described in the following:

### Substrate

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate, a silicon substrate or a backplane.

### Anode layer

The anode layer may be formed by depositing or sputtering a material that is used to form the anode layer. The material used to form the anode layer may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode layer may also be formed using metals, typically silver (Ag), gold (Au), or metal alloys.

### Hole transport layer

The organic electronic device according to the present invention may further comprise at least one hole transport layer (HTL). According to one embodiment of the present invention, the at least one hole transport layer is comprised in one of the at least two light-emitting units, wherein preferably at least one hole transport layer is comprised in each light-emitting unit.

A hole transport layer (HTL) may be formed on the HIL or CGL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL or CGL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (α-NPD); and triphenylamine-based compound, such as 4,4',4"-tris(N-carbazolyl)triphenylamine (TCTA). Among these compounds, TCTA can transport holes and inhibit excitons from being diffused into the EML.

According to one embodiment of the present invention, the hole transport layer may comprise a substantially covalent matrix compound as described above.

According to a preferred embodiment of the present invention, the hole injection layer and the hole transport layer may comprise an identical substantially covalent matrix compound as described above.

According to one embodiment of the present invention, the hole transport layer may comprise a compound of formula (XII) or (XIII) as described above.

According to a preferred embodiment of the present invention, the hole injection layer and the hole transport layer may comprise an identical compound of formula (XII) or (XIII) as described above.

According to a preferred embodiment of the present invention, the p-type charge generation layer, the hole injection layer and the hole transport layer may comprise an identical substantially covalent matrix compound.

According to a preferred embodiment of the present invention, the p-type charge generation layer, the hole injection layer and the hole transport layer may comprise an identical an identical compound of formula (XII) or (XIII) as described above.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

### Electron blocking layer

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

### Photoactive layer (PAL)

According to an embodiment of the present invention, the organic electronic device may further comprise a photoactive layer, wherein the photoactive layer is arranged between the anode layer and the cathode layer.

The photoactive layer converts an electrical current into photons or photons into an electrical current.

The PAL may be formed on the HTL by vacuum deposition, spin coating, slot-die coating, printing, casting, LB deposition, or the like. When the PAL is formed using vacuum deposition or spin coating, the conditions for deposition and coating may be similar to those for the formation of the HIL. However, the conditions for deposition and coating may vary, according to the compound that is used to form the PAL.

The photoactive layer may be a light-emitting layer or a light-absorbing layer, in particular a light-emitting layer.

### Emission layer (EML)

According to an embodiment of the present invention, the organic electronic device may further comprise an emission layer, wherein the emission layer is arranged between the anode layer and the cathode layer.

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp)3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

### Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and azine derivatives, preferably triazine or pyrimidine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

### Electron transport layer (ETL)

The organic electronic device according to the present invention may further comprise at least one electron transport layer (ETL). According to one embodiment of the present invention, the at least one electron transport layer is comprised in one of the at least two light-emitting units, wherein preferably at least one electron transport layer is comprised in each light-emitting unit.

According to another embodiment of the present invention, the electron transport layer may further comprise an azine compound, preferably a pyridine, pyrimidine or triazine compound, and most preferably a triazine compound or a pyrimidine compound.

According to another embodiment of the present invention, the electron transport layer may further comprise 2-([1,1'-biphenyl]-4-yl)-4-(9,9-diphenyl-9H-fluoren-4-yl)-6-phenyl-1,3,5-triazine, 2-(3-(2,6-dimethylpyridin-3-yl)-5-(phenanthren-9-yl)phenyl)-4,6-diphenyl-1,3,5-triazine, 3'-(4-phenyl-6-(spiro[fluorene-9,9'-xanthen]-2'-yl)-1,3,5-triazin-2-yl)-[1,1'-biphenyl]-4-carbonitrile, and 4'-(4-(4-(4,6-diphenyl-1,3,5-triazin-2-yl)phenyl)naphthalen-1-yl)-[1,1'-biphenyl]-4-carbonitrile.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the ETL is within this range, the ETL may have satisfactory electron-injecting properties, without a substantial penalty in driving voltage.

According to another embodiment of the present invention, the organic electronic device may further comprise a hole blocking layer and an electron transport layer, wherein the hole blocking layer and the electron transport layer comprise an azine compound. Preferably, the azine compound is a pyridine, pyrimidine or triazine compound, and most preferably a triazine compound.

### Electron injection layer (EIL)

An optional EIL, which may facilitates injection of electrons from the cathode, may be formed on the ETL preferably closest to the cathode, and more preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

### Cathode layer

The cathode layer is formed on the ETL or optional EIL. The cathode layer may be formed of a metal, an alloy, an electrically conductive compound, or a mixture thereof. The cathode electrode may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO.

The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.

In a preferred embodiment, the cathode layer comprises a metal or metal alloy and is transparent.

It is to be understood that the cathode layer is not part of an electron injection layer or the electron transport layer.

Further layouts of the organic electroluminescent device

According to one embodiment of the present invention, the organic electroluminescent device comprises, preferably in the following order, an anode layer; a hole injection layer; a first hole transport layer; a first electron blocking layer ; a first emission layer; a first optional hole blocking layer; and a first electron transport layer; wherein the hole injection layer is in direct contact to the anode layer, and wherein the hole injection layer comprises a first hole transport matrix compound and a compound of formula (II) which is a metal compound selected from a metal salt or metal complex comprising a metal cation and at least one monoanion consisting of at least 20 covalently bound atoms and/or at least one monoanionic ligand consisting of at least 20 covalently bound atoms; a first charge generation layer disposed over the first electron transport layer, wherein the first charge generation layer comprises a first n-type charge generation layer, and a first p-type charge generation layer, wherein the first p-type charge generation layer, comprise a second hole transport matrix compound, and a compound of formula (I), wherein the first n-type charge generation layer,comprises a matrix compound and a metal dopant, wherein preferably the metal dopant is selected from Ytterbium, Lithium or Magnesium; a second hole transport layer ,; a second electron blocking layer ,; a second emission layer ,; a second optional hole blocking layer, , an electron transport layer, an electron injection layer and a cathode layer.

According to one embodiment of the present invention, the organic electroluminescent device comprises, preferably in the following order, an anode layer, a hole injection layer , a hole transport layer, a first electron blocking layer, and a first emission layer,wherein the hole injection layer comprises a first hole transport matrix compound and a compound of formula (II) which is a metal compound selected from a metal salt or metal complex comprising a metal cation and at least one monoanion consisting of at least 20 covalently bound atoms and/or at least one monoanionic ligand consisting of at least 20 covalently bound atoms, and wherein the hole injection layer is in direct contact to the anode layer, a first optional hole blocking layer, a first electron transport layer, a first charge generation layer disposed over the first electron transport layer , wherein the first charge generation layer comprises a first n-type charge generation layer, and a first p-type charge generation layer , wherein the first p-type charge generation layer comprise a second hole transport matrix compound, and a compound of formula (I), wherein the first n-type charge generation layer comprises a matrix compound and a metal dopant, wherein preferably the metal dopant is selected from Ytterbium, Lithium or Magnesium; a second hole transport layer , and a second electron blocking layer ; a second emission layer ; a second optional hole blocking layer ; a second electron transport layer ; a second charge generation layer disposed over the second electron transport layer , wherein the second charge generation layer comprises a second n-type charge generation layer , and a second p-type charge generation layer, wherein the second p-type charge generation layer comprise a second hole transport matrix compound, and a compound of formula (I), wherein the second n-type charge generation layer comprises a matrix compound and a metal dopant, wherein preferably the metal dopant is selected from Ytterbium, Lithium, Magnesium; a third hole transport layer (HTL3), and a third electron blocking layer ; a third emission layer ; a third optional hole blocking layer , an electron transport layer , an electron injection layer , and a cathode layer (CAT).

According to one embodiment of the present invention, the organic electroluminescent device comprises, preferably in the following order, an anode layer , a hole injection layer , a hole transport layer , a first electron blocking layer , a first emission layer ; wherein the hole injection layer comprises a first hole transport matrix compound and a compound of formula (II) which is a metal compound selected from a metal salt or metal complex comprising a metal cation and at least one monoanion consisting of at least 20 covalently bound atoms and/or at least one monoanionic ligand consisting of at least 20 covalently bound atoms, and wherein the hole injection layer is in direct contact to the anode layer; a first optional hole blocking layer ; a first electron transport layer ; a first charge generation layer disposed over the first electron transport layer , wherein the first charge generation layer comprises a first n-type charge generation layer , and a first p-type charge generation layer , wherein the first p-type charge generation layer comprise a second hole transport matrix compound, and a compound of formula (I), wherein the first n-type charge generation layer comprises a matrix compound and a metal dopant, wherein preferably the metal dopant is selected from Ytterbium, Lithium or Magnesium; a second hole transport layer , and a second electron blocking layer ; a second emission layer ; a second optional hole blocking layer ; a second electron transport layer ; a second charge generation layer disposed over the second electron transport layer , wherein the second charge generation layer comprises a second n-type charge generation layer , and a second p-type charge generation layer, wherein the second p-type charge generation layer comprise a second hole transport matrix compound, and a compound of formula (I), wherein the second n-type charge generation layer (n-CGL2) comprises a matrix compound and a metal dopant, wherein preferably the metal dopant is selected from Ytterbium, Lithium, Magnesium; a third hole transport layer , and a third electron blocking layer ; a third emission layer ; a third optional hole blocking layer ; a third electron transport layer ; a charge generation layer disposed over the third electron transport layer , wherein the third charge generation layer comprises a third n-type charge generation layer , and a third p-type charge generation layer ; wherein the third p-type charge generation layer comprises a second hole transport matrix compound, and a compound of formula (I), wherein the third n-type charge generation layer comprises a matrix compound and a metal dopant, wherein preferably the metal dopant is selected from Ytterbium, Lithium or Magnesium; a fourth hole transport layer ; a fourth electron blocking layer ; a fourth emission layer ; a fourth optional hole blocking layer , an electron transport layer , an electron injection layer , and a cathode layer .

### Description of the Drawings

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.
FIG. 1 is a schematic sectional view of an organic electroluminescent device according to an exemplary embodiment of the present invention.
FIG. 2 is a schematic sectional view of an organic electroluminescent device according to an exemplary embodiment of the present invention.
FIG. 3 is a schematic sectional view of an organic electroluminescent device according to an exemplary embodiment of the present invention.
FIG. 4 is a schematic sectional view of an organic electroluminescent device according to an exemplary embodiment of the present invention.

Hereinafter, the figures are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

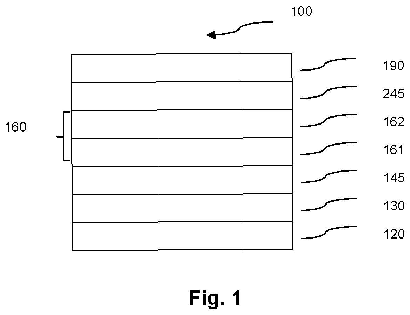

Referring to Fig. 1 the organic electroluminescent device 100 includes an anode layer (ANO) 120, a hole injection layer (HIL) 130, a first emission layer (EML1) 145, wherein the hole injection layer (HIL) 130 comprises a hole transport matrix compound and a metal compound, wherein the metal compound is selected from a metal salt or metal complex comprising a metal cation and at least one monoanion consisting of at least 20 covalently bound atoms and/or at least one monoanionic ligand consisting of at least 20 covalently bound atoms.

The organic electroluminescent device further comprises a first charge generation layer (CGL1) 160, wherein the first charge generation layer (CGL1) 160 comprises a first n-type charge generation layer (n-CGL1) 161, and a first p-type charge generation layer (p-CGL1) 162, wherein the first n-type charge generation layer (n-CGL1) 161 comprises a matrix compound and a metal dopant, wherein preferably the metal dopant is selected from Ytterbium, Lithium or Magnesium.

The organic electroluminescent device 100 further comprises a second emission layer (EML2) 245, and a cathode layer (CAT) 190.

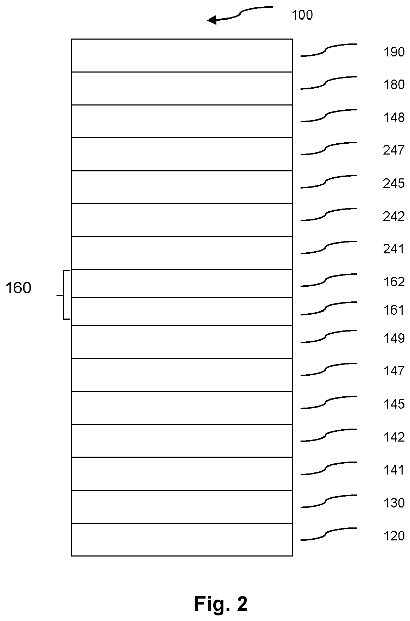

Fig. 2 is a schematic sectional view of an organic electroluminescent device 100, according to one exemplary embodiment of the present invention.

Referring to Fig. 2 the organic electroluminescent device 100 includes an anode layer (ANO) 120, a hole injection layer (HIL) 130, a first hole transport layer (HTL1) 141, a first electron blocking layer (EBL1) 142, a first emission layer (EML1) 145, a first optional hole blocking layer (HBL1) 147, and a first electron transport layer (ETL1) 149, wherein the hole injection layer (HIL) 130 comprises a first hole transport matrix compound and a compound of formula (II) which is a metal compound selected from a metal salt or metal complex comprising a metal cation and at least one monoanion consisting of at least 20 covalently bound atoms and/or at least one monoanionic ligand consisting of at least 20 covalently bound atoms.

The organic electroluminescent device further comprises a first charge generation layer (CGL1) 160 disposed over the first electron transport layer (ETL1) 149, wherein the first charge generation layer (CGL1) 160 comprises a first n-type charge generation layer (n-CGL1) 161, and a first p-type charge generation layer (p-CGL1) 162, wherein the first p-type charge generation layer (p-CGL1) 162 comprise a second hole transport matrix compound, and a compound of formula (I);
wherein the first n-type charge generation layer (n-CGL1) 161 comprises a matrix compound and a metal dopant, wherein preferably the metal dopant is selected from Ytterbium, Lithium or Magnesium.

The organic electroluminescent device 100 further comprises a second hole transport layer (HTL2) 241, a second electron blocking layer (EBL2) 242.

The organic electroluminescent device 100 further comprises a second emission layer (EML2) 245.

The organic electroluminescent device 100 further comprises a second optional hole blocking layer (HBL2) 247, an electron transport layer (ETL) 148, an electron injection layer (EIL) 180, and a cathode layer (CAT) 190.

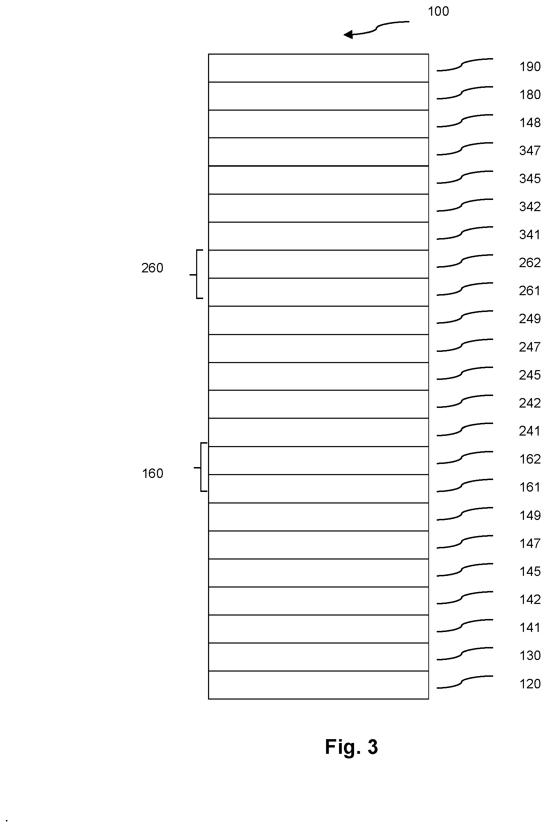

Fig. 3 is a schematic sectional view of an organic electroluminescent device 100, according to one exemplary embodiment of the present invention.

Referring to Fig. 3 the organic electroluminescent device 100 includes an anode layer (ANO) 120, a hole injection layer (HIL) 130, a hole transport layer (HTL1) 141, a first electron blocking layer (EBL1) 142, and a first emission layer (EML1) 145; wherein the hole injection layer (HIL) 130 comprises a first hole transport matrix compound and a compound of formula (II) which is a metal compound selected from a metal salt or metal complex comprising a metal cation and at least one monoanion consisting of at least 20 covalently bound atoms and/or at least one monoanionic ligand consisting of at least 20 covalently bound atoms.

The organic electroluminescent device 100 further comprises a first optional hole blocking layer (HBL1) 147.

The organic electroluminescent device 100 further comprises a first electron transport layer (ETL1) 149.

The organic electroluminescent device further comprises a first charge generation layer (CGL1) 160 disposed over the first electron transport layer (ETL1) 149, wherein the first charge generation layer (CGL1) 160 comprises a first n-type charge generation layer (n-CGL1) 161, and a first p-type charge generation layer (p-CGL1) 162, wherein the first p-type charge generation layer (p-CGL1) 162 comprise a second hole transport matrix compound, and a compound of formula (I);
wherein the first n-type charge generation layer (n-CGL1) 161 comprises a matrix compound and a metal dopant, wherein preferably the metal dopant is selected from Ytterbium, Lithium or Magnesium.

The organic electroluminescent device 100 further comprises a second hole transport layer (HTL2) 241, and a second electron blocking layer (EBL2) 242.

The organic electroluminescent device 100 further comprises a second emission layer (EML2) 245.

The organic electroluminescent device 100 further comprises a second optional hole blocking layer (HBL2) 247.

The organic electroluminescent device 100 further comprises a second electron transport layer (ETL2) 249.

The organic electroluminescent device further comprises a second charge generation layer (CGL2) 260 disposed over the second electron transport layer (ETL2) 249, wherein the second charge generation layer (CGL2) 260 comprises a second n-type charge generation layer (n-CGL2) 261, and a second p-type charge generation layer (p-CGL2) 262, wherein the second p-type charge generation layer (p-CGL2) 262 comprise a second hole transport matrix compound, and a compound of formula (I);
wherein the second n-type charge generation layer (n-CGL2) 261 comprises a matrix compound and a metal dopant, wherein preferably the metal dopant is selected from Ytterbium, Lithium, Magnesium.

The organic electroluminescent device 100 further comprises a third hole transport layer (HTL3) 341, and a third electron blocking layer (EBL3) 342.

The organic electroluminescent device 100 further comprises a third emission layer (EML3) 345.

The organic electroluminescent device 100 further comprises a third optional hole blocking layer (HBL3) 347, an electron transport layer (ETL)148, an electron injection layer (EIL) 180, and a cathode layer (CAT) 190.

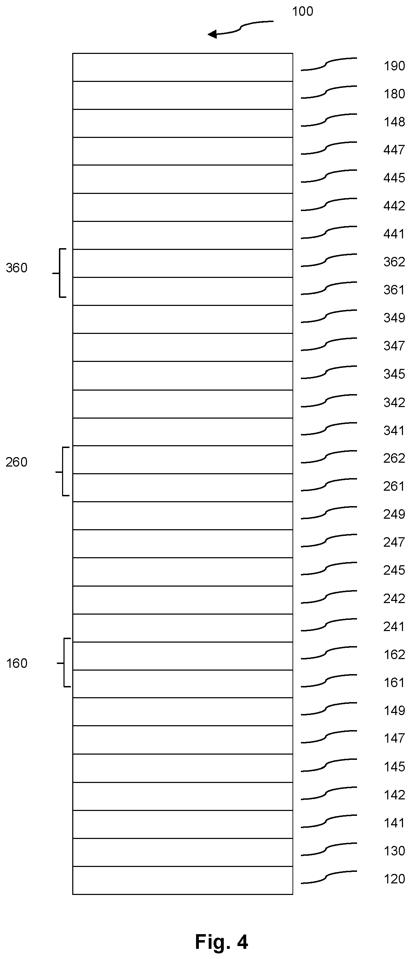

Fig. 4 is a schematic sectional view of an organic electroluminescent device 100, according to one exemplary embodiment of the present invention.

Referring to Fig. 4 the organic electroluminescent device 100 includes an anode layer (ANO) 120, a hole injection layer (HIL) 130, a hole transport layer (HTL1) 141, a first electron blocking layer (EBL1) 142, a first emission layer (EML1) 145; wherein the hole injection layer (HIL) 130 comprises a first hole transport matrix compound and a compound of formula (II) which is a metal compound selected from a metal salt or metal complex comprising a metal cation and at least one monoanion consisting of at least 20 covalently bound atoms and/or at least one monoanionic ligand consisting of at least 20 covalently bound atoms..

The organic electroluminescent device 100 further comprises a first optional hole blocking layer (HBL1) 147.

The organic electroluminescent device 100 further comprises a first electron transport layer (ETL1) 149.

The organic electroluminescent device further comprises a first charge generation layer (CGL1) 160 disposed over the first electron transport layer (ETL1) 149, wherein the first charge generation layer (CGL1) 160 comprises a first n-type charge generation layer (n-CGL1) 161, and a first p-type charge generation layer (p-CGL1) 162, wherein the first p-type charge generation layer (p-CGL1) 162 comprise a second hole transport matrix compound, and a compound of formula (I);
wherein the first n-type charge generation layer (n-CGL1) 161 comprises a matrix compound and a metal dopant, wherein preferably the metal dopant is selected from Ytterbium, Lithium or Magnesium.

The organic electroluminescent device 100 further comprises a second hole transport layer (HTL2) 241, and a second electron blocking layer (EBL2) 242.

The organic electroluminescent device 100 further comprises a second emission layer (EML2) 245.

The organic electroluminescent device 100 further comprises a second optional hole blocking layer (HBL2) 247.

The organic electroluminescent device 100 further comprises a second electron transport layer (ETL2) 249.

The organic electroluminescent device further comprises a second charge generation layer (CGL2) 260 disposed over the second electron transport layer (ETL2) 249, wherein the second charge generation layer (CGL2) 260 comprises a second n-type charge generation layer (n-CGL2) 261, and a second p-type charge generation layer (p-CGL2) 262, wherein the second p-type charge generation layer (p-CGL2) 262 comprise a second hole transport matrix compound, and a compound of formula (I),
wherein the second n-type charge generation layer (n-CGL2) 261 comprises a matrix compound and a metal dopant, wherein preferably the metal dopant is selected from Ytterbium, Lithium, Magnesium; .

The organic electroluminescent device 100 further comprises a third hole transport layer (HTL3) 341, and a third electron blocking layer (EBL3) 342.

The organic electroluminescent device 100 further comprises a third emission layer (EML3) 345.

The organic electroluminescent device 100 further comprises a third optional hole blocking layer (HBL3) 347.

The organic electroluminescent device 100 further comprises a third electron transport layer (ETL3) 349,.

The organic electroluminescent device further comprises a charge generation layer (CGL3) 360 disposed over the third electron transport layer (ETL3) 349, wherein the third charge generation layer (CGL3) 360 comprising a third n-type charge generation layer (n-CGL3) 361, and a third p-type charge generation layer (p-CGL3) 362,
wherein the third p-type charge generation layer (p-CGL3) 362 comprise a second hole transport matrix compound, and a compound of formula (I);
wherein the third n-type charge generation layer (n-CGL3) 361 comprises a matrix compound and a metal dopant, wherein preferably the metal dopant is selected from Ytterbium, Lithium or Magnesium, .

The organic electroluminescent device 100 further comprises a fourth hole transport layer (HTL4) 441, and a fourth electron blocking layer (EBL4) 442.

The organic electroluminescent device 100 further comprises a fourth emission layer (EML4) 345.

The organic electroluminescent device 100 further comprises a fourth optional hole blocking layer (HBL4) 447, an electron transport layer (ETL) 148, an electron injection layer (EIL) 180, and a cathode layer (CAT) 190.

Hereinafter, one or more exemplary embodiments of the present invention will be described in detail with, reference to the following examples. However, these examples are not intended to limit the purpose and scope of the one or more exemplary embodiments of the present invention.

### Detailed description

The invention is furthermore illustrated by the following examples which are illustrative only and non-binding.

Compounds of formula (I) may be prepared as described in EP2180029A1 and WO2016097017A1.

### Calculated HOMO and LUMO

The HOMO of the hole transport matrix compound and the LUMO for compounds with formula (I) are calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G* basis set in the gas phase.

The calculations the LUMO values for compounds with formula (II) are performed by applying the hybrid functional B3LYP with the Def2-TZVP basis set with the SDD Effective Core Potentials (ECPs) for the metals, in the gas phase as implemented in the program package ORCA Version 5.0.3-f.1 (Department of Theory and Spectroscopy, Max Planck Institute für Kohlenforschung Kaiser Wilhelm Platz 1, 45470 Muelheim/Ruhr, Germany).

If more than one conformation is viable, the conformation with the lowest total energy is selected.

### General procedure for fabrication of OLEDs

### OLED comprising a charge generation layer (CGL) according to the invention and comparative devices

For the Examples, a glass substrate with an anode layer comprising a first anode sub-layer of 8 nm ITO, a second anode sub-layer of 120 nm Ag, and a third anode sub-layer of 10 nm ITO was cut to a size of 25 mm x 25 mm x 0.7 mm, ultrasonically washed with water for 60 minutes and then with isopropanol for 20 minutes. The liquid film was removed in a nitrogen stream, followed by plasma treatment, to prepare the anode layer. The plasma treatment was performed in nitrogen atmosphere or in an atmosphere comprising 98 vol.-% nitrogen and 2 vol.-% oxygen.

Then, a hole injection layer (HIL) having a thickness of 10 nm is formed on the anode layer by co-depositing F3 (N-([1,1'-biphenyl]-4-yl)-9,9-dimethyl-N-(4-(9-phenyl-9H-carbazol-3-yl)phenyl)-9H-fluoren-2-amine) or CuPC (cf. the description of the tables below) and a metal salt or metal complex or comparative example according to Table 3.

Then, a first hole transport layer (HTL1) having a thickness of 27 nm is formed on the HIL by depositing F3 (N-([1,1'-biphenyl]-4-yl)-9,9-dimethyl-N-(4-(9-phenyl-9H-carbazol-3-yl)phenyl)-9H-fluoren-2-amine).

Then, a first electron blocking layer (EBL1) having a thickness of 5 nm is formed on the HTL1 by depositing N-([1,1'-biphenyl]-4-yl)-9,9-diphenyl-N-(4-(triphenylsilyl)phenyl)-9H-fluoren-2-amine.

Then, a first emission layer (EML1) having a thickness of 20 nm is formed on the EBL1 by co-depositing 97 vol.-% H09 (Sun Fine Chemicals, Korea) as EML host and 3 vol.-% BD200 (Sun Fine Chemicals, Korea) as fluorescent blue dopant.

Then, a first hole blocking layer (HBL1) having a thickness of 5 nm is formed on the first emission layer by depositing 2-(3'-(9,9-dimethyl-9H-fluoren-2-yl)-[1,1'-biphenyl]-3-yl)-4,6-diphenyl-1,3,5-triazine.

Then, a first electron transport layer (ETL1) having a thickness of 20 nm is formed on the first emission layer by co-depositing 4'-(4-(4-(4,6-diphenyl-1,3,5-triazin-2-yl)phenyl)naphthalen-1-yl)-[1,1'-biphenyl]-4-carbonitrile and LiQ in a ratio of 50:50 wt.-%.

Then, the n-CGL having a thickness of 10 nm is formed on the ETL by co-depositing 99 vol.-% 2,2'-(1,3-Phenylene)bis[9-phenyl-1,10-phenanthroline] and 1 vol.-% Yb.

Then, the p-CGL having a thickness of 10 nm is formed on the n-CGL by co-depositing F3 (N-([1,1'-biphenyl]-4-yl)-9,9-dimethyl-N-(4-(9-phenyl-9H-carbazol-3-yl)phenyl)-9H-fluoren-2-amine) as a matrix compound and dopant compound. The composition of the p-CGL can be seen in Table 3.

Then, a second hole transport layer (HTL2) having a thickness of 24 nm is formed on the p-CGL by depositing F3 (N-([1,1'-biphenyl]-4-yl)-9,9-dimethyl-N-(4-(9-phenyl-9H-carbazol-3-yl)phenyl)-9H-fluoren-2-amine).

Then, a second electron blocking layer (EBL2) having a thickness of 5 nm is formed on the HTL2 by depositing N-([1,1'-biphenyl]-4-yl)-9,9-diphenyl-N-(4-(triphenylsilyl)phenyl)-9H-fluoren-2-amine.

Then, a second emission layer (EML2) having a thickness of 20 nm is formed on the EBL2 by co-depositing 97 vol.-% H09 (Sun Fine Chemicals, Korea) as EML host and 3 vol.-% BD200 (Sun Fine Chemicals, Korea) as fluorescent blue dopant.

Then, a second hole blocking layer (HBL2) having a thickness of 5 nm is formed on the EML2 by depositing 2-(3'-(9,9-dimethyl-9H-fluoren-2-yl)-[1,1'-biphenyl]-3-yl)-4,6-diphenyl-1,3,5-triazine.

Then, a second electron transport layer (ETL2) having a thickness of 30 nm is formed on the HBL by co-depositing 4'-(4-(4-(4,6-diphenyl-1,3,5-triazin-2-yl)phenyl)naphthalen-1-yl)-[1,1'-biphenyl]-4-carbonitrile and LiQ in a ratio of 50:50 wt.-%.

Then, an electron injection layer (EIL) having a thickness of 2 nm is formed on the ETL2 by depositing Yb.

Then, the cathode layer having a thickness of 13 nm is formed on the EIL by co-depositing Ag:Mg (90:10 vol.-%) at a rate of 0.01 to 1 Å/s at 10⁻⁷ mbar.

Then, a capping layer having a thickness of 75 nm is formed on the cathode layer by depositing compound F3 (N-([1,1'-biphenyl]-4-yl)-9,9-dimethyl-N-(4-(9-phenyl-9H-carbazol-3-yl)phenyl)-9H-fluoren-2-amine).

The OLED stack is protected from ambient conditions by encapsulation of the device with a glass slide. Thereby, a cavity is formed, which includes a getter material for further protection.

### OLED containing a hole injection layer but no charge generation layer as comparative example

For the top emission OLED devices, a substrate with dimensions of 150 mm x 150 mm x 0.7 mm was ultrasonically cleaned with 2% aqueous solution of Deconex FPD 211 for 7 minutes and then pure water for 5 minutes, and dried for 15 minutes in a spin dryer. Subsequently, Ag was deposited as anode at a pressure of 10⁻⁵ to 10⁻⁷ mbar on the substrate.

Then, N-({[1,1-'biphenyl]-4-yl)-9,9,dimethyl-N-(4-(9-phenyl-9H-carbazol-3-yl)phenyl)-9H-fluoren-2-amine} (compound F3, cf. above) or CuPC, cf. the description below and compound of formula (II) or a comparative compound according to Table 1 were vacuum deposited on the anode, to form a HIL having a thickness of 10 nm. The amount of compound of formula (II) in the HIL can be seen in Table 4.

Then, N-({[1,1-'biphenyl]-4-yl)-9,9,dimethyl-N-(4-(9-phenyl-9H-carbazol-3-yl)phenyl)-9H-fluoren-2-amine} was vacuum deposited on the HIL, to form a first HTL having a thickness of 128 nm.

Then N-([1,1'-biphenyl]-4-yl)-9,9-diphenyl-N-(4-triphenylsilyl)phenyl)-9H-fluoren-2-amine (CAS 1613079-70-1) was vacuum deposited on the HTL, to form an electron blocking layer (EBL) having a thickness of 5 nm.

Then 97 vol.-% H09 (Sun Fine Chemicals, Korea) as EML host and 3 vol.-% BD200 (Sun Fine Chemicals, Korea) as fluorescent blue dopant were deposited on the EBL, to form a first blue-emitting EML with a thickness of 20 nm.

Then the hole blocking layer is formed with a thickness of 5 nm by depositing 2-(3'-(9,9-dimethyl-9H-fluoren-2-yl)-[1,1'-biphenyl]-3-yl)-4,6-diphenyl-1,3,5-triazine on the emission layer.

Then, the electron transporting layer (ETL) having a thickness of 31 nm is formed on the hole blocking layer by depositing 50 wt.-% 4'-(4-(4-(4,6-diphenyl-1,3,5-triazin-2-yl)phenyl)naphthalen-1-yl)-[1,1'-biphenyl]-4-carbonitrile and 50 wt.-% LiQ.

Then Yb was evaporated at a rate of 0.01 to 1 Å/s at 10⁻⁷ mbar to form an electron injection layer with a thickness of 2 nm on the electron transporting layer.

Ag/Mg (90:10 vol%) is evaporated at a rate of 0.01 to 1 Å/s at 10⁻⁷ mbar to form a cathode with a thickness of 13 nm.

Then, N-({[1,1-'biphenyl]-4-yl)-9,9,dimethyl-N-(4-(9-phenyl-9H-carbazol-3-yl)phenyl)-9H-fluoren-2-amine} was vacuum deposited on the cathode layer to form a capping layer with a thickness of 75 nm.

The OLED stack is protected from ambient conditions by encapsulation of the device with a glass slide. Thereby, a cavity is formed, which includes a getter material for further protection.

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/m² using an Instrument Systems CAS-140CT array spectrometer (calibrated by Deutsche Akkreditierungsstelle (DAkkS)) for each of the voltage values. The cd/A efficiency at 15 mA/cm² is determined by interpolating the luminance-voltage and current-voltage characteristics, respectively.

In bottom emission devices, the emission is predominately Lambertian and quantified in percent external quantum efficiency (EQE). To determine the efficiency EQE in % the light output of the device is measured using a calibrated photodiode at 15 mA/cm².

In top emission devices, the emission is forward directed, non-Lambertian and also highly dependent on the mirco-cavity. Therefore, the efficiency EQE will be higher compared to bottom emission devices. To determine the efficiency EQE in % the light output of the device is measured using a calibrated photodiode at 15 mA/cm².

Lifetime LT of the device is measured at ambient conditions (20°C) and 30 mA/cm², using a Keithley 2400 sourcemeter, and recorded in hours.

The brightness of the device is measured using a calibrated photo diode. The lifetime LT is defined as the time till the brightness of the device is reduced to 97 % of its initial value.

The increase in operating voltage ΔU is used as a measure of the operational voltage stability of the device.

This increase is also determined during the LT measurement and by subtracting the operating voltage after 1 hour after the start of operation of the device from the operating voltage after 100 hours. $ΔU = \left[\left.U100 h\right)-U\left(1h\right)\right]$

The smaller the value of ΔU the better is the operating voltage stability.

### Technical Effect of the invention

### Table 1: Calculated LUMO of compounds

In the following the calculated LUMO levels of several compounds of formula (II) as well as comparative compounds are seen:

**Table 1: LUMOs of several selected compounds of formula (II)**

| **Compound** | **Structure** | **LUMO** |
|---|---|---|
| | | DFT |
| | | B3LYP/def2-TZVP |
| WO3 | *WO₃* | *-5.12* |
| CNHAT | 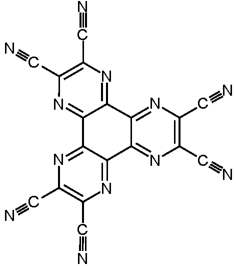 | *-4.86* |
| M1 | 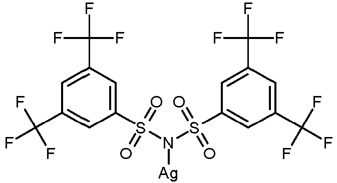 | *-3.64* |
| M2 | 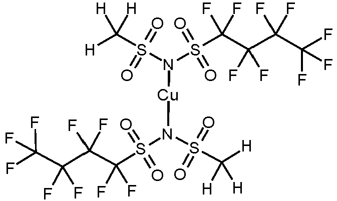 | *-6.03* |
| M3 | 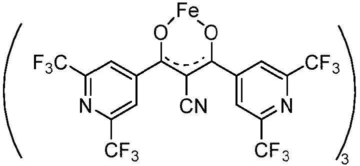 | *-6.02* |
| M4 | 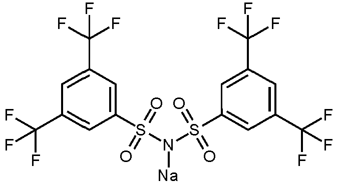 | *-2.23* |
| M5 | 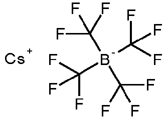 | *-1.68* |
| M6 | 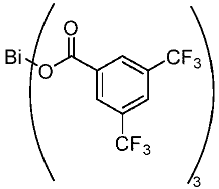 | -2.68 |
| M7 | 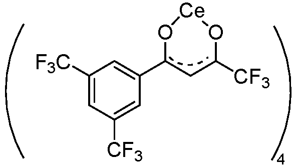 | -4.86 |
| M8 | 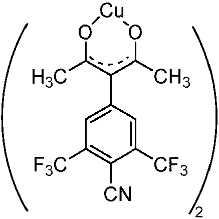 | -3.82 |
| M9 | 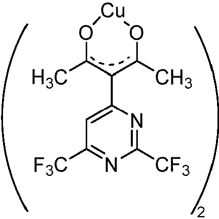 | -3.83 |
| M10 | 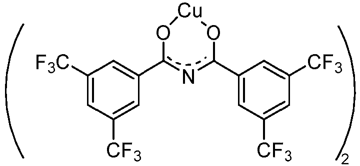 | -4.44 |
| M11 | 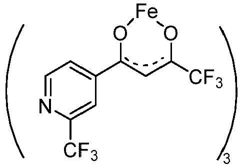 | -4.93 |
| M12 | 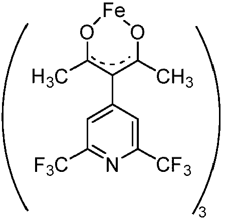 | -4.13 |
| M13 | 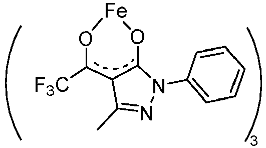 | -4.41 |
| M14 | 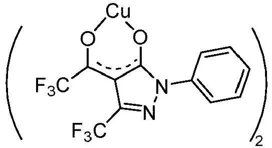 | -4.69 |
| M15 | 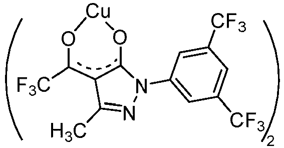 | -4.70 |
| M16 | 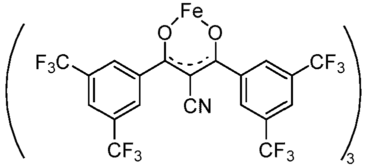 | -5.28 |
| M17 | 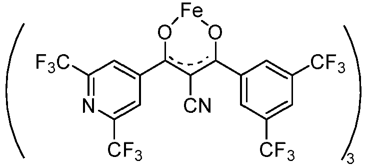 | -5.64 |

In the following Table 2 the LUMOs of several compounds of formula (I) are shown.

**Table 2: LUMOs of several selected compounds of formula (I)**

| Compound | Ar¹ of A¹ | Ar² of A² | Ar³ of A³ | LUMO |
|---|---|---|---|---|
| | | | | [eV] |
| | | | | DFT |
| | | | | B3LYP/6-31G* |
| BR1 | 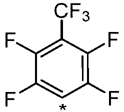 | 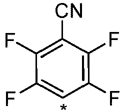 | 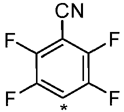 | -5.10 |
| BR2 | 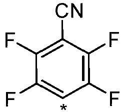 | 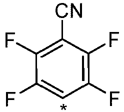 | 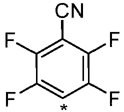 | -5.19 |
| BR3 | 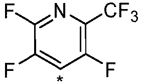 | 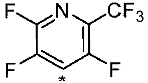 | 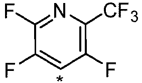 | -5.29 |
| BR4 | 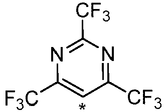 | 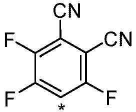 | 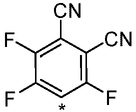 | -5.44 |
| BR5 | 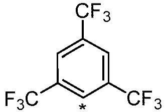 | 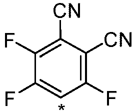 | 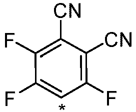 | -5.22 |
| BR6 | 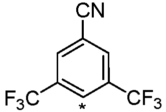 | 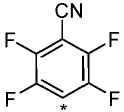 | 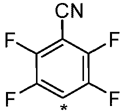 | -5.07 |
| BR7 | 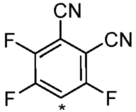 | 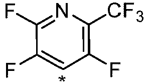 | 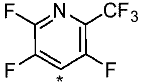 | -5.34 |
| BR8 | 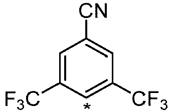 | 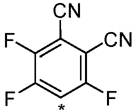 | 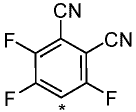 | -5.32 |
| BR9 | 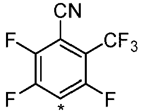 | 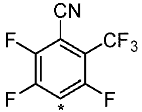 | 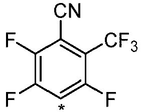 | -5.32 |
| BR10 | 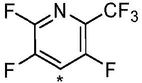 | 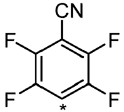 | 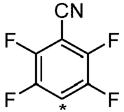 | -5.23 |
| BR11 | 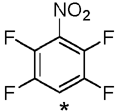 | 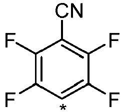 | 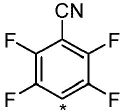 | -5.21 |
| BR12 | 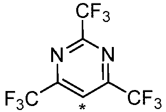 | 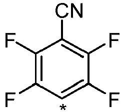 | 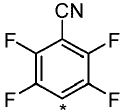 | -5.19 |
| BR13 | 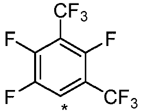 | 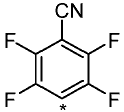 | 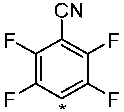 | -5.10 |
| BR14 | 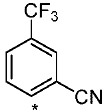 | 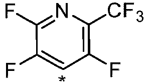 | 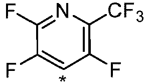 | -5.12 |

Table 3 shows the setup and performance of several comparative (C-1 to C-5) and inventive examples (I-1 to I-20). In all examples, N-({[1,1-'biphenyl]-4-yl)-9,9,dimethyl-N-(4-(9-phenyl-9H-carbazol-3-yl)phenyl)-9H-fluoren-2-amine} was used as p-HIL hole transport matrix compound, except for C-4 and C-5 where it was CuPC:

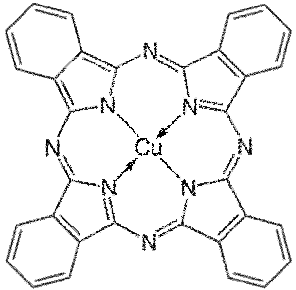

The chemical formula of CNHAT is as follows:

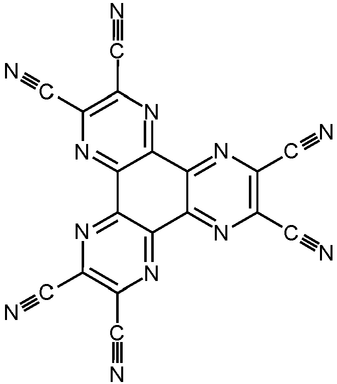

All inventive devices exhibit a lower operational voltage and at the same time a current efficiency in consideration of the cavity CIEY higher than the comparative devices.

**Table 3: Setup and performance of several comparative and inventive examples**

| **No.** | **p-HIL dopant** | **p-HIL dopant conc. [mol%]** | **p-CGL** | **p-CGL dopant conc. [mol%]** | **CIEy** | **Voltage at 15mA/cm² [V]** | **Rel. Voltage** | **CEff/CIEy at 15mA/cm² [cd/A]** | **Rel. Voltage Ceff/CIEy** | **LT97 at 30mA/cm² [h]** | **Vrise (1-100h) at 30mA/cm² [V]** |
|---|---|---|---|---|---|---|---|---|---|---|---|
| C-1 | WO₃ | 15 | BR1 | 7 | 0.050 | 7.63 | 100% | 251 | 100% | 104 | 0.120 |
| C-2 | WO₃ | 7 | BR1 | | 0.052 | 7.65 | 100% | 251 | 100% | 97 | 0.109 |
| C-3 | WO₃ | 12 | BR1 | | 0.051 | 7.65 | 100% | 251 | 100% | 96 | 0.127 |
| C-4 | CNHAT | 5 | BR1 | 7 | 0.040 | 10.16 | 133% | 203 | 81% | 2 | 0.218 |
| C-5 | CNHAT | 7 | BR1 | 7 | 0.042 | 9.95 | 130% | 200 | 80% | 2 | 0.262 |
| I-1 | M1 | 3 | BR1 | 7 | 0.044 | 7.56 | 99% | 262 | 104% | 95 | 0.080 |
| I-2 | M2 | 3 | BR1 | 7 | 0.044 | 7.58 | 99% | 261 | 104% | 92 | 0.121 |
| I-3 | M13 | 7 | BR1 | 7 | 0.045 | 7.60 | 99% | 256 | 102% | 100 | 0.130 |
| I-4 | M4 | 3 | BR1 | 7 | 0.045 | 7.58 | 99% | 260 | 103% | 87 | 0.122 |
| I-5 | M7 | 3 | BR1 | 7 | 0.047 | 7.58 | 99% | 254 | 101% | 104 | 0.110 |
| I-6 | M7 | 3 | BR2 | 7 | 0.047 | 7.52 | 98% | 254 | 101% | 104 | 0.106 |
| I-7 | M7 | 3 | BR4 | 7 | 0.047 | 7.51 | 98% | 254 | 101% | 104 | 0.111 |
| I-8 | M7 | 3 | BR5 | 7 | 0.048 | 7.52 | 98% | 254 | 101% | 104 | 0.112 |
| I-9 | M16 | 3 | BR1 | 7 | 0.047 | 7.58 | 99% | 257 | 102% | 97 | 0.110 |
| I-10 | M16 | 3 | BR2 | 7 | 0.047 | 7.48 | 98% | 257 | 102% | 101 | 0.101 |
| I-11 | M16 | 3 | BR5 | 7 | 0.047 | 7.52 | 98% | 257 | 102% | 101 | 0.109 |
| I-12 | M16 | 3 | BR4 | 7 | 0.046 | 7.49 | 98% | 257 | 102% | 101 | 0.110 |
| I-13 | M5 | 7 | BR1 | 7 | 0.046 | 7.58 | 99% | 257 | 102% | 106 | 0.114 |
| I-14 | M6 | 7 | BR1 | 7 | 0.043 | 7.59 | 99% | 263 | 105% | 108 | 0.215 |
| I-15 | M8 | 7 | BR1 | 7 | 0.045 | 7.60 | 99% | 262 | 104% | 145 | 0.370 |
| I-16 | M9 | 7 | BR1 | 7 | 0.048 | 7.60 | 99% | 255 | 102% | 149 | 0.574 |
| I-17 | M10 | 7 | BR1 | 7 | 0.046 | 7.61 | 99% | 259 | 103% | 200 | 0.600 |
| I-18 | M11 | 7 | BR1 | 7 | 0.044 | 7.57 | 99% | 263 | 105% | 154 | 0.595 |
| I-19 | M12 | 7 | BR1 | 7 | 0.043 | 7.58 | 99% | 262 | 105% | 117 | 0.956 |
| I-20 | M14 | 7 | BR1 | 7 | 0.047 | 7.60 | 99% | 256 | 102% | 104 | 0.124 |

In order to further illustrate the effect of the present invention, several single-stack devices were investigated (the build- up was described above).

Table 4 shows shows the setup and performance of these devices (all comparative, C6-C26).

In all examples, N-({[1,1-'biphenyl]-4-yl)-9,9,dimethyl-N-(4-(9-phenyl-9H-carbazol-3-yl)phenyl)-9H-fluoren-2-amine} was used as p-HIL hole transport matrix compound, except for C-8 where it was CuPC.

**Table 4: Setup and performance of several comparative single-stack devices.**

| **No.** | **p-HIL dopant** | **p-HIL dopant conc. [mol%]** | **CIEy** | **CEff/CIEy at 15mA/cm² [cd/A]** | |
|---|---|---|---|---|---|
| C-6 | WO₃ | 6 | 0.044 | 151 | 100% |
| C-7 | WO₃ | 11 | 0.044 | 151 | 100% |
| C-8 | CNHAT | 7 | Device did not work | | |
| C-9 | M2 | 3 | 0.044 | 150 | 99% |
| C-10 | M2 | 4 | 0.043 | 150 | 99% |
| C-11 | M1 | 3 | 0.046 | 152 | 100% |
| C-12 | M1 | 5 | 0.047 | 151 | 100% |
| C-13 | M14 | 7 | 0.044 | 152 | 100% |
| C-14 | M6 | 8 | 0.045 | 150 | 99% |
| C-15 | M4 | 5 | 0.044 | 152 | 100% |
| C-16 | M16 | 3 | 0.044 | 152 | 100% |
| C-17 | M7 | 3 | 0.044 | 150 | 99% |
| C-18 | M5 | 6 | 0.044 | 152 | 100% |
| C-19 | M11 | 8 | 0.045 | 149 | 98% |
| C-20 | M12 | 6 | 0.044 | 151 | 100% |
| C-21 | M8 | 5 | 0.044 | 150 | 99% |
| C-22 | M8 | 9 | 0.044 | 151 | 100% |
| C-23 | M9 | 5 | 0.044 | 151 | 100% |
| C-24 | M10 | 7 | 0.046 | 149 | 98% |
| C-25 | M13 | 8 | 0.044 | 150 | 99% |
| C-26 | M6 | 6 | 0.044 | 151 | 100% |

It is apparent that there is no real change when using compounds of formula (II) instead of comparative compounds..

## Claims

1. An organic electroluminescent device (100) comprising an anode layer (120), a cathode layer (190), a first emission layer (145), second emission layer (245), a hole injection layer (130), and a first charge generation layer (160);
wherein the hole injection layer (130) is in direct contact to the anode layer;
wherein the hole injection layer (130) comprises a first hole transport matrix compound and a compound of formula (II) which is a metal compound selected from a metal salt or a metal complex comprising a metal cation and at least one monoanion consisting of at least 20 covalently bound atoms and/or at least one monoanionic ligand consisting of at least 20 covalently bound atoms;
wherein the first charge generation layer (160) is arranged between the first emission layer (145) and the second emission layer (245);
wherein the first charge generation layer (160) comprises a first n-type charge generation layer (161) and a first p-type charge generation player (162);
wherein the first n-type charge generation layer (161) is closer to the anode layer (120) than the first p-type charge generation player (162);
wherein the first n-type charge generation layer (161) comprises a metal dopant and an matrix compound,
**characterized in that** first p-type charge generation layer (162) comprises a second hole transport matrix compound and a compound of formula (I); 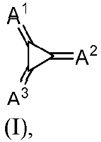
wherein in formula (I)
- A¹ is independently selected from a group of formula (Ia) 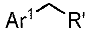 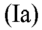
wherein Ar¹ is independently selected from substituted or unsubstituted C₆ to C₃₆ aryl, and substituted or unsubstituted C₂ to C₃₆ heteroaryl;
wherein for the case that Ar¹ is substituted, one or more of the substituents are independently selected from the group consisting of D, an electron-withdrawing group, halogen, Cl, F, CN, - NO₂, substituted or unsubstituted C₁ to C₈ alkyl, partially fluorinated C₁ to C₈ alkyl, perfluorinated C₁ to C₈ alkyl, substituted or unsubstituted C₁ to C₈ alkoxy, partially fluorinated C₁ to C₈ alkoxy, perfluorinated C₁ to C₈ alkoxy, substituted or unsubstituted C₆ to C₃₀ aryl, and substituted or unsubstituted C₆ to C₃₀ heteroaryl and;
wherein the one or more substituents of C₆ to C₃₀ aryl, C₆ to C₃₀ heteroaryl, C₁ to C₈ alkyl, C₁ to C₈ alkoxy are independently selected from D, an electron-withdrawing group, halogen, Cl, F, CN, -NO₂, partially fluorinated C₁ to C₈ alkyl, perfluorinated C₁ to C₈ alkyl, partially fluorinated C₁ to C₈ alkoxy, perfluorinated C₁ to C₈ alkoxy;
- A² is independently selected from a group of formula (Ib) 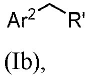
wherein Ar² is independently selected from substituted or unsubstituted C₆ to C₃₆ aryl, and substituted or unsubstituted C₂ to C₃₆ heteroaryl;
wherein for the case that Ar² is substituted, one or more of the substituents are independently selected from the group consisting of D, an electron-withdrawing group, halogen, Cl, F, CN, - NO₂, substituted or unsubstituted C₁ to C₈ alkyl, partially fluorinated C₁ to C₈ alkyl, perfluorinated C₁ to C₈ alkyl, substituted or unsubstituted C₁ to C₈ alkoxy, partially fluorinated C₁ to C₈ alkoxy, perfluorinated C₁ to C₈ alkoxy, substituted or unsubstituted C₆ to C₃₀ aryl, and substituted or unsubstituted C₆ to C₃₀ heteroaryl and;
wherein the one or more substituents of C₆ to C₃₀ aryl, C₆ to C₃₀ heteroaryl, C₁ to C₈ alkyl, C₁ to C₈ alkoxy are independently selected from D, an electron-withdrawing group, halogen, Cl, F, CN, -NO₂, partially fluorinated C₁ to C₈ alkyl, perfluorinated C₁ to C₈ alkyl, partially fluorinated C₁ to C₈ alkoxy, perfluorinated C₁ to C₈ alkoxy;
- A³ is independently selected from a group of formula (Ic) 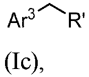
wherein Ar³ is independently selected from substituted or unsubstituted C₆ to C₃₆ aryl, and substituted or unsubstituted C₂ to C₃₆ heteroaryl;
wherein for the case that Ar³ is substituted, one or more of the substituents are independently selected from the group consisting of D, an electron-withdrawing group, halogen, Cl, F, CN, -NO₂, substituted or unsubstituted C₁ to C₈ alkyl, partially fluorinated C₁ to C₈ alkyl, perfluorinated C₁ to C₈ alkyl, substituted or unsubstituted C₁ to C₈ alkoxy, partially fluorinated C₁ to C₈ alkoxy, perfluorinated C₁ to C₈ alkoxy, substituted or unsubstituted C₆ to C₃₀ aryl, and substituted or unsubstituted C₆ to C₃₀ heteroaryl and;
wherein the one or more substituents of C₆ to C₃₀ aryl, C₆ to C₃₀ heteroaryl, C₁ to C₈ alkyl, C₁ to C₈ alkoxy are independently selected from D, an electron-withdrawing group, halogen, Cl, F, CN, -NO₂, partially fluorinated C₁ to C₈ alkyl, perfluorinated C₁ to C₈ alkyl, partially fluorinated C₁ to C₈ alkoxy, perfluorinated C₁ to C₈ alkoxy;
and wherein in A¹, A², and A³ each R' is independently selected from substituted or unsubstituted C₆ to C₁₈ aryl, C₃ to C₁₈ heteroaryl, electron-withdrawing group, substituted or unsubstituted C₁ to C₈ alkyl, partially fluorinated C₁ to C₈ alkyl, perfluorinated C₁ to C₈ alkyl, halogen, F and CN;
wherein the one or more substituents of C₆ to C₁₈ aryl, C₆ to C_{I8} heteroaryl, C₁ to C₈ alkyl are independently selected from D, an electron-withdrawing group, halogen, Cl, F, CN, -NO₂, partially fluorinated C₁ to C₆ alkyl, perfluorinated C₁ to C₆ alkyl, partially fluorinated C₁ to C₆ alkoxy, perfluorinated C₁ to C₆ alkoxy.

2. The organic electroluminescent device according to claim 1, wherein the compound of formula (II) has a LUMO energy level of ≥ -7.0 eV to ≤-1.5 eV whereby the calculations are performed by applying the hybrid functional B3LYP with the Def2-TZVP basis set with the SDD Effective Core Potentials (ECPs) for the metals in the gas phase as implemented in the program package ORCA Version 5.0.3-f.1 (Department of Theory and Spectroscopy, Max Planck Institute für Kohlenforschung Kaiser Wilhelm Platz 1, 45470 Muelheim/Ruhr, Germany).

3. The organic electroluminescent device of claim 1 or 2, wherein compound of formula (II) comprises at least one monoanion consisting of at least 20 covalently bound atoms and/or at least one monoanionic ligand consisting of at least 20 covalently bound atoms, wherein the monoanion or the monoanionic ligand is presented by L- according to formula (IV) or compound of formula (II) is represented by formula (IIa): 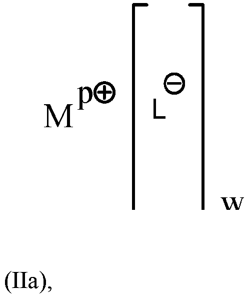 wherein
M is a metal ion;
p is the valency of M;
w is n;
wherein L⁻ can be selected the same or different;
wherein compound of formula (IIa) can optionally comprise an ancillary ligand (AL), which coordinates to the metal cation or the metal cation M^{p+};
wherein L⁻ is represented by 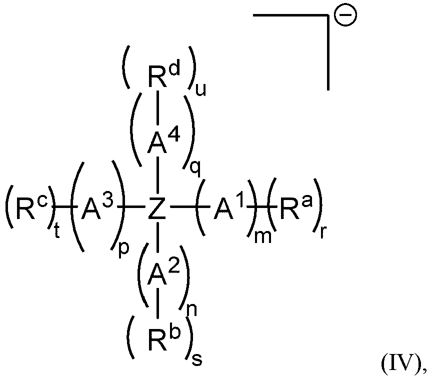
m, n, p, and q are independently selected from 0 or 1;
r, s, t, and u are independently selected from 0 or 1;
at least one of r, s, t, and u is 1;
Z is selected from CR¹, C, O, N, B;
if Z is selected O then n, p, q and are selected from 0 and s, t and u are selected from 0;
if Z is selected from N or CR¹ then p and q are selected from 0, and t and u are selected from 0;
if Z is selected from C then q is selected from 0, and u is selected from 0;
if Z is selected from B then n, m, p, and q are selected from 1, and r, s, t, and u are selected from 1;
A¹, A², A³ and A⁴ are independently selected from C=O, C-O, C=NR², C-NR³, SO, SO₂, or P(=O)R⁴;
wherein Z can form a double bond to A¹, A², A³ and A⁴, if A¹, A², A³ and A⁴ is selected from C-O or C-NR³ and Z is selected from N, O or CR¹, or A¹, A², A³ and A⁴ is selected from C-O or C-NR³ and Z is selected from C_{;}
and wherein optionally two of A¹, A², A³ and A⁴ together can form a substituted or unsubstituted heterocycle or substituted or unsubstituted carbocycle with Z, or wherein optionally one of A¹, A², A³ and A⁴ can form a substituted or unsubstituted heterocycle or substituted or unsubstituted carbocycle with Z
wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl;
R¹ is selected from H, D, electron-withdrawing group, halogen, Cl, F, CN, NO₂, SF₅, isonitrile, ester group, carboxylic group, carbonyl group, acyl group, thio group sulfinyl group, sulfonyl group, phosphine group, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₁ to C₁₂ alkoxy, partially perfluorinated C₁ to C₆ alkoxy, perfluorinated C₁ to C₆ alkoxy, CF₃, substituted or unsubstituted C₆ to C₄₀ aryl, substituted or unsubstituted C₂ to C₄₀ heteroaryl, substituted or unsubstituted C₃ to C₃₀, carbocyclyl, substituted or unsubstituted C₃ to C₃₀ heterocyclyl;
wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N;
R², R³ and R⁴ are independently selected from H, D, electron-withdrawing group, halogen, Cl, F, CN, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, substituted or unsubstituted C₁ to C₆ alkoxy, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₃₀ heteroaryl, substituted or unsubstituted C₃ to C₃₀ carbocyclyl, substituted or unsubstituted C₂ to C₃₀ heterocyclyl, wherein the substituents on R², R³ and R⁴ are independently selected from D, electron-withdrawing group, halogen, Cl, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃;
R^{a}, R^{b}, R^{c} and R^{d} are independently selected from H, D, electron-withdrawing group, halogen, F, Cl, CN, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₆ to C₄₀ aryl, substituted or unsubstituted C₂ to C₃₀ heteroaryl, substituted or unsubstituted carbocyclyl, substituted or unsubstituted C₂ to C₃₀ heterocyclyl, O, S, N, NR⁵, substituted or unsubstituted amine group having 0 to 20 carbon atoms;
wherein the one more substituents on R^{a}, R^{b}, R^{c} and R^{d} are independently selected from electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, partially perfluorinated C₁ to C₆ alkoxy, perfluorinated C₁ to C₆ alkoxy, OCF₃;
wherein R⁵ is selected from substituted or unsubstituted C₆ to C₄₀ aryl, substituted or unsubstituted C₂ to C₄₀ heteroaryl, substituted or unsubstituted C₁ to C₁₂ alkyl, partially perfluorinated C₁ to C₁₂ alkyl, perfluorinated C₁ to C₁₂ alkyl,
wherein the one or more substituents on R⁵ is selected from electron-withdrawing group, halogen, F, CN, NO₂, SF₅, isonitrile, ester group, carboxylic group, carbonyl group, acyl group, thio group sulfinyl group, sulfonyl group, phosphine group, partially fluorinated C₁ to C₁₂ alkyl, perfluorinated C₁ to C₁₂ alkyl, CF3, CF₂CF₃, partially fluorinated C₁ to C₆ alkoxy, perfluorinated C₁ to C₆ alkoxy, OCF₃, OCF₂CCF₃;
preferably at least one of R^{a}, R^{b}, R^{c} and R^{d} is independently selected from substituted or unsubstituted C₆ to C₄₀ aryl, substituted or unsubstituted C₂ to C₄₀ heteroaryl, substituted or unsubstituted C₁ to C₁₂ alkyl, substituted or unsubstituted C₃ to C₃₀ carbocyclyl, substituted or unsubstituted C₂ to C₃₀ heterocyclyl,
wherein the substituents on R^{a}, R^{b}, R^{c} and R^{d} are independently selected from electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃,;
wherein
optionally one of R^{a}, R^{b}, R^{c}, R^{d} can independently from each other form a substituted or unsubstituted heterocycle or substituted or unsubstituted C₃ to C₄₀ carbocycle with R¹,
wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl;
wherein the one or more substituent on the substituent on the heterocycle or carbocyle is independently selected form D, electron-withdrawing group, halogen, F, substituted or unsubstituted C₁ to C₁₂ alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃.

4. The organic electroluminescent device according to any one of claims 1 or 3, wherein the monoanion or the monoanionic ligand L- is selected from (V), (VI), (VII) or (VIII) or (IX): 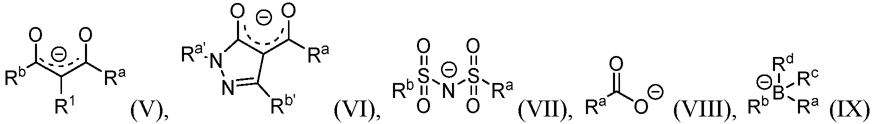 whereby
R^{a'} are independently selected from substituted or unsubstituted C₁ to C₁₂ alkyl,
substituted or unsubstituted C₆ to C₁₉ aryl, substituted or unsubstituted C₂ to C₂₀ heteroaryl, or substituted or unsubstituted 6-membered heteroaryl;
R¹'' is selected from substituted or unsubstituted C₁ to C₁₂ alkyl, substituted or unsubstituted C₆ to C₁₉ aryl, substituted or unsubstituted C₂ to C₂₀ heteroaryl, substituted or unsubstituted 6-membered heteroaryl, or CN;
wherein
at least one of the substituents of the substituted C₁ to C₁₂ alkyl, substituted C₆ to C₁₉ aryl, substituted C₂ to C₂₀ heteroaryl, or substituted 6-membered heteroaryl are independently selected from halogen, Cl, F, CN, partially or perfluorinated C₁ to C₈ alkyl, partially or perfluorinated C₁ to C₈ alkoxy;
wherein in formula (VI)
at least one of R^{a'}, R^{b'} and R^{a} or the group of R^{a'}, R^{b'} and R^{a} comprises at least three atoms selected from the group consisting of halogen, Cl, F or N;
- the remaining Rs are as defined above.

5. The organic electroluminescent device according to claim 4, wherein at least one of Ra, Rb, Rc or Rd or Ra, Rb, Rc and Rd is/are independently selected from D1 to D105: 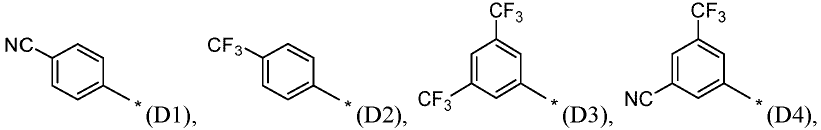 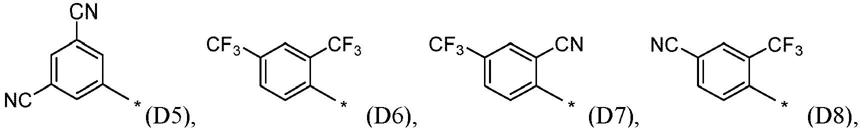 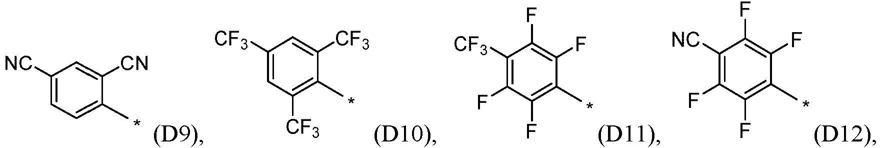 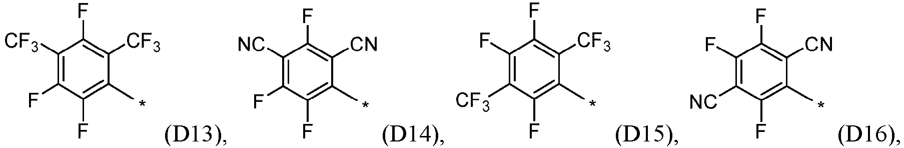 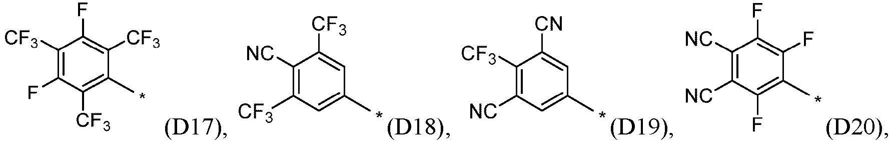 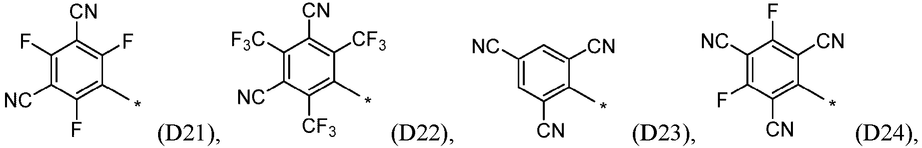 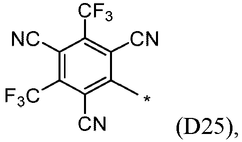 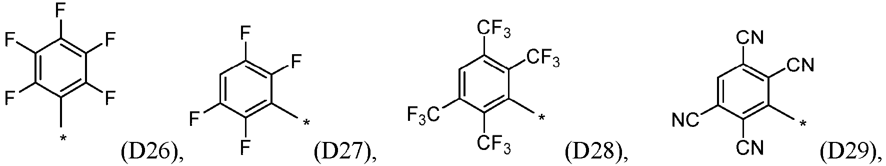 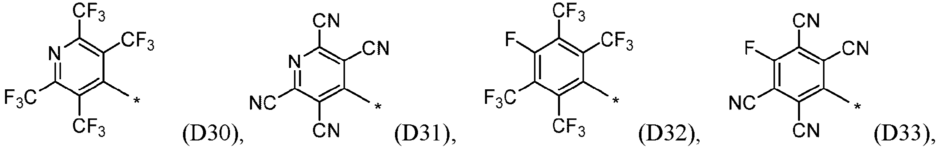 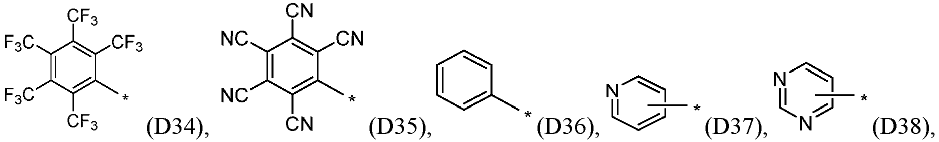 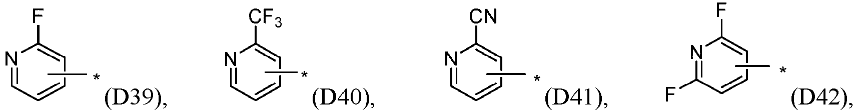 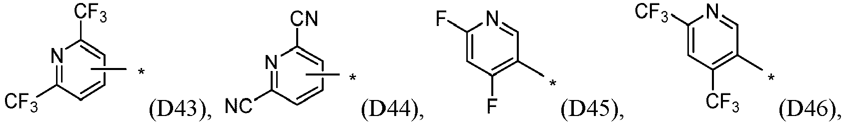 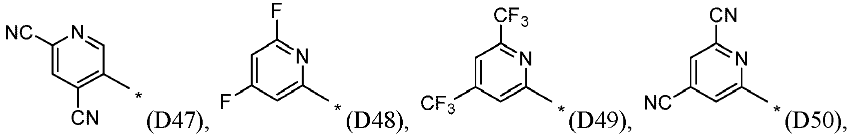 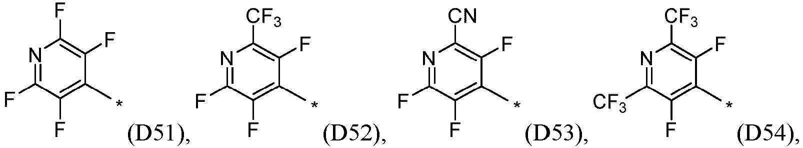 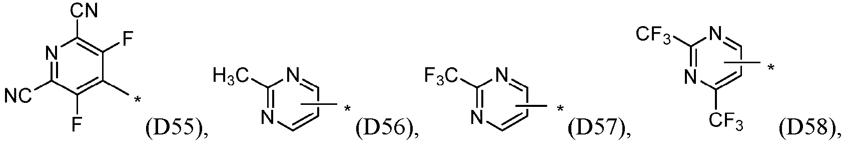 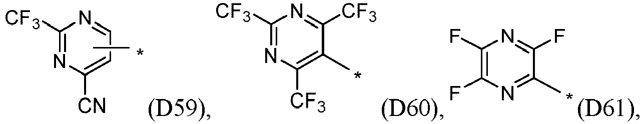 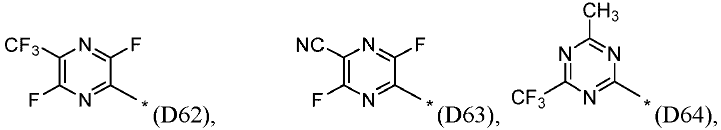 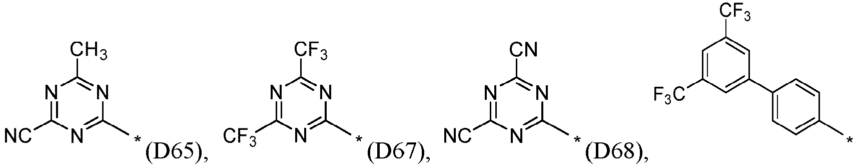 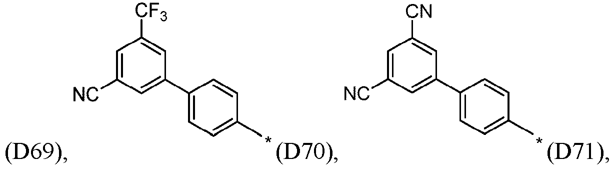 -CF₃ (D72), -C₂F₅ (D73), -C₃F₇ (D74), -CF₂CF₂CF₃ (D75), 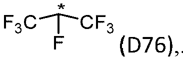 -C₄F₉ (D77), -CF₂CF₂CF₂CF₃ (D78) 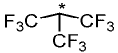 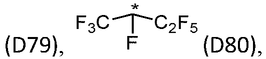 -C₅F₁₁ (D81), -C₆F₁₃ (D82), -CH3 (D83), -C₂H₅ (D84) -CH(CH₃)₂ (D85), -C(CH₃)₃ (D86), 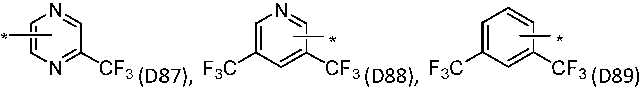 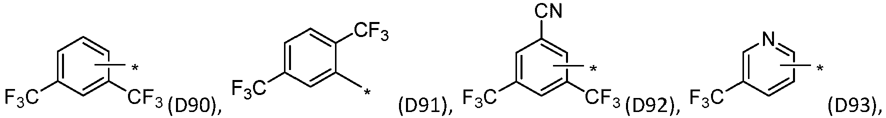 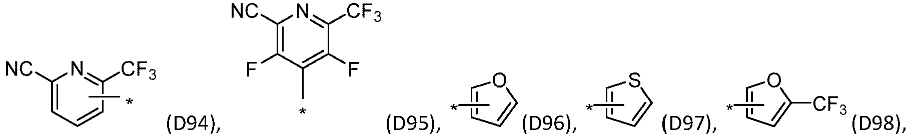 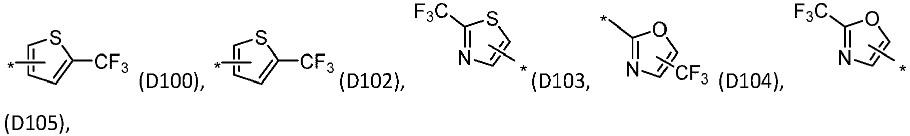 wherein the "*" or "-" denotes the binding position.

6. The organic electroluminescent device according to claim 5, wherein the monoanion or the monoanionic ligand is selected from L1 to L405:

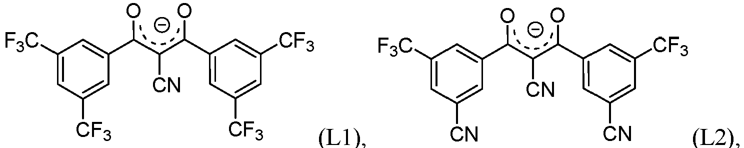

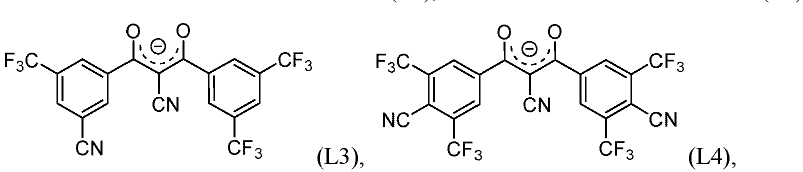

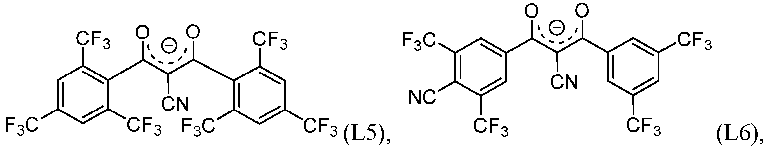

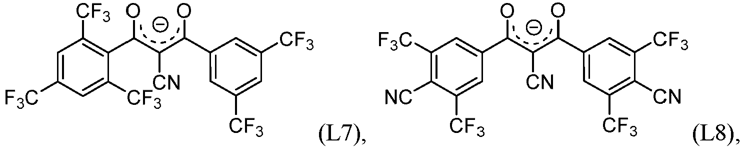

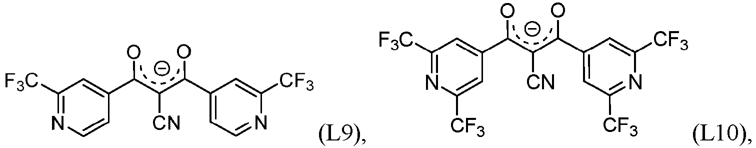

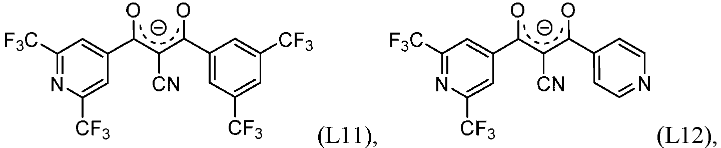

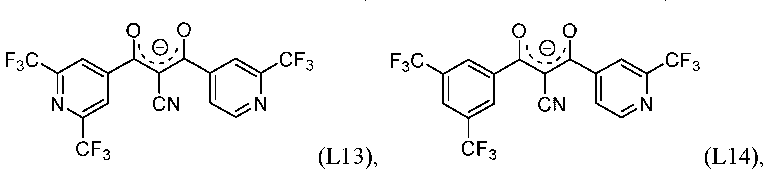

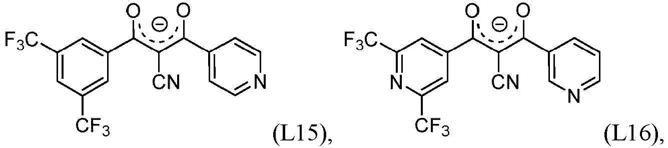

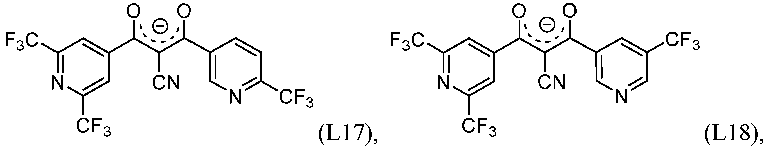

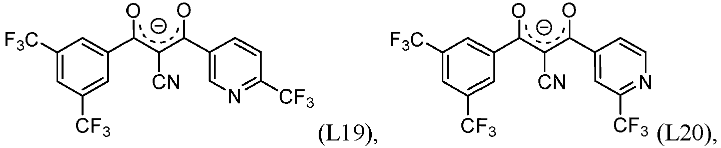

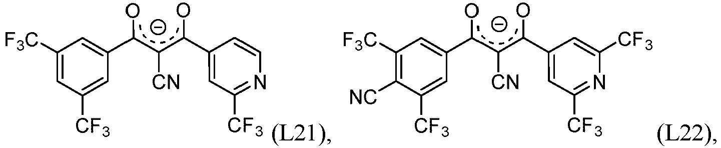

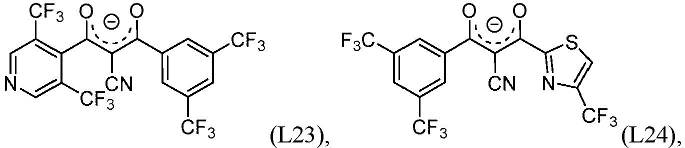

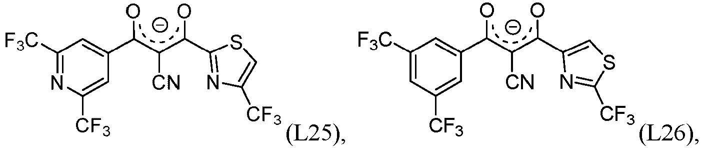

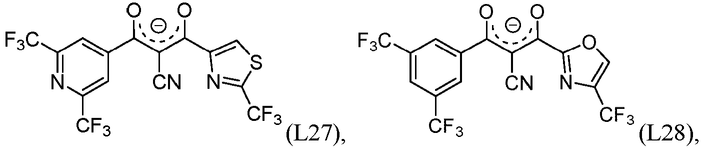

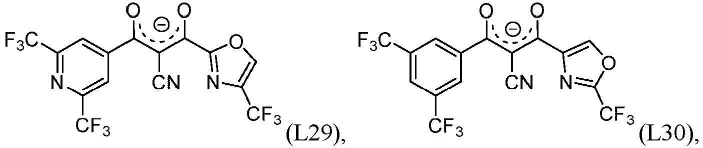

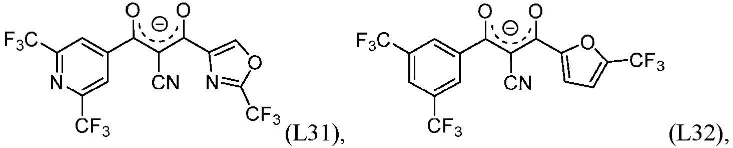

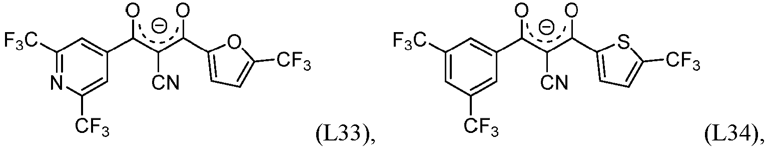

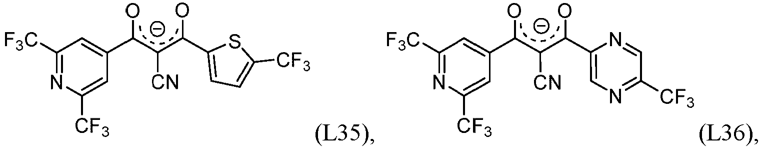

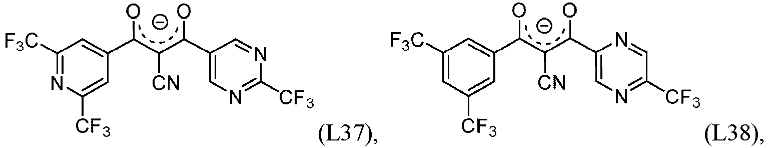

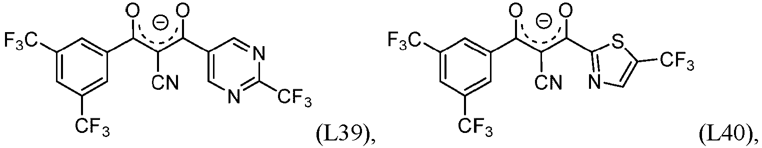

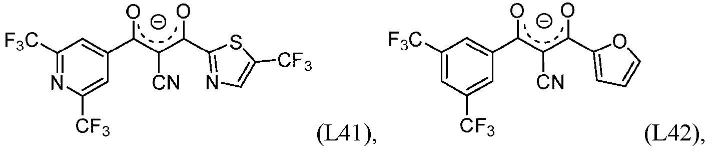

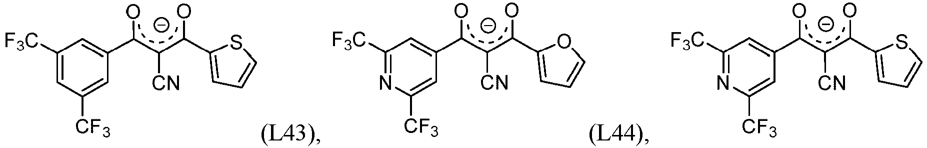

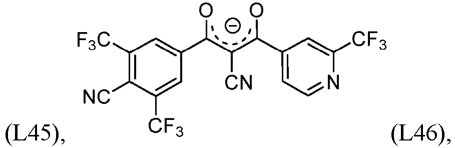

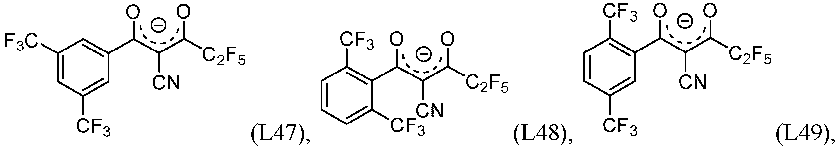

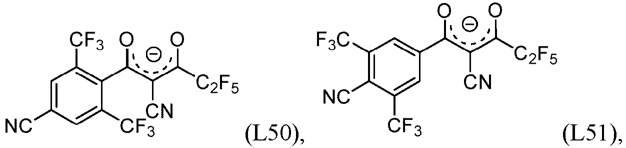

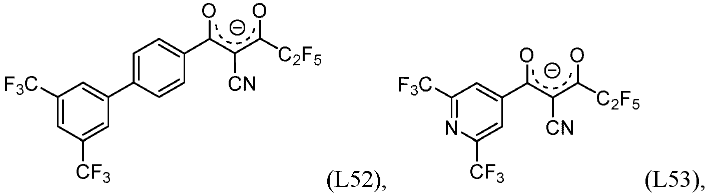

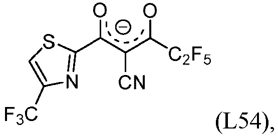

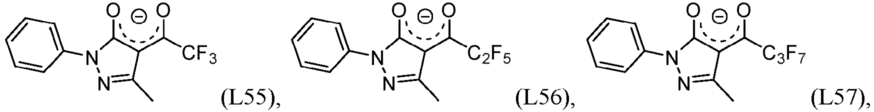

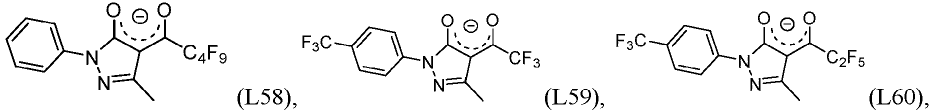

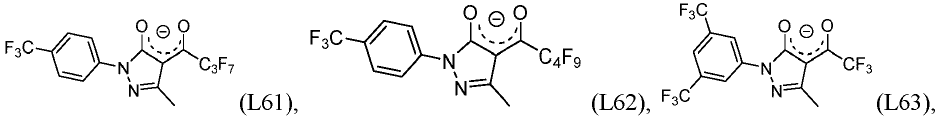

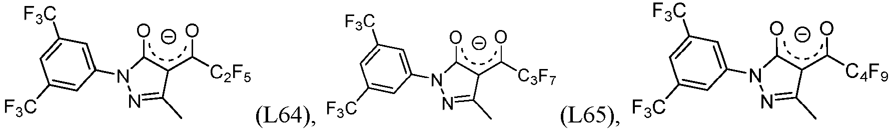

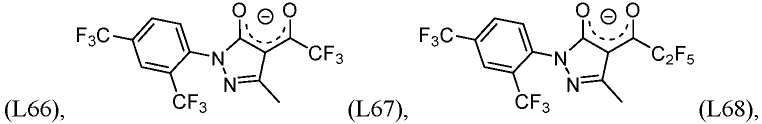

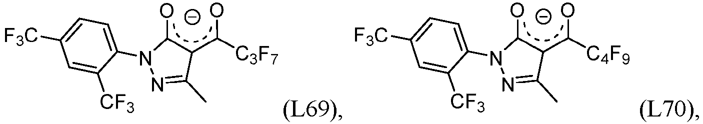

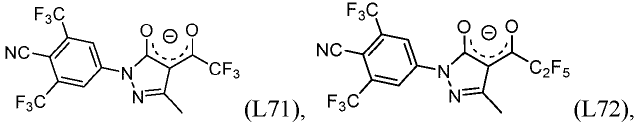

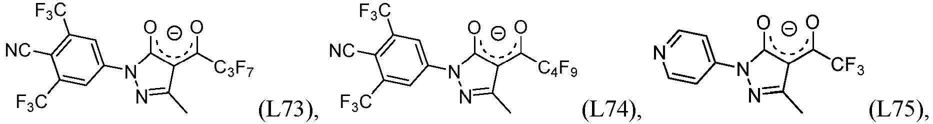

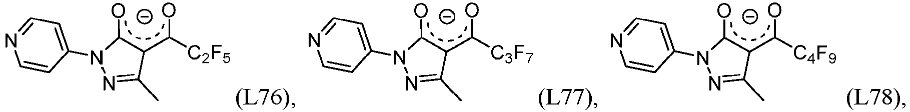

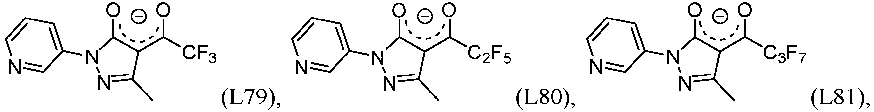

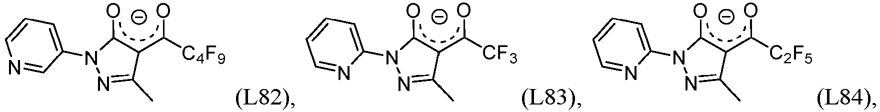

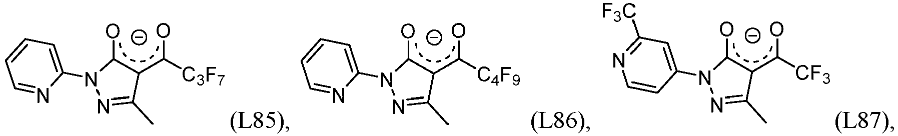

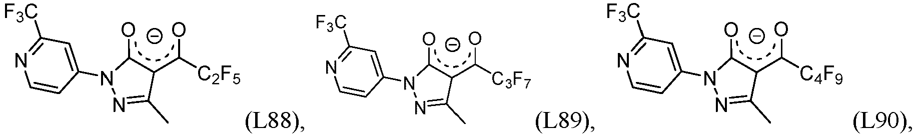

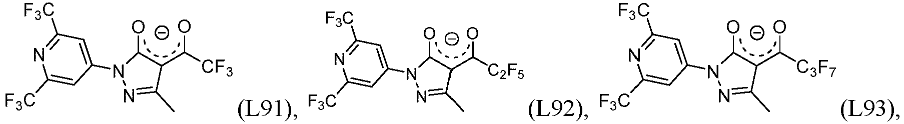

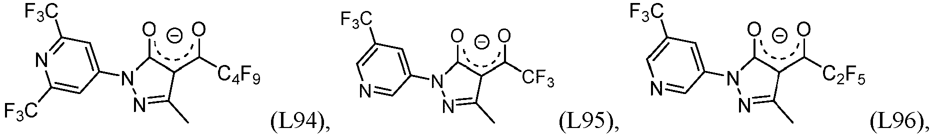

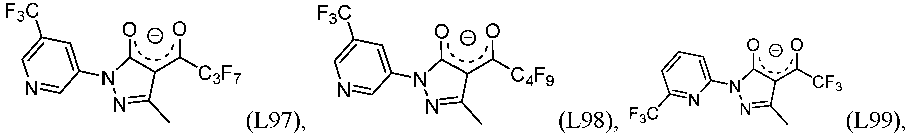

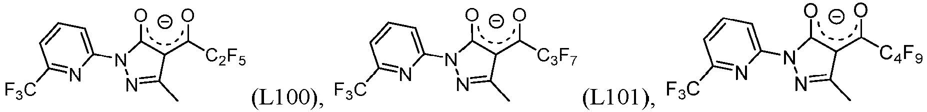

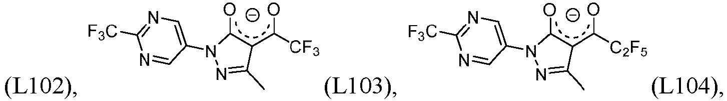

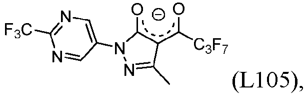

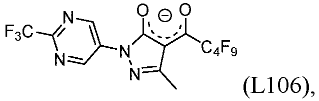

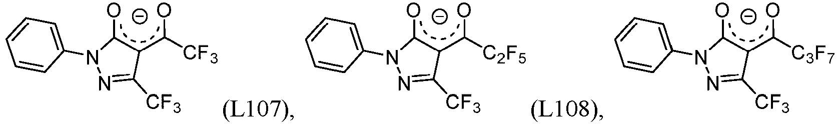

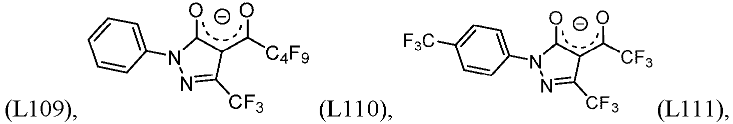

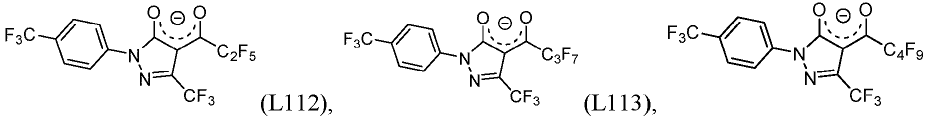

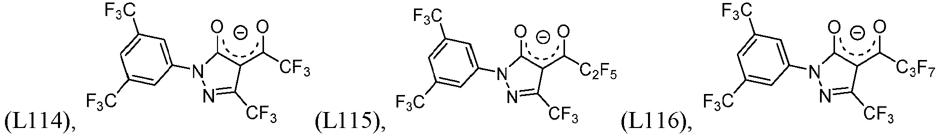

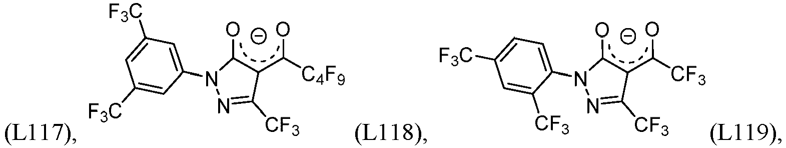

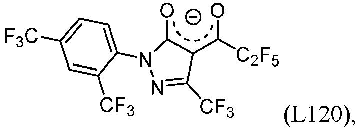

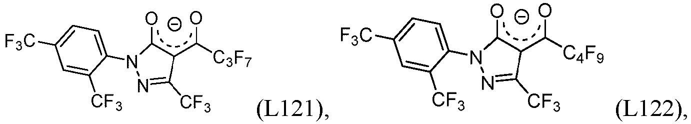

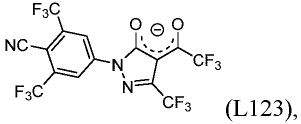

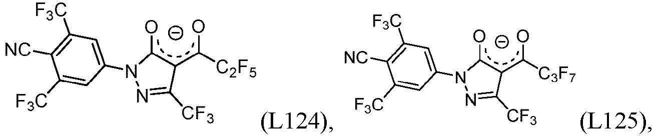

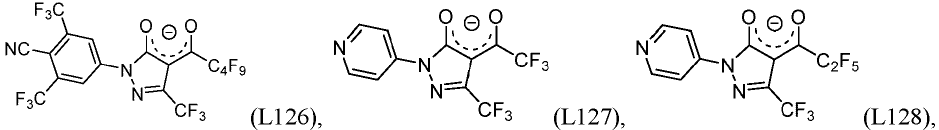

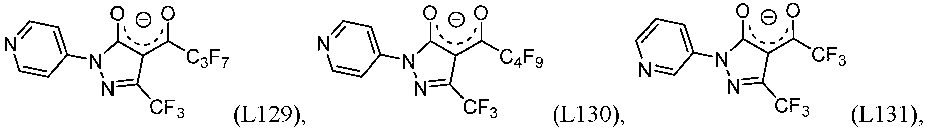

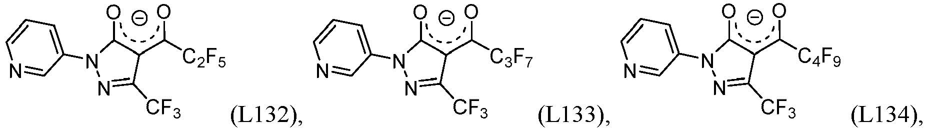

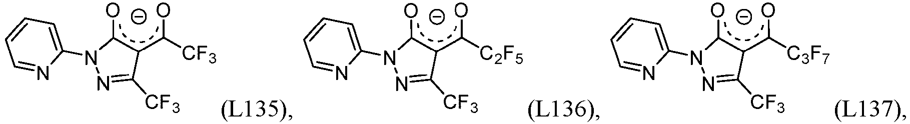

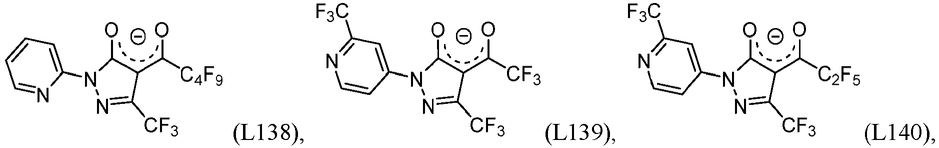

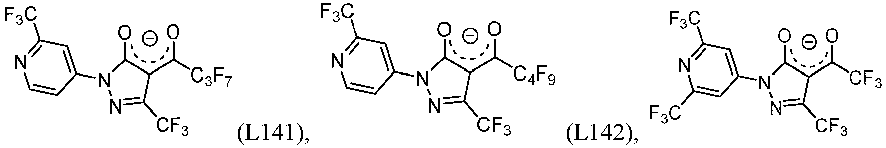

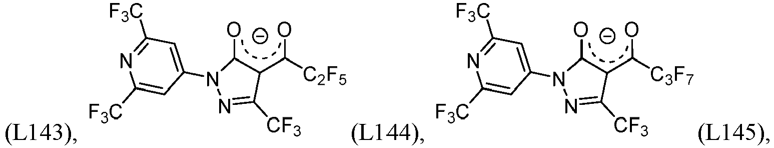

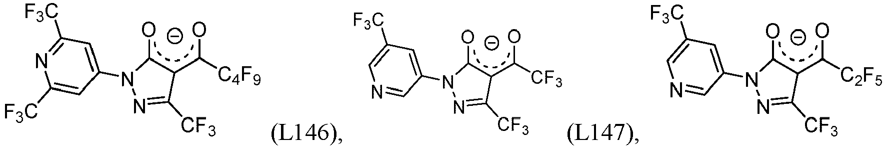

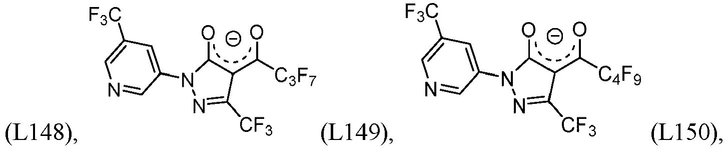

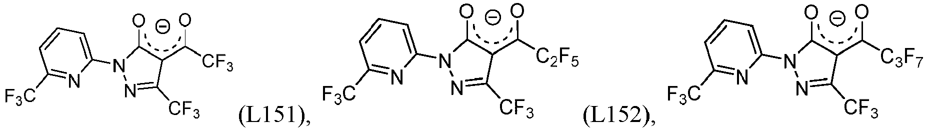

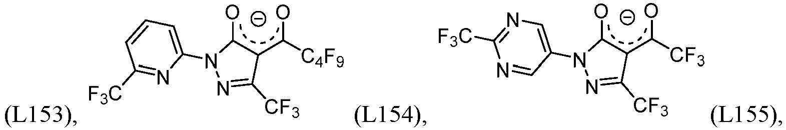

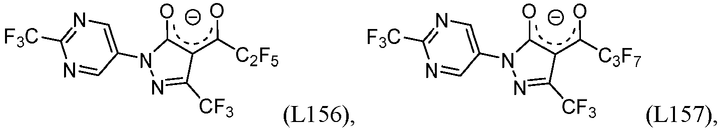

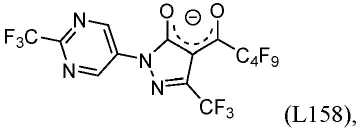

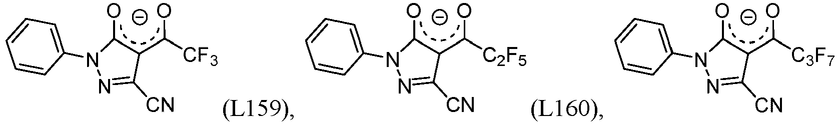

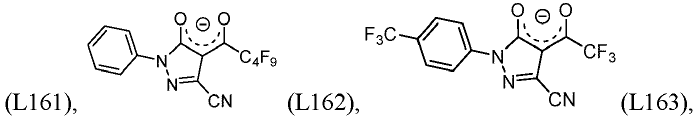

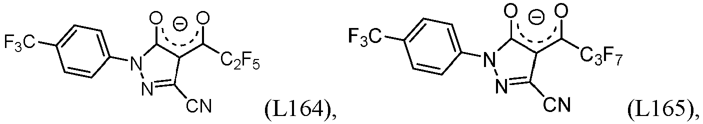

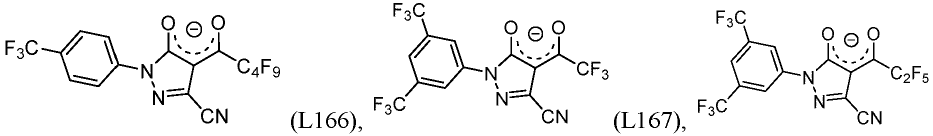

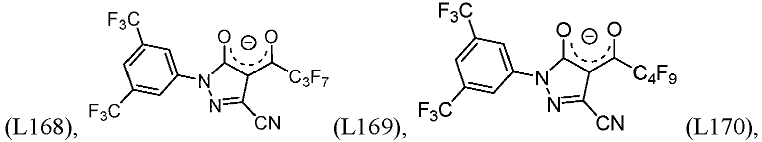

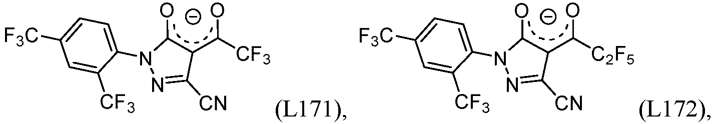

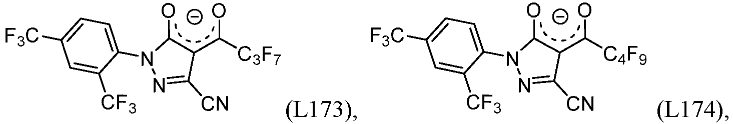

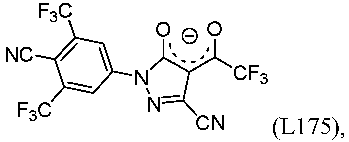

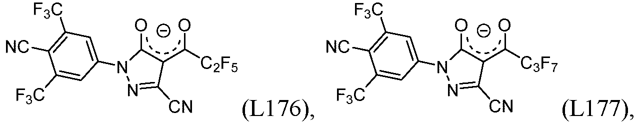

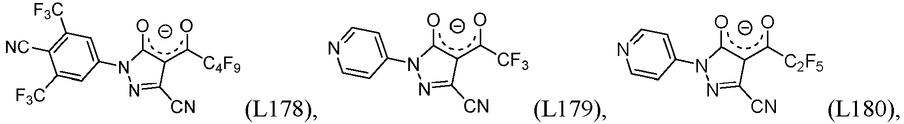

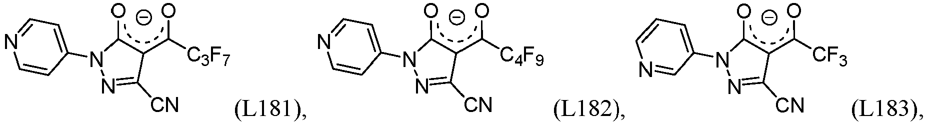

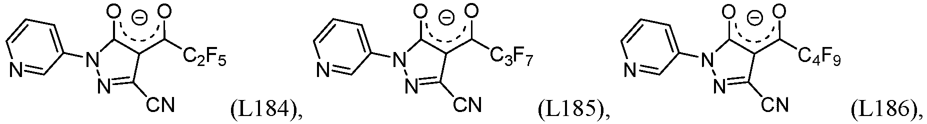

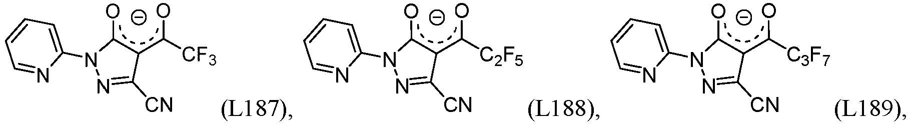

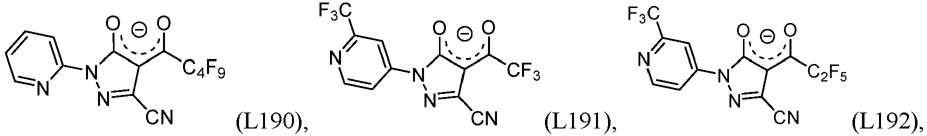

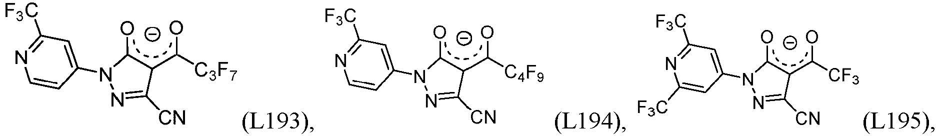

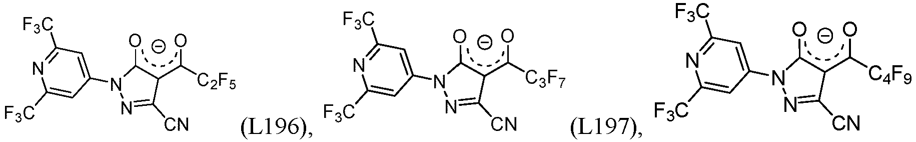

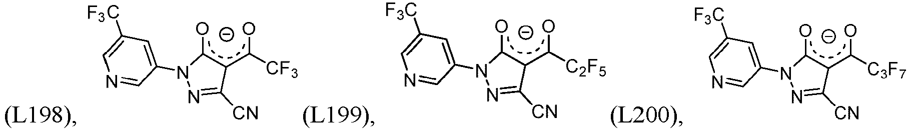

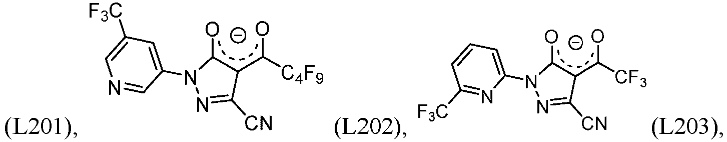

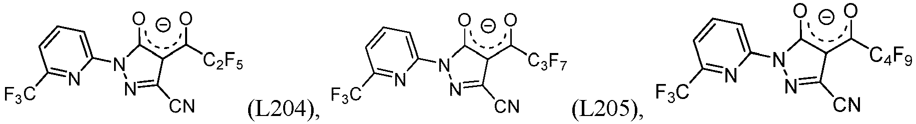

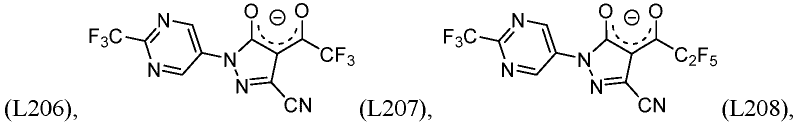

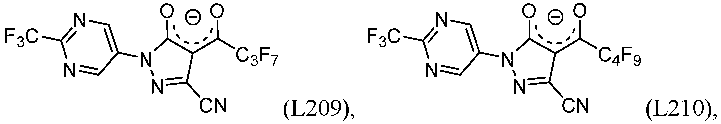

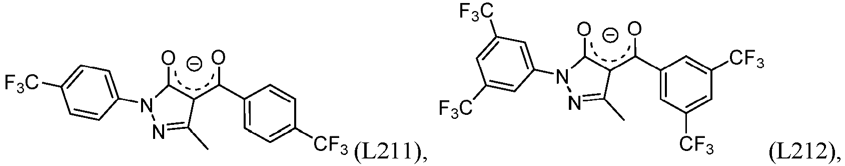

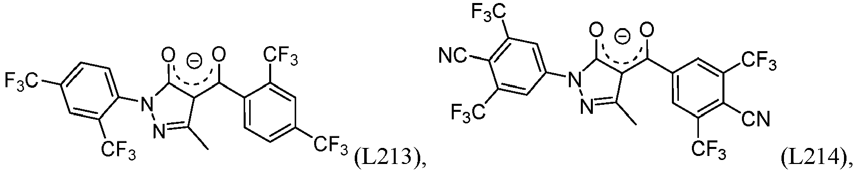

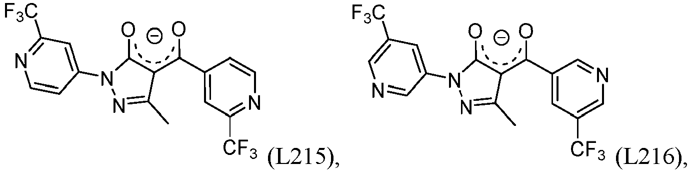

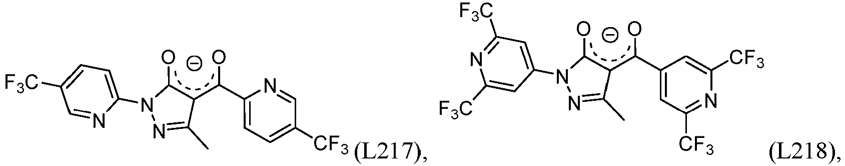

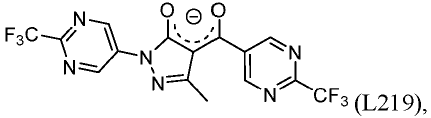

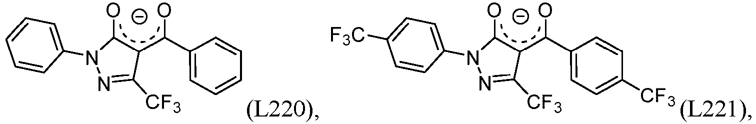

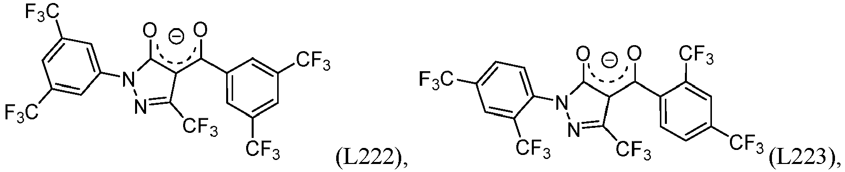

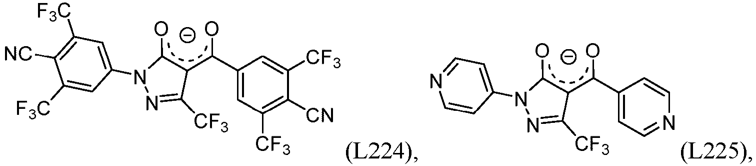

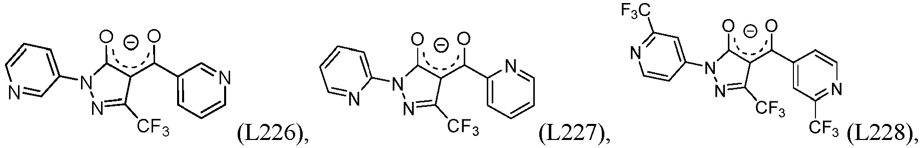

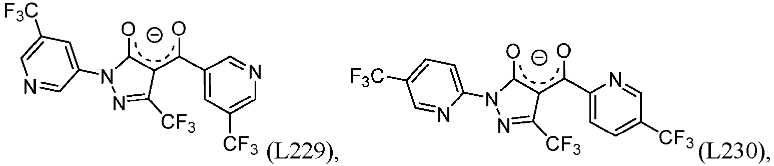

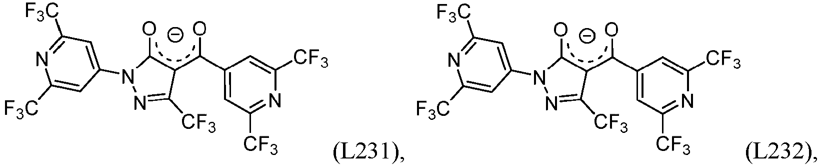

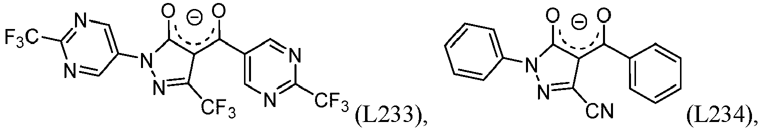

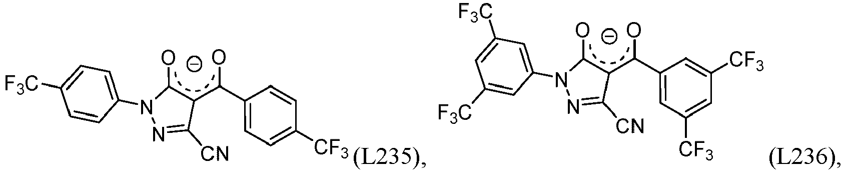

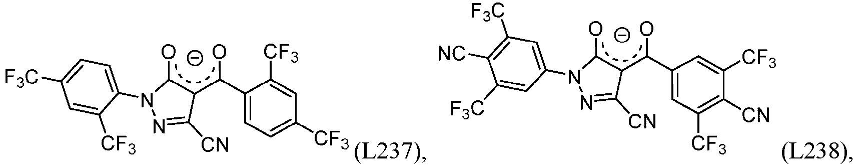

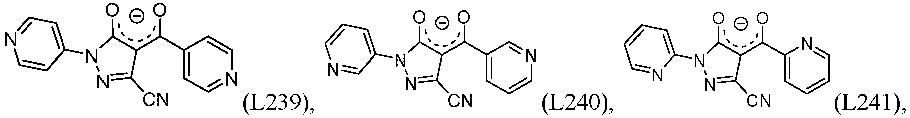

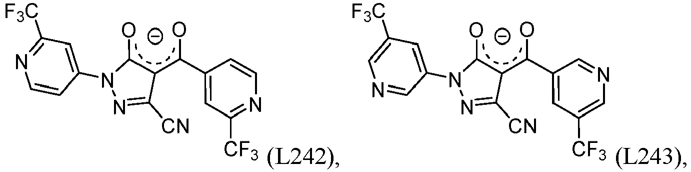

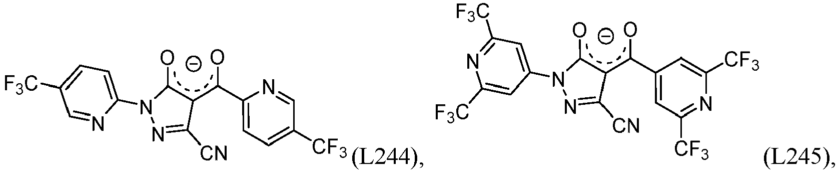

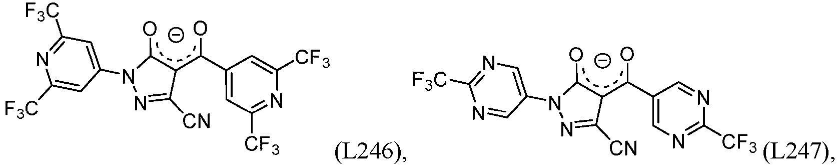

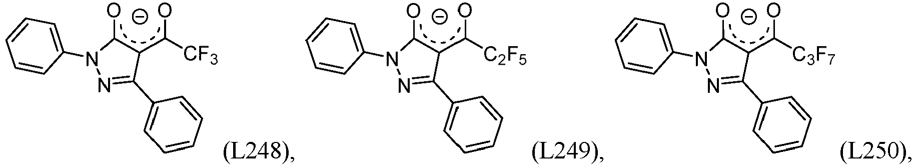

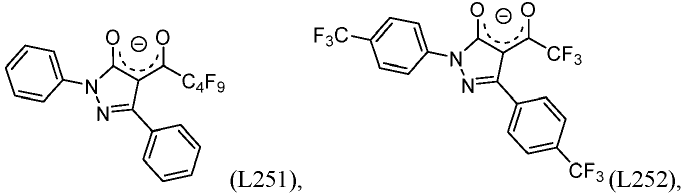

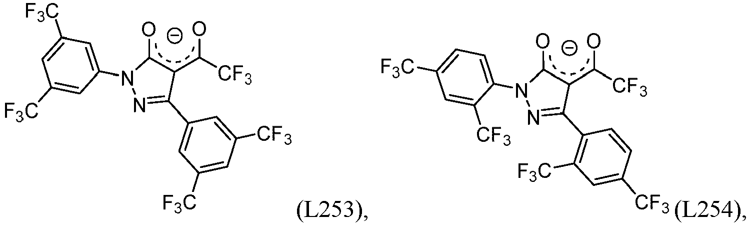

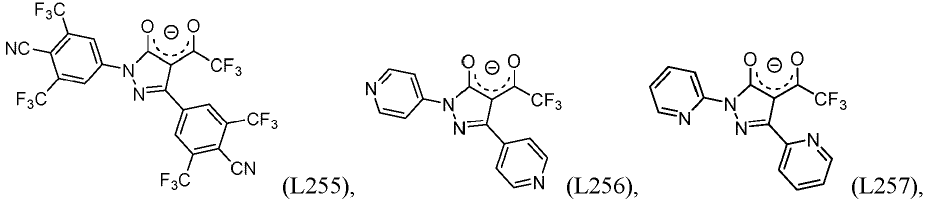

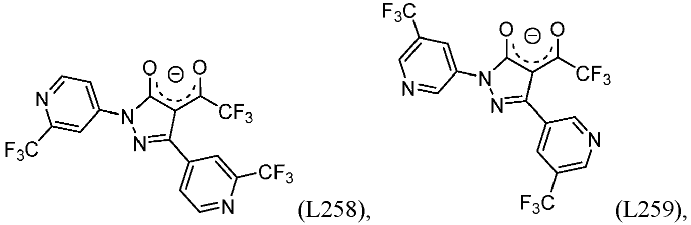

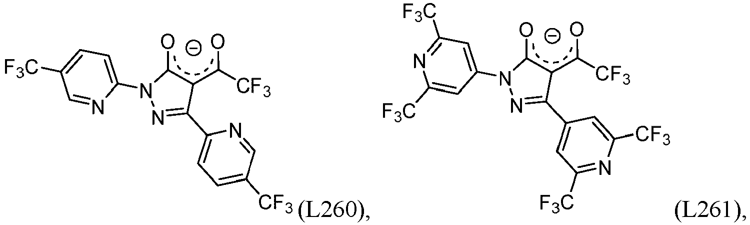

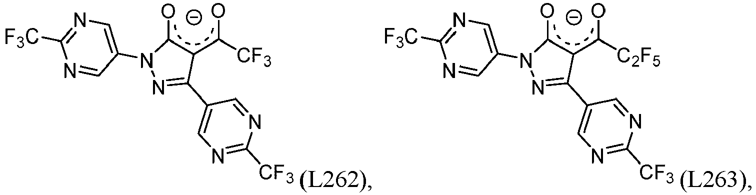

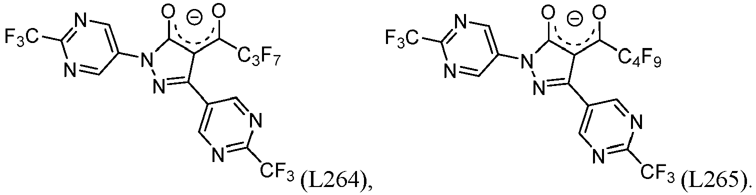

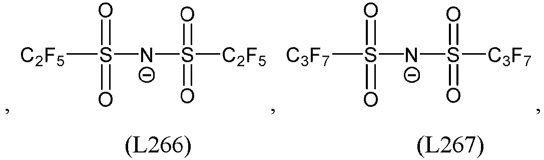

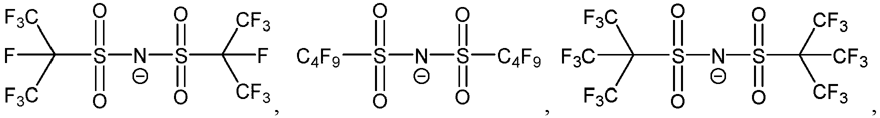

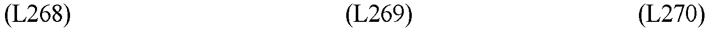

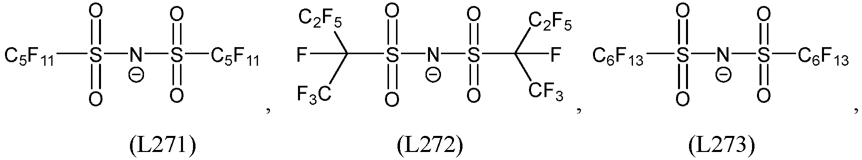

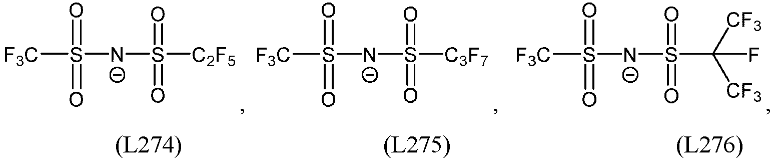

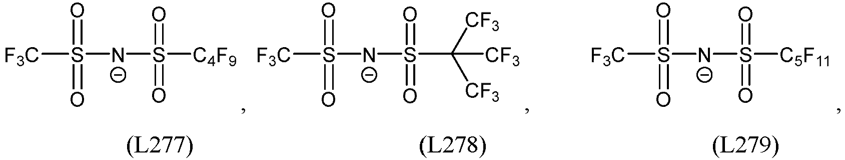

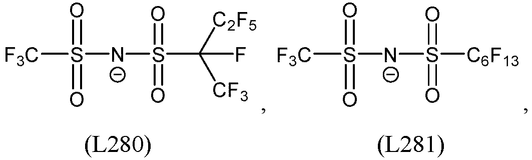

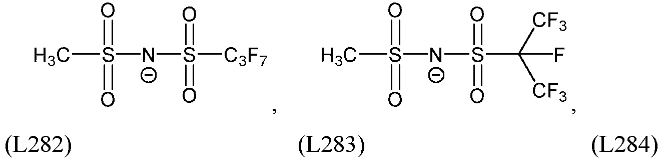

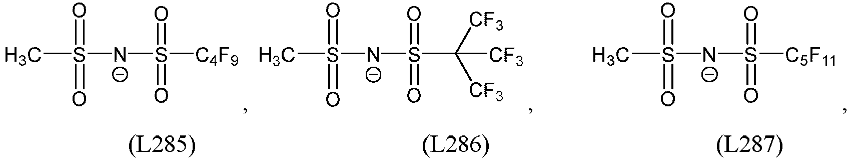

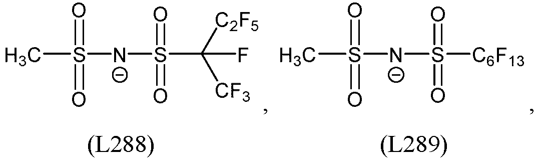

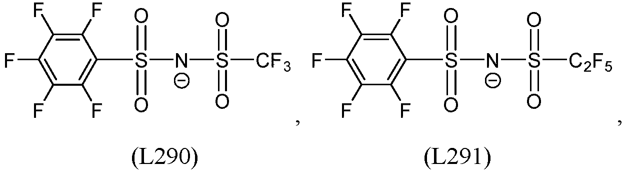

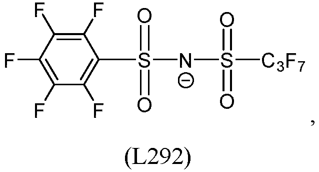

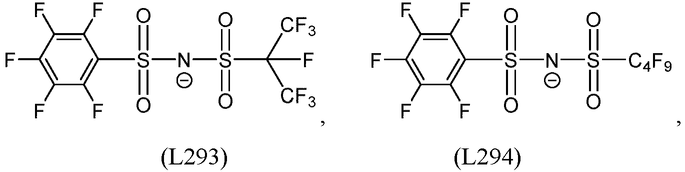

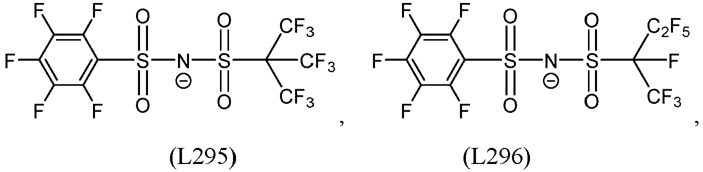

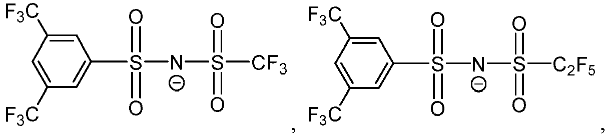

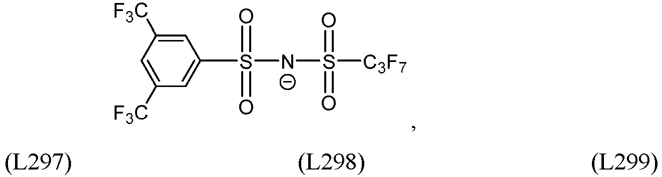

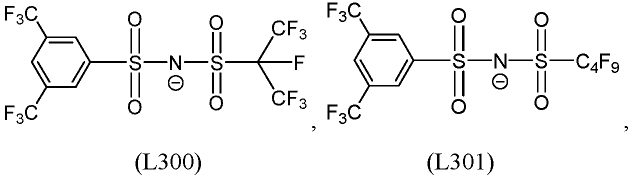

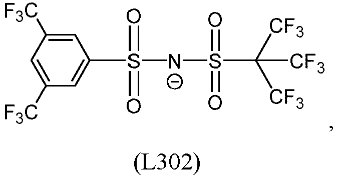

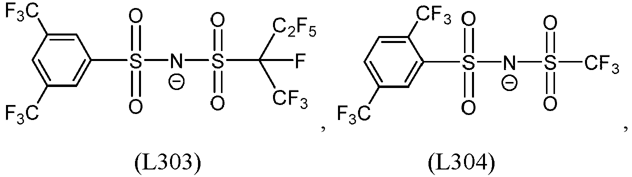

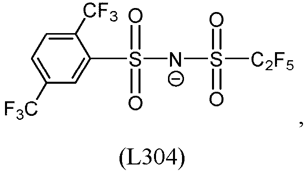

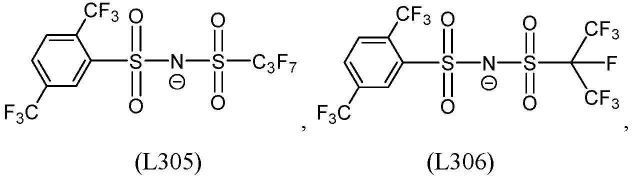

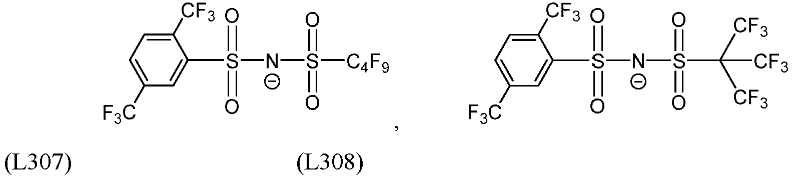

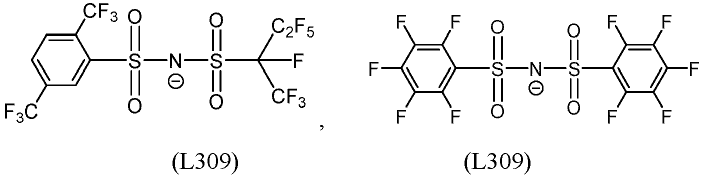

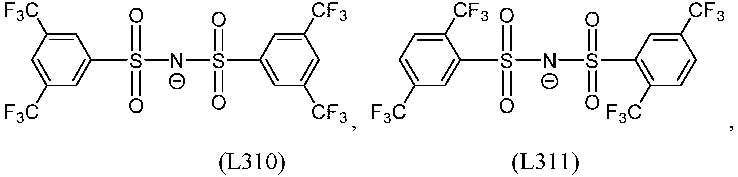

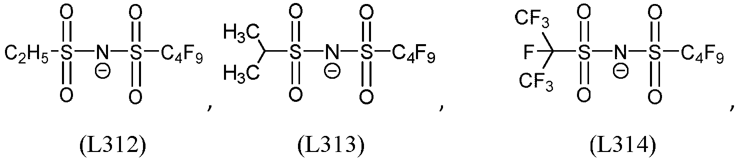

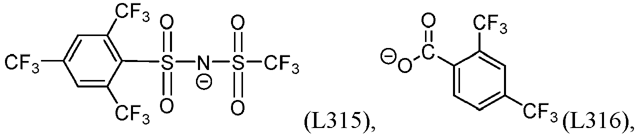

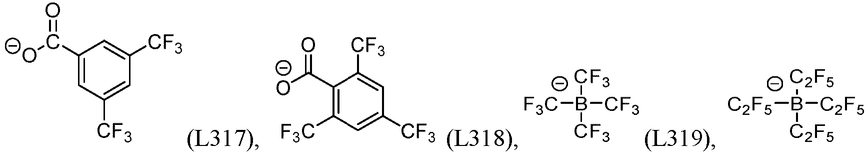

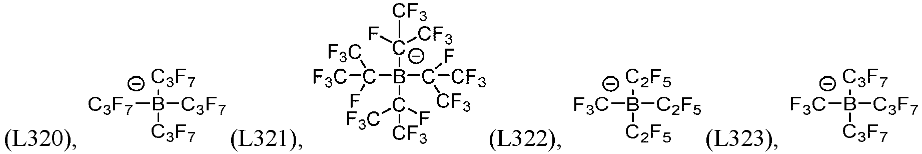

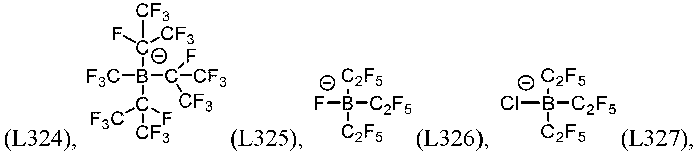

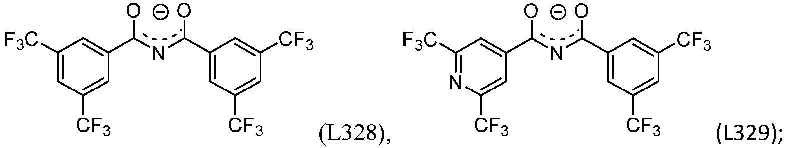

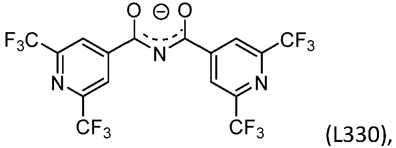

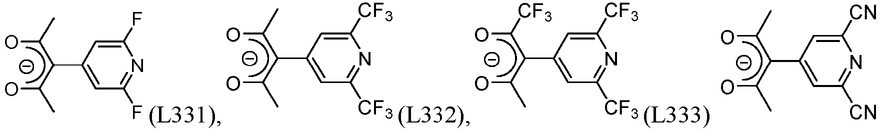

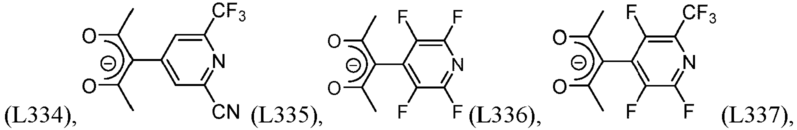

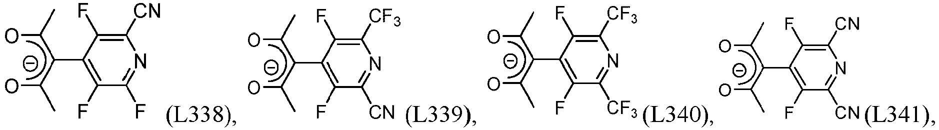

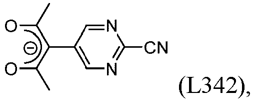

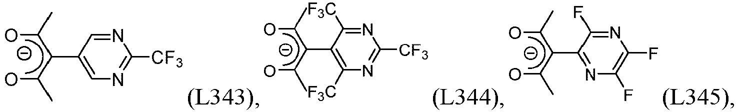

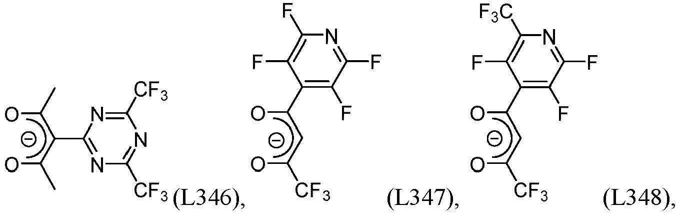

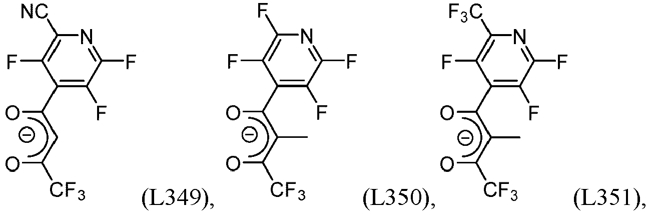

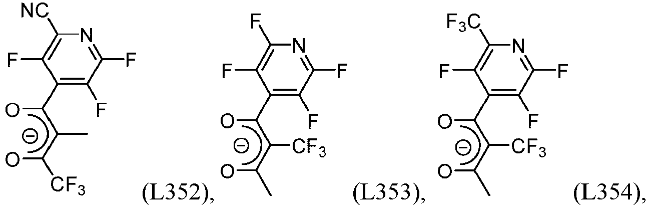

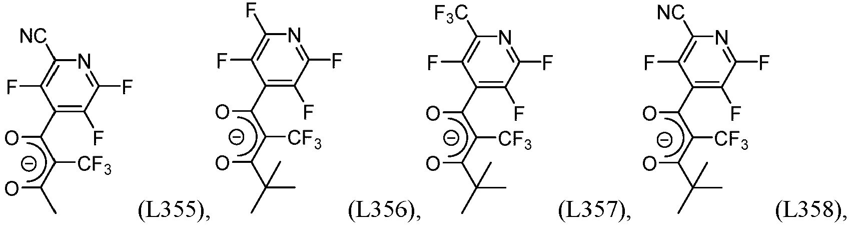

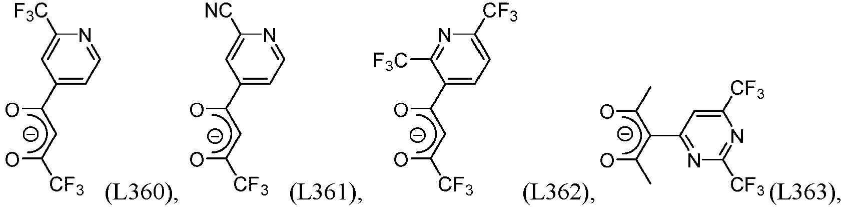

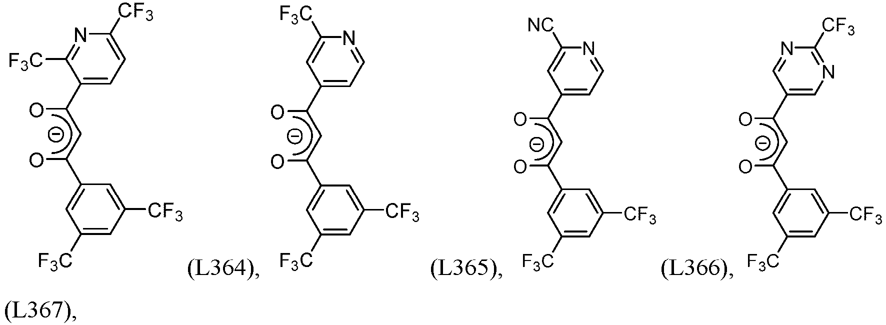

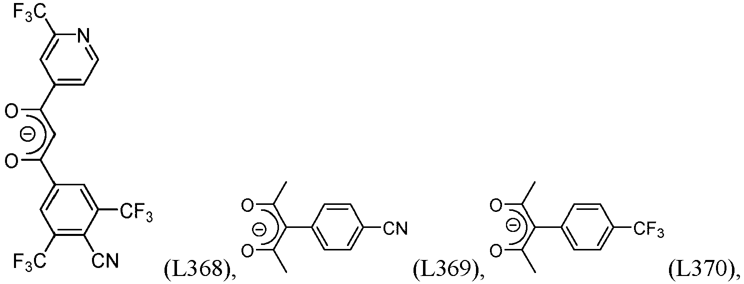

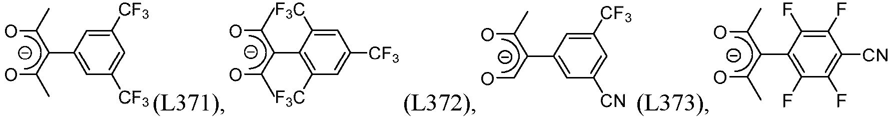

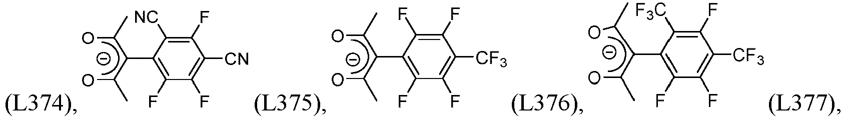

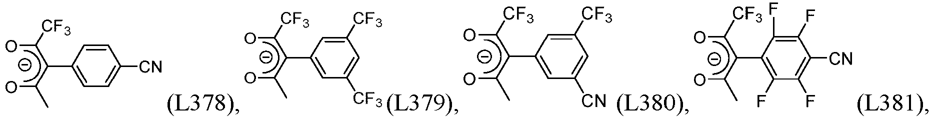

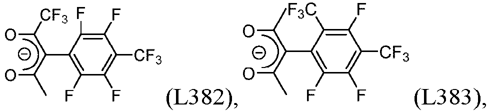

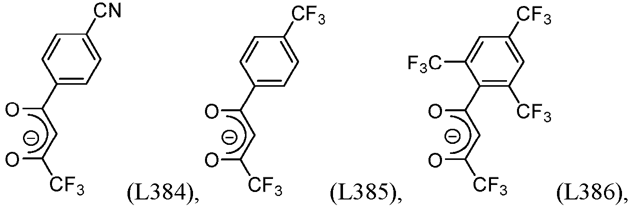

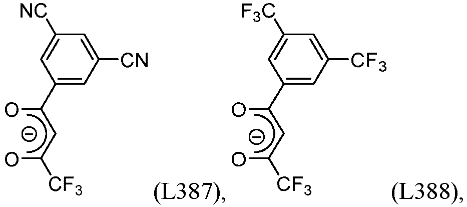

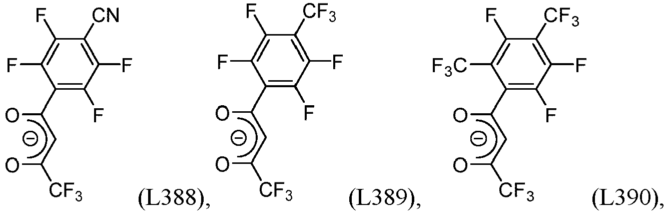

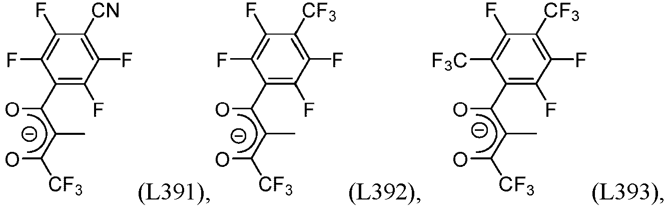

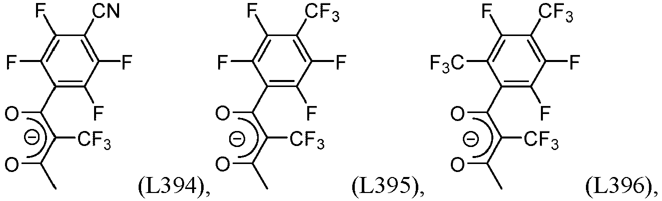

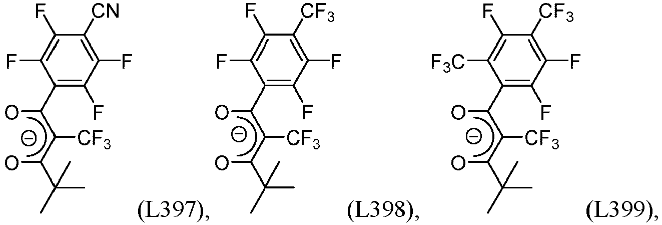

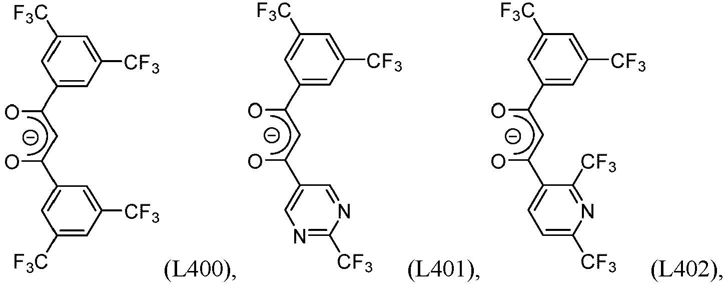

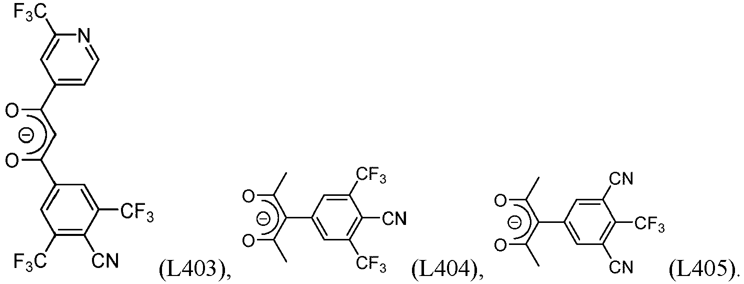

7. The organic electroluminescent device according to any one of claims 1 to 6, whereby the compound of formula (I) is present in the p-type charge generation layer in an amount of ≥1 wt% and ≤20 wt% based on the total weight of the p-type charge generation layer

8. The organic electroluminescent device according to any one of claims 1 to 7, whereby the compound of formula (I) comprises at least one CF₃ group.

9. The organic electroluminescent device according to any one of claims 1 to 8, wherein in formula (I) Ar¹, Ar² and Ar³ are independently selected from a group according to the following formula (III) and preferably each R' is selected from CN. 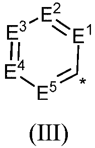 wherein
E¹ is selected from CW¹ or N;
E² is selected from CW² or N;
E³ is selected from CW³ or N;
E⁴ is selected from CW⁴ or N;
E⁵ is selected from CW⁵ or N;
W¹, W², W³, W⁴ and W⁵ (if present) are independently selected from electron-withdrawing group, CN, halogen, Cl, F, NO₂, substituted or unsubstituted C₁ to C₈ alkyl, partially fluorinated C₁ to C₈ alkyl, perfluorinated C₁ to C₈ alkyl, substituted or unsubstituted C₁ to C₈ alkoxy, partially fluorinated C₁ to C₈ alkoxy, perfluorinated C₁ to C₆ alkoxy, OCF₃,
substituted or unsubstituted C₆ to C₃₀ aryl, substituted or unsubstituted C₃ to C₃₀ heteroaryl, D or H,
wherein the one or more substituents is independently selected from D, halogen, Cl, F, CN, NO₂, partially fluorinated C₁ to C₈ alkyl, perfluorinated C₁ to C₈ alkyl, partially fluorinated C₁ to C₈ alkoxy, perfluorinated C₁ to C₈ alkoxy,
wherein the asterisk "*" denotes the binding position.

10. The organic electroluminescent device according to claim 9, wherein in formula (III) W¹, W², W³, W⁴ and W⁵ (if present) are independently selected from electron-withdrawing group, CN, halogen, Cl, F, NO₂, partially fluorinated or perfluorinated C₁ to C₈ alkyl, partially fluorinated or perfluorinated C₁ to C₆ alkoxy, D or H, and wherein preferably each R' is selected from CN

11. The organic electroluminescent device according to any one of claims 1 to 10, wherein in formula (I), Ar¹, Ar² and Ar³ are independently selected from B1 to B64 and preferably each R' is selected from CN: 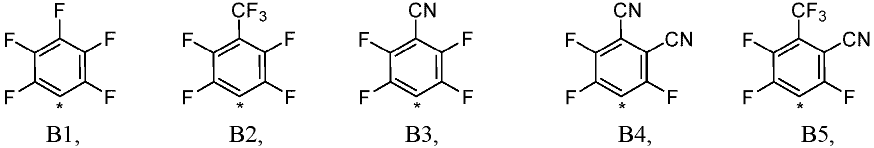 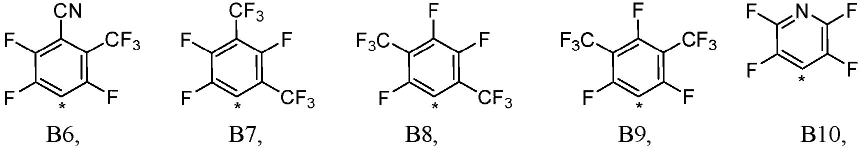 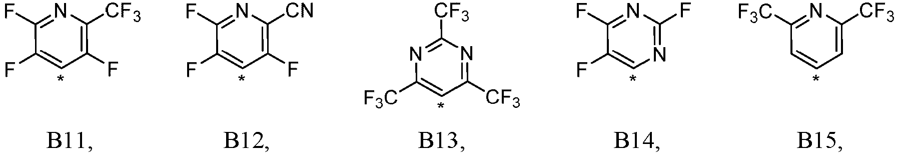 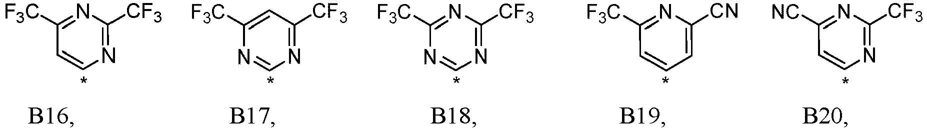 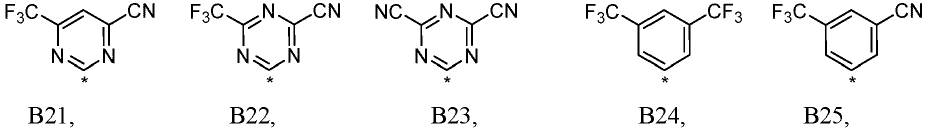 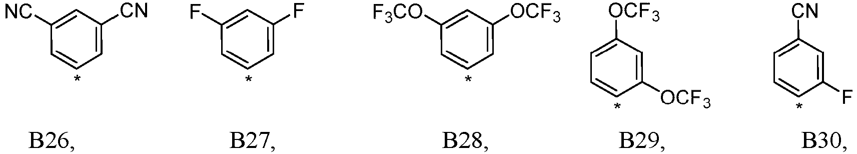 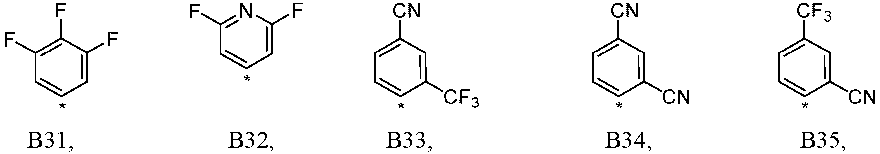 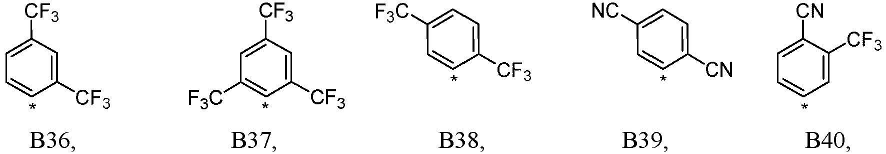 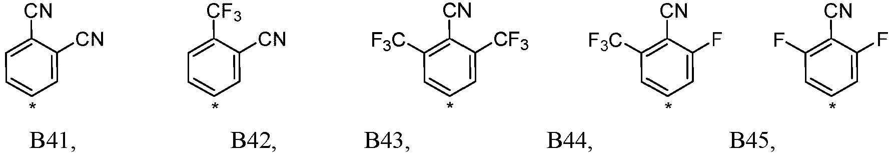 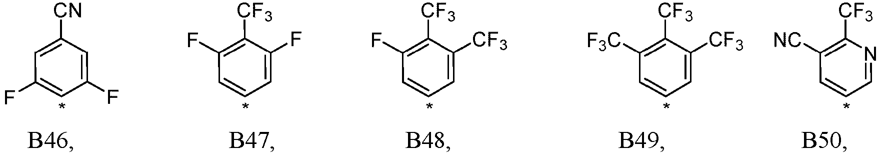 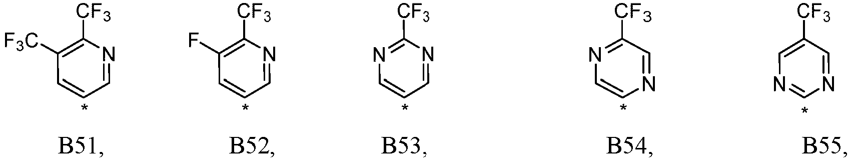 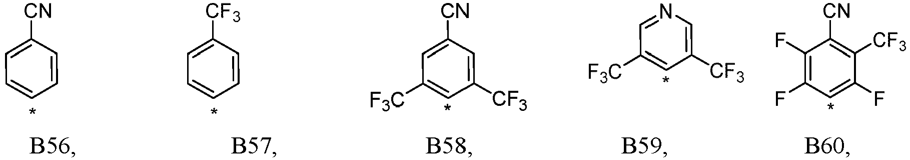 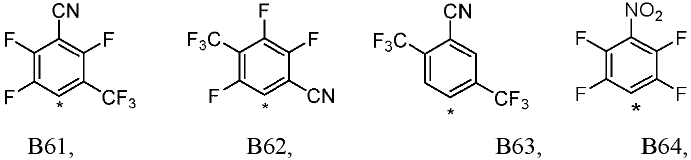 wherein the asterisk "*" denotes the binding position.

12. The organic electroluminescent device according to any one of claims 1 to 11, whereby the metal dopant of the first n-type charge generation layer is a metal selected from the group consisting of Li, Mg and Yb or a metal alloy comprising a metal selected from the group consisting of Li, Mg and Yb

13. The organic electroluminescent device according to any one of claims 1 to 12, whereby the metal dopant of the first n-type charge generation layer is Yb or a metal alloy comprising a metal selected from the group consisting of Li and Yb

14. The organic electroluminescent device according to any one of claims 1 to 13, whereby the organic luminescent device is an organic light emitting diode.

15. A display device comprising an organic electroluminescent device according to any of the claims 1 to 14.

## Patentansprüche

1. Organische elektrolumineszierende Vorrichtung (100), die eine Anodenschicht (120), eine Kathodenschicht (190), eine erste Emissionsschicht (145), eine zweite Emissionsschicht (245), eine Lochinjektionsschicht (130) und eine erste Ladungserzeugungsschicht (160) umfasst, wobei sich die Lochinjektionsschicht (130) in direktem Kontakt mit der Anodenschicht befindet,
wobei die Lochinjektionsschicht (130) eine erste Lochtransportmatrixverbindung und eine Verbindung der Formel (II), bei der es sich um eine aus einem Metallsalz oder einem ein Metallkation und mindestens ein aus mindestens 20 kovalent gebundenen Atomen bestehendes Monoanion und/oder mindestens einen aus mindestens 20 kovalent gebundenen Atomen bestehenden monoanionischen Liganden umfassenden Metallkomplex ausgewählte Metallverbindung handelt, umfasst,
wobei die erste Ladungserzeugungsschicht (160) zwischen der ersten Emissionsschicht (145) und der Anodenschicht (245) angeordnet ist,
wobei die erste Ladungserzeugungsschicht (160) eine erste n-Typ-Ladungserzeugungsschicht (161) und eine erste p-Typ-Ladungserzeugungsschicht (162) umfasst,
wobei sich die erste n-Typ-Ladungserzeugungsschicht (161) näher an der Anodenschicht (120) als die erste p-Typ-Ladungserzeugungsschicht (162) befindet,
wobei die erste n-Typ-Ladungserzeugungsschicht (161) einen Metalldotierungsstoff und eine Matrixverbindung umfasst,
**dadurch gekennzeichnet, dass** die erste p-Typ-Ladungserzeugungsschicht (162) eine zweite Lochtransportmatrixverbindung und eine Verbindung der Formel (I) umfasst, 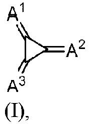
wobei in Formel (I)
- A¹ unabhängig aus einer Gruppe der Formel (Ia) ausgewählt ist 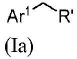
wobei Ar¹ unabhängig aus substituiertem oder unsubstituiertem C₆- bis C₃₆-Aryl und substituiertem oder unsubstituiertem C₂- bis C₃₆-Heteroaryl ausgewählt ist, wobei, wenn Ar¹ substituiert ist, einer oder mehrere der Substituenten unabhängig voneinander aus der aus D, einer elektronenziehenden Gruppe, Halogen, Cl, F, CN, -NO₂, substituiertem oder unsubstituiertem C₁- bis C₈-Alkyl, teilweise fluoriertem C₁- bis C₈-Alkyl, perfluoriertem C₁-bis C₈-Alkyl, substituiertem oder unsubstituiertem C₁-bis C₈-Alkoxy, teilweise fluoriertem C₁- bis C₈-Alkoxy, perfluoriertem C₁- bis C₈-Alkoxy, substituiertem oder unsubstituiertem C₆- bis C₃₀-Aryl und substituiertem oder unsubstituiertem C₆- bis C₃₀-Heteroaryl bestehenden Gruppe ausgewählt sind und
wobei der eine oder die mehreren Substituenten von C₆-bis C₃₀-Aryl, C₆- bis C₃₀-Heteroaryl, C₁- bis C₈-Alkyl, C₁-bis C₈-Alkoxy unabhängig voneinander aus D, einer elektronenziehenden Gruppe, Halogen, Cl, F, CN, -NO₂, teilweise fluoriertem C₁- bis C₈-Alkyl, perfluoriertem C₁-bis C₈-Alkyl, teilweise fluoriertem C₁- bis C₈-Alkoxy, perfluoriertem C₁- bis C₈-Alkoxy ausgewählt sind,
- A² unabhängig aus einer Gruppe der Formel (Ib) ausgewählt ist 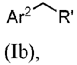
wobei Ar² unabhängig aus substituiertem oder unsubstituiertem C₆- bis C₃₆-Aryl und substituiertem oder unsubstituiertem C₂- bis C₃₆-Heteroaryl ausgewählt ist, wobei, wenn Ar² substituiert ist, einer oder mehrere der Substituenten unabhängig voneinander aus der aus D, einer elektronenziehenden Gruppe, Halogen, Cl, F, CN, -NO₂, substituiertem oder unsubstituiertem C₁- bis C₈-Alkyl, teilweise fluoriertem C₁- bis C₈-Alkyl, perfluoriertem C₁-bis C₈-Alkyl, substituiertem oder unsubstituiertem C₁-bis C₈-Alkoxy, teilweise fluoriertem C₁- bis C₈-Alkoxy, perfluoriertem C₁- bis C₈-Alkoxy, substituiertem oder unsubstituiertem C₆- bis C₃₀-Aryl und substituiertem oder unsubstituiertem C₆- bis C₃₀-Heteroaryl bestehenden Gruppe ausgewählt sind und
wobei der eine oder die mehreren Substituenten von C₆-bis C₃₀-Aryl, C₆- bis C₃₀-Heteroaryl, C₁- bis C₈-Alkyl, C₁-bis C₈-Alkoxy unabhängig voneinander aus D, einer elektronenziehenden Gruppe, Halogen, Cl, F, CN, -NO₂, teilweise fluoriertem C₁- bis C₈-Alkyl, perfluoriertem C₁-bis C₈-Alkyl, teilweise fluoriertem C₁- bis C₈-Alkoxy, perfluoriertem C₁- bis C₈-Alkoxy ausgewählt sind,
- A³ unabhängig aus einer Gruppe der Formel (Ic) ausgewählt ist 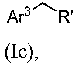
wobei Ar³ unabhängig aus substituiertem oder unsubstituiertem C₆- bis C₃₆-Aryl und substituiertem oder unsubstituiertem C₂- bis C₃₆-Heteroaryl ausgewählt ist, wobei, wenn Ar³ substituiert ist, einer oder mehrere der Substituenten unabhängig voneinander aus der aus D, einer elektronenziehenden Gruppe, Halogen, Cl, F, CN, -NO₂, substituiertem oder unsubstituiertem C₁- bis C₈-Alkyl, teilweise fluoriertem C₁- bis C₈-Alkyl, perfluoriertem C₁-bis C₈-Alkyl, substituiertem oder unsubstituiertem C₁-bis C₈-Alkoxy, teilweise fluoriertem C₁- bis C₈-Alkoxy, perfluoriertem C₁- bis C₈-Alkoxy, substituiertem oder unsubstituiertem C₆- bis C₃₀-Aryl und substituiertem oder unsubstituiertem C₆- bis C₃₀-Heteroaryl bestehenden Gruppe ausgewählt sind und
wobei der eine oder die mehreren Substituenten von C₆-bis C₃₀-Aryl, C₆- bis C₃₀-Heteroaryl, C₁- bis C₈-Alkyl, C₁-bis C₈-Alkoxy unabhängig voneinander aus D, einer elektronenziehenden Gruppe, Halogen, Cl, F, CN, -NO₂, teilweise fluoriertem C₁- bis C₈-Alkyl, perfluoriertem C₁-bis C₈-Alkyl, teilweise fluoriertem C₁- bis C₈-Alkoxy, perfluoriertem C₁- bis C₈-Alkoxy ausgewählt sind,
und wobei in A¹, A² und A³ R' jeweils unabhängig aus substituiertem oder unsubstituiertem C₆- bis C₁₈-Aryl, C₃-bis C₁₈-Heteroaryl, einer elektronenziehenden Gruppe, substituiertem oder unsubstituiertem C₁- bis C₈-Alkyl, teilweise fluoriertem C₁- bis C₈-Alkyl, perfluoriertem C₁-bis C₈-Alkyl, Halogen, F und CN ausgewählt ist,
wobei der eine oder die mehreren Substituenten von C₆-bis C₁₈-Aryl, C₆- bis C₁₈-Heteroaryl, C₁- bis C₈-Alkyl unabhängig voneinander aus D, einer elektronenziehenden Gruppe, Halogen, Cl, F, CN, -NO₂, teilweise fluoriertem C₁- bis C₆-Alkyl, perfluoriertem C₁- bis C₆-Alkyl, teilweise fluoriertem C₁- bis C₆-Alkoxy, perfluoriertem C₁- bis C₆-Alkoxy ausgewählt sind,

2. Organische elektrolumineszierende Vorrichtung nach Anspruch 1, wobei die Verbindung der Formel (II) ein LUMO-Energieniveau von ≥ -7,0 EV bis ≤ -1,5 EV aufweist, wobei die Berechnungen unter Verwendung des Hybridfunktionals B3LYP mit dem Def2-TZVP-Basissatz und den SDD-Effective-Core-Potentialen (ECPs) für die Metalle in der Gasphase durchgeführt werden, wie sie im Programmpaket ORCA Version 5.0.3-f.1 implementiert sind (Abteilung für Theorie und Spektroskopie, Max-Planck-Institut für Kohlenforschung, Kaiser-Wilhelm-Platz 1, 45470 Mülheim/Ruhr, Deutschland).

3. Organische elektrolumineszierende Vorrichtung nach Anspruch 1 oder 2, wobei die Verbindung der Formel (II) mindestens ein aus mindestens 20 kovalent gebundenen Atomen bestehendes Monoanion und/oder mindestens einen aus mindestens 20 kovalent gebundenen Atomen bestehenden monoanionischen Liganden umfasst, wobei das Monoanion bzw. der monoanionische Ligand durch L- gemäß Formel (IV) wiedergegeben wird oder die Verbindung der Formel (II) durch Formel (IIa) wiedergegeben wird: 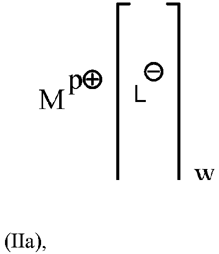 wobei
M für ein Metallion steht,
p für die Wertigkeit von M steht,
W für n steht,
wobei L⁻ gleich oder verschieden ausgewählt sein kann, wobei die Verbindung der Formel (IIa) gegebenenfalls einen Hilfsliganden (AL) umfassen kann, der an das Metallkation oder das Metallkation M^{p+} koordiniert, wobei L⁻ wiedergegeben wird durch 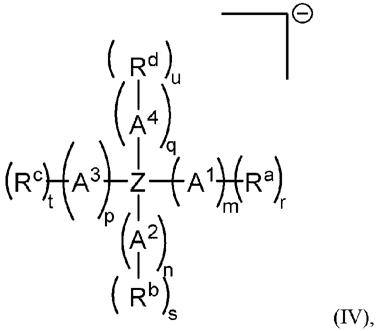
m, n, p und q unabhängig voneinander aus 0 oder 1 ausgewählt sind,
r, s, t und u unabhängig voneinander aus 0 oder 1 ausgewählt sind,
mindestens eines von r, s, t und u für 1 steht,
Z aus CR¹, C, O, N, B ausgewählt ist,
wenn Z für O steht, n, p, q für 0 stehen und s, t und u für 0 stehen,
wenn Z für N oder CR¹ steht, p und q für 0 stehen und t und u für 0 stehen,
wenn Z für C steht, q für 0 steht und u für 0 steht,
wenn Z für B steht, n, m, p und q für 1 stehen und r, s, t und u für 1 stehen,
A¹, A², A³ and A⁴ unabhängig voneinander aus C=O, C-O, C=NR², C-NR³, SO, SO₂ oder P(=O)R⁴ ausgewählt sind,
wobei Z eine Doppelbindung zu A¹, A², A³ und A⁴ bilden kann, wenn A¹, A², A³ und A⁴ aus C-O oder C-NR³ ausgewählt sind und Z aus N, O oder CR¹ ausgewählt ist oder A¹, A², A³ und A⁴ aus C-O oder C-NR³ ausgewählt ist und Z für C steht,
und wobei gegebenenfalls zwei der Reste A¹, A², A³ und A⁴ zusammen einen substituierten oder unsubstituierten Heterocyclus oder einen substituierten oder unsubstituierten Carbocyclus mit Z bilden können oder wobei gegebenenfalls einer der Reste A¹, A², A³ und A⁴ einen substituierten oder unsubstituierten Heterocyclus oder einen substituierten oder unsubstituierten Carbocyclus mit Z bilden kann,
wobei der eine oder die mehreren Substituenten am Heterocyclus oder Carbocyclus unabhängig voneinander aus D, einer elektronenziehenden Gruppe, Halogen, F, CN, NO₂, SF₅, Isonitril, einer Estergruppe, einer Carboxylgruppe, einer Carbonylgruppe, einer Acylgruppe, einer Thiogruppe, einer Sulfinylgruppe, einer Sulfonylgruppe, einer Phosphingruppe, substituiertem oder unsubstituiertem Alkyl, teilweise perfluoriertem C₁- bis C₁₂-Alkyl, perfluoriertem C₁- bis C₁₂-Alkyl, CF₃, teilweise perfluoriertem C₁- bis C₆-Alkoxy, perfluoriertem C₁- bis C₆-Alkoxy, OCF₃, substituiertem oder unsubstituiertem C₆-bis C₄₀-Aryl, substituiertem C₂- bis C₄₀-Heteroaryl, substituiertem oder unsubstituiertem C₃- bis C₃₀-Carbocyclyl oder substituiertem oder unsubstituiertem C₂-bis C₃₀-Heterocyclyl ausgewählt sind,
R¹ aus H, D, einer elektronenziehenden Gruppe, Halogen, Cl, F, CN, NO₂, SF₅, Isonitril, einer Estergruppe, einer Carboxylgruppe, einer Carbonylgruppe, einer Acylgruppe, einer Thiogruppe, einer Sulfinylgruppe, einer Sulfonylgruppe, einer Phosphingruppe, substituiertem oder unsubstituiertem C₁- bis C₁₂-Alkyl, teilweise perfluoriertem C₁- bis C₁₂-Alkyl, perfluoriertem C₁- bis C₁₂-Alkyl, CF₃, substituiertem oder unsubstituiertem C₁-bis C₁₂-Alkoxy, teilweise perfluoriertem C₁- bis C₆-Alkoxy, perfluoriertem C₁- bis C₆-Alkoxy, CF₃, substituiertem oder unsubstituiertem C₆- bis C₄₀-Aryl, substituiertem oder unsubstituiertem C₂- bis C₄₀-Heteroaryl, substituiertem oder unsubstituiertem C₃- bis C₃₀-Carbocyclyl, substituiertem oder unsubstituiertem C₃-bis C₃₀-Heterocyclyl ausgewählt ist,
wobei der eine oder die mehreren Substituenten an R¹ unabhängig voneinander aus D, einer elektronenziehenden Gruppe, Halogen, F, CN, NO₂, SF₅, Isonitril, einer Estergruppe, einer Carboxylgruppe, einer Carbonylgruppe, einer Acylgruppe, einer Thiogruppe, einer Sulfinylgruppe, einer Sulfonylgruppe, einer Phosphingruppe, teilweise perfluoriertem C₁- bis C₁₂-Alkyl, perfluoriertem C₁- bis C₁₂-Alkyl, CF₃, teilweise perfluoriertem C₁- bis C₆-Alkoxy, perfluoriertem C₁- bis C₆-Alkoxy, OCF₃, =N ausgewählt sind,
R², R³ und R⁴ unabhängig voneinander aus H, D, einer elektronenziehenden Gruppe, Halogen, Cl, F, CN, einer Estergruppe, einer Carboxylgruppe, einer Carbonylgruppe, einer Acylgruppe, einer Thiogruppe, einer Sulfinylgruppe, einer Sulfonylgruppe, einer Phosphingruppe, substituiertem oder unsubstituiertem Alkyl, teilweise perfluoriertem C₁- bis C₁₂-Alkyl, perfluoriertem C₁- bis C₁₂-Alkyl, CF₃, substituiertem oder unsubstituiertem C₁- bis C₆-Alkoxy, teilweise perfluoriertem C₁- bis C₆-Alkoxy, perfluoriertem C₁- bis C₆-Alkoxy, OCF₃, substituiertem oder unsubstituiertem C₆-bis C₄₀-Aryl, substituiertem oder unsubstituiertem C₂- bis C₃₀-Heteroaryl, substituiertem oder unsubstituiertem C₃-bis C₃₀-Carbocyclyl, substituiertem oder unsubstituiertem C₂- bis C₃₀-Heterocyclyl ausgewählt sind,
wobei die Substituenten an R², R³ und R⁴ unabhängig voneinander aus D, einer elektronenziehenden Gruppe, Halogen, Cl, F, CN, NO₂, SF₅, Isonitril, einer Estergruppe, einer Carboxylgruppe, einer Carbonylgruppe, einer Acylgruppe, einer Thiogruppe, einer Sulfinylgruppe, einer Sulfonylgruppe, einer Phosphingruppe, teilweise perfluoriertem C₁- bis C₁₂-Alkyl, perfluoriertem C₁- bis C₁₂-Alkyl, CF₃, teilweise perfluoriertem C₁- bis C₆-Alkoxy, perfluoriertem C₁-C₆-Alkoxy, OCF₃ ausgewählt sind,
R^{a}, R^{b}, R^{c} und R^{d} unabhängig voneinander aus H, D, einer elektronenziehenden Gruppe, Halogen, F, Cl, CN, substituiertem oder unsubstituiertem C₁- bis C₁₂-Alkyl, teilweise perfluoriertem C₁- bis C₁₂-Alkyl, perfluoriertem C₁- bis C₁₂-Alkyl, CF₃, substituiertem oder unsubstituiertem C₆- bis C₄₀-Aryl, substituiertem oder unsubstituiertem C₂- bis C₃₀-Heteroaryl, substituiertem oder unsubstituiertem Carbocyclyl, substituiertem oder unsubstituiertem C₂- bis C₃₀-Heterocyclyl, O, S, N, NR⁵, einer substituierten oder unsubstituierten Amingruppe mit 0 bis 20 Kohlenstoffatomen ausgewählt sind,
wobei der eine oder die mehreren Substituenten an R^{a}, R^{b}, R^{c} und R^{d} unabhängig voneinander aus einer elektronenziehenden Gruppe, Halogen, F, CN, NO₂, SF₅, Isonitril, einer Estergruppe, einer Carboxylgruppe, einer Carbonylgruppe, einer Acylgruppe, einer Thiogruppe, einer Sulfinylgruppe, einer Sulfonylgruppe, einer Phosphingruppe, teilweise perfluoriertem C₁- bis C₁₂-Alkyl, perfluoriertem C₁- bis C₁₂-Alkyl, teilweise perfluoriertem C₁- bis C₆-Alkoxy, perfluoriertem C₁-C₆-Alkoxy, OCF₃ ausgewählt sind,
wobei R⁵ aus substituiertem oder unsubstituiertem C₆- bis C₄₀-Aryl, substituiertem oder unsubstituiertem C₂- bis C₄₀-Heteroaryl, substituiertem oder unsubstituiertem C₁-bis C₁₂-Alkyl, teilweise perfluoriertem C₁- bis C₁₂-Alkyl, perfluoriertem C₁- bis C₁₂-Alkyl ausgewählt ist,
wobei der eine oder die mehreren Substituenten an R⁵ aus elektronenziehender Gruppe, Halogen, F, CN, NO₂, SF₅, Isonitril, einer Estergruppe, einer Carboxylgruppe, einer Carbonylgruppe, einer Acylgruppe, einer Thiogruppe, einer Sulfinylgruppe, einer Sulfonylgruppe, einer Phosphingruppe, teilweise fluoriertem C₁- bis C₁₂-Alkyl, perfluoriertem C₁- bis C₁₂-Alkyl, CF₃, CF₂CF₃, teilweise fluoriertem C₁- bis C₆-Alkoxy, perfluoriertem C₁- bis C₆-Alkoxy, OCF₃, OCF₂CCF₃ ausgewählt sind,
wobei vorzugsweise mindestens einer der Reste R^{a}, R^{b}, R^{c} und R^{d} unabhängig aus substituiertem oder unsubstituiertem C₆- bis C₄₀-Aryl, substituiertem oder unsubstituiertem C₂- bis C₄₀-Heteroaryl, substituiertem oder unsubstituiertem C₁- bis C₁₂-Alkyl, substituiertem oder unsubstituiertem C₃- bis C₃₀-Carbocyclyl, substituiertem oder unsubstituiertem C₂- bis C₃₀-Heterocyclyl ausgewählt ist,
wobei die Substituenten an R^{a}, R^{b}, R^{c} und R^{d} unabhängig voneinander aus einer elektronenziehenden Gruppe, Halogen, F, CN, NO₂, SF₅, Isonitril, einer Estergruppe, einer Carboxylgruppe, einer Carbonylgruppe, einer Acylgruppe, einer Thiogruppe, einer Sulfinylgruppe, einer Sulfonylgruppe, einer Phosphingruppe, teilweise perfluoriertem C₁- bis C₁₂-Alkyl, perfluoriertem C₁- bis C₁₂-Alkyl, CF₃, teilweise perfluoriertem C₁- bis C₆-Alkoxy, perfluoriertem C₁-C₆-Alkoxy, OCF₃ ausgewählt sind,
wobei
gegebenenfalls einer der Reste R^{a}, R^{b}, R^{c}, R^{d} unabhängig von den anderen einen substituierten oder unsubstituierten Heterocyclus oder einen substituierten oder unsubstituierten C₃- bis C₄₀-Carbocyclus mit R¹ bilden kann,
wobei der eine oder die mehreren Substituenten am Heterocyclus oder Carbocyclus unabhängig voneinander aus D, einer elektronenziehenden Gruppe, Halogen, F, CN, NO₂, SF₅, Isonitril, einer Estergruppe, einer Carboxylgruppe, einer Carbonylgruppe, einer Acylgruppe, einer Thiogruppe, einer Sulfinylgruppe, einer Sulfonylgruppe, einer Phosphingruppe, substituiertem oder unsubstituiertem Alkyl, teilweise perfluoriertem C₁- bis C₁₂-Alkyl, perfluoriertem C₁- bis C₁₂-Alkyl, CF₃, teilweise perfluoriertem C₁- bis C₆-Alkoxy, perfluoriertem C₁- bis C₆-Alkoxy, OCF₃, substituiertem oder unsubstituiertem C₆-bis C₄₀-Aryl, substituiertem C₂- bis C₄₀-Heteroaryl, substituiertem oder unsubstituiertem C₃- bis C₃₀-Carbocyclyl oder substituiertem oder unsubstituiertem C₂-bis C₃₀-Heterocyclyl ausgewählt sind,
wobei der eine oder die mehreren Substituenten an dem Substituenten an dem Heterocyclus oder Carbocylus unabhängig aus D, einer elektronenziehenden Gruppe, Halogen, F, substituiertem oder unsubstituiertem C₁- bis C₁₂-Alkyl, teilweise perfluoriertem C₁- bis C₁₂-Alkyl, perfluoriertem C₁- bis C₁₂-Alkyl, CF₃, teilweise perfluoriertem C₁- bis C₆-Alkoxy, perfluoriertem C₁- bis C₆-Alkoxy, OCF₃ ausgewählt sind.

4. Organische elektrolumineszierende Vorrichtung nach Anspruch 1 oder 3, wobei das Monoanion oder der monoanionische Ligand L- aus (V), (VI), (VII) oder (VIII) oder (IX) ausgewählt ist: 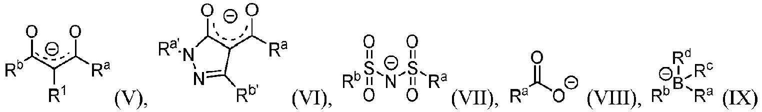 wobei
R^{a'} unabhängig aus unsubstituiertem und substituiertem C₁-bis C₁₂-Alkyl, substituiertem oder unsubstituiertem C₆-bis C₁₉-Aryl, substituiertem oder unsubstituiertem C₂- bis C₂₀-Heteroaryl oder substituiertem oder unsubstituiertem 6-gliedrigem Heteroaryl ausgewählt sind,
R^{b'} aus unsubstituiertem und substituiertem C₁- bis C₁₂-Alkyl, substituiertem oder unsubstituiertem C₆- bis C₁₉-Aryl, substituiertem oder unsubstituiertem C₂- bis C₂₀-Heteroaryl, substituiertem oder unsubstituiertem 6-gliedrigem Heteroaryl oder CN ausgewählt ist,
wobei
mindestens einer der Substituenten des substituierten C₁-bis C₁₂-Alkyl, des substituierten C₆- bis C₁₉-Aryl, des substituierten C₂- bis C₂₀-Heteroaryl oder des substituierten 6-gliedrigen Heteroaryl unabhängig aus Halogen, Cl, F, CN, teilweise fluoriertem oder perfluoriertem C₁- bis C₈-Alkyl, teilweise fluoriertem oder perfluoriertem C₁- bis C₈-Alkoxy ausgewählt ist, wobei in Formel (VI)
mindestens einer der Reste R^{a'}, R^{b'} und R^{a} oder die Gruppe von R^{a'}, R^{b'} und R^{a} mindestens drei Atome aus der aus Halogen, Cl, F oder N bestehenden Gruppe ausgewählte Atome umfasst,
- die übrigen Reste R sind wie oben definiert.

5. Organische elektrolumineszierende Vorrichtung nach Anspruch 4, wobei mindestens einer der Reste Ra, Rb, Rc oder Rd oder Ra, Rb, Rc und Rd unabhängig aus D1 bis D105 ausgewählt ist/sind: 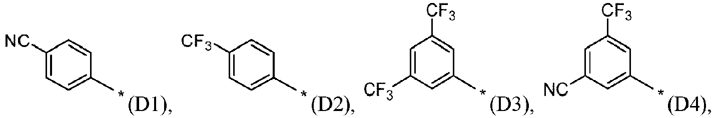 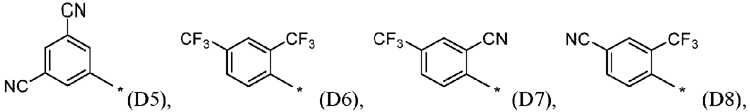 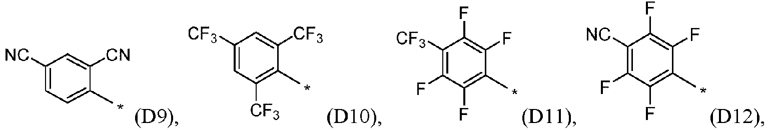 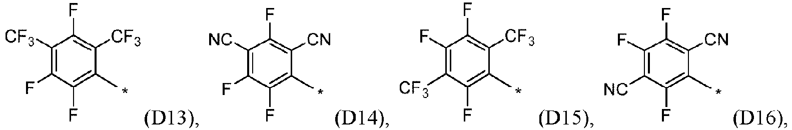 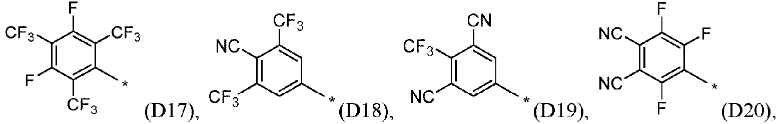 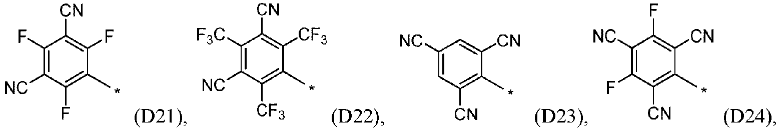 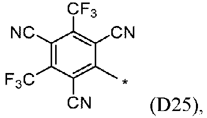 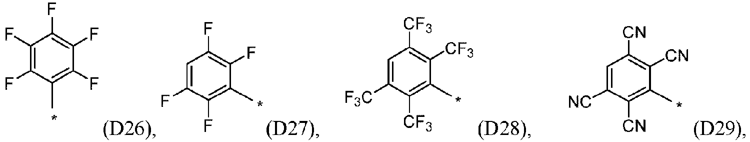 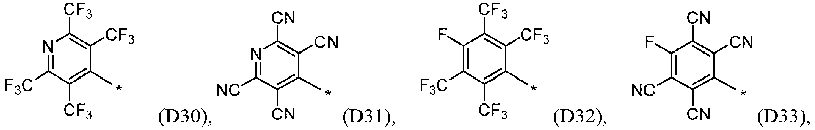 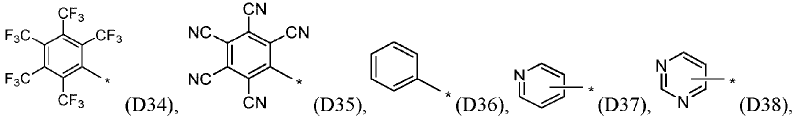 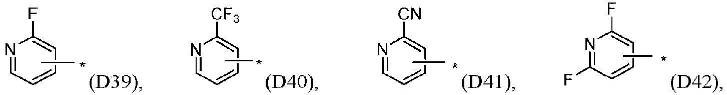 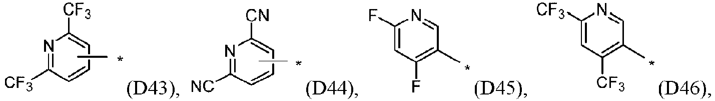 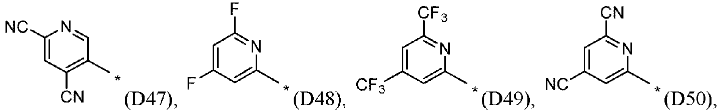 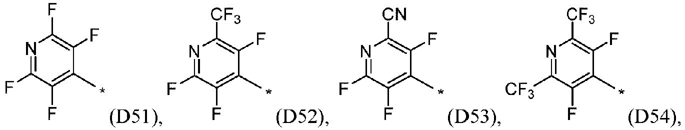 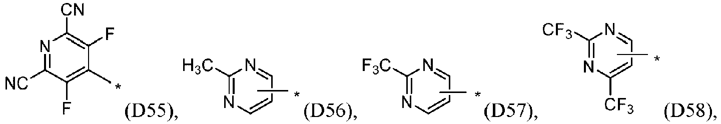 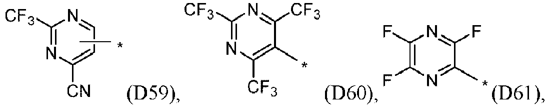 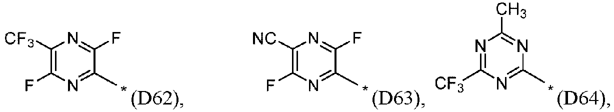 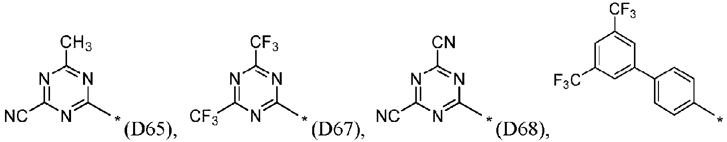 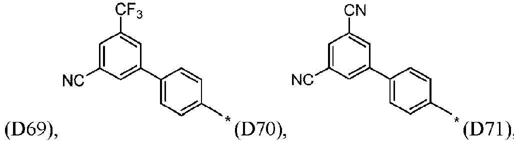 -CF₃ (D72), -C₂F₅ (D73), -C₃F₇ (D74), -CF₂CF₂CF₃ (D75), 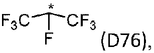 -C₄F₉ (D77), -CF₂CF₂CF₂CF₃ (D78) 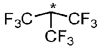 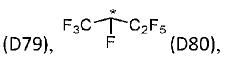 -C₅F₁₁ (D81), -C₆F₁₃ (D82), -CH3 (D83), -C₂H₅ (D84) -CH(CH₃)₂ 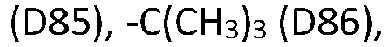 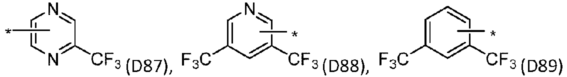 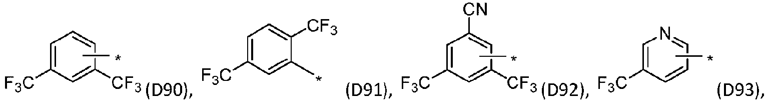 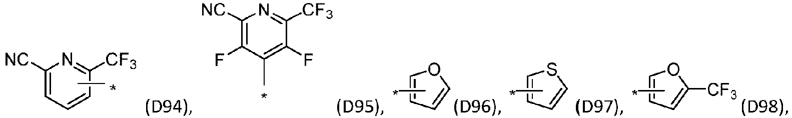 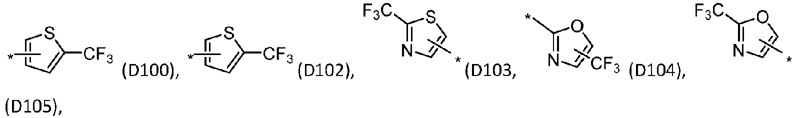 wobei das "*" or "-" die Bindungsposition bezeichnet.

6. Organische elektrolumineszierende Vorrichtung nach Anspruch 5, wobei das Monoanion oder der monoanionische Ligand aus L1 bis L405 ausgewählt ist:

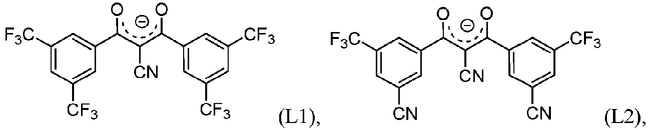

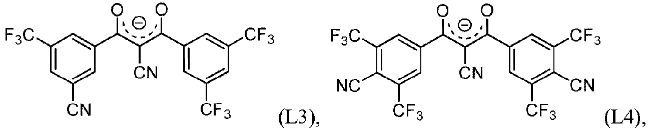

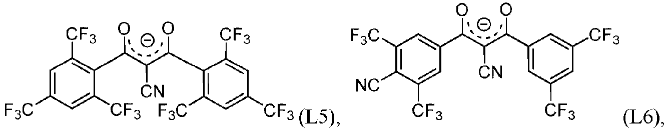

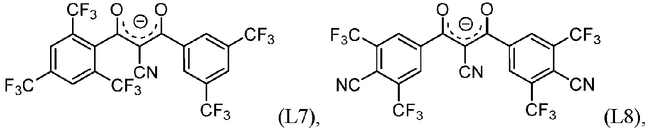

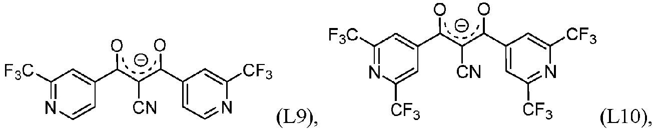

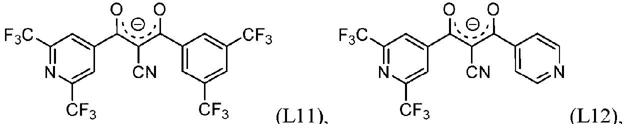

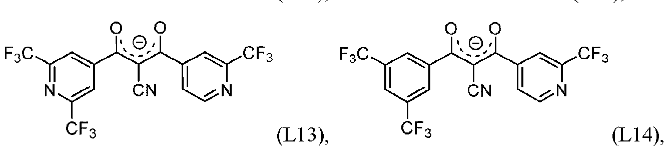

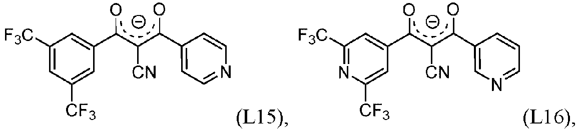

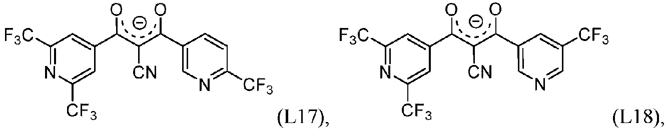

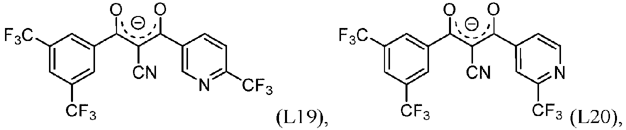

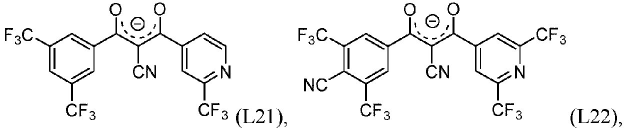

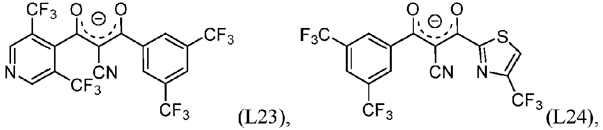

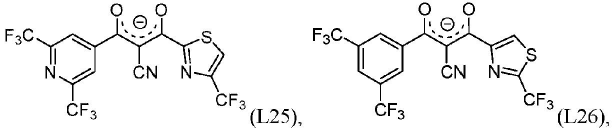

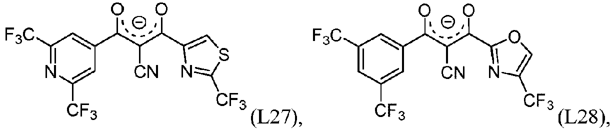

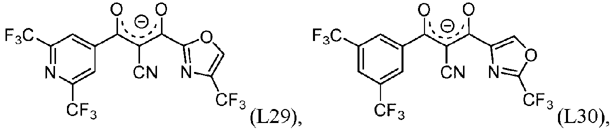

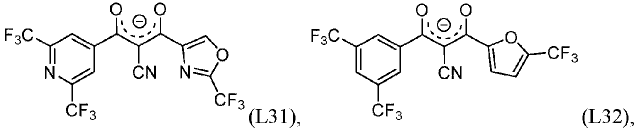

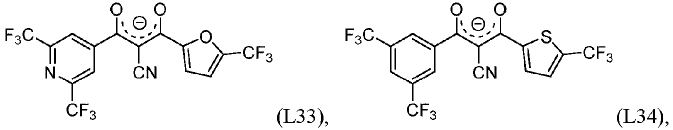

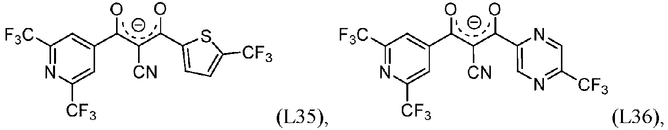

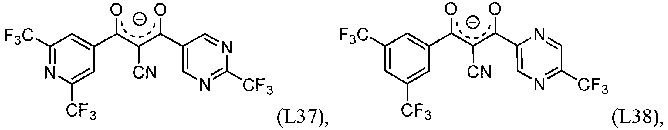

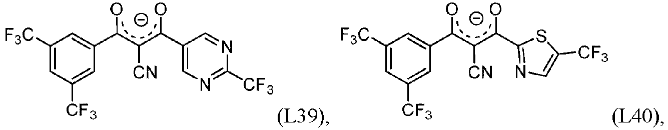

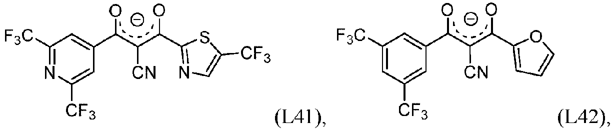

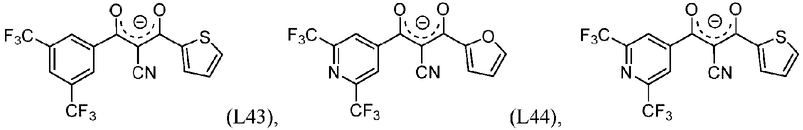

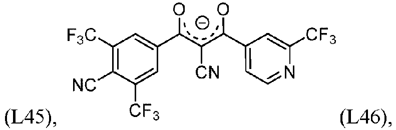

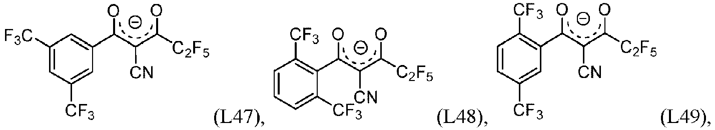

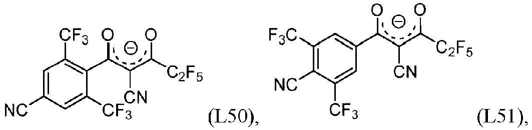

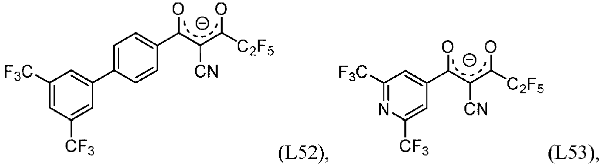

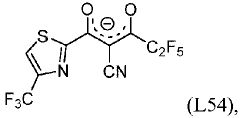

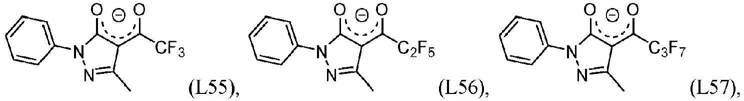

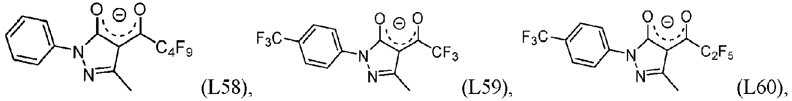

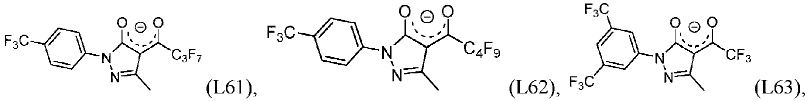

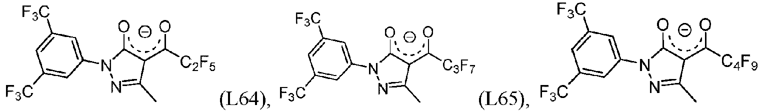

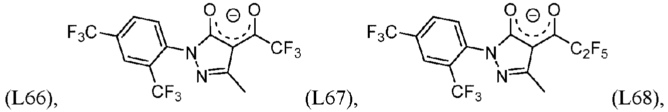

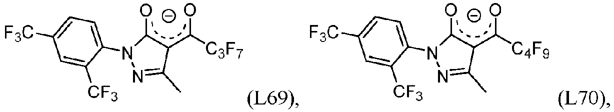

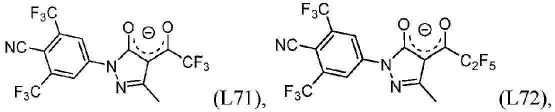

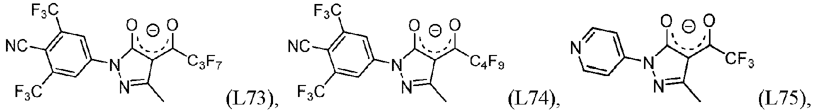

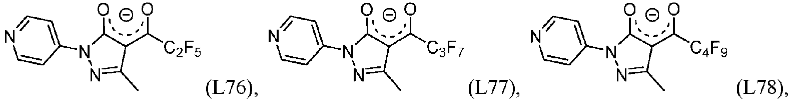

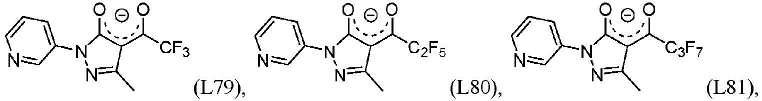

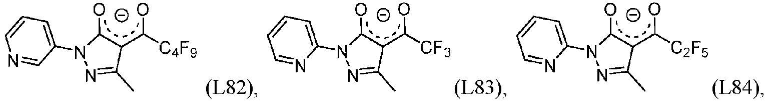

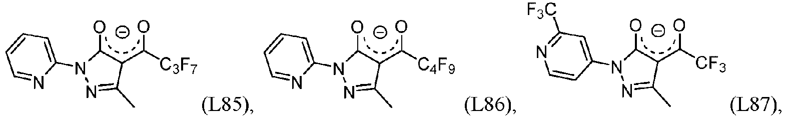

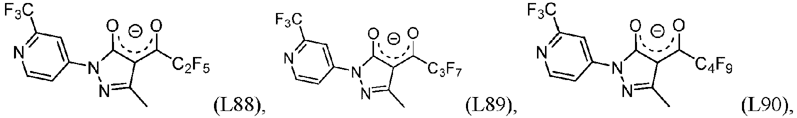

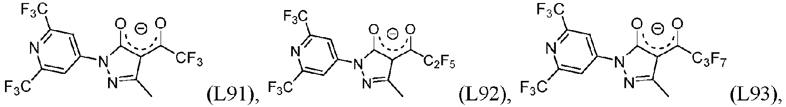

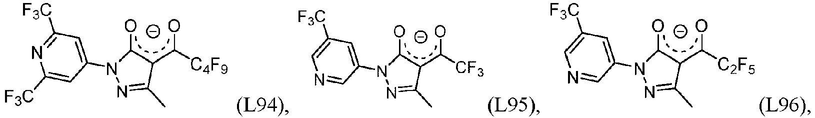

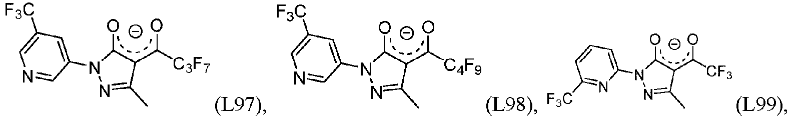

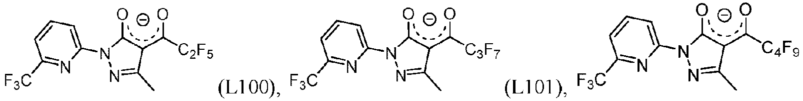

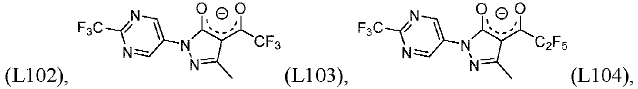

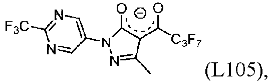

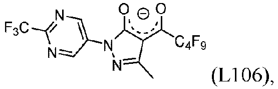

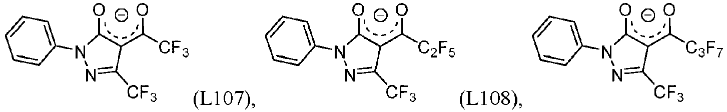

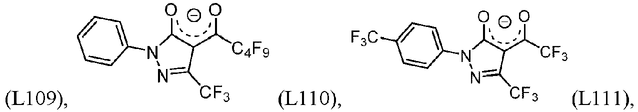

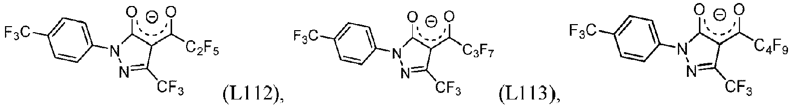

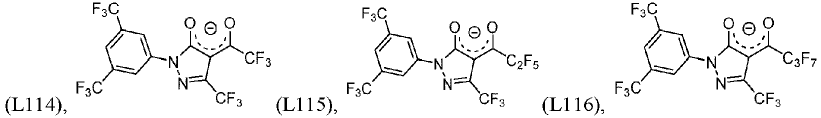

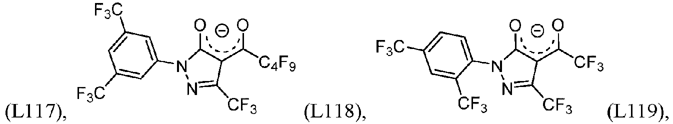

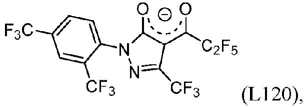

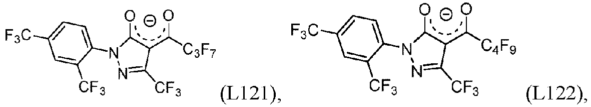

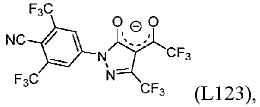

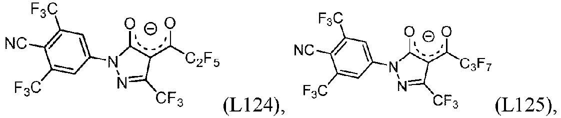

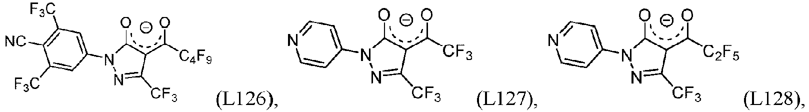

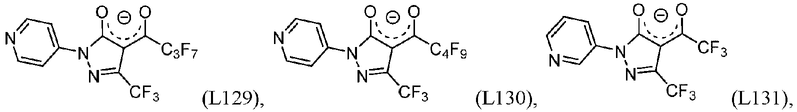

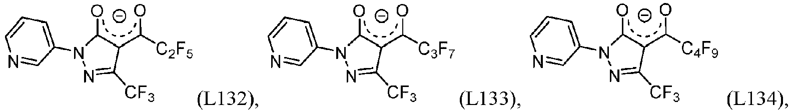

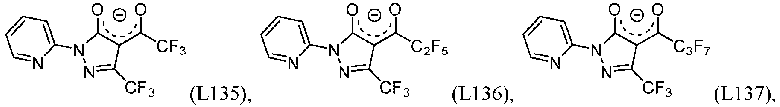

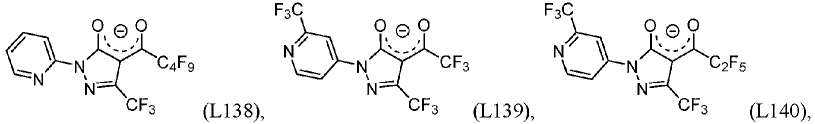

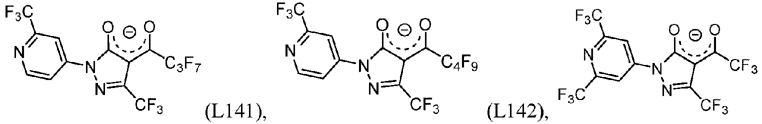

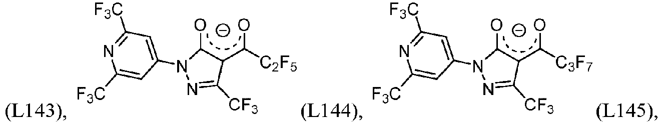

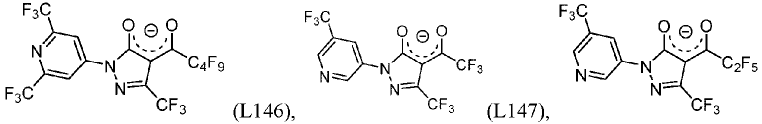

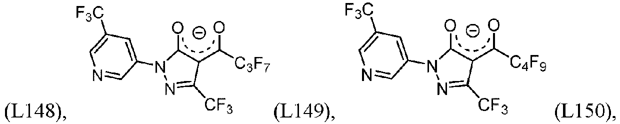

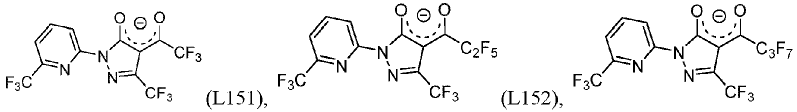

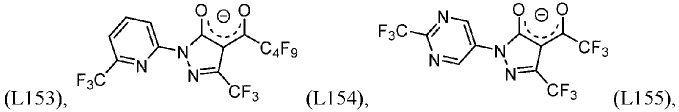

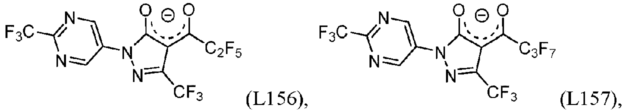

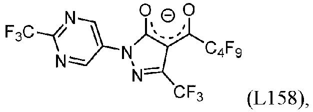

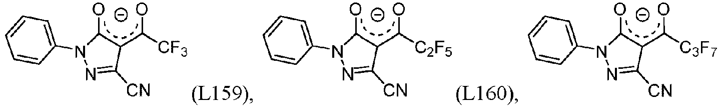

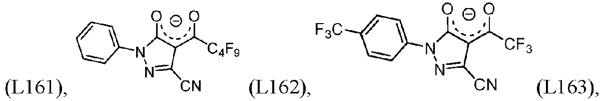

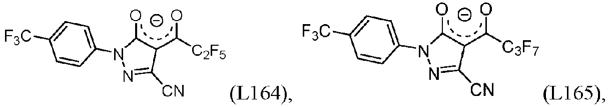

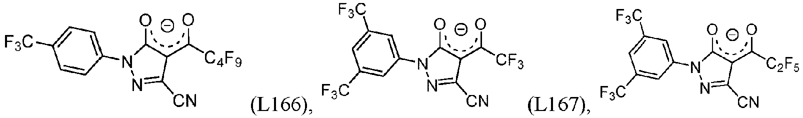

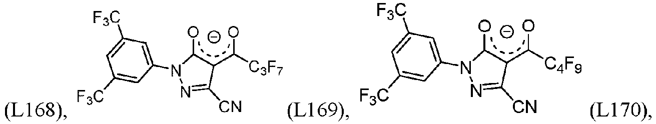

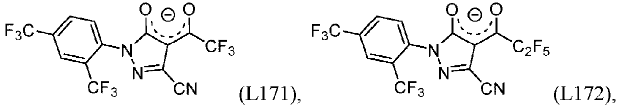

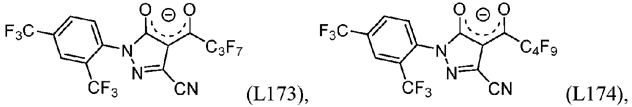

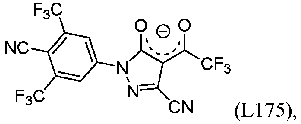

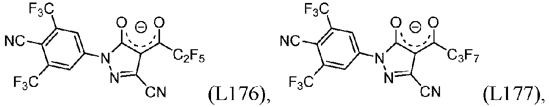

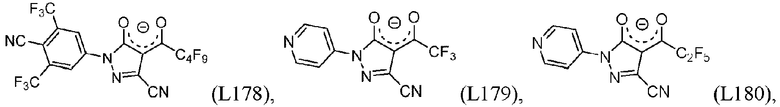

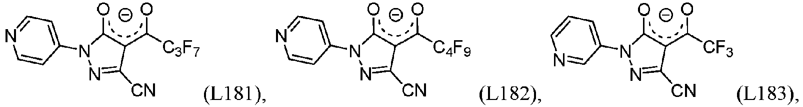

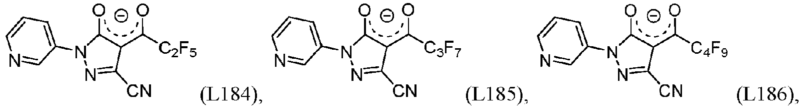

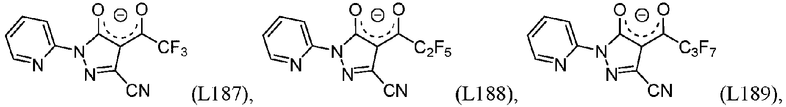

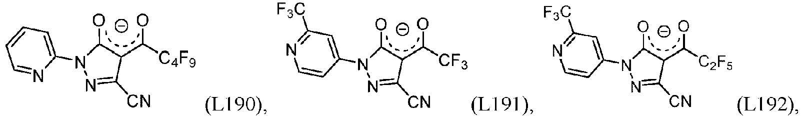

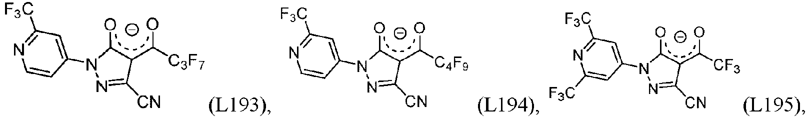

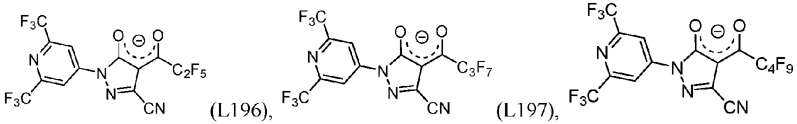

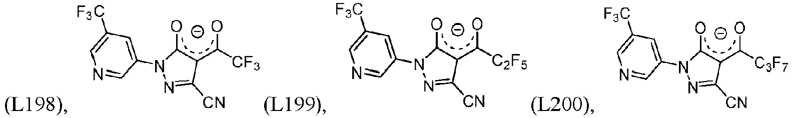

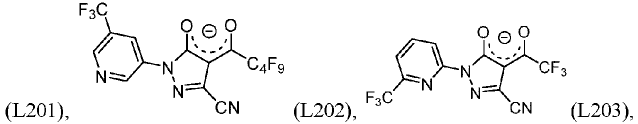

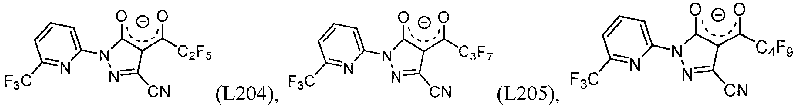

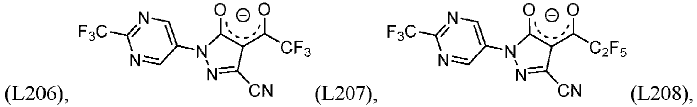

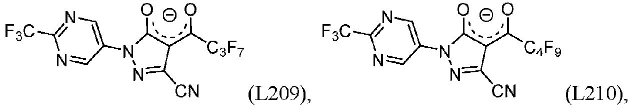

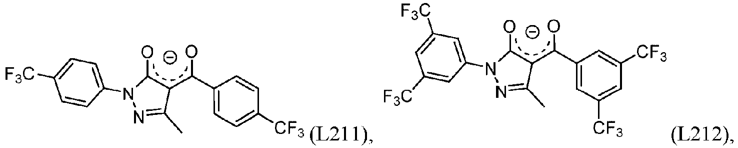

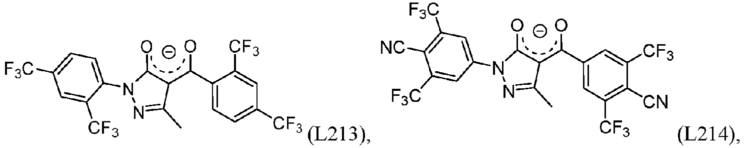

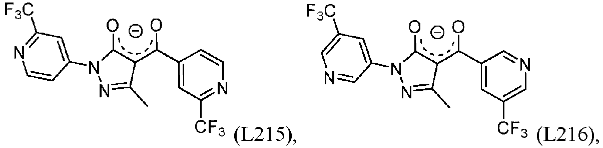

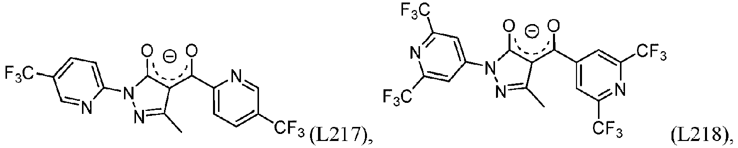

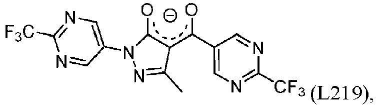

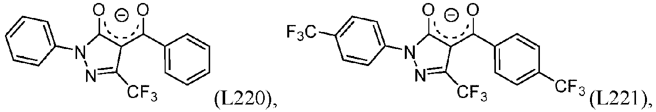

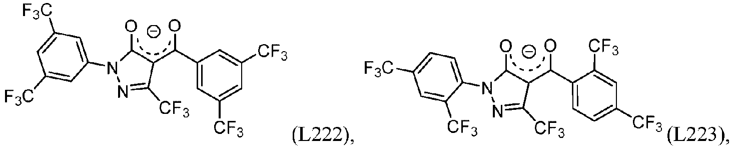

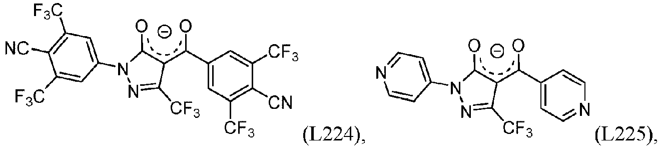

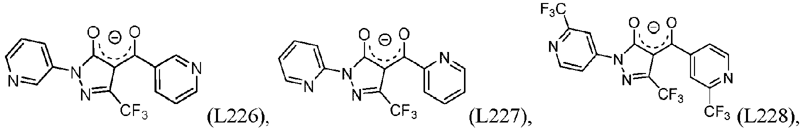

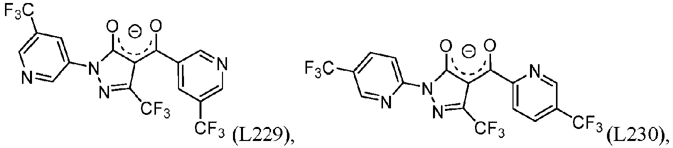

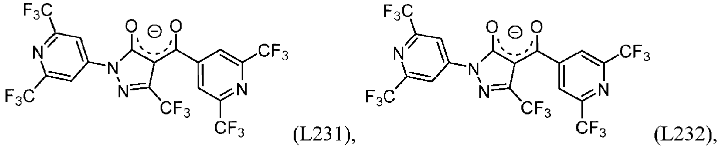

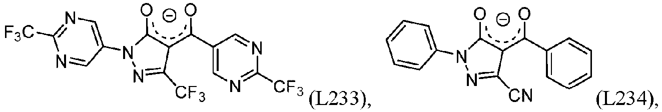

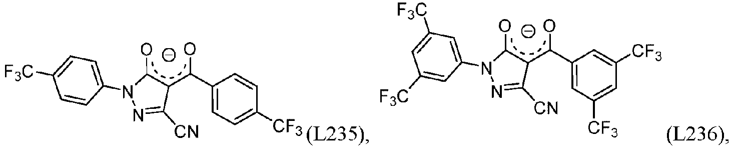

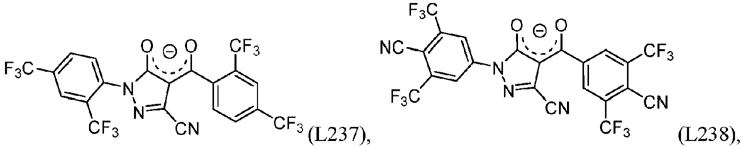

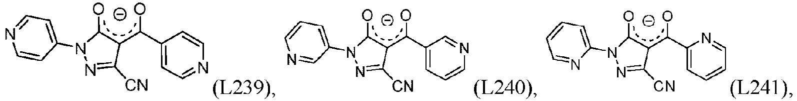

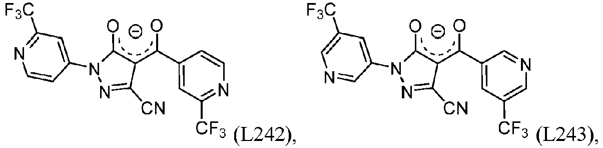

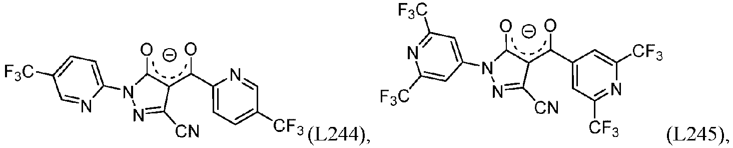

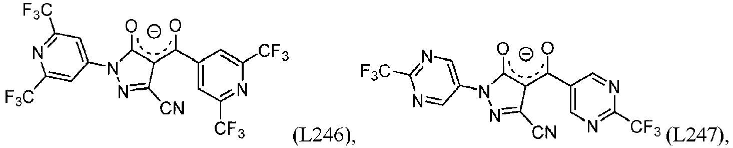

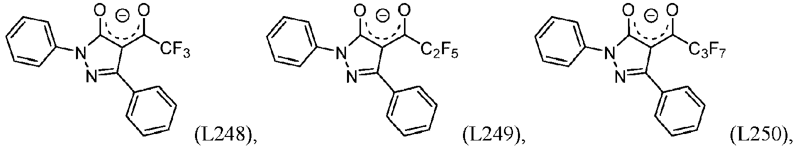

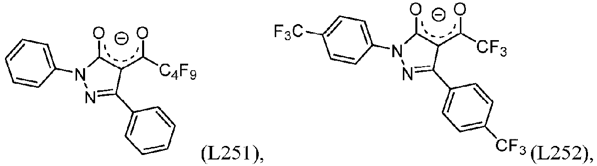

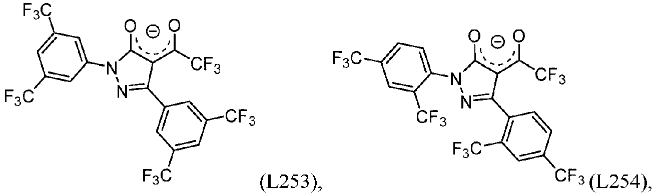

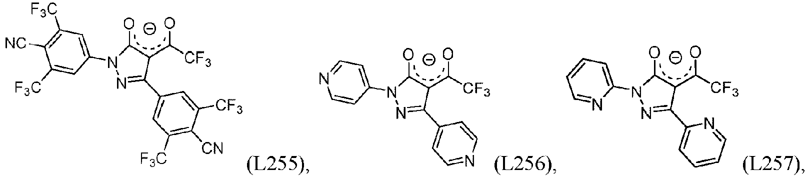

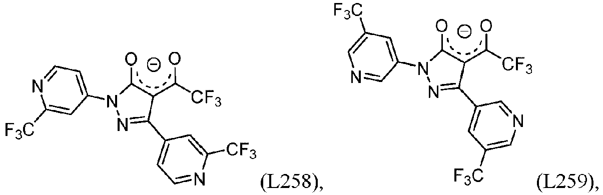

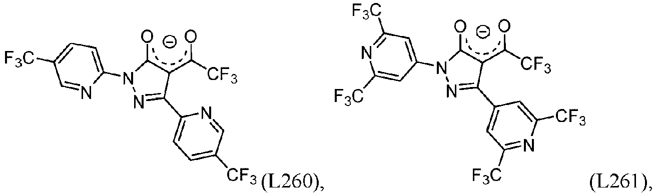

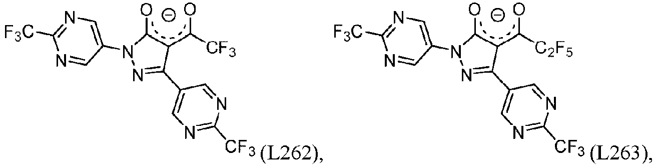

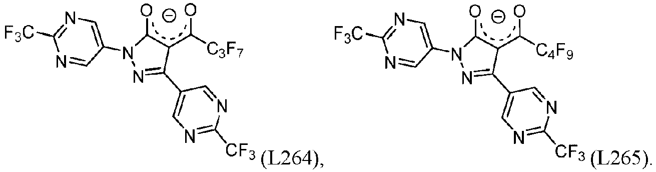

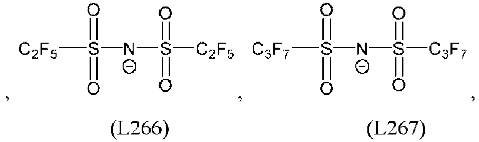

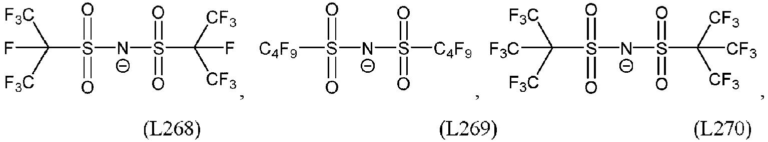

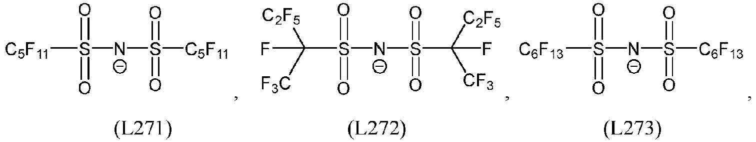

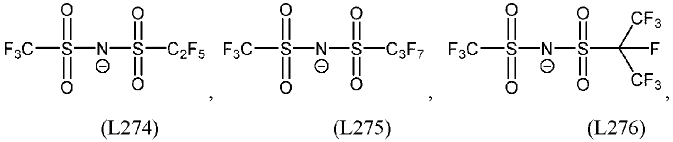

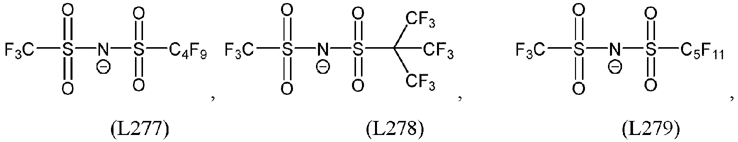

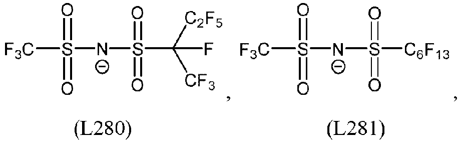

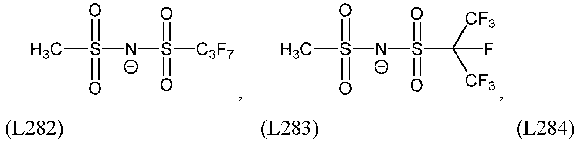

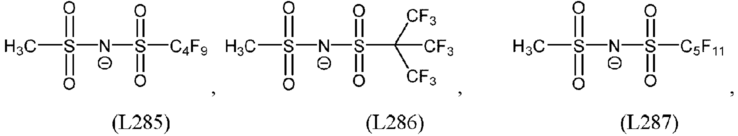

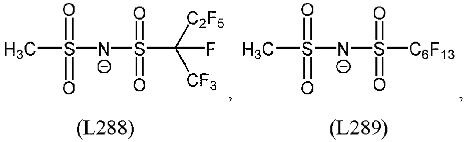

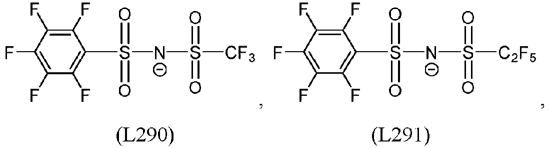

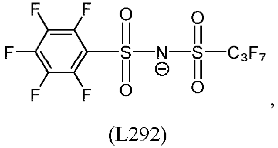

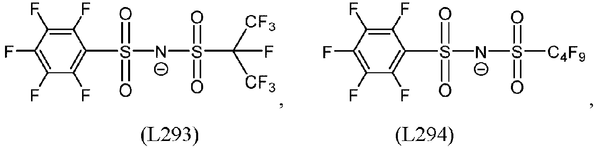

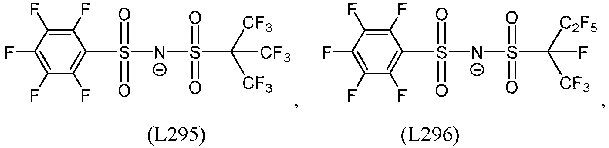

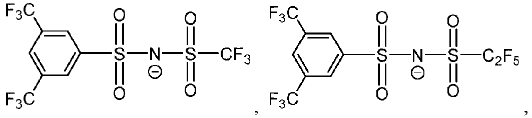

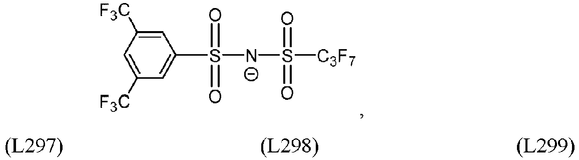

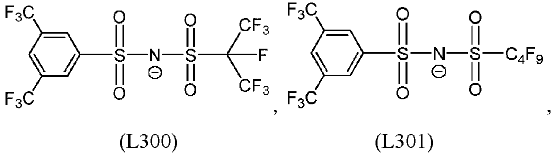

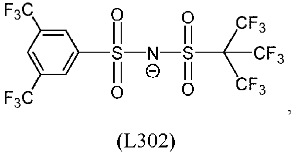

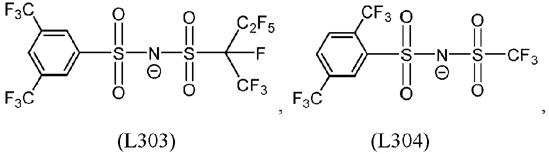

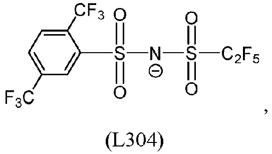

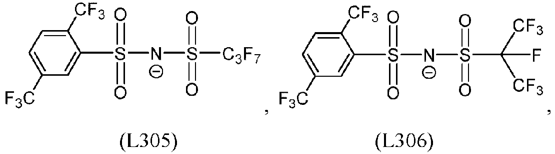

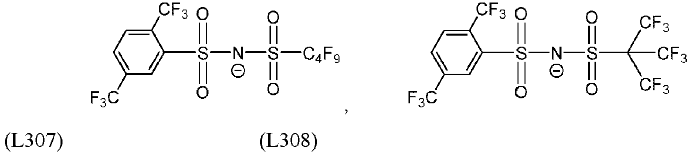

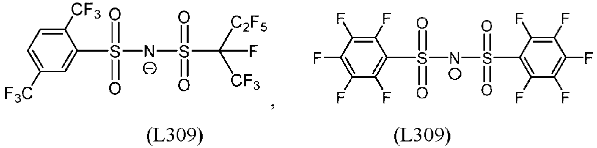

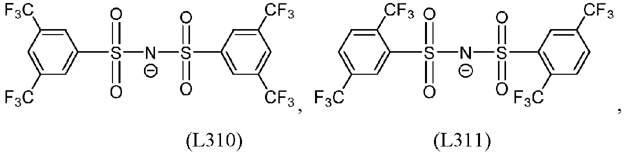

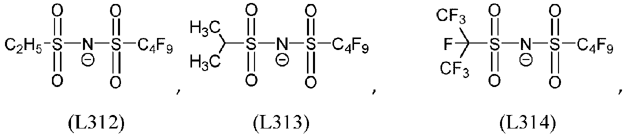

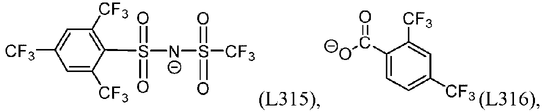

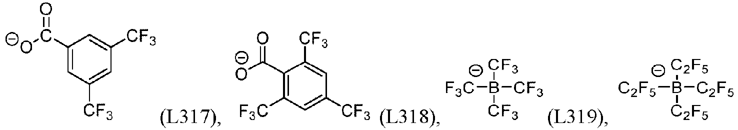

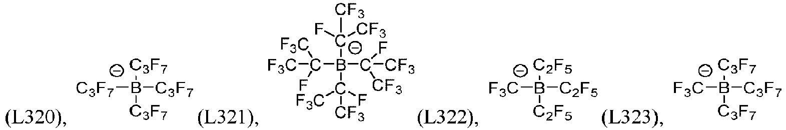

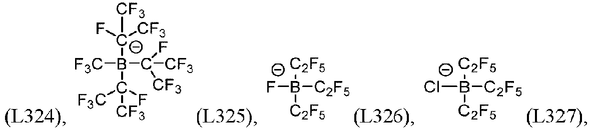

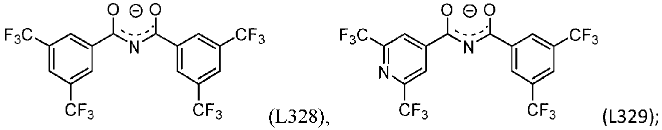

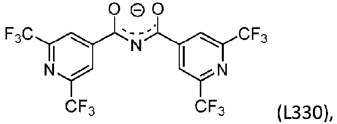

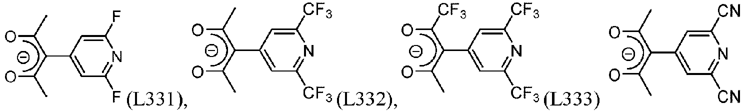

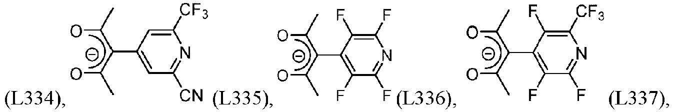

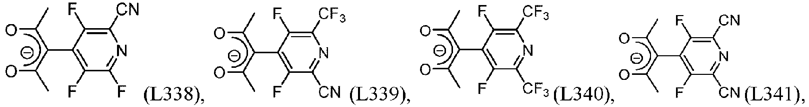

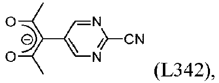

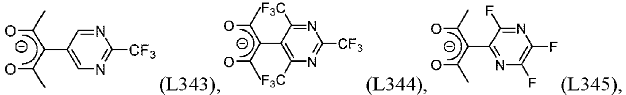

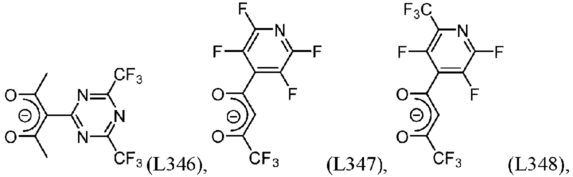

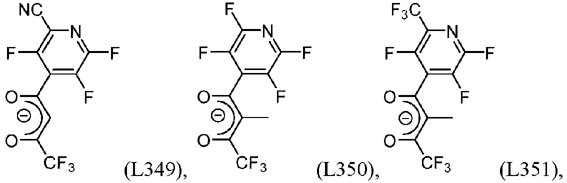

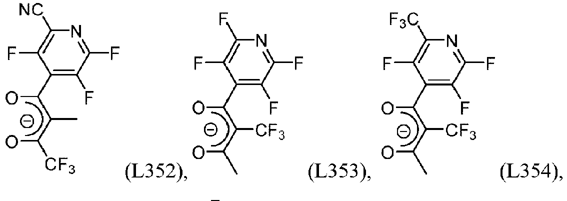

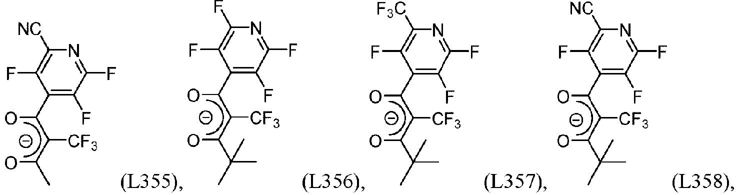

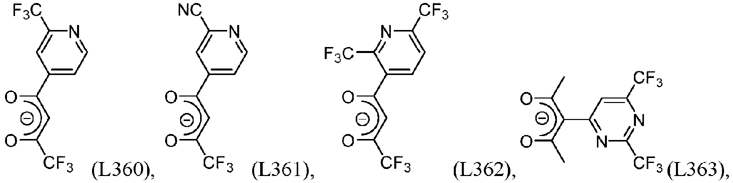

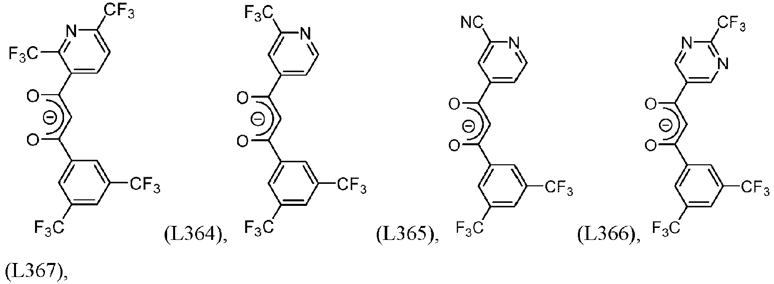

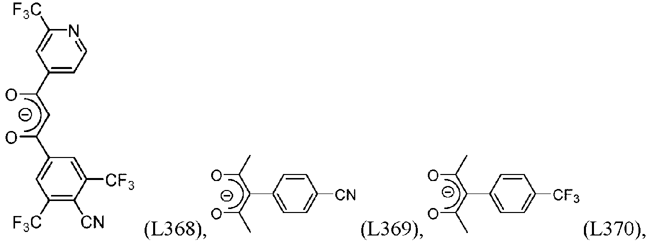

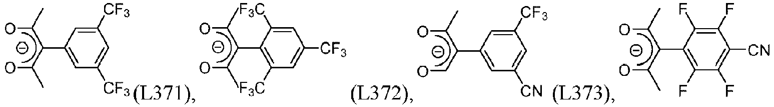

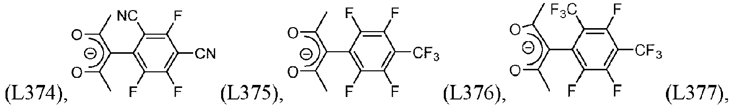

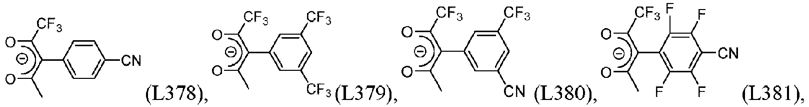

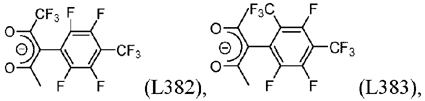

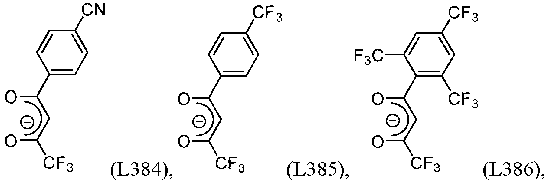

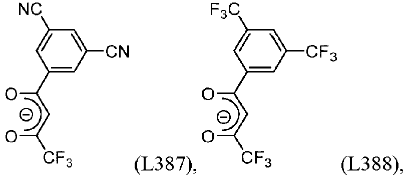

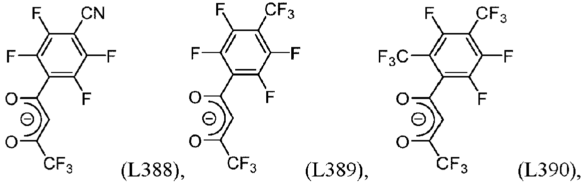

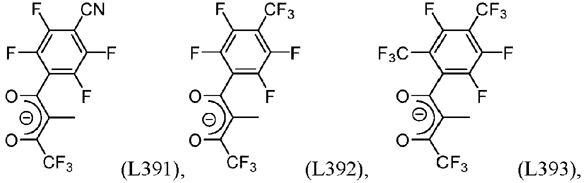

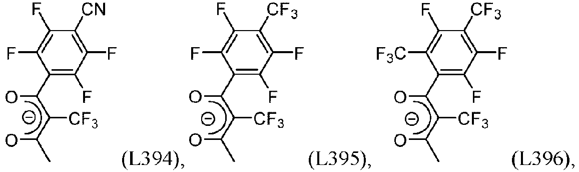

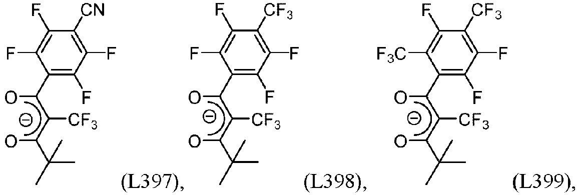

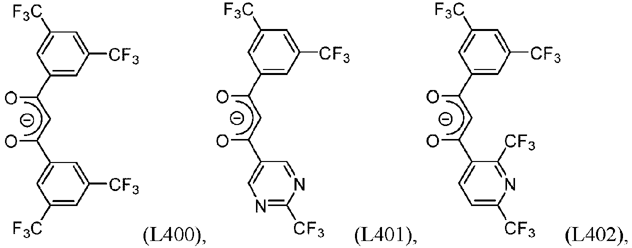

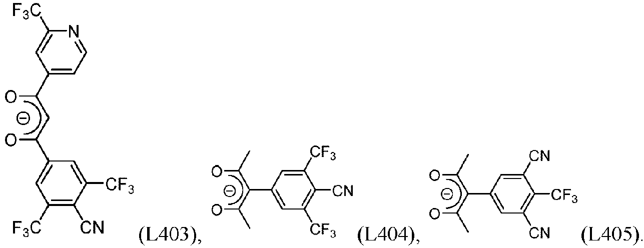

7. Organische elektrolumineszierende Vorrichtung nach einem der Ansprüche 1 bis 6, wobei die Verbindung der Formel (I) in der p-Typ-Ladungserzeugungsschicht in einer Menge von ≥1 Gew.-% und ≤20 Gew.-%, bezogen auf das Gesamtgewicht der p-Typ-Ladungserzeugungsschicht, vorliegt.

8. Organische elektrolumineszierende Vorrichtung nach einem der Ansprüche 1 bis 7, wobei die Verbindung der Formel (I) mindestens eine CF₃-Gruppe umfasst.

9. Organische elektrolumineszierende Vorrichtung nach einem der Ansprüche 1 bis 8, wobei in Formel (I) Ar¹, Ar² und Ar³ unabhängig voneinander aus einer Gruppe gemäß der folgenden Formel (III) ausgewählt sind und vorzugsweise R' jeweils aus CN ausgewählt ist. 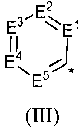 wobei
E¹ aus CW¹ oder N ausgewählt ist,
E² aus CW² oder N ausgewählt ist,
E³ aus CW³ oder N ausgewählt ist,
E⁴ aus CW⁴ oder N ausgewählt ist,
E⁵ aus CW⁵ oder N ausgewählt ist,
W¹, W², W³, W⁴ und W⁵ (falls vorhanden) unabhängig voneinander aus einer elektronenziehenden Gruppe, CN, Halogen, Cl, F, NO₂, substituiertem oder unsubstituiertem C₁- bis C₈-Alkyl, teilweise fluoriertem C₁- bis C₈-Alkyl, perfluoriertem C₁- bis C₈-Alkyl, substituiertem oder unsubstituiertem C₁- bis C₈-Alkoxy, teilweise fluoriertem C₁- bis C₈-Alkoxy, perfluoriertem C₁- bis C₆-Alkoxy, OCF₃, substituiertem oder unsubstituiertem C₆- bis C₃₀-Aryl, substituiertem oder unsubstituiertem C₃- bis C₃₀-Heteroaryl, D oder H ausgewählt sind,
wobei der eine oder die mehreren Substituenten unabhängig voneinander aus D, Halogen, Cl, F, CN, NO₂, teilweise fluoriertem C₁- bis C₈-Alkyl, perfluoriertem C₁- bis C₈-Alkyl, teilweise fluoriertem C₁- bis C₈-Alkoxy, perfluoriertem C₁- bis C₈-Alkoxy ausgewählt sind,
wobei das Sternchen "*" die Bindungsposition bezeichnet.

10. Organische elektrolumineszierende Vorrichtung nach Anspruch 9, wobei in Formel (III) W¹, W², W³, W⁴ und W⁵ (falls vorhanden) unabhängig aus einer elektronenziehenden Gruppe, CN, Halogen, Cl, F, NO₂, teilweise fluoriertem oder perfluoriertem C₁- bis C₈-Alkyl, teilweise fluoriertem oder perfluoriertem C₁- bis C₆-Alkoxy, D oder H ausgewählt sind und wobei vorzugsweise R' jeweils für CN steht

11. Organische elektrolumineszierende Vorrichtung nach einem der Ansprüche 1 bis 10, wobei in Formel (I) Ar¹, Ar² und Ar³ unabhängig voneinander aus B1 bis B64 ausgewählt sind und vorzugsweise R' jeweils für CN steht: 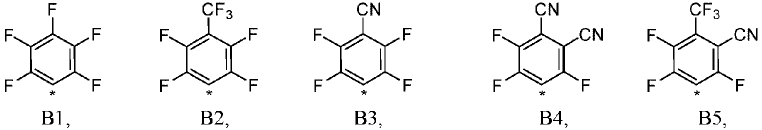 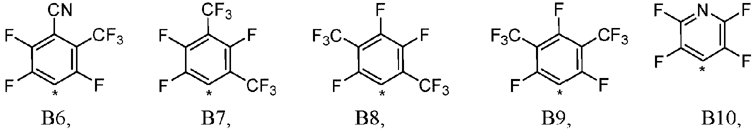 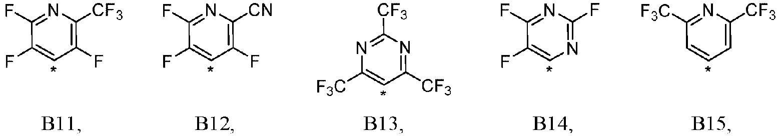 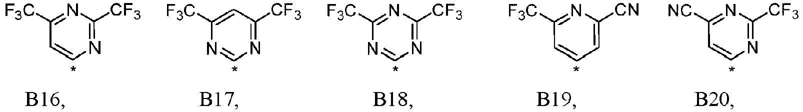 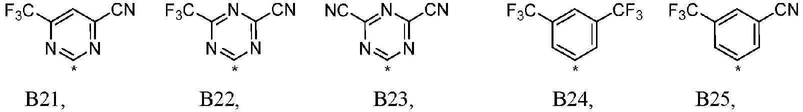 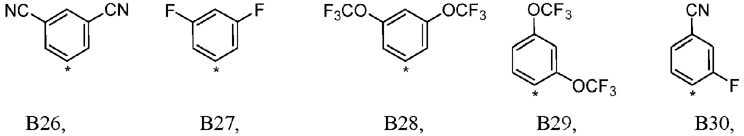 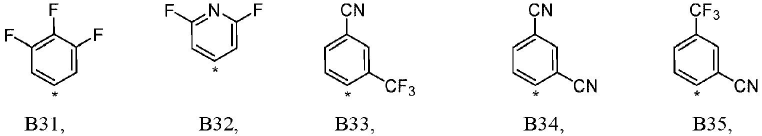 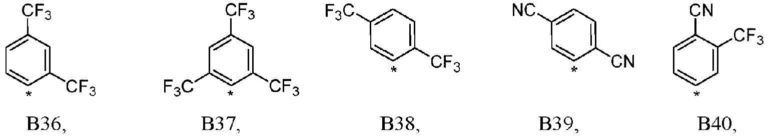 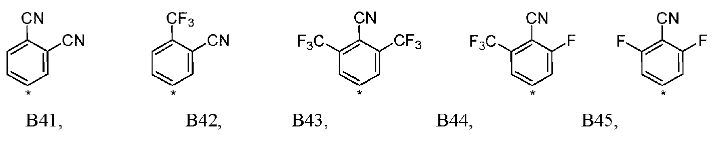 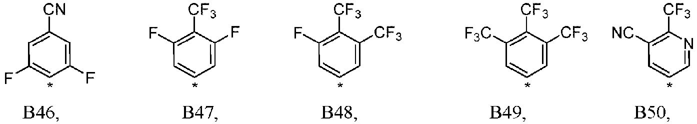 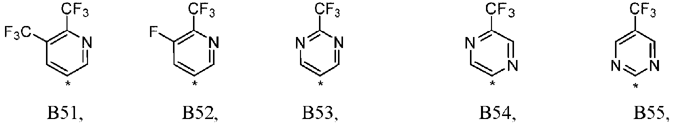 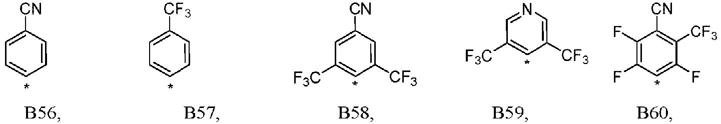 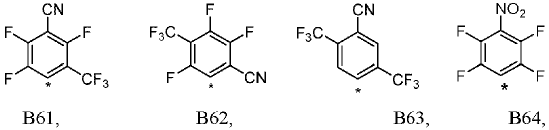 wobei das Sternchen "*" die Bindungsposition bezeichnet.

12. Organische elektrolumineszierende Vorrichtung nach einem der Ansprüche 1 bis 11, wobei der Metalldotierungsstoff der ersten n-Typ-Ladungserzeugungsschicht ein aus der aus Li, Mg und Yb bestehenden Gruppe ausgewähltes Metall oder eine ein aus der aus Li, Mg und Yb bestehenden Gruppe ausgewähltes Metall umfassende Metalllegierung ist.

13. Organische elektrolumineszierende Vorrichtung nach einem der Ansprüche 1 bis 12, wobei der Metalldotierungsstoff der ersten n-Typ-Ladungserzeugungsschicht Yb oder eine ein aus der aus Li und Yb bestehenden Gruppe ausgewähltes Metall umfassende Metalllegierung ist.

14. Organische elektrolumineszierende Vorrichtung nach einem der Ansprüche 1 bis 13, wobei die organische lumineszierende Vorrichtung eine organische Leuchtdiode ist.

15. Anzeigevorrichtung, die eine organische elektrolumineszierende Vorrichtung nach einem der Ansprüche 1 bis 14 umfasst.

## Revendications

1. Dispositif électroluminescent organique (100) comprenant une couche d'anode (120), une couche de cathode (190), une première couche d'émission (145), une deuxième couche d'émission (245), une couche d'injection de trous (130), et une première couche de génération de charge (160) ;
dans lequel la couche d'injection de trous (130) est en contact direct avec la couche d'anode ;
Dans lequel la couche d'injection de trous (130) comprend un premier composé de matrice de transport de trous et un composé de formule (II) qui est un composé métallique choisi parmi un sel métallique ou un complexe métallique comprenant un cation métallique et au moins un monoanion constitué d'au moins 20 atomes liés de manière covalente et/ou au moins un ligand monoanionique constitué d'au moins 20 atomes liés de manière covalente ;
dans lequel la première couche de génération de charge (160) est agencée entre la première couche d'émission (145) et la deuxième couche d'émission (245) ;
dans lequel la première couche de génération de charge (160) comprend une première couche de génération de charge de type n (161) et une première couche de génération de charge de type p (162) ;
dans lequel la première couche de génération de charge de type n (161) est plus proche de la couche d'anode (120) que la première couche de génération de charge de type p (162) ;
dans lequel la première couche de génération de charge de type n (161) comprend un dopant métallique et un composé de matrice,
**caractérisé en ce que** la première couche de génération de charge de type p (162) comprend un deuxième composé de matrice de transport de trous et un composé de formule (I) ; 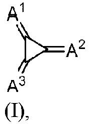
dans lequel, dans la formule (I)
- A¹ est indépendamment choisi parmi un groupe de formule (Ia) 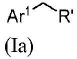
dans laquelle Ar¹ est indépendamment choisi parmi C₆ à C₃₆ aryle substitué ou non substitué, et C₂ à C₃₆ hétéroaryle substitué ou non substitué ;
dans laquelle, dans le cas où Ar¹ est substitué, un ou plusieurs des substituants sont indépendamment choisis dans le groupe constitué par D, un groupe électroattracteur, halogène, Cl, F, CN, -NO₂, alkyle en C₁ à C₈ substitué ou non substitué, alkyle en C₁ à C₈ partiellement fluoré, alkyle en C₁ à C₈ perfluoré, alcoxy en C₁ à C₈ substitué ou non substitué, alcoxy en C₁ à C₈ partiellement fluoré, alcoxy en C₁ à C₈ perfluoré, aryle en C₆ à C₃₀ substitué ou non substitué, et hétéroaryle en C₆ à C₃₀ substitué ou non substitué et ;
dans laquelle le ou les substituants de aryle en C₆ à C₃₀, hétéroaryle en C₆ à C₃₀, alkyle en C₁ à C₈, alcoxy en C₁ à C₈ sont choisis indépendamment parmi D, un groupe électroattracteur, halogène, Cl, F, CN, -NO₂, alkyle en C₁ à C₈ partiellement fluoré, alkyle en C₁ à C₈ perfluoré, alcoxy en C₁ à C₈ partiellement fluoré, alcoxy en C₁ à C₈ perfluoré ;
- A² est indépendamment choisi parmi un groupe de formule (Ib) 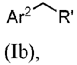
dans laquelle Ar² est indépendamment choisi parmi C₆ à C₃₆ aryle substitué ou non substitué, et C₂ à C₃₆ hétéroaryle substitué ou non substitué ;
dans laquelle, dans le cas où Ar² est substitué, un ou plusieurs des substituants sont indépendamment choisis dans le groupe constitué par D, un groupe électroattracteur, halogène, Cl, F, CN, -NO₂, alkyle en C₁ à C₈ substitué ou non substitué, alkyle en C₁ à C₈ partiellement fluoré, alkyle en C₁ à C₈ perfluoré, alcoxy en C₁ à C₈ substitué ou non substitué, alcoxy en C₁ à C₈ partiellement fluoré, alcoxy en C₁ à C₈ perfluoré, aryle en C₆ à C₃₀ substitué ou non substitué, et hétéroaryle en C₆ à C₃₀ substitué ou non substitué et ;
dans laquelle le ou les substituants de aryle en C₆ à C₃₀, hétéroaryle en C₆ à C₃₀, alkyle en C₁ à C₈, alcoxy en C₁ à C₈ sont choisis indépendamment parmi D, un groupe électroattracteur, halogène, Cl, F, CN, -NO₂, alkyle en C₁ à C₈ partiellement fluoré, alkyle en C₁ à C₈ perfluoré, alcoxy en C₁ à C₈ partiellement fluoré, alcoxy en C₁ à C₈ perfluoré ;
- A³ est indépendamment choisi parmi un groupe de formule (Ic) 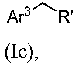
dans laquelle Ar³ est indépendamment choisi parmi C₆ à C₃₆ aryle substitué ou non substitué, et C₂ à C₃₆ hétéroaryle substitué ou non substitué ;
dans laquelle, dans le cas où Ar³ est substitué, un ou plusieurs des substituants sont indépendamment choisis dans le groupe constitué par D, un groupe électroattracteur, halogène, Cl, F, CN, -NO₂, alkyle en C₁ à C₈ substitué ou non substitué, alkyle en C₁ à C₈ partiellement fluoré, alkyle en C₁ à C₈ perfluoré, alcoxy en C₁ à C₈ substitué ou non substitué, alcoxy en C₁ à C₈ partiellement fluoré, alcoxy en C₁ à C₈ perfluoré, aryle en C₆ à C₃₀ substitué ou non substitué, et hétéroaryle en C₆ à C₃₀ substitué ou non substitué et ;
dans laquelle le ou les substituants de aryle en C₆ à C₃₀, hétéroaryle en C₆ à C₃₀, alkyle en C₁ à C₈, alcoxy en C₁ à C₈ sont choisis indépendamment parmi D, un groupe électroattracteur, halogène, Cl, F, CN, -NO₂, alkyle en C₁ à C₈ partiellement fluoré, alkyle en C₁ à C₈ perfluoré, alcoxy en C₁ à C₈ partiellement fluoré, alcoxy en C₁ à C₈ perfluoré ;
et dans laquelle, dans A¹, A², et A³, chaque R' est indépendamment choisi parmi aryle en C₆ à C₁₈ substitué ou non substitué, hétéroaryle en C₃ à C₁₈, un groupe électroattracteur, alkyle en C₁ à C₈ substitué ou non substitué, alkyle en C₁ à C₈ partiellement fluoré, alkyle en C₁ à C₈ perfluoré, halogène, F et CN ;
dans laquelle le ou les substituants de aryle en C₆ à C₁₈, hétéroaryle en C₆ à C₁₈, alkyle en C₁ à C₈ sont indépendamment choisis parmi D, un groupe électroattracteur, halogène, Cl, F, CN, -NO₂, alkyle en C₁ à C₆ partiellement fluoré, alkyle en C₁ à C₆ perfluoré, alcoxy en C₁ à C₆ partiellement fluoré, alcoxy en C₁ à C₆ perfluoré.

2. Dispositif électroluminescent organique selon la revendication 1, dans lequel le composé de formule (II) a un niveau d'énergie LUMO de ≥ -7,0 eV à ≤ -1,5 eV, moyennant quoi les calculs sont effectués en appliquant le B3LYP fonctionnel hybride avec l'ensemble de base Def2-TZVP avec les potentiels de noyau effectif SDD (ECP) pour les métaux dans la phase gazeuse tels que mis en œuvre dans le paquet de programme ORCA version 5.0.3-f.1 (Department of Theory and Spectroscopy, Max Planck Institute für Kohlenforschung Kaiser Wilhelm Platz 1, 45470 Muelheim/Ruhr, Allemagne).

3. Dispositif électroluminescent organique selon la revendication 1 ou 2, dans lequel le composé de formule (II) comprend au moins un monoanion constitué d'au moins 20 atomes liés de manière covalente et/ou au moins un ligand monoanionique constitué d'au moins 20 atomes liés de manière covalente, le monoanion ou le ligand monoanionique étant présenté par L- selon la formule (IV) ou le composé de formule (II) étant représenté par la formule (IIa) : 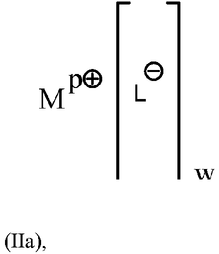 dans laquelle
M est un ion métallique ;
p est la valence de M ;
w est n ;
dans laquelle L⁻ peut être choisi identique ou différent ;
dans laquelle le composé de formule (IIa) peut éventuellement comprendre un ligand auxiliaire (Al), qui coordine au cation métallique ou au cation métallique M^{p+} ;
dans laquelle L⁻ est représenté par 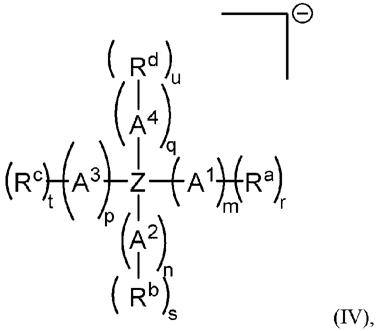
m, n, p, et q sont indépendamment choisis parmi 0 ou 1 ; r, s, t, et u sont indépendamment choisis parmi 0 ou 1 ; au moins l'un de r, s, t, et u est 1 ;
Z est choisi parmi CR¹, C, O, N, B ;
si Z est choisi O, alors n, p, q et sont choisis parmi 0 et s, t et u sont choisis parmi 0 ;
si Z est choisi parmi N ou CR¹, alors p et q sont choisis parmi 0, et t et u sont choisis parmi 0 ;
si Z est choisi parmi C, alors q est choisi parmi 0, et u est choisi parmi 0 ;
si Z est choisi parmi B, alors n, m, p, et q sont choisis parmi 1, et r, s, t, et u sont choisis parmi 1 ;
A¹, A², A³ et A⁴ sont choisis indépendamment parmi C=O, C-O, C=NR², C-NR³, SO, SO₂, ou P(=O)R⁴ ;
dans laquelle Z peut former une double liaison à A¹, A², A³ et A⁴, si A¹, A², A³ et A⁴ sont choisis parmi C-O ou C-NR³ et Z est choisi parmi N, O ou CR¹, ou A¹, A², A³ et A⁴ sont choisis parmi C-O ou C-NR³ et Z sont choisis parmi C ;
et dans laquelle éventuellement deux parmi A¹, A², A³ et A⁴ peuvent former avec Z conjointement un hétérocycle substitué ou non substitué ou un carbocycle substitué ou non substitué, ou dans laquelle éventuellement l'un parmi A¹, A², A³ et A⁴ peut former avec Z un hétérocycle substitué ou non substitué ou un carbocycle substitué ou non substitué,
dans laquelle le ou les substituants sur l'hétérocycle ou le carbocycle sont indépendamment choisis parmi D, un groupe électroattracteur, halogène, F, CN, NO₂, SF₅, isonitrile, un groupe ester, un groupe carboxylique, un groupe carbonyle, un groupe acyle, un groupe thio, un groupe sulfinyle, un groupe sulfonyle, un groupe phosphine, alkyle substitué ou non substitué, C₁ à C₁₂ alkyle partiellement perfluoré, C₁ à C₁₂ alkyle perfluoré, CF₃, C₁ à C₆ alcoxy partiellement perfluoré, C₁ à C₆ alcoxy perfluoré, OCF₃, C₆ à C₄₀ aryle substitué ou non substitué, C₂ à C₄₀ hétéroaryle substitué ou non substitué, C₃ à C₃₀ carbocyclyle substitué ou non substitué, ou C₂ à C₃₀ hétérocyclyle substitué ou non substitué ;
R¹ est choisi parmi H, D, un groupe électroattracteur, halogène, Cl, F, CN, NO₂, SF₅, isonitrile, un groupe ester, un groupe carboxylique, un groupe carbonyle, un groupe acyle, un groupe thio, un groupe sulfinyle, un groupe sulfonyle, un groupe phosphine, C₁ à C₁₂ alkyle substitué ou non substitué, C₁ à C₁₂ alkyle partiellement perfluoré, C₁ à C₁₂ alkyle perfluoré, CF₃, C₁ à C₁₂ alcoxy substitué ou non substitué, C₁ à C₆ alcoxy partiellement perfluoré, C₁ à C₆ alcoxy perfluoré, OCF₃, C₆ à C₄₀ aryle substitué ou non substitué, C₂ à C₄₀ hétéroaryle substitué ou non substitué, C₃ à C₃₀ carbocyclyle substitué ou non substitué, C₃ à C₃₀ hétérocyclyle substitué ou non substitué ;
dans laquelle le ou les substituants sur R¹ sont indépendamment choisis parmi D, un groupe électroattracteur, halogène, F, CN, NO₂, SF₅, isonitrile, un groupe ester, un groupe carboxylique, un groupe carbonyle, un groupe acyle, un groupe thio, un groupe sulfinyle, un groupe sulfonyle, un groupe phosphine, alkyle en C₁ à C₁₂ partiellement perfluoré, alkyle en C₁ à C₁₂ perfluoré, CF₃, alcoxy en C₁ à C₆ partiellement perfluoré, alcoxy en C₁ à C₆ perfluoré, OCF₃, =N ;
R², R³ et R⁴ sont indépendamment choisis parmi H, D, un groupe électroattracteur, halogène, Cl, F, CN, un groupe ester, un groupe carboxylique, un groupe carbonyle, un groupe acyle, un groupe thio, un groupe sulfinyle, un groupe sulfonyle, un groupe phosphine, alkyle substitué ou non substitué, C₁ à C₁₂ alkyle partiellement perfluoré, C₁ à C₁₂ alkyle perfluoré, CF₃, C₁ à C₆ alcoxy substitué ou non substitué, C₁ à C₆ alcoxy partiellement perfluoré, C₁ à C₆ alcoxy perfluoré, OCF₃, C₆ à C₄₀ aryle substitué ou non substitué, C₂ à C₃₀ hétéroaryle substitué ou non substitué, C₃ à C₃₀ carbocyclyle substitué ou non substitué, C₂ à C₃₀ hétérocyclyle substitué ou non substitué,
dans laquelle les substituants sur R², R³ et R⁴ sont indépendamment choisis parmi D, un groupe électroattracteur, halogène, Cl, F, CN, NO₂, SF₅, isonitrile, un groupe ester, un groupe carboxylique, un groupe carbonyle, un groupe acyle, un groupe thio, un groupe sulfinyle, un groupe sulfonyle, un groupe phosphine, alkyle en C₁ à C₁₂ partiellement perfluoré, alkyle en C₁ à C₁₂ perfluoré, CF₃, alcoxy en C₁ à C₆ partiellement perfluoré, alcoxy en C₁ à C₆ perfluoré, OCF₃ ;
R^{a}, R^{b}, R^{c} et R^{d} sont indépendamment choisis parmi H, D, un groupe électroattracteur, halogène, F, Cl, CN, alkyle en C₁ à C₁₂ substitué ou non substitué, alkyle en C₁ à C₁₂ partiellement perfluoré, alkyle en C₁ à C₁₂ perfluoré, CF₃, aryle en C₆ à C₄₀ substitué ou non substitué, hétéroaryle en C₂ à C₃₀ substitué ou non substitué, carbocyclyle substitué ou non substitué, hétérocyclyle en C₂ à C₃₀ substitué ou non substitué, O, S, N, NR⁵, un groupe amine ayant 0 à 20 atomes de carbone substitué ou non substitué ;
dans laquelle le ou les substituants sur R^{a}, R^{b}, R^{c} et R^{d} sont indépendamment choisis parmi un groupe électroattracteur, halogène, F, CN, NO₂, SF₅, isonitrile, un groupe ester, un groupe carboxylique, un groupe carbonyle, un groupe acyle, un groupe thio, un groupe sulfinyle, un groupe sulfonyle, un groupe phosphine, alkyle en C₁ à C₁₂ partiellement perfluoré, alkyle en C₁ à C₁₂ perfluoré, alcoxy en C₁ à C₆ partiellement perfluoré, alcoxy en C₁ à C₆ perfluoré, OCF₃ ;
dans laquelle R⁵ est choisi parmi C₆ à C₄₀ aryle substitué ou non substitué, C₂ à C₄₀ hétéroaryle substitué ou non substitué, C₁ à C₁₂ alkyle substitué ou non substitué, C₁ à C₁₂ alkyle partiellement perfluoré, C₁ à C₁₂ alkyle perfluoré,
dans laquelle le ou les substituants sur R⁵ sont choisis parmi un groupe électroattracteur, halogène, F, CN, NO₂, SF₅, isonitrile, un groupe ester, un groupe carboxylique, un groupe carbonyle, un groupe acyle, un groupe thio, un groupe sulfinyle, un groupe sulfonyle, un groupe phosphine, alkyle en C₁ à C₁₂ partiellement fluoré, alkyle en C₁ à C₁₂ perfluoré, CF₃, CF₂CF₃, alcoxy en C₁ à C₆ partiellement fluoré, alcoxy en C₁ à C₆ perfluoré, OCF₃, OCF₂CCF₃ ;
de préférence, au moins l'un parmi R^{a}, R^{b}, R^{c} et R^{d} est choisi indépendamment parmi aryle en C₆ à C₄₀ substitué ou non substitué, hétéroaryle en C₂ à C₄₀ substitué ou non substitué, alkyle en C₁ à C₁₂ substitué ou non substitué, carbocyclyle en C₃ à C₃₀ substitué ou non substitué, hétérocyclyle en C₂ à C₃₀ substitué ou non substitué, dans laquelle les substituants sur R^{a}, R^{b}, R^{c} et R^{d} sont indépendamment choisis parmi un groupe électroattracteur, halogène, F, CN, NO₂, SF₅, isonitrile, un groupe ester, un groupe carboxylique, un groupe carbonyle, un groupe acyle, un groupe thio, un groupe sulfinyle, un groupe sulfonyle, un groupe phosphine, alkyle en C₁ à C₁₂ partiellement perfluoré, alkyle en C₁ à C₁₂ perfluoré, CF₃, alcoxy en C₁ à C₆ partiellement perfluoré, alcoxy en C₁ à C₆ perfluoré, OCF₃ ;
dans laquelle
éventuellement l'un parmi R^{a}, R^{b}, R^{c}, R^{d} peut, indépendamment les uns des autres, former un hétérocycle substitué ou non substitué ou un carbocycle en C₃ à C₄₀ substitué ou non substitué, avec R¹,
dans laquelle le ou les substituants sur l'hétérocycle ou le carbocycle sont indépendamment choisis parmi D, un groupe électroattracteur, halogène, F, CN, NO₂, SF₅, isonitrile, un groupe ester, un groupe carboxylique, un groupe carbonyle, un groupe acyle, un groupe thio, un groupe sulfinyle, un groupe sulfonyle, un groupe phosphine, alkyle substitué ou non substitué, C₁ à C₁₂ alkyle partiellement perfluoré, C₁ à C₁₂ alkyle perfluoré, CF₃, C₁ à C₆ alcoxy partiellement perfluoré, C₁ à C₆ alcoxy perfluoré, OCF₃, C₆ à C₄₀ aryle substitué ou non substitué, C₂ à C₄₀ hétéroaryle substitué ou non substitué, C₃ à C₃₀ carbocyclyle substitué ou non substitué, ou C₂ à C₃₀ hétérocyclyle substitué ou non substitué ;
dans laquelle le ou les substituants sur le substituant sur l'hétérocycle ou le carbocyle sont indépendamment choisis parmi D, un groupe attracteur d'électrons, halogène, F, alkyle en C₁ à C₁₂ substitué ou non substitué, alkyle en C₁ à C₁₂ partiellement perfluoré, alkyle en C₁ à C₁₂ perfluoré, CF₃, alcoxy en C₁ à C₆ partiellement perfluoré, alcoxy en C₁ à C₆ perfluoré, OCF₃.

4. Dispositif électroluminescent organique selon l'une quelconque des revendications 1 ou 3, dans lequel le monoanion ou le ligand monoanionique L- est choisi parmi (V), (VI), (VII) ou (VIII) ou (IX) : 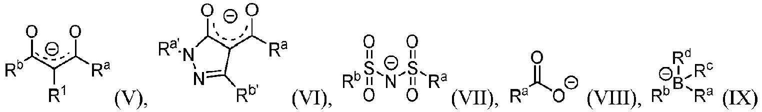 moyennant quoi
R^{a'} sont indépendamment choisis parmi alkyle en C₁ à C₁₂ substitué ou non substitué, aryle en C₆ à C₁₉ substitué ou non substitué, hétéroaryle en C₂ à C₂₀ substitué ou non substitué ou hétéroaryle à 6 chaînons substitué ou non substitué ;
R^{b'} est choisi parmi alkyle en C₁ à C₁₂ substitué ou non substitué, aryle en C₆ à C₁₉ substitué ou non substitué, hétéroaryle en C₂ à C₂₀ substitué ou non substitué, hétéroaryle à 6 chaînons substitué ou non substitué, ou CN ;
dans laquelle
au moins un des substituants parmi l'alkyle en C₁ à C₁₂ substitué, aryle en C₆ à C₁₉ substitué, hétéroaryle en C₂ à C₂₀ substitué ou hétéroaryle à 6 chaînons substitué est indépendamment choisi parmi halogène, Cl, F, CN, alkyle en C₁ à C₈ partiellement ou perfluoré, alcoxy en C₁ à C₈ partiellement ou perfluoré ;
dans lequel, dans la formule (VI)
au moins l'un parmi R^{a'}, R^{b'} et R^{a} ou le groupe de R^{a'}, R^{b'} et R^{a} comprend au moins trois atomes choisis dans le groupe constitué par halogène, Cl, F ou N ;
- les R restants sont tels que définis ci-dessus.

5. Dispositif électroluminescent organique selon la revendication 4, dans lequel au moins l'un parmi Ra, Rb, RC ou Rd ou Ra, Rb, RC et Rd est/sont indépendamment choisi(s) parmi D1 à D105 : 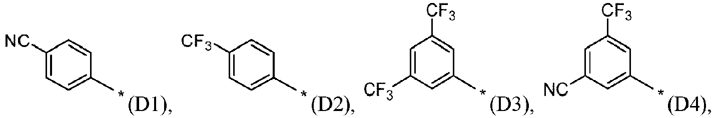 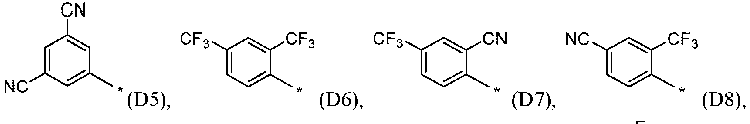 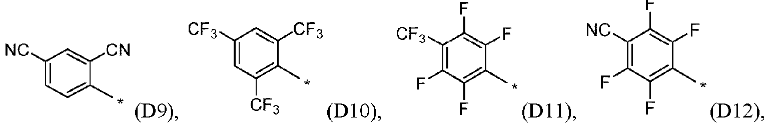 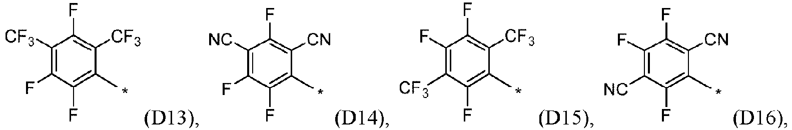 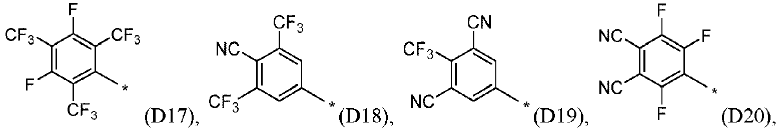 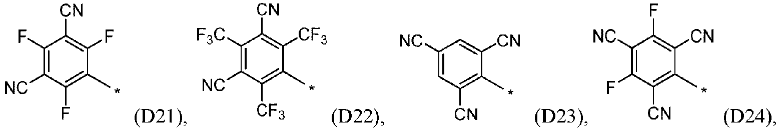 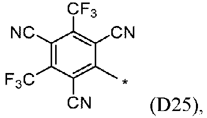 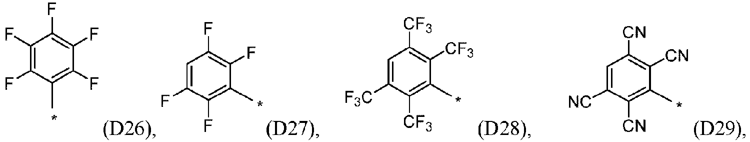 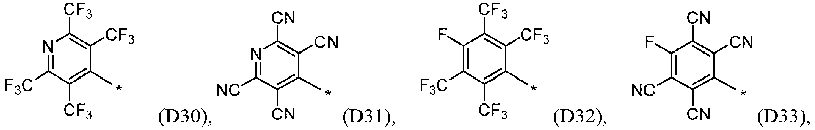 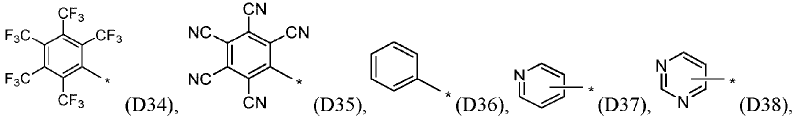 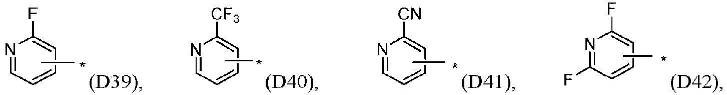 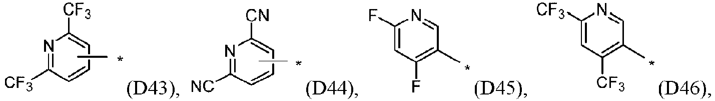 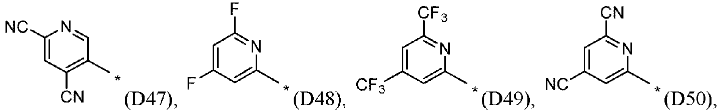 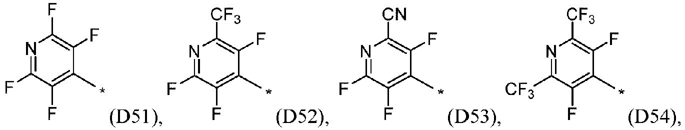 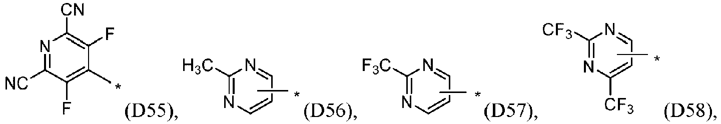 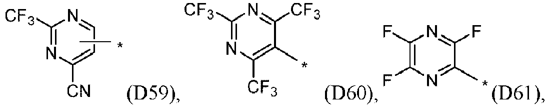 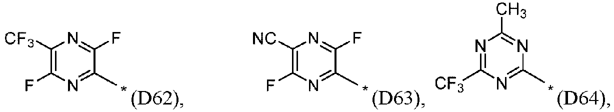 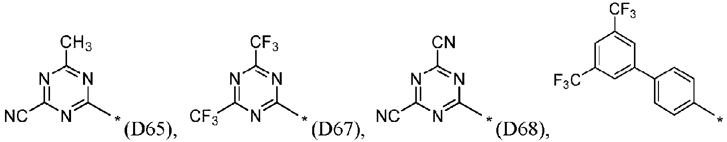 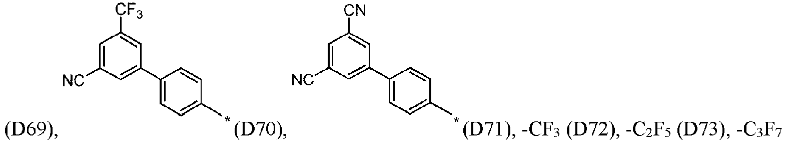 (D74), -CF₂CF₂CF₃ (D75), 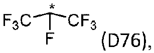 -C₄F₉ (D77), -CF₂CF₂CF₂CF₃ (D78) 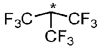 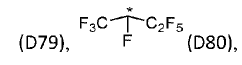 , -C₅F₁₁ (D81), -C₆F₁₃ (D82), -CH3 (D83), -C₂H₅ (D84) -CH(CH₃)₂ 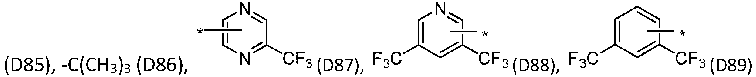 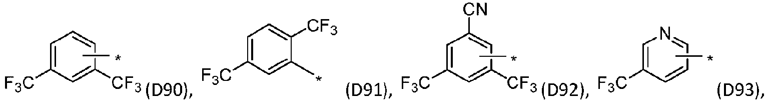 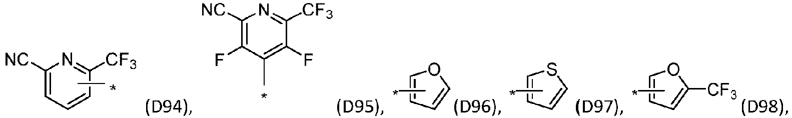 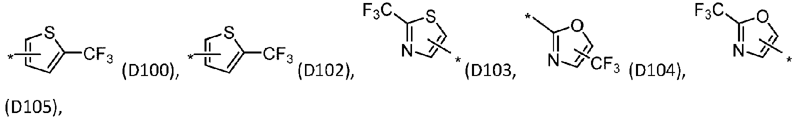 dans lesquels « * » ou « - » désigne la position de liaison.

6. Dispositif électroluminescent organique selon la revendication 5, dans lequel le monoanion ou le ligand monoanionique est choisi parmi L1 à L405 :

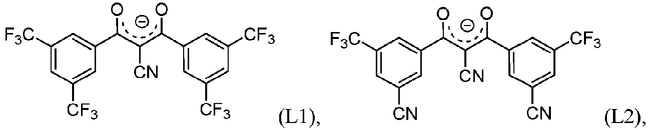

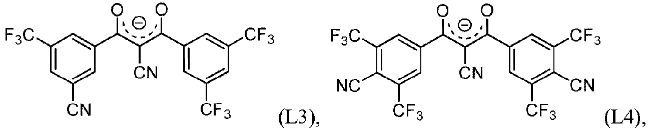

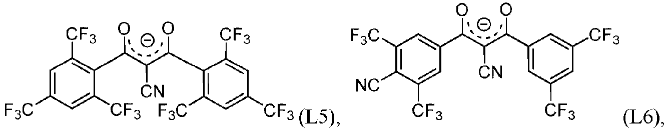

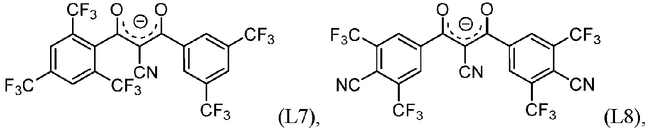

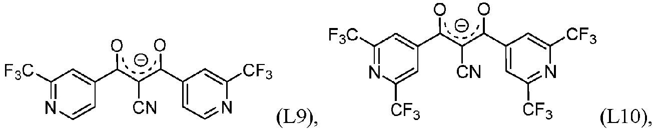

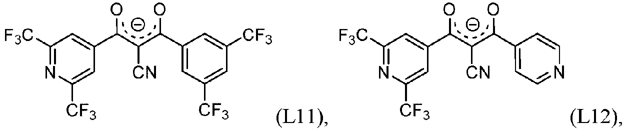

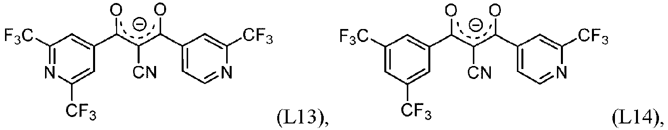

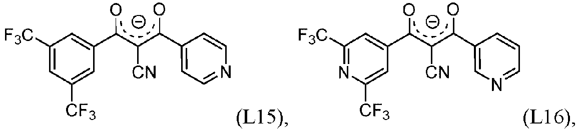

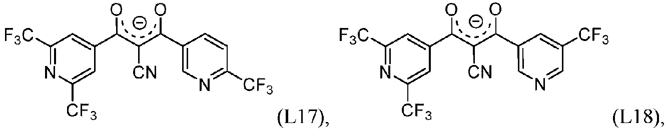

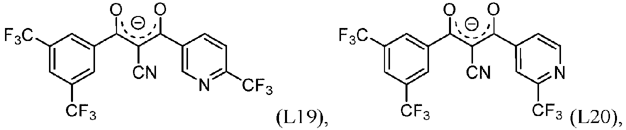

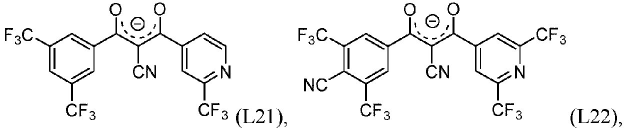

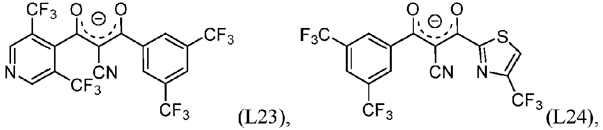

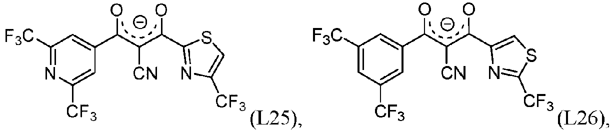

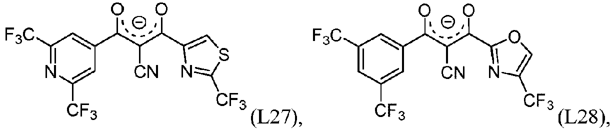

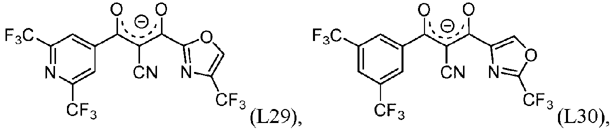

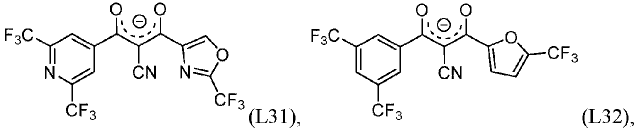

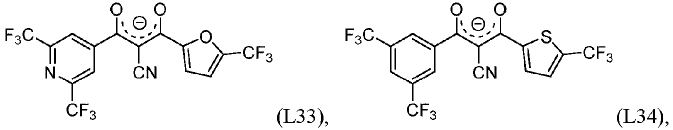

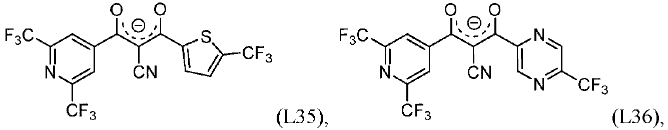

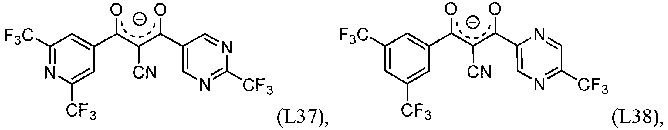

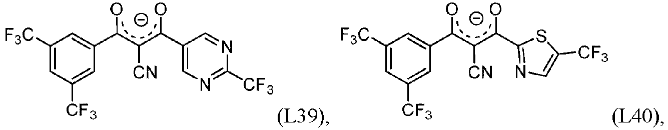

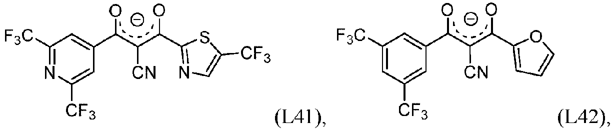

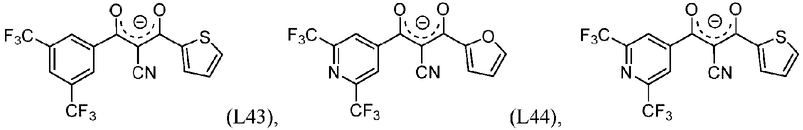

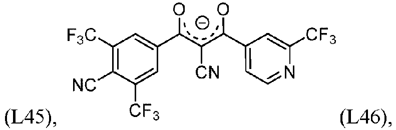

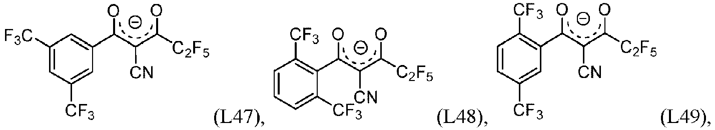

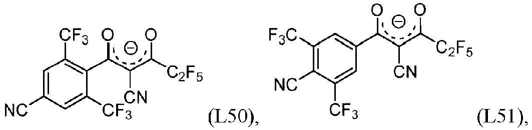

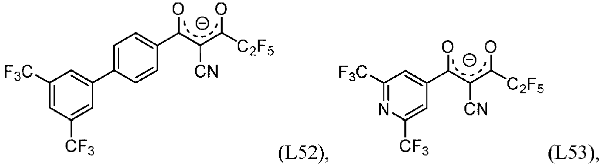

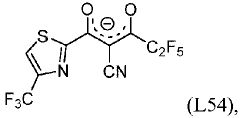

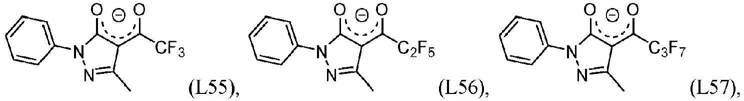

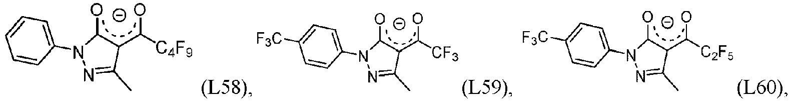

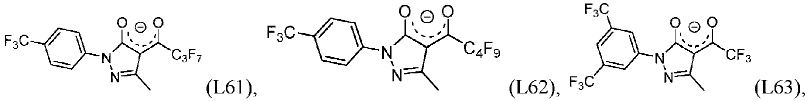

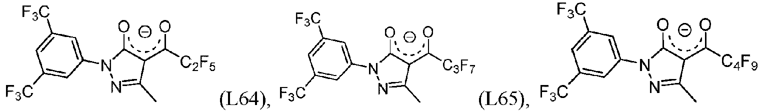

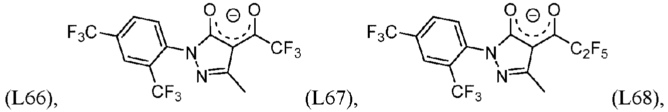

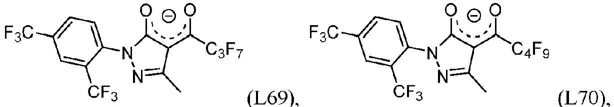

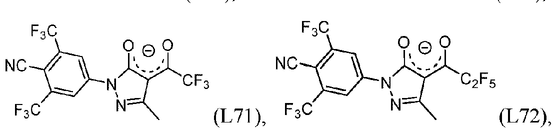

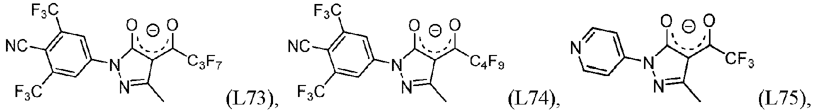

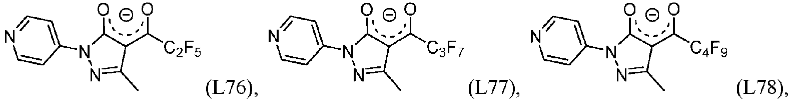

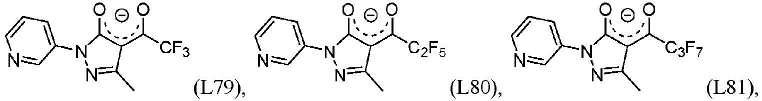

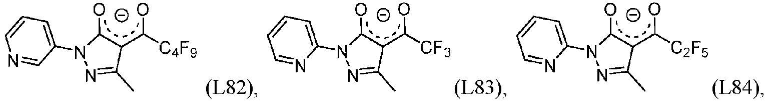

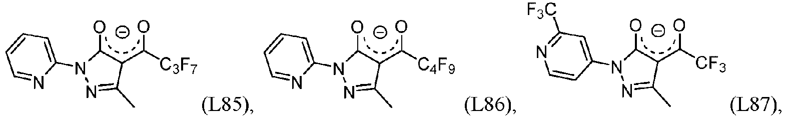

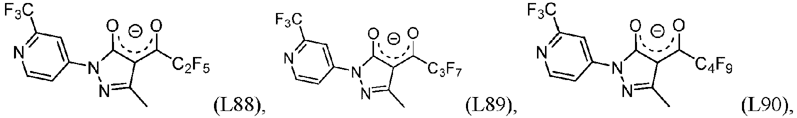

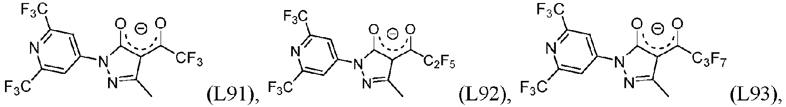

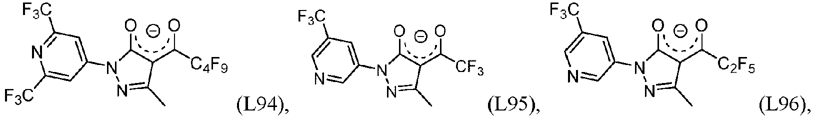

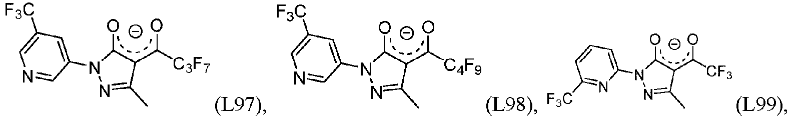

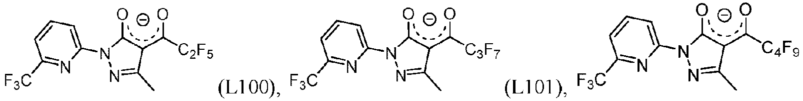

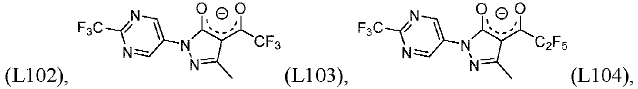

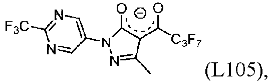

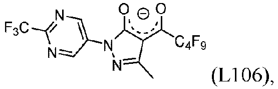

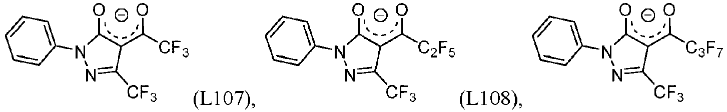

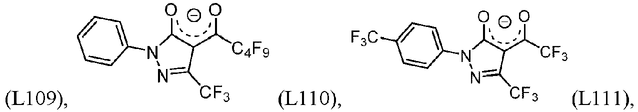

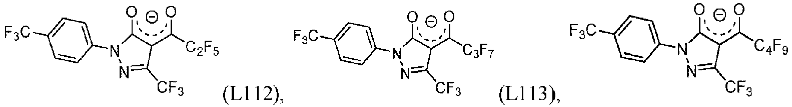

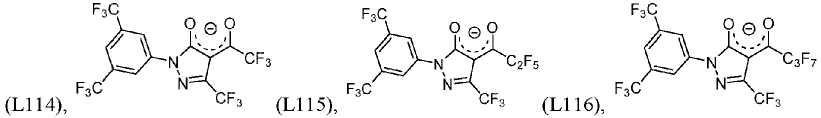

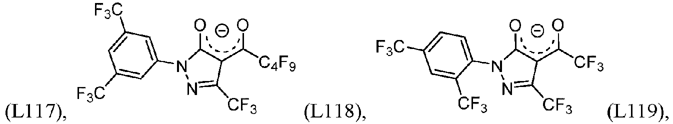

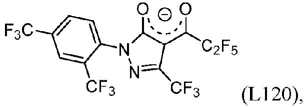

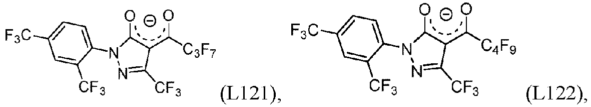

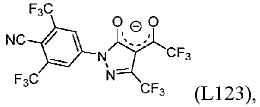

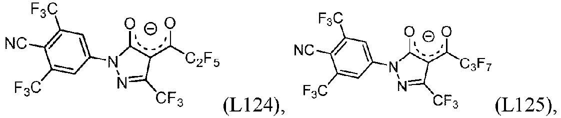

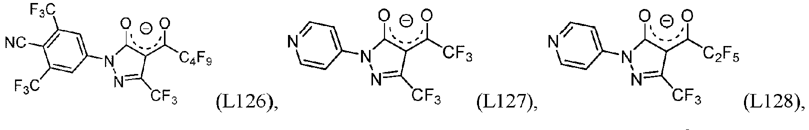

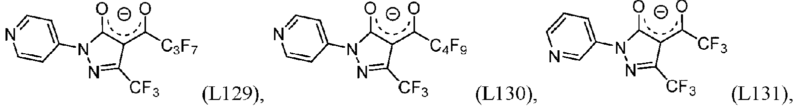

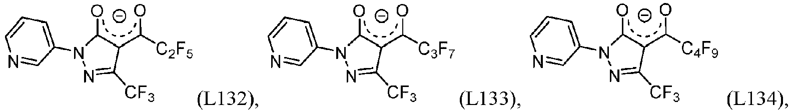

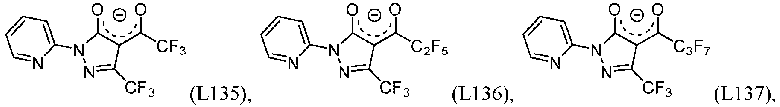

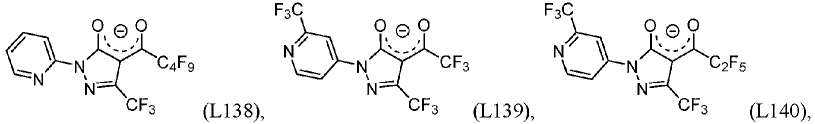

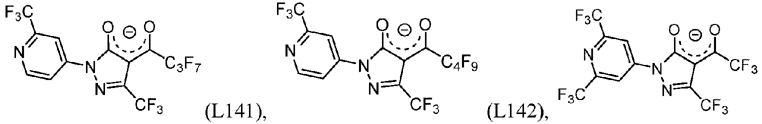

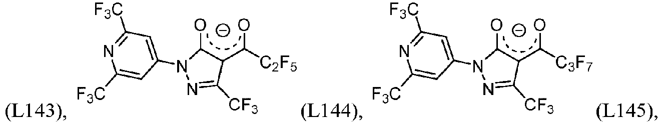

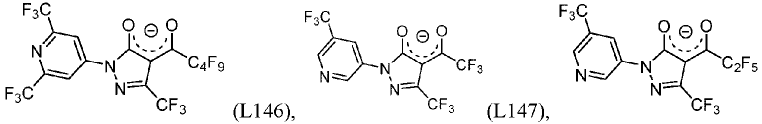

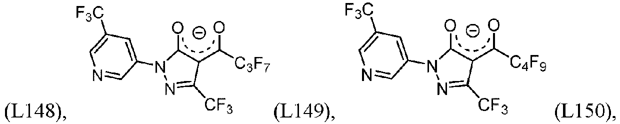

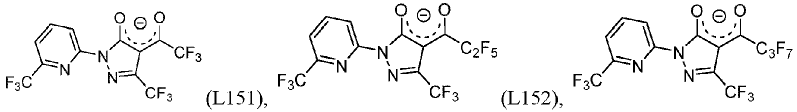

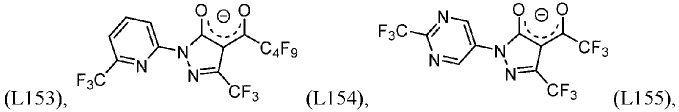

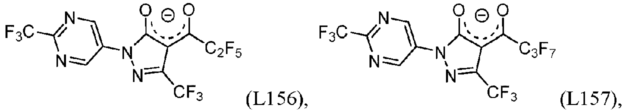

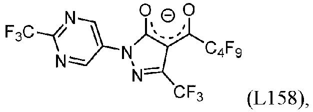

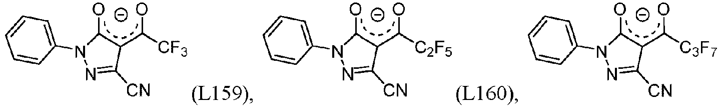

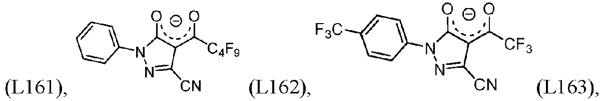

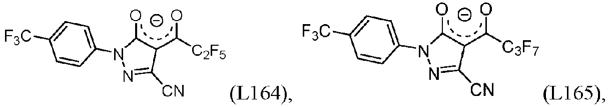

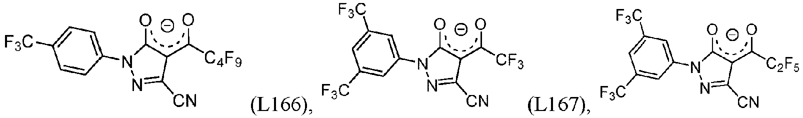

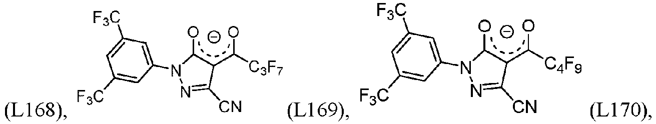

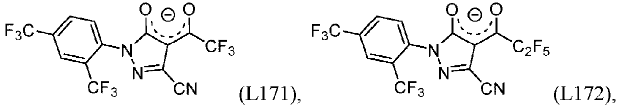

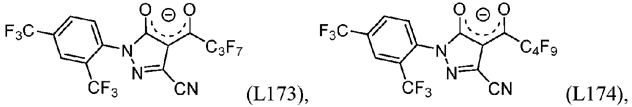

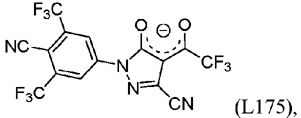

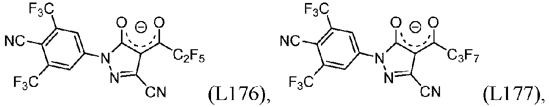

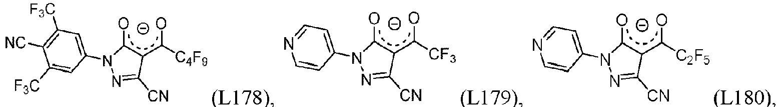

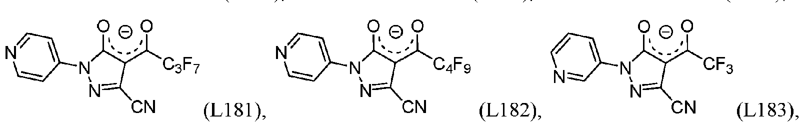

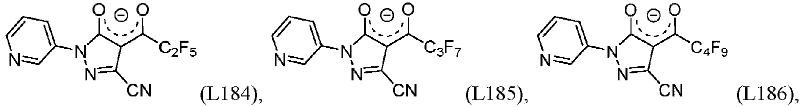

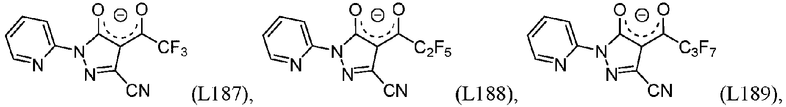

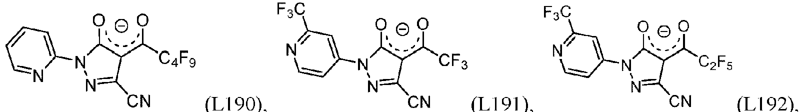

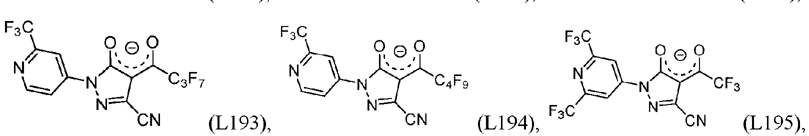

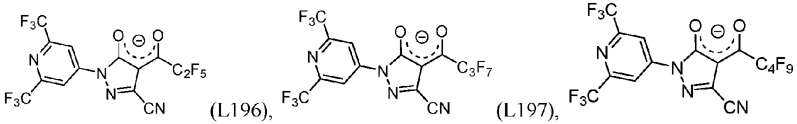

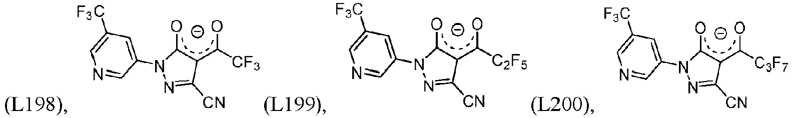

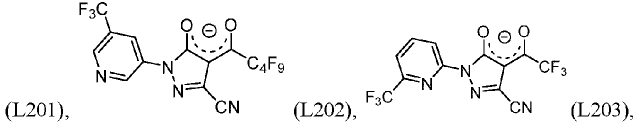

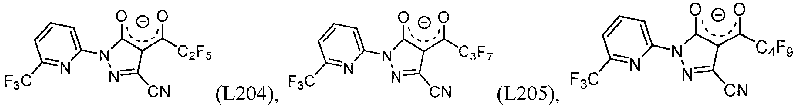

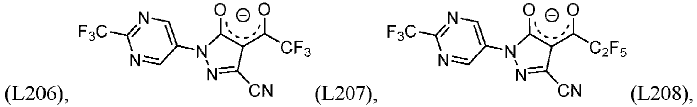

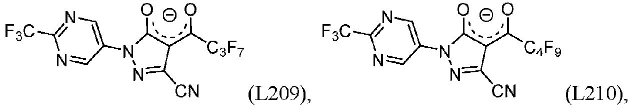

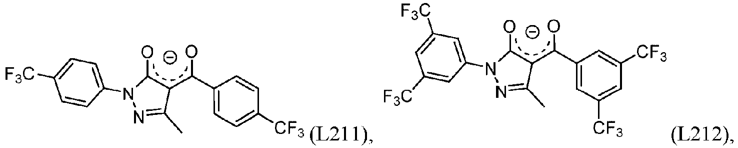

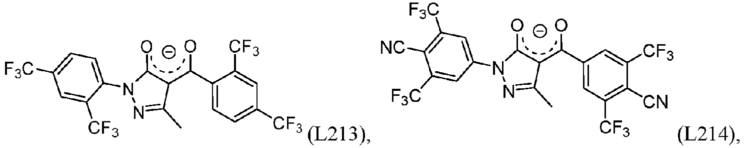

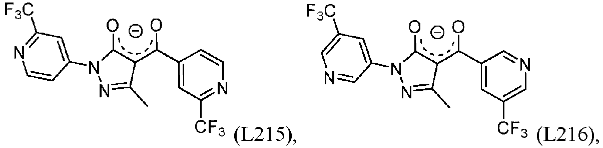

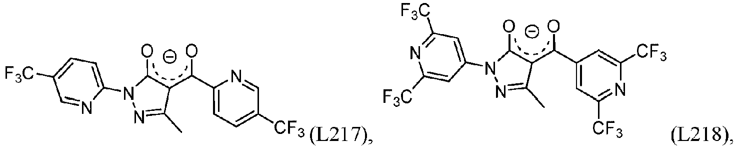

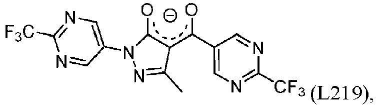

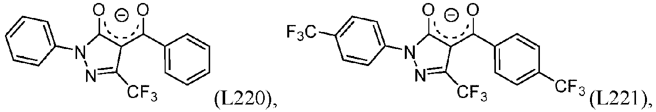

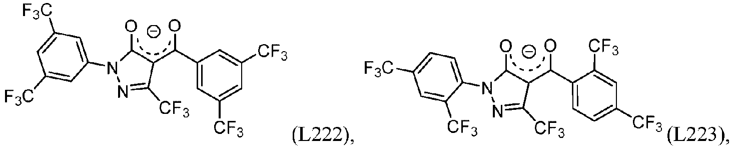

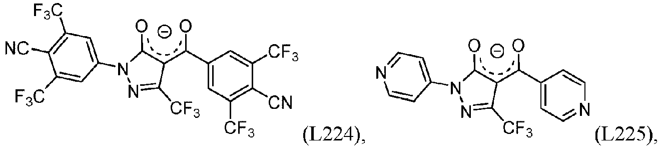

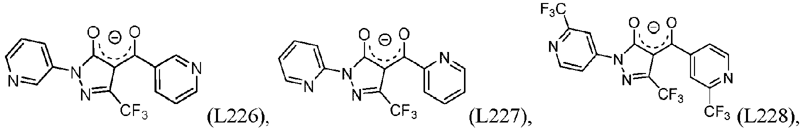

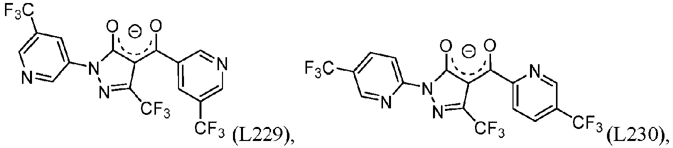

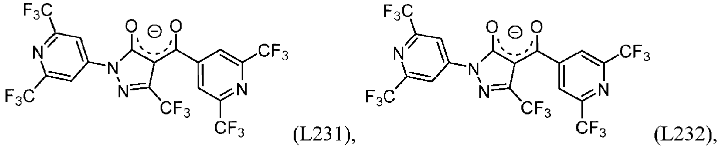

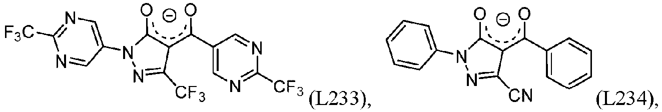

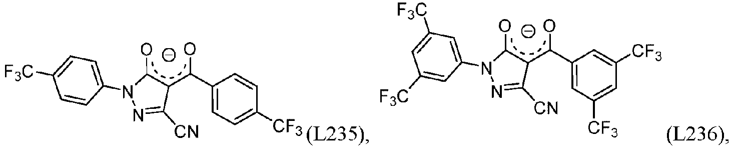

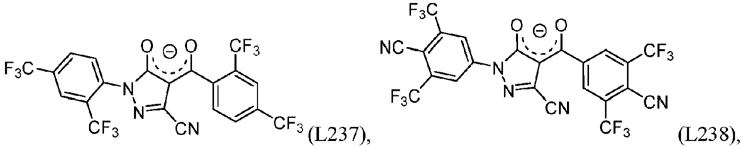

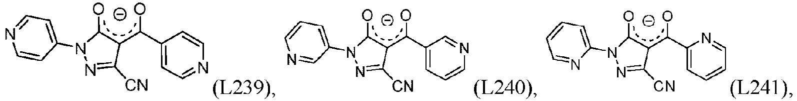

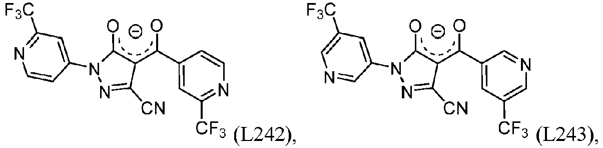

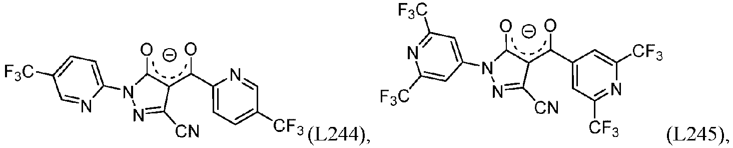

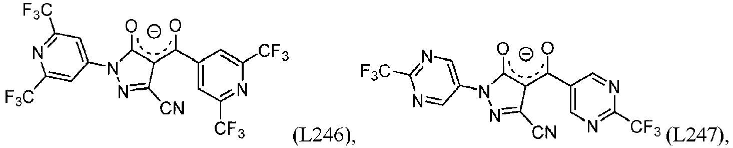

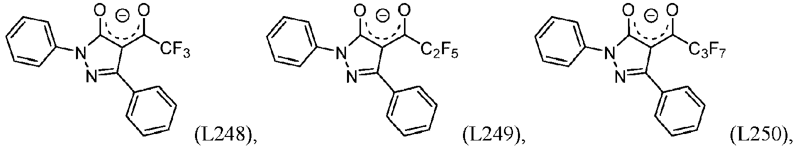

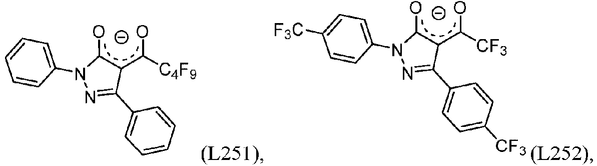

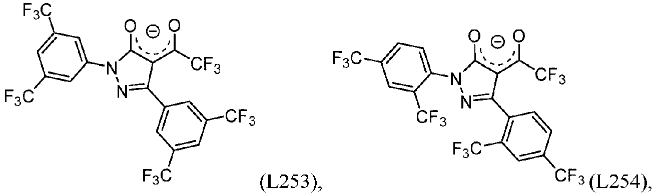

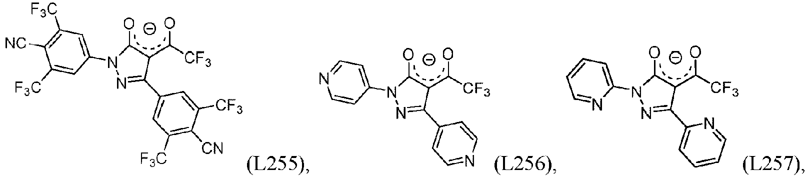

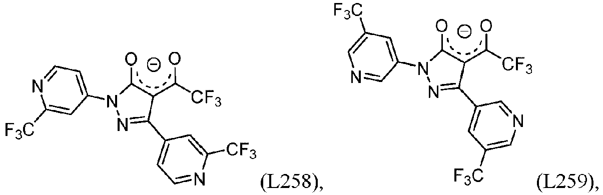

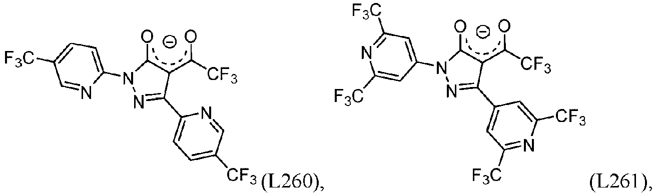

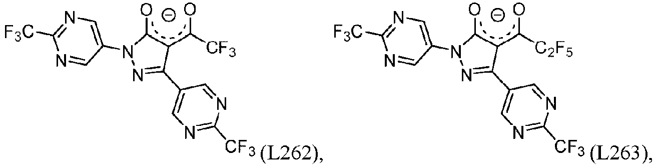

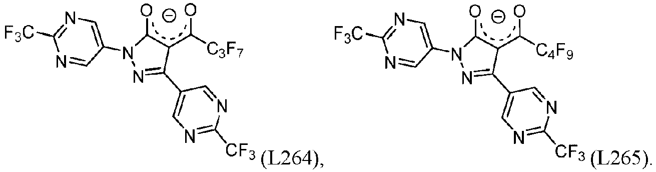

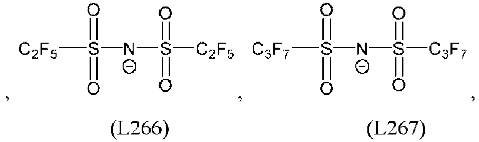

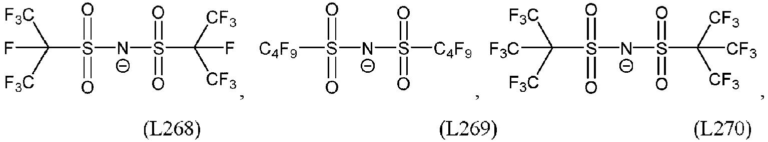

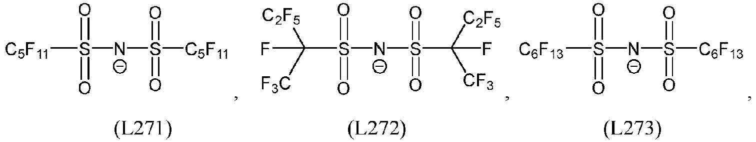

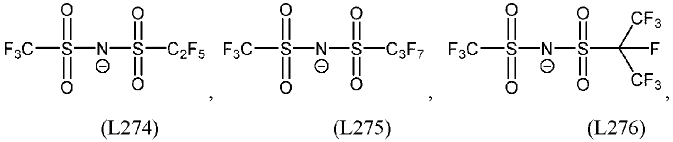

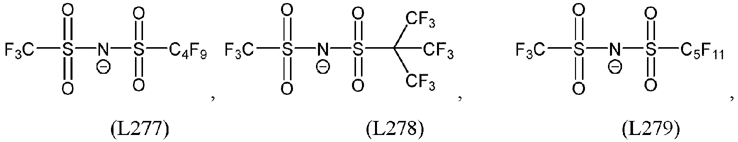

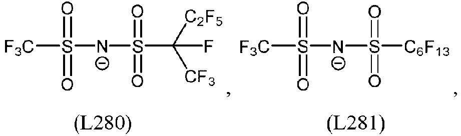

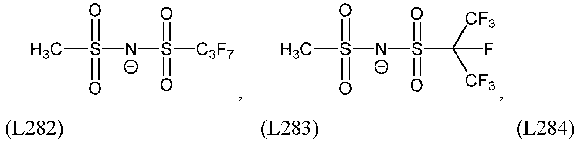

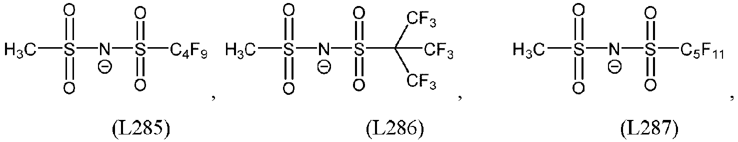

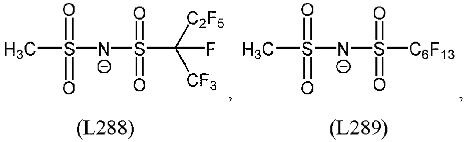

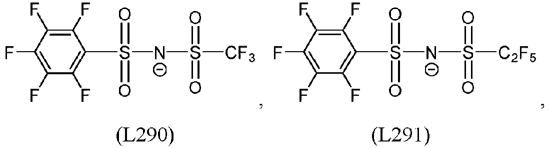

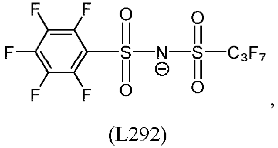

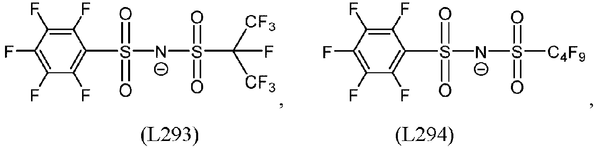

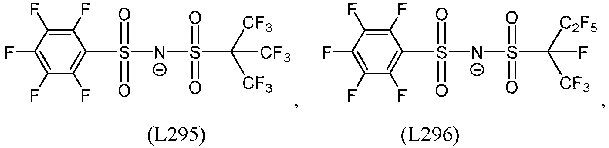

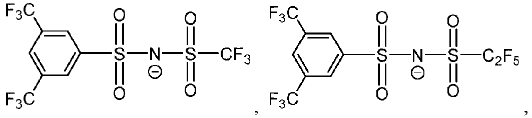

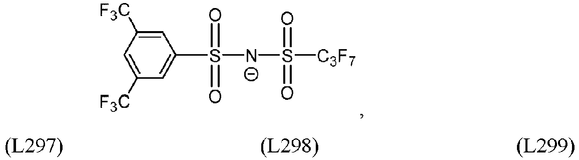

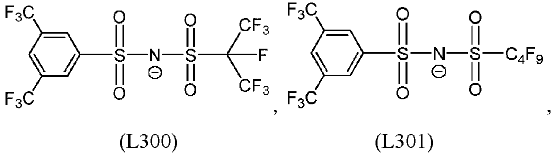

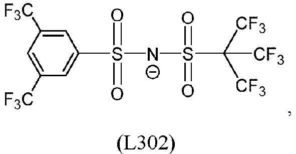

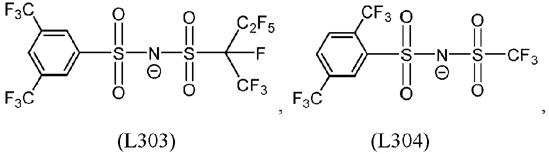

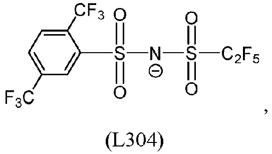

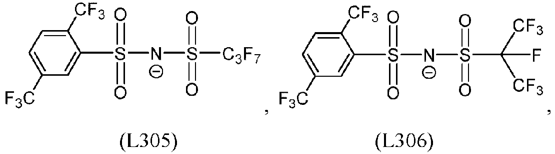

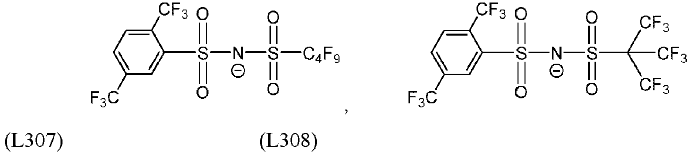

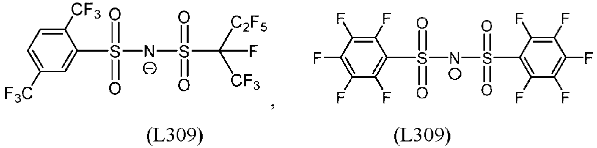

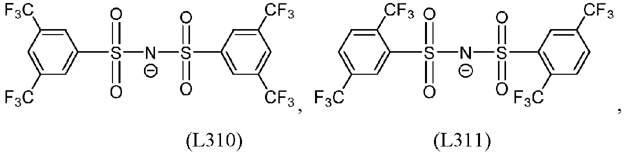

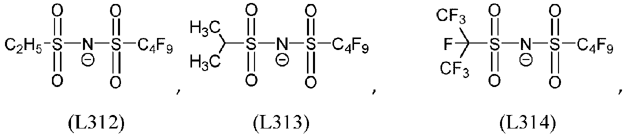

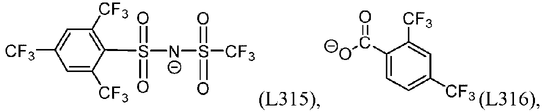

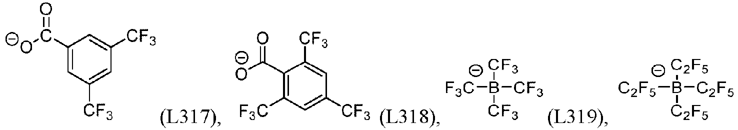

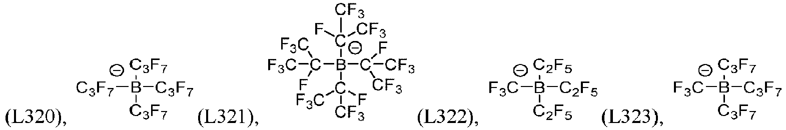

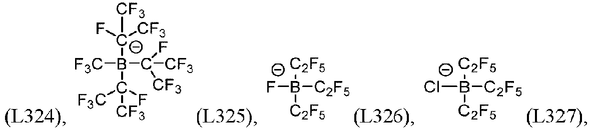

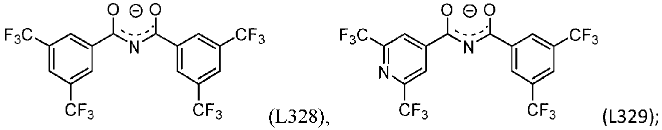

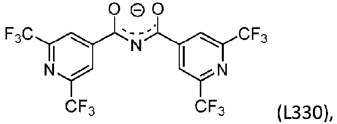

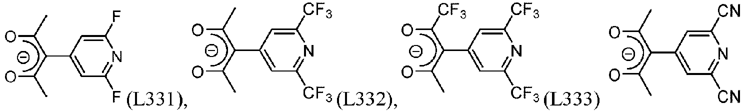

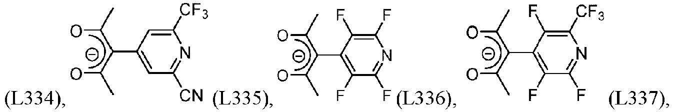

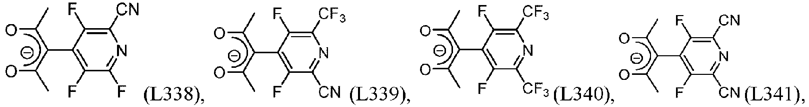

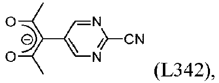

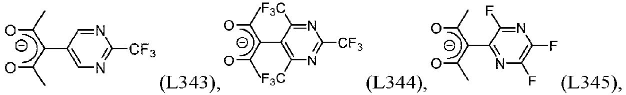

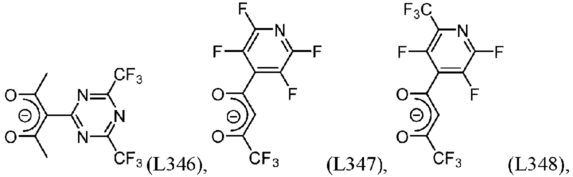

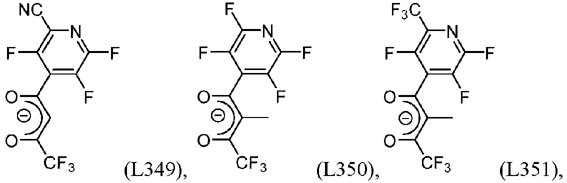

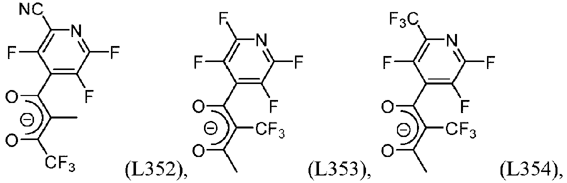

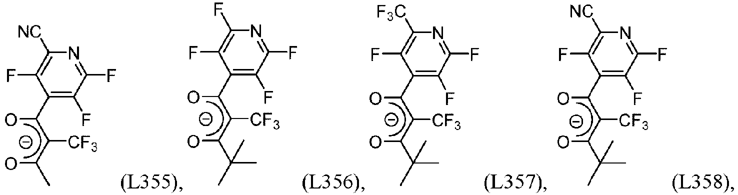

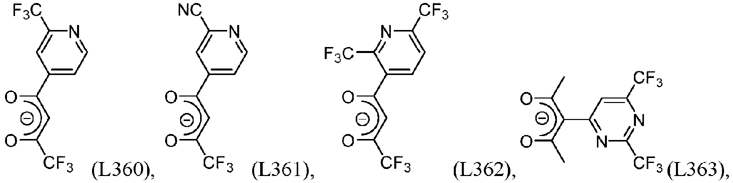

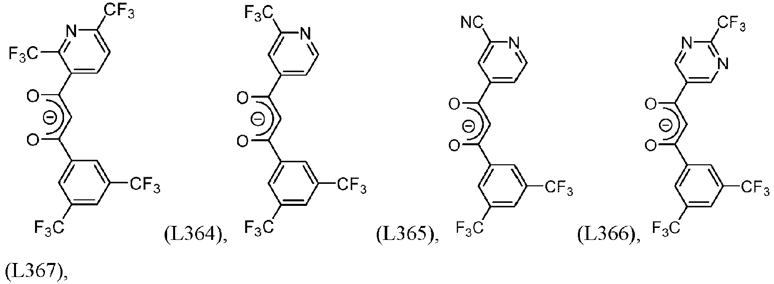

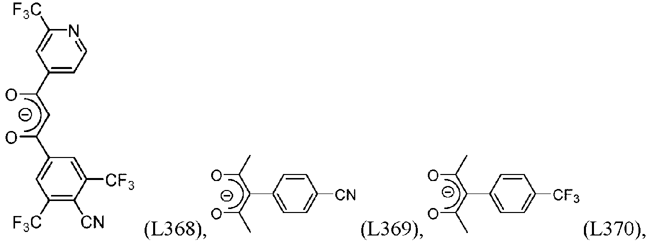

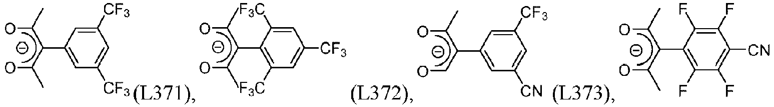

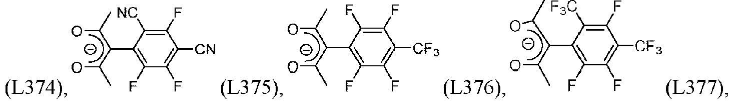

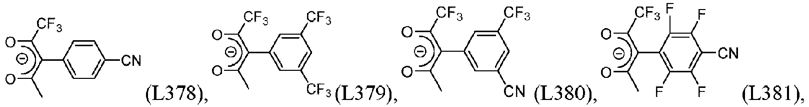

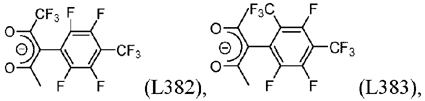

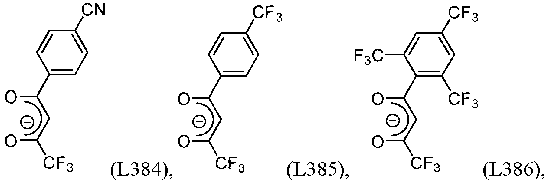

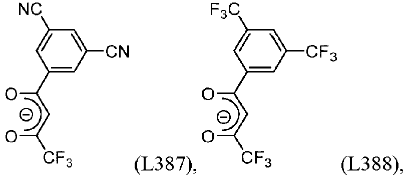

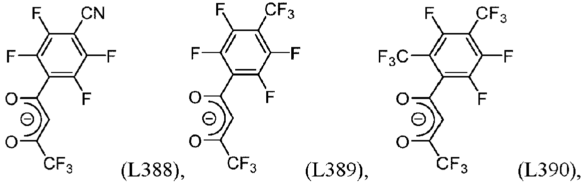

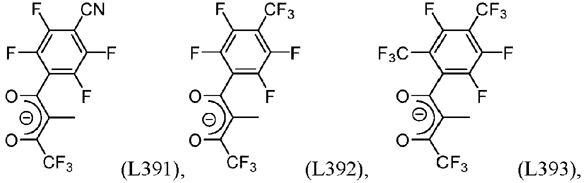

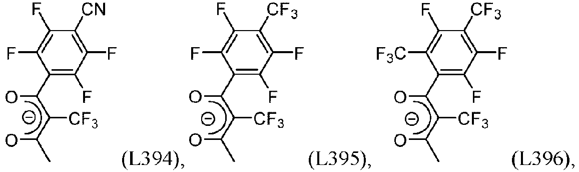

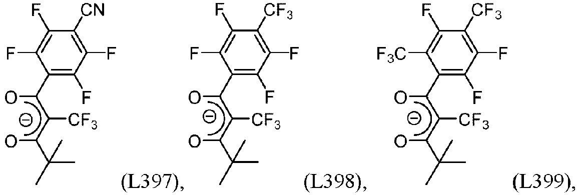

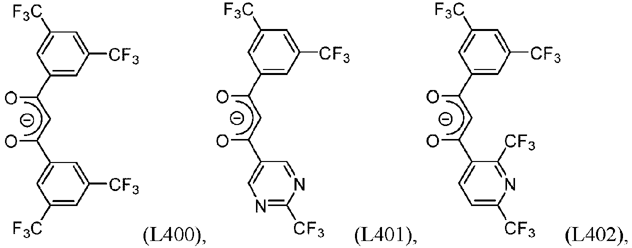

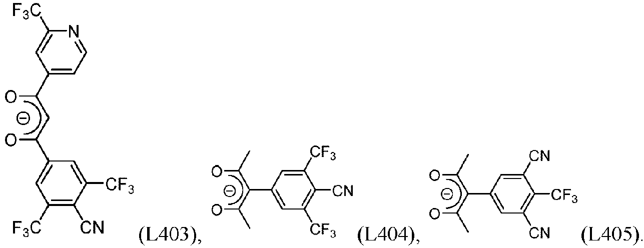

7. Dispositif électroluminescent organique selon l'une quelconque des revendications 1 à 6, dans lequel le composé de formule (I) est présent dans la couche de génération de charge de type p en une quantité de ≥ 1 % en poids et ≤ 20 % en poids sur la base du poids total de la couche de génération de charge de type p.

8. Dispositif électroluminescentes organique selon l'une quelconque des revendications 1 à 7, dans lequel le composé de formule (I) comprend au moins un groupe CF₃.

9. Dispositif électroluminescent organique selon l'une quelconque des revendications 1 à 8, dans lequel, dans la formule (I), Ar¹, Ar² et Ar³ sont indépendamment choisis parmi un groupe selon la formule (III) suivante et de préférence chaque R' est choisi parmi CN, 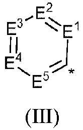 dans laquelle
E¹ est choisi parmi CW¹ ou N ;
E² est choisi parmi CW² ou N ;
E³ est choisi parmi CW³ ou N ;
E⁴ est choisi parmi CW⁴ ou N ;
E⁵ est choisi parmi CW⁵ ou N ;
W¹, W², W³, W⁴ et W⁵ (s'ils sont présents) sont choisis indépendamment parmi groupe électroattracteur, CN, halogène, Cl, F, NO₂, alkyle en C₁ à C₈ substitué ou non substitué, alkyle en C₁ à C₈ partiellement fluoré, alkyle en C₁ à C₈ perfluoré, alcoxy en C₁ à C₈ substitué ou non substitué, alcoxy en C₁ à C₈ partiellement fluoré, alcoxy en C₁ à C₆ perfluoré, OCF₃, aryle en C₆ à C₃₀ substitué ou non substitué, hétéroaryle en C₃ à C₃₀ substitué ou non substitué, D ou H,
dans laquelle le ou les substituants sont indépendamment choisis parmi D, halogène, Cl, F, CN, NO₂, alkyle en C₁ à C₈ partiellement fluoré, alkyle en C₁ à C₈ perfluoré, alcoxy en C₁ à C₈ partiellement fluoré, alcoxy en C₁ à C₈ perfluoré,
dans laquelle l'astérisque « * » désigne la position de liaison.

10. Dispositif électroluminescent organique selon la revendication 9, dans lequel, dans la formule (III), W¹, W², W³, W⁴ et W⁵ (s'ils sont présents) sont choisis indépendamment parmi un groupe électroattracteur, CN, halogène, Cl, F, NO₂, alkyle en C₁ à C₈ partiellement fluoré ou perfluoré, alcoxy en C₁ à C₆ partiellement fluoré ou perfluoré, D ou H, et de préférence chaque R' étant choisi parmi CN.

11. Dispositif électroluminescent organique selon l'une quelconque des revendications 1 à 10, dans lequel, dans la formule (I), Ar¹, Ar² et Ar³ sont indépendamment sélectionnés parmi B1 à B64, et préférablement chaque R' est choisi parmi CN : 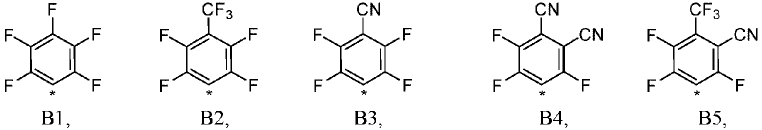 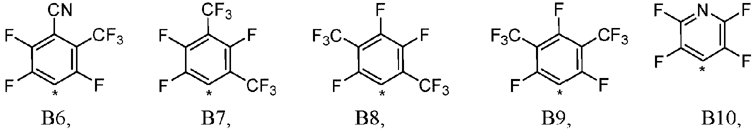 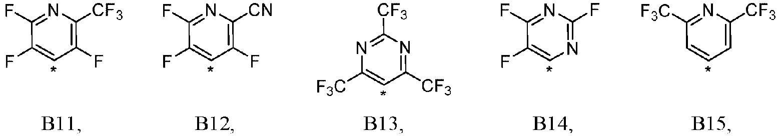 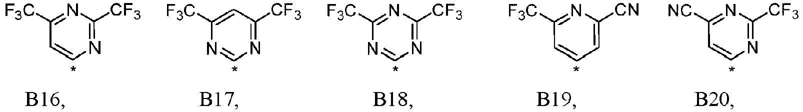 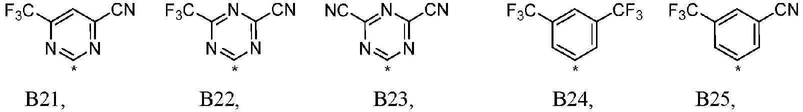 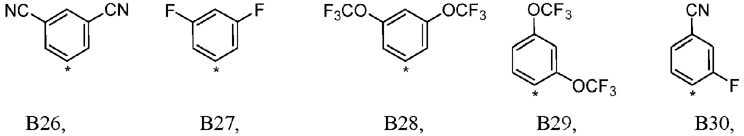 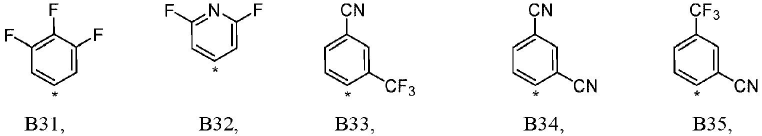 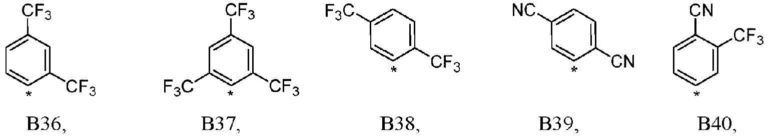 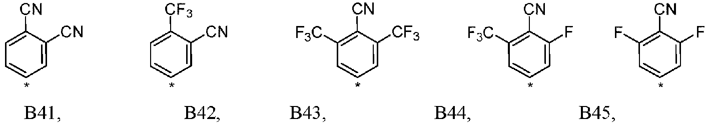 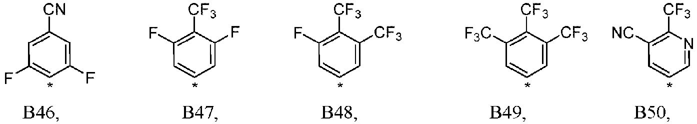 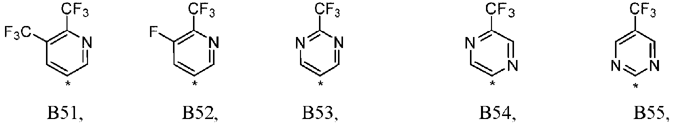 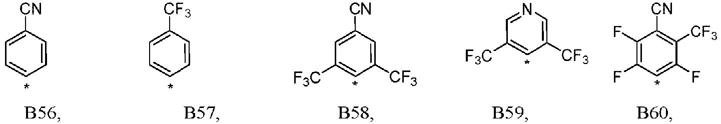 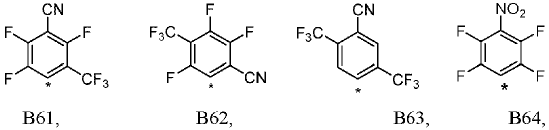 dans laquelle l'astérisque « * » désigne la position de liaison.

12. Dispositif électroluminescent organique selon l'une quelconque des revendications 1 à 11, dans lequel le dopant métallique de la première couche de génération de charge de type n est un métal choisi dans le groupe constitué de Li, Mg et Yb ou un alliage métallique comprenant un métal choisi dans le groupe constitué de Li, Mg et Yb.

13. Dispositif électroluminescent organique selon l'une quelconque des revendications 1 à 12, dans lequel le dopant métallique de la première couche de génération de charge de type n est Yb ou un alliage métallique comprenant un métal choisi dans le groupe constitué de Li et Yb.

14. Dispositif électroluminescent organique selon l'une quelconque des revendications 1 à 13, dans lequel le dispositif luminescent organique est une diode électroluminescente organique.

15. Dispositif d'affichage comprenant un dispositif électroluminescent organique selon l'une quelconque des revendications 1 à 14.
